(19) Europäisches Patentamt
European Patent Office
Office européen des brevets

(11) **EP 1 125 359 B1**

(12) **EUROPEAN PATENT SPECIFICATION**

(45) Date of publication and mention
of the grant of the patent:
**21.04.2004 Bulletin 2004/17**

(21) Application number: **99954996.7**

(22) Date of filing: **20.10.1999**

(51) Int Cl.⁷: **H03D 3/00**, H03D 7/00

(86) International application number:
**PCT/US1999/024299**

(87) International publication number:
**WO 2000/024117 (27.04.2000 Gazette 2000/17)**

(54) **METHOD AND SYSTEM FOR DOWN-CONVERTING AN ELECTROMAGNETIC SIGNAL**

VERFAHREN UND SYSTEM FÜR ABWÄRTSUMWANDLUNG EINES ELEKTROMAGNETISCHEN SIGNALS

PROCEDE ET SYSTEME DE TRANSPOSITION D'UN SIGNAL ELECTROMAGNETIQUE PAR ABAISSEMENT DE FREQUENCE

(84) Designated Contracting States:
**AT BE CH CY DE DK ES FI FR GR IE IT LI LU MC NL PT SE**
Designated Extension States:
**AL LT LV MK RO SI**

(30) Priority: **21.10.1998 US 176022**
**16.04.1999 US 293095**
**16.04.1999 US 293342**

(43) Date of publication of application:
**22.08.2001 Bulletin 2001/34**

(60) Divisional application:
**02079190.1 / 1 315 285**

(73) Proprietor: **Parker Vision, Inc.**
**Jacksonville, FL 32256 (US)**

(72) Inventors:
• **SORRELLS, David, F.**
**Middleburg, FL 32068 (US)**
• **BULTMAN, Michael, J.**
**Jacksonville, FL 32246 (US)**
• **COOK, Robert, W.**
**Switzerland, FL 32259 (US)**
• **LOOKE, Richard, C.**
**Jacksonville, FL 32257 (US)**
• **MOSES, Charley, D., Jr.**
**Jacksonville, FL 32217 (US)**
• **RAWLINS, Gregory, S.**
**Heathrow, FL 32746 (US)**
• **RAWLINS, Michael, W.**
**Lake Mary, FL 32746 (US)**

(74) Representative:
**Cross, James Peter Archibald et al**
**R.G.C. Jenkins & Co.,**
**26 Caxton Street**
**London SW1H 0RJ (GB)**

(56) References cited:
WO-A-94/05087          WO-A-96/02977
WO-A-96/39750          US-A- 4 888 557
US-A- 5 172 070

• SHEN D H ET AL: "A 900MHZ INTEGRATED DISCRETE-TIME FILTERING RF FRONT-END" IEEE INTERNATIONAL SOLID STATE CIRCUITS CONFERENCE, vol. 39, February 1996 (1996-02), page 54/55, 417 XP000685536

**Description**

*Background of the Invention*

*Field of the Invention*

The present invention relates to down-conversion of modulated electromagnetic carrier signals to intermediate frequency signals. The present invention also relates to under-sampling and to transferring energy at aliasing rates.

*Related Art*

Information signals (baseband signals) include, but are not limited to, video baseband signals, voice baseband signals, computer baseband signals, etc. Baseband signals include analog baseband signals and digital baseband signals.

It is often beneficial to propagate information signals at higher frequencies. This is generally true regardless of whether the propagation medium is wire, optic fiber, space, air, liquid, etc.. To enhance efficiency and practicality, such as improved ability to radiate and added ability for multiple channels of baseband signals, up-conversion to a higher frequency is utilized. Conventional up-conversion processes modulate higher frequency carrier signals with baseband signals. Modulation refers to a variety of techniques for impressing information from the baseband signals onto the higher frequency carrier signals. The resultant signals are referred to herein as modulated carrier signals. For example, the amplitude of an amplitude modulated ("AM") carrier signal varies in relation to changes in the baseband signal, the frequency of a frequency modulated ("FM") carrier signal varies in relation to changes in the baseband signal, and the phase of a phase modulated ("PM") carrier signal varies in relation to changes in the baseband signal.

In order to process the information that was in the baseband signal, the information must be extracted, or demodulated, from the modulated carrier signal. However, because conventional signal processing technology is limited in operational speed, conventional signal processing technology cannot easily demodulate a baseband signal from higher frequency modulated carrier signal directly. Instead, higher frequency modulated carrier signals must be down-converted to an intermediate frequency (IF), from where aconventional demodulator can demodulate the baseband signal.

Conventional down-converters include electrical components whose properties are frequency dependent. As a result, conventional down-converters are designed around specific frequencies or frequency ranges and do not work well outside their designed frequency range.

Conventional down-converters generate unwanted image signals and thus must include filters for filtering the unwanted image signals. However, such filters reduce the power level of the modulated carrier signals. As a result, conventional down-converters include power amplifiers, which require external energy sources.

When a received modulated carrier signal is relatively weak, as in, for example, a radio receiver, conventional down-converters include additional power amplifiers, which require additional external energy.

For example, WO 94 05087 A, dated 3 March 1994, is directed to a direct conversion receiver for multiple protocols. The receiver utilizes a sample and hold circuit for sub-sampling an input signal, the output of which is applied to a sigma-delta loop to provide a high speed, low resolution data stream, which in turn is applied to a decimator, which provides a quadrature data signal.

WO 96 39750 A, dated 12 December 1992, is directed to RF signal reception using frequency shifting by discrete-time sub-sampling down-conversion. A sample and hold circuit sub-samples the analog RF channel of frequency fc, converting it to a discrete-time image signal of frequency fi. Successive down-sampling, anti-alias filtering, and amplification of the discrete-time image signal yields a low-frequency discrete-time signal containing a down-converted channel of frequency fk. The low-frequency discrete-time signal is then digitized, filtered, and demodulated to reveal its baseband information content.

WO 96 02977, dated 1 February 1996, is directed to a receiver using sample and hold, and track and hold circuits in place of conventional mixers.

US-A-5557641 is directed to charge-coupled device based transmitters and receivers. According to this document, a charge coupled device (CCD) receives and demodulates a signal.

What is needed includes, without limitation:

an improved method and system for down-converting modulated electromagnetic carrier signals;
a method and system for transferring energy and for augmenting such energy transfer when down-converting modulated electromagnetic carrier signals;
a controlled impedance method and system for down-converting a modulated electromagnetic carrier signal;
a controlled aperture under-sampling method and system for down-converting a modulated electromagnetic carrier signal;

a method and system for down-converting modulated electromagnetic carrier signals using a universal down-converter design that can be easily configured for different frequencies;

a method and system for down-converting modulated electromagnetic carrier signals using a local oscillator frequency that is substantially lower than the carrier frequency;

a method and system for down-converting modulated electromagnetic carrier signals using only one local oscillator;

a method and system for down-converting modulated electromagnetic carrier signals that uses fewer filters than conventional down-converters;

a method and system for down-converting modulated electromagnetic carrier signals using less power than conventional down-converters;

a method and system for down-converting modulated electromagnetic carrier signals that uses less space than conventional down-converters;

a method and system for down-converting modulated electromagnetic carrier signals that uses fewer components than conventional down-converters; and

a method and system for down-converting modulated electromagnetic carrier signals that can be implemented on an integrated circuit (IC).

### *Summary of the Invention*

According to one aspect of the present invention, there is provided a method according to claim 1.

According to another aspect of the present invention, there is provided apparatus according to claim 42.

Generally, embodiments of the present invention operate by receiving a modulated electromagnetic carrier signal. The embodiments also receive an energy transfer aliasing signal having an aliasing rate. The embodiments alias the modulated carrier signal according to the aliasing signal to down-convert the modulated carrier signal to an intermediate frequency (IF) signal. The invention is applicable to any type of modulated electromagnetic carrier signal.

Further features and advantages of the invention, as well as the structure and operation of various embodiments of the invention, are described in detail below with reference to the accompanying drawings.

The drawing in which an element first appears is typically indicated by the leftmost digit(s) in the corresponding reference number.

### *Brief Description of the Drawings*

The present invention will be described with reference to the accompanying drawings wherein:

FIGS.1 illustrates a structural block diagram of an example modulator;

FIG. 2 illustrates an example analog modulating baseband signal;

FIG. 3 illustrates an example digital modulating baseband signal;

FIG. 4 illustrates an example carrier signal;

FIGS. 5A-5C illustrate example signal diagrams related to amplitude modulation;

FIGS. 6A-6C illustrate example signal diagrams related to amplitude shift keying modulation;

FIGS. 7A-7C illustrate example signal diagrams related to frequency modulation;

FIGS. 8A-8C illustrate example signal diagrams related to frequency shift keying modulation;

FIGS. 9A-9C illustrate example signal diagrams related to phase modulation;

FIGS. 10A-10C illustrate example signal diagrams related to phase shift keying modulation;

FIG. 11 illustrates a structural block diagram of a conventional receiver;

FIG. 12 illustrates a flowchart for down-converting a modulated carrier signal by transferring energy from the modulated carrier signal at an aliasing rate according to embodiments of the invention;

FIGS. 13A-E illustrate example signal diagrams associated with the flowchart in FIG. 12 according to embodiments of the invention;

FIG.14 is a flowchart that illustrates an example process for determining an aliasing rate associated with an aliasing signal according to an embodiment of the invention;

FIG. 15A-H illustrate example energy transfer signals according to embodiments of the invention;

FIGS. 16A-G illustrate example signal diagrams associated with down-converting an analog AM signal to an intermediate frequency by transferring energy at an aliasing rate according to embodiments of the invention;

FIGS. 17A-G illustrate example signal diagrams associated with down-converting an digital AM signal to an intermediate frequency by transferring energy at an aliasing rate according to embodiments of the invention;

FIGS. 18A-G illustrate example signal diagrams associated with down-converting an analog FM signal to an intermediate frequency by transferring energy at an aliasing rate according to embodiments of the invention;

FIGS. 19A-G illustrate example signal diagrams associated with down-converting an digital FM signal to an intermediate frequency by transferring energy at an aliasing rate according to embodiments of the invention;

FIGS. 20A-G illustrate example signal diagrams associated with down-converting an analog PM signal to an intermediate frequency by transferring energy at an aliasing rate according to embodiments of the invention;

FIGS. 21A-G illustrate example signal diagrams associated with down-converting a digital PM signal to an intermediate frequency by transferring energy at an aliasing rate according to embodiments of the invention;

FIG. 22 illustrates a block diagram of an energy transfer system according to an embodiment of the invention;

FIG. 23A illustrates an exemplary gated transfer system according to an embodiment of the invention;

FIG. 23B illustrates an exemplary inverted gated transfer system according to an embodiment of the invention;

FIG. 24 illustrates an example embodiment of the gated transfer module according to an embodiment of the invention;

FIGS. 25A-D illustrate example implementations of a switch module according to embodiments of the invention;

FIG. 26A illustrates an example embodiment of the gated transfer module as including a break-before-make module according to an embodiment of the invention;

FIG. 26B illustrates an example timing diagram for an energy transfer signal according to an embodiment of the invention;

FIG. 26C illustrates an example timing diagram for an isolation signal according to an embodiment of the invention;

FIGS. 27A-F illustrate example storage modules according to embodiments of the invention;

FIG. 27G illustrates an integrated gated transfer system according to an embodiment of the invention;

FIGS. 27H-K illustrate example aperture generators;

FIG. 27L illustrates an oscillator according to an embodiment of the present invention;

FIG. 28 illustrates an energy transfer system with an optional energy transfer signal module according to an embodiment of the invention;

FIG. 29 illustrates an aliasing module with input and output impedance match according to an embodiment of the invention;

FIG. 30 illustrates an example pulse generator;

FIGS. 31A and B illustrate example waveforms related to the pulse generator of FIG. 30;

FIG. 32 illustrates an example energy transfer module with a switch module and a reactive storage module according to an embodiment of the invention;

FIG. 33 illustrates an example inverted gated transfer module as including a switch module and a storage module according to an embodiment of the invention;

FIGS. 34A-F illustrate an example signal diagrams associated with an inverted gated energy transfer module according to embodiments of the invention;

FIGS. 35A-E illustrate energy transfer modules in various differential configurations according to embodiments of the invention;

FIGS. 36A-C illustrate example impedance matching circuits according to embodiments of the invention;

FIGS. 37A-B illustrate example under-sampling systems;

FIGS. 38A-F illustrate example timing diagrams for under-sampling systems;

FIGS. 39A-F illustrate example timing diagrams for an under-sampling system when the load is a relatively low impedance load;

FIGS. 40A-F illustrate example timing diagrams for an under-sampling system when the holding capacitance has a larger value;

FIGS. 41A-B illustrate example energy transfer systems according to embodiments of the invention;

FIGS. 42A-F illustrate example timing diagrams for energy transfer systems according to embodiments of the present invention;

FIG. 43A illustrates an example energy transfer signal module according to an embodiment of the present invention;

FIG. 43B illustrates a flowchart of state machine operation according to an embodiment of the present invention;

FIG. 43C is an example energy transfer signal module;

FIG. 44 is a schematic diagram of a circuit to down-convert a 915 MHZ signal to a 5 MHZ signal using a 101.1 MHZ clock according to an embodiment ofthe present invention;

FIG. 45 shows simulation waveforms for the circuit of FIG. 44 according to embodiments of the present invention;

FIG. 46 is a schematic diagram of a circuit to down-convert a 915 MHZ signal to a 5 MHz signal using a 101 MHZ clock according to an embodiment of the present invention;

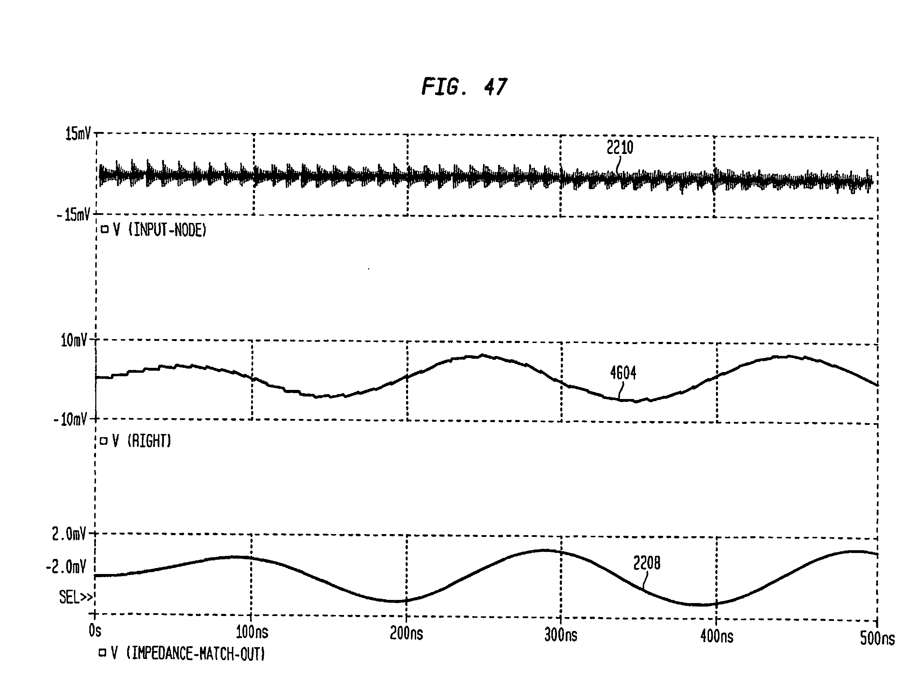

FIG. 47 shows simulation waveforms for the circuit of FIG. 46 according to embodiments of the present invention;

FIG. 48 is a schematic diagram of a circuit to down-convert a 915 MHZ signal to a 5 MHZ signal using a 101.1 MHZ clock according to an embodiment of the present invention;

FIG. 49 shows simulation waveforms for the circuit of FIG. 48 according to an embodiment of the present invention;

FIG. 50 shows a schematic of the circuit in FIG. 44 connected to an FSK source that alternates between 913 and 917 MHZ at a baud rate of 500 Kbaud according to an embodiment of the present invention;

FIG. 51 shows, for FIG. 50, the original FSK waveform and the down-converted waveform at the output of the load impedance match circuit according to an embodiment of the present invention;

FIG. 52A illustrates an example energy transfer system according to an embodiment of the invention;

FIGS. 52B-C illustrate example timing diagrams for the example system ofFIG. 52A;

FIG. 53 illustrates an example bypass network according to an embodiment of the invention;

FIG. 54 illustrates another example bypass network according to an embodiment of the invention;

FIG. 55 illustrates an example energy transfer system according to an embodiment of the invention;

FIG. 56 illustrates an example embodiment of the invention;

FIG. 56A illustrates an example real time aperture control circuit according to an embodiment of the invention;

FIG. 56B illustrates a timing diagram of an example clock signal for real time aperture control, according to an embodiment of the invention;

FIG. 56C illustrates a timing diagram of an example optional enable signal for real time aperture control, according to an embodiment of the invention;

FIG. 56D illustrates a timing diagram of an inverted clock signal for real time aperture control, according to an embodiment of the invention;

FIG. 56E illustrates a timing diagram of an example delayed clock signal for real time aperture control, according to an embodiment of the invention;

FIG. 56F illustrates a timing diagram of an example energy transfer including pulses having apertures that are controlled in real time, according to an embodiment of the invention;

FIG. 57 is a block diagram of a differential system that utilizes non-inverted gated transfer units, according to an embodiment of the invention;

FIG. 58 illustrates another example embodiment of the invention;

FIG. 59 illustrates another example embodiment of the invention;

FIG. 60 illustrates another example embodiment of the invention;

FIG. 61 illustrates another example embodiment of the invention;

FIG. 62 illustrates another example embodiment of the invention;

FIG. 63 illustrates another example embodiment of the invention;

FIG. 64 illustrates another example embodiment of the invention;

FIG. 65A is a timing diagram for the example embodiment of FIG. 61;

FIG. 65B is a timing diagram for the example embodiment of FIG. 62;

FIG. 66A is a timing diagram for the example embodiment of FIG. 63;

FIG. 66B is a timing diagram for the example embodiment of FIG. 64;

FIG. 67A illustrates an example embodiment of the invention;

FIG. 67B illustrates equations for determining charge transfer, in accordance with the present invention;

FIG. 67C illustrates relationships between capacitor charging and aperture, in accordance with the present invention;

FIG. 67D illustrates relationships between capacitor charging and aperture, in accordance with the present invention;

FIG. 67E illustrates power-charge relationship equations, in accordance with the present invention;

FIG. 67F illustrates insertion loss equations, in accordance with the present invention;

FIG. 68A illustrates a single FET configuration of the energy transfer module, in accordance with an aspect of the present invention;

FIG. 68B illustrates FET conductivity vs. $V_{GS}$;

FIGs. 69A-C illustrate signal waveforms associated with the energy transfer module of FIG. 68A;

FIG. 70 illustrates the energy transfer module with a complementary FET configuration, in accordance with an aspect of the present invention;

FIGs. 71A-E illustrate signal waveforms associated with the energy transfer module of FIG. 70;

FIG. 72 illustrates another example of the energy transfer module, in accordance with an aspect of the present invention;

FIG. 73 illustrates another example of the energy transfer module, in accordance with an aspect of the present invention;

FIG. 74 illustrates another example of the energy transfer module, in accordance with an aspect of the present invention;

FIG. 75 illustrates another example of the energy transfer module, in accordance with an aspect of the present invention;

FIGS. 76-78 illustrate signal waveforms associated with the energy transfer module of FIG. 74;

FIGS. 79-81 illustrate signal waveforms associated with the energy transfer module of FIG. 75;

FIG. 82A is a block diagram of a splitter according to an embodiment of the invention;

FIG. 82B is a more detailed diagram of the splitter according to an embodiment of the invention;

FIGS. 82C and 82D are example waveforms related to the splitter of FIGS. 82A and 82B;

FIG. 82E is a block diagram of an I/Q circuit with a splitter according to an embodiment of the invention;

FIGS. 82F-82J are example waveforms related to the diagram of FIG. 82A;

FIG. 83 is a block diagram of a switch module according to an embodiment of the invention;

FIG. 84A is an implementation example of the block diagram of FIG. 83;

FIGS. 84B-84Q are example waveforms related to FIG. 84A;

FIG. 85A is another implementation example of the block diagram of FIG. 83;

FIGS. 85B-85Q are example waveforms related to FIG. 85A;

FIG. 86A is an example MOSFET embodiment of the invention;

FIG. 86B is an example MOSFET embodiment of the invention;

FIG. 86C is an example MOSFET embodiment of the invention;

FIG. 87A is another implementation example of the block diagram of FIG. 83; and

FIGS. 87B-879Q are example waveforms related to FIG. 85A.

## Table of Contents

**I. Introduction**

1. Modulation

2. Demodulation

3.. Overview of the Invention

    3.1 Determining the Aliasing rate

4. Benefits of the Invention Using an Example Conventional Receiver for Comparison

**II. Energy Transfer**

1. Energy Transfer Compared to Under-Sampling

    1.1 Review of Under-Sampling

        1.1.1 Effects of Lowering the Impedance of the Load

        1.1.2 Effects of Increasing the Value of the Holding Capacitance

    1.2 Introduction to Energy Transfer

2. Down-Converting Modulated Carrier Signal to an IF Modulated Carrier Signal by Transferring Energy from the Modulated Carrier Signal at an Aliasing Rate

    2.1 High Level Description

        2.1.1 Operational Description

        2.1.2 Structural Description

    2.2 Example Embodiments

        2.2.1 First Example Embodiment: Amplitude Modulation

            2.2.1.1 Operational Description

                2.2.1.1.1 Analog AM Carrier Signal

2.2.1.1.2 Digital AM Carrier Signal

2.2.1.2 Structural Description

2.2.2 Second Example Embodiment: Frequency Modulation

2.2.2.1 Operational Description

2.2.2.1.1 Analog FM Carrier Signal
2.2.2.1.2 Digital FM Carrier Signal

2.2.2.2 Structural Description

2.2.3 Third Example Embodiment: Phase Modulation

2.2.3.1 Operational Description

2.2.3.1.1 Analog PM Carrier Signal
2.2.3.1.2 Digital PM Carrier Signal

2.2.3.2 Structural Description

3. Implementation Examples

3.1 The Energy Transfer System as a Gated Transfer System

3.1.1 The Gated Transfer System as a Switch Module and a Storage Module
3.1.2 The Gated Transfer System as Break-Before-Make Module
3.1.3 Example Implementations of the Switch Module
3.1.4 Example Implementations of the Storage Module
3.1.5 Optional Energy Transfer Signal Module

3.2 The Energy Transfer System as an Inverted Gated Transfer System

3.2.1 The Inverted Gated Transfer System as a Switch Module and a Storage Module

3.3 Rail to Rail Operation for Improved Dynamic Range

3.3.1 Introduction
3.3.2 Complementary UFT Structure for Improved Dynamic Range
3.3.3 Biased Configurations
3.3.4 Simulation Examples

3.4 Optimized Switch Structures

3.4.1 Splitter in CMOS
3.4.2 I/Q Circuit

3.5 Example I and Q Implementations

3.5.1 Switches of Different Sizes
3.5.2 Reducing Overall Switch Area
3.5.3 Charge Injection Cancellation
3.5.4 Overlapped Capacitance

4. Optional Optimizations of Energy Transfer at an Aliasing Rate

4.1 Doubling the Aliasing Rate ($F_{AR}$) of the Energy Transfer Signal

EP 1 125 359 B1

    4.2 Differential Implementations

        4.2.1 An Example Illustrating Energy Transfer Differentially

            4.2.1.1 Differential Input-to-Differential Output
            4.2.1.2 Single Input-to-Differential Output
            4.2.1.3 Differential Input-to-Single Output

            4.2.2 Specific Alternative Embodiments
            4.2.3 Specific Examples of Optimizations and Configurations for Inverted and Non-Inverted Differential Designs

        4.3 Smoothing the Down-Converted Signal
        4.4 Impedance Matching
        4.5 Tanks and Resonant Structures
        4.6 Charge and Power Transfer Concepts
        4.7 Optimizing and Adjusting the Non-Negligible Aperture Width/Duration

            4.7.1 Varying Input and Output Impedances
            4.7.2 Real Time Aperture Control

        4.8 Adding a Bypass Network
        4.9 Modifying the Energy Transfer Signal Utilizing Feedback

    5. Example Energy Transfer Downconverters

**V. Conclusions**

*I. Introduction*

*1. Modulation*

It is often beneficial to propagate information signals at higher frequencies. This includes baseband signals, such as digital data information signals and analog information signals. A baseband signal can be up-converted to a higher frequency modulated carrier signal by using the baseband signal to modulate a higher frequency carrier signal, $F_C$. When used in this manner, such a baseband signal is herein called a modulating baseband signal $F_{MB}$.

Modulation imparts changes to the carrier signal $F_C$ that represent information in the modulating baseband signal $F_{MB}$. The changes can be in the form of amplitude changes, frequency changes, phase changes, etc., or any combination thereof. The resultant signal is referred to herein as a modulated carrier signal $F_{MC}$. The modulated carrier signal $F_{MC}$ includes the carrier signal $F_C$ modulated by the modulating baseband signal, $F_{MB}$, as in:

$$F_{MB} \text{ combined with } F_C \rightarrow F_{MC}$$

The modulated carrier signal $F_{MC}$ oscillates at, or near the frequency of the carrier signal $F_C$ and can thus be efficiently propagated.

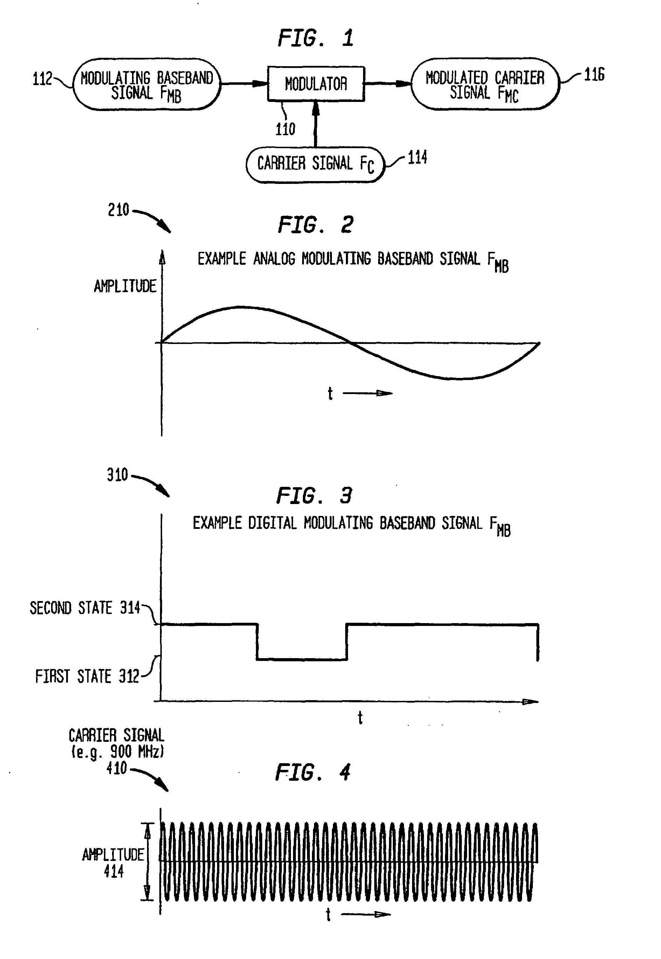

FIG. 1 illustrates an example modulator 110, wherein the carrier signal $F_C$ is modulated by the modulating baseband signal $F_{MB}$, thereby generating the modulated carrier signal $F_{MC}$.

Modulating baseband signal $F_{MB}$ can be an analog baseband signal, a digital baseband signal, or a combination thereof.

FIG. 2 illustrates the modulating baseband signal $F_{MB}$ as an exemplary analog modulating baseband signal 210. The exemplary analog modulating baseband signal 210 can represent any type of analog information including, but not limited to, voice/speech data, music data, video data, etc. The amplitude of analog modulating baseband signal 210 varies in time.

Digital information includes a plurality of discrete states. For ease of explanation, digital information signals are discussed below as having two discrete states. But the invention is not limited to this embodiment.

FIG. 3 illustrates the modulating baseband signal $F_{MB}$ as an exemplary digital modulating baseband signal 310. The digital modulating baseband signal 310 can represent any type of digital data including, but not limited to, digital computer information and digitized analog information. The digital modulating baseband signal 310 includes a first state 312 and a second state 314. In an embodiment, first state 312 represents binary state 0 and second state 314 represents binary state 1. Alternatively, first state 312 represents binary state 1 and second state 314 represents binary state 0. Throughout the remainder of this disclosure, the former convention is followed, whereby first state 312 represents binary state zero and second state 314 represents binary state one. But the invention is not limited to this embodiment. First state 312 is thus referred to herein as a low state and second state 314 is referred to herein as a high state. Digital modulating baseband signal 310 can change between first state 312 and second state 314 at a data rate, or baud rate, measured as bits per second.

Carrier signal $F_C$ is modulated by the modulating baseband signal $F_{MB}$, by any modulation technique, including, but not limited to, amplitude modulation (AM), frequency modulation (FM), phase modulation (PM), etc., or any combination thereof. Examples are provided below for amplitude modulating, frequency modulating, and phase modulating the analog modulating baseband signal 210 and the digital modulating baseband signal 310, on the carrier signal $F_C$. The examples are used to assist in the description of the invention. The invention is not limited to, or by, the examples.

FIG. 4 illustrates the carrier signal $F_C$ as a carrier signal 410. In the example of FIG. 4, the carrier signal 410 is illustrated as a 900 MHZ carrier signal. Alternatively, the carrier signal 410 can be any other frequency. Example modulation schemes are provided below, using the examples signals from FIGS. 2, 3 and 4.

### 1.1 Amplitude Modulation

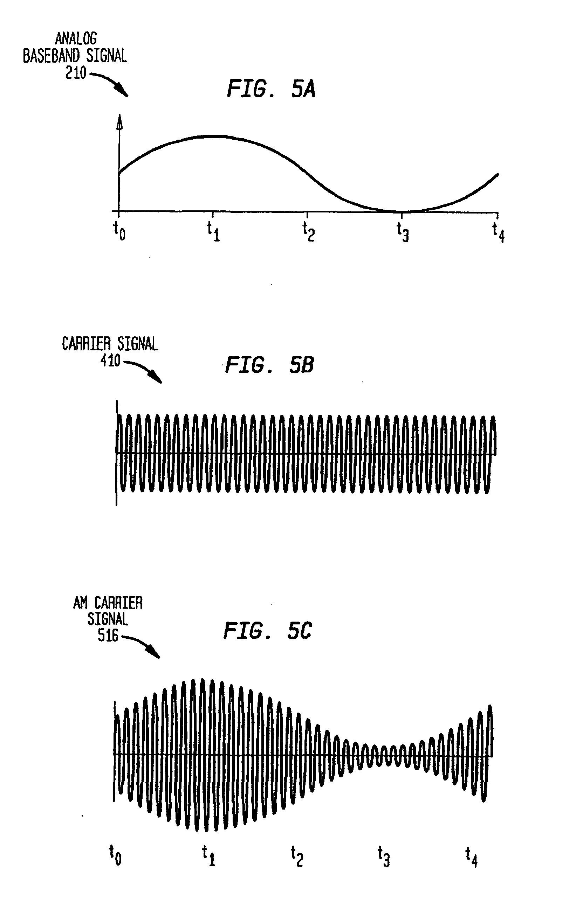

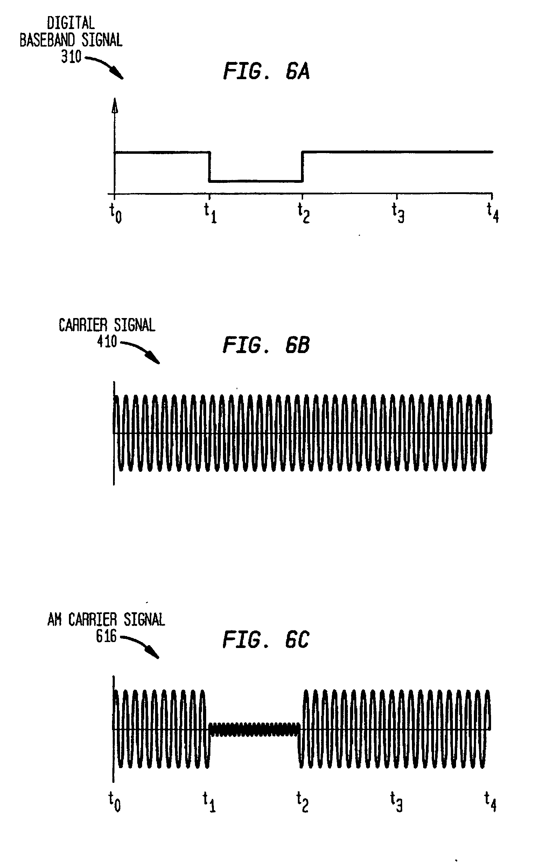

In amplitude modulation (AM), the amplitude of the modulated carrier signal $F_{MC}$ is a function of the amplitude of the modulating baseband signal $F_{MB}$. FIGS. 5A-5C illustrate example timing diagrams for amplitude modulating the carrier signal 410 with the analog modulating baseband signal 210. FIGS. 6A-6C illustrate example timing diagrams for amplitude modulating the carrier signal 410 with the digital modulating baseband signal 310.

FIG. 5A illustrates the analog modulating baseband signal 210. FIG. 5B illustrates the carrier signal 410. FIG. 5C illustrates an analog AM carrier signal 516, which is generated when the carrier signal 410 is amplitude modulated using the analog modulating baseband signal 210. As used herein, the term "analog AM carrier signal" is used to indicate that the modulating baseband signal is an analog signal.

The analog AM carrier signal 516 oscillates at the frequency of carrier signal 410. The amplitude of the analog AM carrier signal 516 tracks the amplitude of analog modulating baseband signal 210, illustrating that the information contained in the analog modulating baseband signal 210 is retained in the analog AM carrier signal 516.

FIG. 6A illustrates the digital modulating baseband signal 310. FIG. 6B illustrates the carrier signal 410. FIG. 6C illustrates a digital AM carrier signal 616, which is generated when the carrier signal 410 is amplitude modulated using the digital modulating baseband signal 310. As used herein, the term "digital AM carrier signal" is used to indicate that the modulating baseband signal is a digital signal.

The digital AM carrier signal 616 oscillates at the frequency of carrier signal 410. The amplitude of the digital AM carrier signal 616 tracks the amplitude of digital modulating baseband signal 310, illustrating that the information contained in the digital modulating baseband signal 310 is retained in the digital AM signal 616. As the digital modulating baseband signal 310 changes states, the digital AM signal 616 shifts amplitudes. Digital amplitude modulation is often referred to as amplitude shift keying (ASK) , and the two terms are used interchangeably throughout the specification.

### 1.2 Frequency Modulation

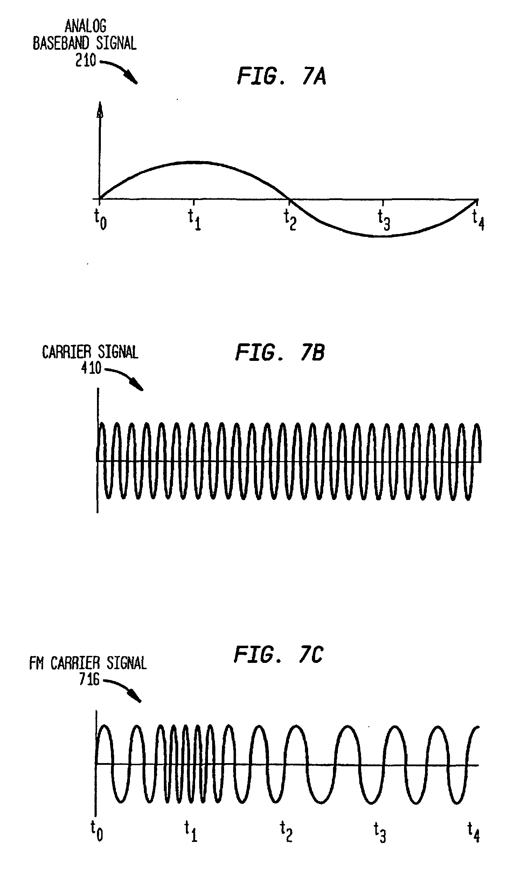

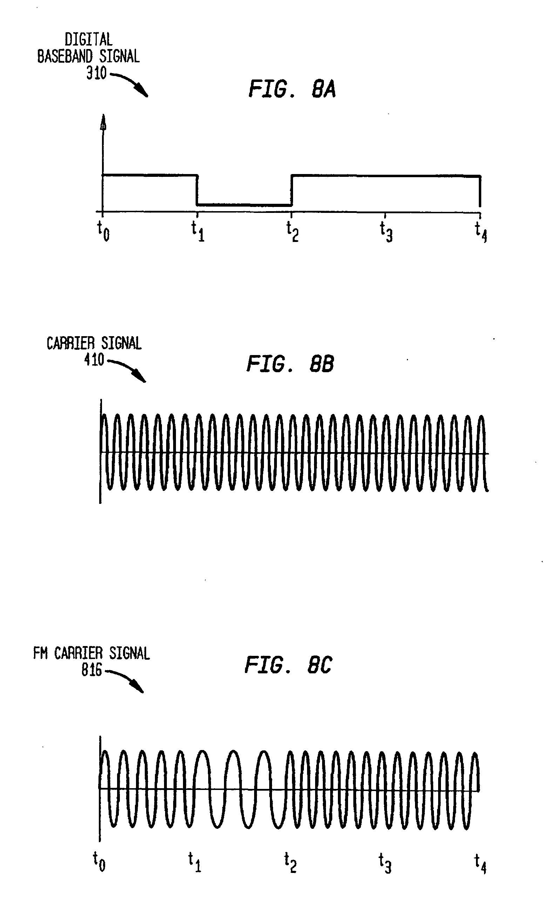

In frequency modulation (FM), the frequency of the modulated carrier signal $F_{MC}$ varies as a function of the amplitude ofthe modulating baseband signal $F_{MB}$. FIGS. 7A-7C illustrate example timing diagrams for frequency modulating the carrier signal 410 with the analog modulating baseband signal 210. FIGS. 8A-8C illustrate example timing diagrams for frequency modulating the carrier signal 410 with the digital modulating baseband signal 310.

FIG. 7A illustrates the analog modulating baseband signal 210. FIG. 7B illustrates the carrier signal 410. FIG. 7C illustrates an analog FM carrier signal 716, which is generated when the carrier signal 410 is frequency modulated using the analog modulating baseband signal 210. As used herein, the term "analog FM carrier signal" is used to indicate that the modulating baseband signal is an analog signal.

The frequency of the analog FM carrier signal 716 varies as a function of amplitude changes on the analog baseband signal 210. In the illustrated example, the frequency of the analog FM carrier signal 716 varies in proportion to the amplitude of the analog modulating baseband signal 210. Thus, at time t1, the amplitude of the analog baseband signal 210 and the frequency of the analog FM carrier signal 716 are at maximums. At time t3, the amplitude of the analog baseband signal 210 and the frequency of the analog FM carrier signal 716 are at minimums.

The frequency of the analog FM carrier signal 716 is typically centered around the frequency of the carrier signal 410. Thus, at time t2, for example, when the amplitude of the analog baseband signal 210 is at a mid-point, illustrated here as zero volts, the frequency of the analog FM carrier signal 716 is substantially the same as the frequency of the carrier signal 410.

FIG. 8A illustrates the digital modulating baseband signal 310. FIG. 8B illustrates the carrier signal 410. FIG. 8C illustrates a digital FM carrier signal 816, which is generated when the carrier signal 410 is frequency modulated using the digital baseband signal 310. As used herein, the term "digital FM carrier signal" is used to indicate that the modulating baseband signal is a digital signal.

The frequency of the digital FM carrier signal 816 varies as a function of amplitude changes on the digital modulating baseband signal 310. In the illustrated example, the frequency of the digital FM carrier signal 816 varies in proportion to the amplitude of the digital modulating baseband signal 310. Thus, between times t0 and t1, and between times t2 and t4, when the amplitude of the digital baseband signal 310 is at the higher amplitude second state, the frequency of the digital FM carrier signal 816 is at a maximum. Between times t1 and t2, when the amplitude of the digital baseband signal 310 is at the lower amplitude first state, the frequency of the digital FM carrier signal 816 is at a minimum. Digital frequency modulation is often referred to as frequency shift keying (FSK), and the terms are used interchangeably throughout the specification.

Typically, the frequency of the digital FM carrier signal 816 is centered about the frequency of the carrier signal 410, and the maximum and minimum frequencies are equally offset from the center frequency. Other variations can be employed but, for ease of illustration, this convention will be followed herein.

### 1.3 Phase Modulation

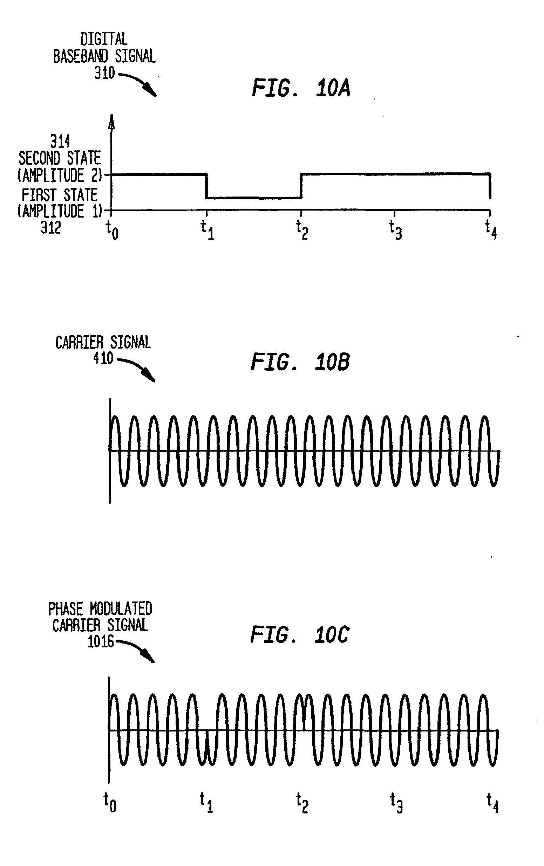

In phase modulation (PM), the phase of the modulated carrier signal $F_{MC}$ varies as a function of the amplitude of the modulating baseband signal $F_{MB}$. FIGS. 9A-9C illustrate example timing diagrams for phase modulating the carrier signal 410 with the analog modulating baseband signal 210. FIGS. 10A-10C illustrate example timing diagrams for phase modulating the carrier signal 410 with the digital modulating baseband signal 310.

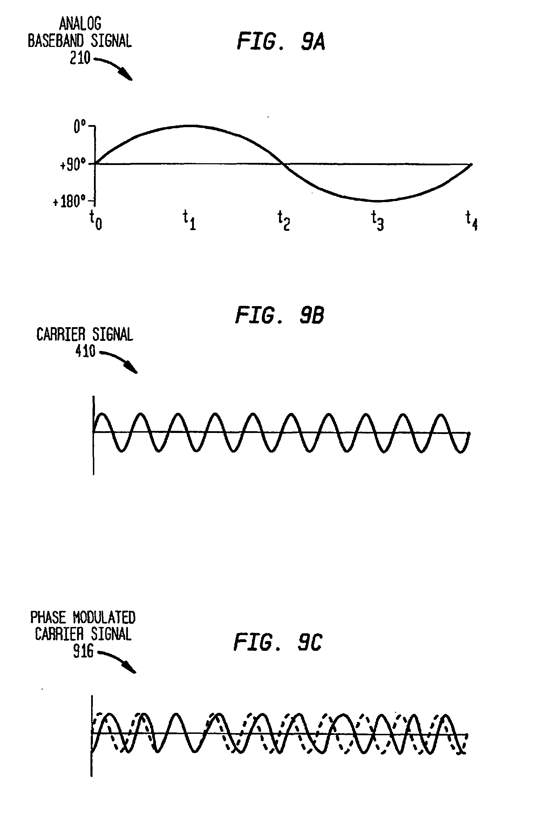

FIG. 9A illustrates the analog modulating baseband signal 210. FIG. 9B illustrates the carrier signal 410. FIG. 9C illustrates an analog PM carrier signal 916, which is generated by phase modulating the carrier signal 410 with the analog baseband signal 210. As used herein, the term "analog PM carrier signal" is used to indicate that the modulating baseband signal is an analog signal.

Generally, the frequency of the analog PM carrier signal 916 is substantially the same as the frequency of carrier signal 410. But the phase of the analog PM carrier signal 916 varies with amplitude changes on the analog modulating baseband signal 210. For relative comparison, the carrier signal 410 is illustrated in FIG. 9C by a dashed line.

The phase of the analog PM carrier signal 916 varies as a function of amplitude changes of the analog baseband signal 210. In the illustrated example, the phase of the analog PM signal 916 lags by a varying amount as determined by the amplitude of the baseband signal 210. For example, at time t1, when the amplitude of the analog baseband signal 210 is at a maximum, the analog PM carrier signal 916 is in phase with the carrier signal 410. Between times t1 and t3, when the amplitude of the analog baseband signal 210 decreases to a minimum amplitude, the phase of the analog PM carrier signal 916 lags the phase of the carrier signal 410, until it reaches a maximum out of phase value at time t3. In the illustrated example, the phase change is illustrated as approximately 180 degrees. Any suitable amount of phase change, varied in any manner that is a function of the baseband signal, can be utilized.

FIG. 10A illustrates the digital modulating baseband signal 310. FIG. 10B illustrates the carrier signal 410. FIG. 10C illustrates a digital PM carrier signal 1016, which is generated by phase modulating the carrier signal 410 with the digital baseband signal 310. As used herein, the term "digital PM carrier signal" is used to indicate that the modulating baseband signal is a digital signal.

The frequency of the digital PM carrier signal 1016 is substantially the same as the frequency of carrier signal 410. The phase of the digital PM carrier signal 1016 varies as a function of amplitude changes on the digital baseband signal 310. In the illustrated example, when the digital baseband signal 310 is at the first state 312, the digital PM carrier signal 1016 is out of phase with the carrier signal 410. When the digital baseband signal 310 is at the second state 314, the digital PM carrier signal 1016 is in-phase with the carrier signal 410. Thus, between times t1 and t2, when the amplitude of the digital baseband signal 310 is at the first state 312, the digital PM carrier signal 1016 is out of phase with the carrier signal 410. Between times t0 and t1, and between times t2 and t4, when the amplitude of the digital baseband signal 310 is at the second state 314, the digital PM carrier signal 1016 is in phase with the carrier signal 410.

In the illustrated example, the out of phase value between times t1 and t3 is illustrated as approximately 180 degrees out of phase. Any suitable amount of phase change, varied in any manner that is a function of the baseband signal, can be utilized. Digital phase modulation is often referred to as phase shift keying (PSK), and the terms are used interchangeably throughout the specification.

*2. Demodulation*

When the modulated carrier signal $F_{MC}$ is received, it can be demodulated to extract the modulating baseband signal $F_{MB}$. Because of the typically high frequency of modulated carrier signal $F_{MC}$, however, it is generally impractical to demodulate the baseband signal $F_{MB}$ directly from the modulated carrier signal $F_{MC}$. Instead, the modulated carrier signal $F_{MC}$ must be down-converted to a lower frequency signal that contains the original modulating baseband signal.

When a modulated carrier signal is down-converted to a lower frequency signal, the lower frequency signal is referred to herein as an intermediate frequency (IF) signal $F_{IF}$. The IF signal $F_{IF}$ oscillates at any frequency, or frequency band, below the frequency of the modulated carrier frequency $F_{MC}$. Down-conversion of $F_{MC}$ to $F_{IF}$ is illustrated as:

$$F_{MC} \rightarrow F_{IF}$$

After $F_{MC}$ is down-converted to the IF modulated carrier signal $F_{IF}$, $F_{IF}$ can be demodulated to a baseband signal $F_{DMB}$, as illustrated by:

$$F_{IF} \rightarrow F_{DMB}$$

$F_{DMB}$ is intended to be substantially similar to the modulating baseband signal $F_{MB}$, illustrating that the modulating baseband signal $F_{MB}$ can be substantially recovered.

It will be emphasized throughout the disclosure that the present invention can be implemented with any type of modulated carrier signal. The above examples of modulated carrier signals are provided for illustrative purposes only. Many variations to the examples are possible. For example, a carrier signal can be modulated with a plurality ofthe modulation types described above. A carrier signal can also be modulated with a plurality of baseband signals, including analogbaseband signals, digital baseband signals, and combinations ofboth analog and digital baseband signals.

*3. Overview of the Invention*

Conventional signal processing techniques follow the Nyquist sampling theorem, which states that, in order to faithfully reproduce a sampled signal, the signal must be sampled at a rate that is greater than twice the frequency of the signal being sampled. When a signal is sampled at less than or equal to twice the frequency of the signal, the signal is said to be under-sampled, or aliased. Conventional signal processing thus teaches away from under-sampling and aliasing, in order to faithfully reproduce a sampled signal. Contrary to conventional wisdom, the present invention is a method and system for down-converting a modulated carrier signal by aliasing the modulated carrier signal.

By taking a carrier and aliasing it at an aliasing rate, the invention can down-convert that carrier to lower frequencies. One aspect that can be exploited by this invention is realizing that the carrier is not the item of interest, the lower baseband signal is of interest to reproduce sufficiently. This baseband signal's frequency content, even though its carrier may be aliased, does satisfy the Nyquist criteria and as a result, the baseband information can be sufficiently reproduced. In accordance with the invention, down-conversion is achieved by transferring non-negligible amounts of energy from a modulated carrier signal.

The term aliasing, as used herein, refers to down-converting a modulated carrier signal by transferring non-negligible amounts energy from the modulated carrier signal at the aliasing rate. Methods for transferring energy from a modulated carrier signal to down-convert the modulated carrier signal are now described at an overview level. More detailed descriptions are provided in subsequent sections.

In accordance with the invention, a modulated carrier signal is down-converted to a lower, or intermediate frequency (IF) signal, by transferring energy from the modulated carrier signal at an aliasing rate. In an exemplary embodiment, a modulated carrier signal $F_{MC}$ is down-converted to an IF signal $F_{IF}$.

$$F_{MC} \rightarrow F_{IF}$$

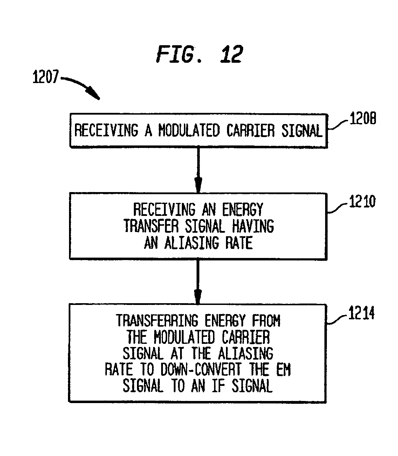

FIG. 12 depicts a flowchart 1207 that illustrates a method for transferring energy from the modulated carrier signal at an aliasing rate to down-convert the modulated carrier signal to an IF signal. The process begins at step 1208, which includes receiving a modulated carrier signal. Step 1210 includes receiving an energy transfer signal having an aliasing rate. Step 1212 includes transferring energy from the modulated carrier signal at the aliasing rate to down-convert the modulated carrier signal to an IF signal.

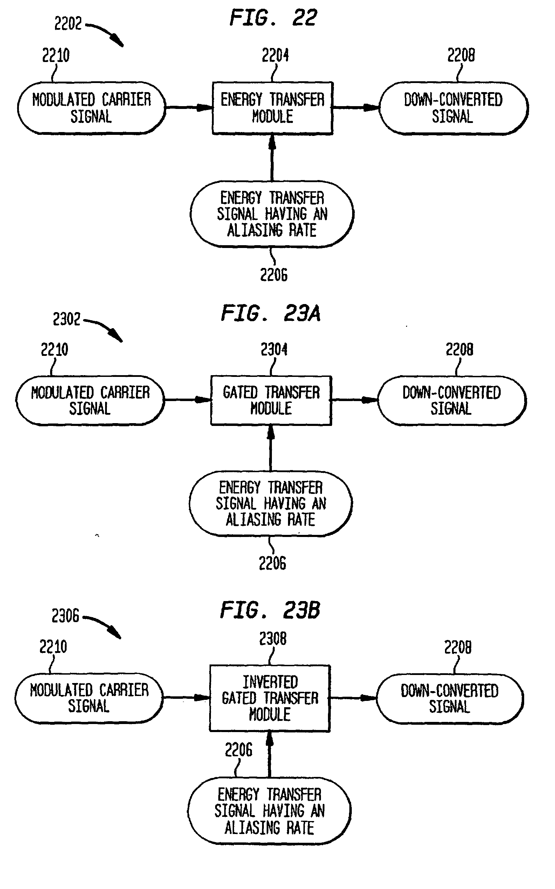

FIG. 22 illustrates a block diagram of an energy transfer system 2202 according to an embodiment of the invention. The energy transfer system 2202 includes an energy transfer module 2204. The energy transfer module 2204 receives a modulated carrier signal 2210 and an energy transfer signal 2206, which includes a train of energy transfer pulses having non-negligible apertures that tend away from zero time in duration, occurring at a frequency equal to the aliasing rate $F_{AR}$. The energy transfer module 2204 transfers energy from the modulated carrier signal 2210 at the aliasing rate $F_{AR}$ of the energy transfer signal 2206. In an embodiment, the energy transfer module 2204 transfers energy from the modulated carrier signal 2210 to down-convert it to the intermediate signal $F_{IF}$ in the manner shown in the operational flowchart 1207 of FIG. 12.

### 3.1 Determining the Aliasing rate

In accordance with the definition of aliasing, the aliasing rate is equal to, or less than, twice the frequency of the modulated carrier signal. Preferably, the aliasing rate is much less than the frequency of the carrier signal. The aliasing rate is preferably more than twice the highest frequency component ofthe modulating baseband signal $F_{MB}$ that is to be reproduced. The above requirements are illustrated in EQ. (1).

$$2 \cdot F_{MC} \geq F_{AR} > 2 \cdot (\text{Highest Freq. Component of } F_{MB}) \qquad \text{EQ. (1)}$$

In other words, by taking a carrier and aliasing it at an aliasing rate, the invention can down-convert that carrier to lower frequencies. One aspect that can be exploited by this invention is that the carrier is not the item of interest; instead the lower baseband signal is of interest to be reproduced sufficiently. The baseband signal's frequency content, even though its carrier may be aliased, satisfies the Nyquist criteria and as a result, the baseband information can be sufficiently reproduced, either as the intermediate modulating carrier signal $F_{IF}$ or as the demodulated direct-to-data baseband signal $F_{DMB}$.

In accordance with the invention, relationships between the frequency of a modulated carrier signal, the aliasing rate, and the intermediate frequency of the down-converted signal, are illustrated in EQ. (2).

$$F_C = n \cdot F_{AR} \pm F_{IF} \qquad \text{EQ. (2)}$$

Where:

$F_C$ is the frequency of the modulated carrier carrier signal that is to be aliased;
$F_{AR}$ is the aliasing rate;
$n$ identifies a harmonic or sub-harmonic of the aliasing rate (generally, n=0.5, 1, 2, 3, 4, ... ); and
$F_{IF}$ is the intermediate frequency of the down-converted signal.

Note that as $(n \cdot F_{AR})$ approaches $F_C$, $F_{IF}$ approaches zero. This is a special case where a modulated carrier signal is directly down-converted to a demodulated baseband signal.

High level descriptions, exemplary embodiments and exemplary implementations of the above and other embodiments of the invention are provided in sections below.

### 4. Benefits of the Invention Using an Example Conventional Receiver for Comparison

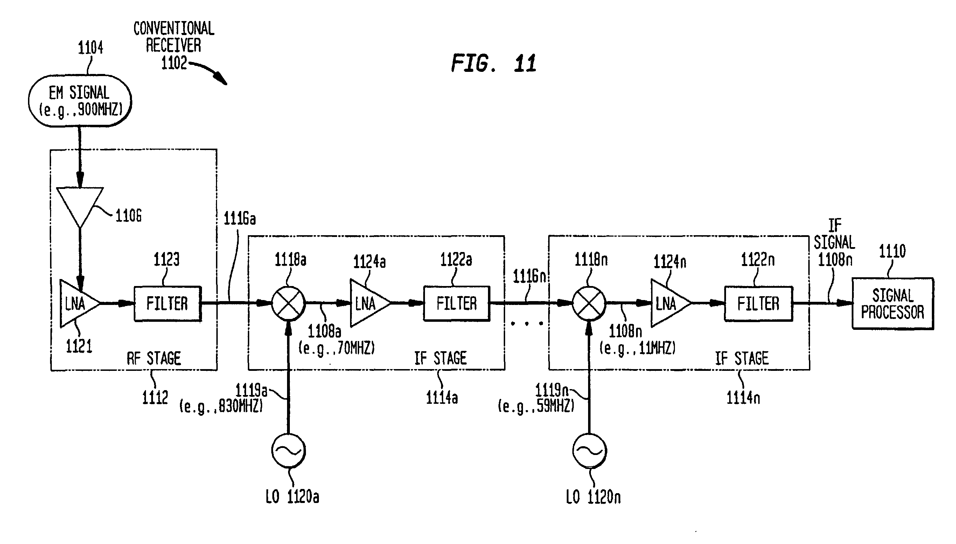

FIG. 11 illustrates an example conventional receiver system 1102. The conventional system 1102 is provided both to help the reader to understand the functional differences between conventional systems and the present invention, and to help the reader to understand the benefits of the present invention.

The example conventional receiver system 1102 receives the modulated carrier signal 2210 via an antenna 1106. The modulated carrier signal 2210 can include a plurality of modulated carrier signals. For example, the modulated carrier signal 2210 includes one or more radio frequency (RF) modulated carrier signals, such as a 900 MHZ modulated carrier signal. Higher frequency RF signals, such as 900 MHZ signals, generally cannot be directly processed by conventional signal processors. Instead, higher frequency RF signals are typically down-converted to lower intermediate frequencies (IF) for processing. The receiver system 1102 down-converts the modulated carrier signal 2210 to an intermediate frequency (IF) signal 1108n, which can be provided to a signal processor 1110. The signal processor 1110 usually includes a demodulator that demodulates the IF signal 1108n to a baseband information signal (demodulated baseband signal).

Receiver system 1102 includes an RF stage 1112 and one or more IF stages 1114. The RF stage 1112 receives the modulated carrier signal 2210. The RF stage 1112 includes the antenna 1106 that receives the modulated carrier signal 2210.

The one or more IF stages 1114a-1114n down-convert the modulated carrier signal 2210 to consecutively lower intermediate frequencies. Each of the one or more IF stages 1114a-1114n includes a mixer 1118a-1118n that down-converts an input modulated carrier signal 1116 to a lower frequency IF signal 1108. By cascading the one or more mixers 1118a-1118n, the modulated carrier signal 2210 is incrementally down-converted to a desired IF signal 1108n.

In operation, each of the one or more mixers 1118 mixes an input modulated carrier signal 1116 with a local oscillator (LO) signal 1119, which is generated by a local oscillator (LO) 1120. Mixing generates sum and difference signals from the input modulated carrier signal 1116 and the LO signal 1119. For example, mixing an input modulated carrier signal 1116a, having a frequency of 900 MHZ, with a LO signal 1119a, having a frequency of 830 MHZ, results in a sum signal, having a frequency of 900 MHZ + 830 MHZ = 1.73 GHZ, and a difference signal, having a frequency of 900 MHZ - 830 MHZ = 70 MHZ.

Specifically, in the example of FIG. 11, the one or more mixers 1118 generate a sum and difference signals for all signal components in the input modulated carrier signal 1116. For example, when the modulated carrier signal 1116a includes a second modulated carrier signal, having a frequency of 760 MHZ, the mixer 1118a generates a second sum signal, having a frequency of 760 MHZ + 830 MHZ = 1.59 GHZ, and a second difference signal, having a frequency of 830 MHZ - 760 MHZ = 70 MHZ. In this example, therefore, mixing two input modulated carrier signals, having frequencies of 900 MHZ and 760 MHZ, respectively, with an LO signal having a frequency of 830 MHZ, results in two IF signals at 70 MHZ.

Generally, it is very difficult, if not impossible, to separate the two 70 MHZ signals. Instead, one or more filters 1122 and 1123 are provided upstream from each mixer 1118 to filter the unwanted frequencies, also known as image frequencies. The filters 1122 and 1123 can include various filter topologies and arrangements such as bandpass filters, one or more high pass filters, one or more low pass filters, combinations thereof, etc.

Typically, the one or more mixers 1118 and the one or more filters 1122 and 1123 attenuate or reduce the strength of the modulated carrier signal 2210. For example, a typical mixer reduces the modulated carrier signal strength by 8 to 12 dB. A typical filter reduces the modulated carrier signal strength by 3 to 6 dB.

As a result, one or more low noise amplifiers (LNAs) 1121 and 1124a-1124n are provided upstream of the one or more filters 1123 and 1122a-1122n. The LNAs and filters can be in reversed order. The LNAs compensate for losses in the mixers 1118, the filters 1122 and 1123, and other components by increasing the modulated carrier signal strength prior to filtering and mixing. Typically, for example, each LNA contributes 15 to 20 dB of amplification.

However, LNAs require substantial power to operate. Higher frequency LNAs require more power than lower frequency LNAs. When the receiver system 1102 is intended to be portable, such as a cellular telephone receiver, for example, the LNAs require a substantial portion of the total power.

At higher frequencies, impedance mismatches between the various stages further reduce the strength of the modulated carrier signal 2210. In order to optimize power transferred through the receiver system 1102, each component should be impedance matched with adjacent components. Since no two components have the exact same impedance characteristics, even for components that were manufactured with high tolerances, impedance matching must often be individually fine tuned for each receiver system 1102. As a result, impedance matching in conventional receivers tends to be labor intensive and more art than science. Impedance matching requires a significant amount of added time and expense to both the design and manufacture of conventional receivers. Since many of the components, such as LNA, filters, and impedance matching circuits, are highly frequency dependent, a receiver designed for one application is generally not suitable for other applications. Instead, a new receiver must be designed, which requires new impedance matching circuits between many of the components.

Conventional receiver components are typically positioned over multiple IC substrates instead of on a single IC substrate. This is partly because there is no single substrate that is optimal for both RF, IF, and baseband frequencies. Other factors may include the sheer number of components, their various sizes and different inherent impedance characteristics, etc. Additional signal amplification is often required when going from chip to chip. Implementation over multiple substrates thus involves many costs in addition to the cost of the ICs themselves.

Conventional receivers thus require many components, are difficult and time consuming to design and manufacture, and require substantial external power to maintain sufficient signal levels. Conventional receivers are thus expensive to design, build, and use.

In an embodiment, the present invention is implemented to replace many, if not all, of the components between the antenna 1106 and the signal processor 1110, with an aliasing module that includes a universal frequency translator (UFT) module. The UFT module is able to down-convert a wide range of modulated carrier signal frequencies using very few components. The UFT is easy to design and build, and requires very little external power. The UFT design can be easily tailored for different frequencies or frequency ranges. For example, UFT design can be easily impedance matched with relatively little tuning. In a direct-to-data embodiment of the invention, where a modulated carrier signal is directly down-converted to a demodulated baseband signal, the invention also eliminates the need for a demodulator in the signal processor 1110.

When the invention is implemented in a receiver system, such as the receiver system 1102, power consumption is significantly reduced and signal to noise ratio is significantly increased.

In an embodiment, the invention can be implemented and tailored for specific applications with easy to calculate and easy to implement impedance matching circuits. As a result, when the invention is implemented as a receiver, such as the receiver 1102, specialized impedance matching experience is not required.

In conventional receivers, components in the IF sections comprise roughly eighty to ninety percent of the total components of the receivers. The UFT design eliminates the IF section(s) and thus eliminates the roughly eighty to ninety percent of the total components of conventional receivers.

Other advantages of the invention include, but are not limited to:

The invention can be implemented as a receiver with only a single local oscillator;

The invention can be implemented as a receiver with only a single, lower frequency, local oscillator;

The invention can be implemented as a receiver using few filters;

The invention can be implemented as a receiver using unit delay filters;

The invention can be implemented as a receiver that can change frequencies and receive different modulation formats with no hardware changes;

The invention can be also be implemented as frequency up-converter in a modulated carrier signal transmitter;

The invention canbe also be implemented as a combination up-converter (transmitter) and down-converter (receiver), referred to herein as a transceiver;

The invention can be implemented in a differential configuration, whereby signal to noise ratios are increased; A receiver designed in accordance with the invention can be implemented on a single IC substrate, such as a silicon-based IC substrate;

A receiver designed in accordance with the invention and implemented on a single IC substrate, such as a silicon-based IC substrate, can down-convert modulated carrier signals from frequencies in the giga Hertz range; A receiver built in accordance with the invention has a relatively flat response over a wide range of frequencies. For example, in an embodiment, a receiver built in accordance with the invention to operate around 800 MHZ has a substantially flat response (i.e., plus or minus a few dB of power) from 100 MHZ to 1 GHZ. This is referred to herein as a wide-band receiver; and

A receiver built in accordance with the invention can include multiple, user-selectable, impedance match modules, each designed for a different wide-band of frequencies, which can be used to scan an ultra-wide-band of frequencies.

### II. Down-Converting by Transferring Energy

The energy transfer embodiments of the invention provide enhanced signal to noise ratios and sensitivity to very small signals, as well as permitting the down-converted signal to drive lower impedance loads unassisted. Fundamental descriptions of how this is accomplished is presented step by step beginning with a comparison to an under-sampling system.

### 1. Energy Transfer Compared to Under-Sampling

Conventional under-sampling systems utilize a sample and hold system controlled by an under-sampling signal. The under-sampling signal includes a train of pulses having negligible apertures that tend towards zero time in duration. The negligible aperture pulses minimize the amount of energy transferred from the modulated carrier signal. This protects the under-sampled modulated carrier signal from distortion or destruction. The negligible aperture pulses also make the sample and hold system a high impedance system. An advantage of under-sampling is that the high impedance input allows accurate voltage reproduction of the under-sampled modulated carrier signal.

Under-sampling systems transfer only negligible amounts of energy. Thus, they are not suitable for all situations. For example, in radio communications, received radio frequency (RF) signals are typically very weak and must be amplified in order to distinguish them overnoise. The negligible amounts of energy transferred by the under-sampling systems thus may not be sufficient to distinguish received RF signals over noise.

In accordance with the invention, methods and systems are disclosed for down-converting modulated carrier signals by transferring non-negligible amounts of energy from the modulated carrier signals. The resultant down-converted signals have sufficient energy to allow the down-converted signals to be distinguishable from noise. The resultant down-converted signals also have sufficient energy to drive lower impedance circuits without buffering.

Down-converting by transferring energy is introduced below in an incremental fashion to distinguish it from under-sampling. The introduction begins with descriptions of under-sampling.

### 1.1 Review of Under-Sampling

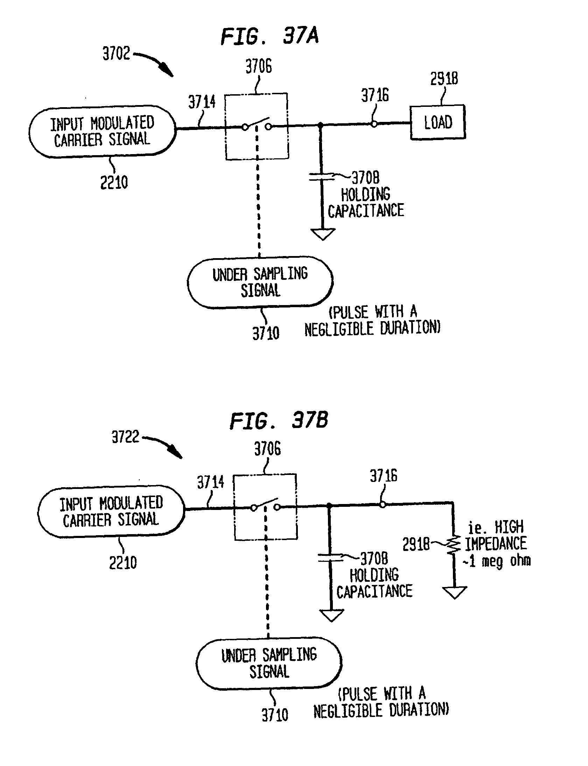

FIG. 37A illustrates an exemplary under-sampling system 3702 for down-converting an input modulated carrier signal 2210. The under-sampling system 3702 includes a switching module 3706 and a holding module shown as a holding capacitance 3708. An under-sampling signal 3710 controls the switch module 3706. The under-sampling signal 3710 includes a train of pulses having negligible pulse widths that tend toward zero time. An example of a negligible pulse width or duration can be in the range of 1-10 psec for under-sampling a 900 MHZ signal. Any other suitable negligible pulse duration can be used as well, where accurate reproduction of the original unaffected input signal voltage is desired without substantially affecting the original input signal voltage.

In an under-sampling environment, the holding capacitance 3708 preferably has a small capacitance value. This allows the holding capacitance 3708 to substantially charge to the voltage of the input modulated carrier signal 2210 during the negligible apertures of the under-sampling signal pulses. For example, in an embodiment, the holding capacitance 3708 has a value in the range of 1pF. Other suitable capacitance values can be used to achieve substantially the voltage of the original unaffected input signal. Various capacitances can be employed for certain effects, which are described below. The under-sampling system is coupled to a load 2918. In FIG. 37B, the load 2918 is illustrated as a high impedance load 2918. A high impedance load is one that is relatively insignificant to an output drive impedance of the system for a given output frequency. The high impedance load 2918 of FIG. 37B allows the holding capacitance 3708 to substantially maintain the charge accumulated during the under-sampling pulses.

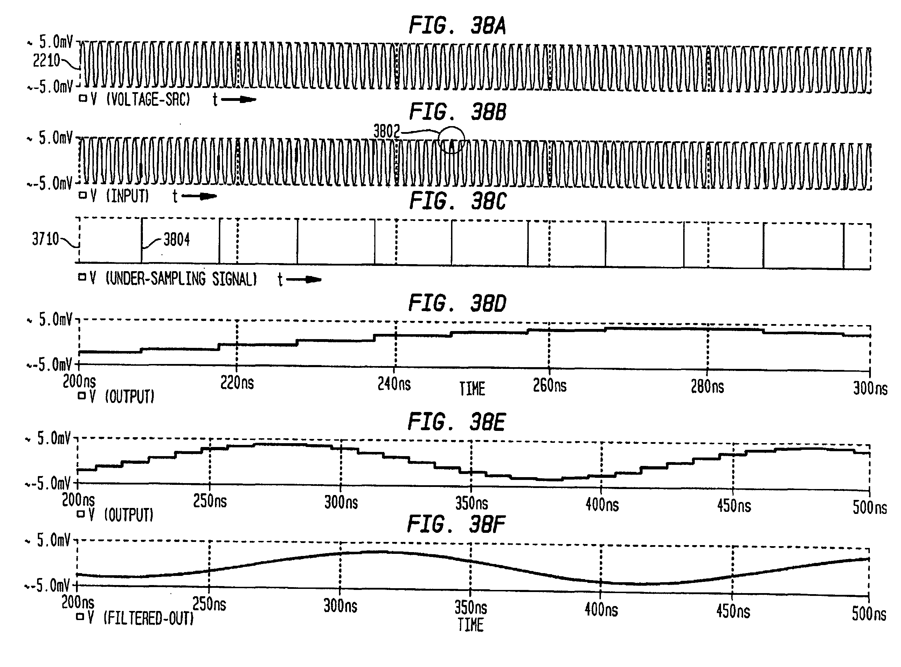

FIGS. 38A-F illustrate example timing diagrams for the under-sampling system 3702. FIG. 38A illustrates an example input modulated carrier signal 2210.

FIG. 38C illustrates an example under-sampling signal 3710, including pulses 3804 having negligible apertures that tend towards zero time in duration.

FIG. 38B illustrates the negligible effects to the input modulated carrier signal 2210 when under-sampled, as measured at a terminal 3714 of the under-sampling system 3702. In FIG. 38B, negligible distortions 3802 correlate with the pulses of the under-sampling signal 3710. In this embodiment, the negligible distortions 3802 occur at different locations of subsequent cycles of the input modulated carrier signal 2210. As a result, the input modulated carrier signal will be down-converted. The negligible distortions 3802 represent negligible amounts of energy, in the form of charge that is transferred to the holding capacitance 3708.

When the load 2918 is a high impedance load, the holding capacitance 3708 does not significantly discharge between pulses 3804. As a result, charge that is transferred to the holding capacitance 3708 during a pulse 3804 tends to "hold" the voltage value sampled constant at the terminal 3716 until the next pulse 3804. When voltage of the input modulated carrier signal 2210 changes between pulses 3804, the holding capacitance 3708 substantially attains the new voltage and the resultant voltage at the terminal 3716 forms a stair step pattern, as illustrated in FIG. 38D.

FIG. 38E illustrates the stair step voltage of FIG. 38D on a compressed time scale. The stair step voltage illustrated in FIG. 38E can be filtered to produce the signal illustrated in FIG. 38F. The signals illustrated in FIGS. 38D, E, and F have substantially all of the baseband characteristics of the input modulated carrier signal 2210 in FIG. 3 8A, except that the signals illustrated in FIGS. 38D, E, and F have been successfully down-converted.

Note that the voltage level of the down-converted signals illustrated in FIGS. 38E and 38F are substantially close to the voltage level of the input modulated carrier signal 2210. The under-sampling system 3702 thus down-converts the input modulated carrier signal 2210 with reasonable voltage reproduction, without substantially affecting the input modulated carrier signal 2210. But also note that the power available at the output is relatively negligible (e. g. :$V^2/R$; $\sim$ 5mV and 1 MOhm), given the input modulated carrier signal 2210 would typically have a driving impedance, in an RF environment, of 50 Ohms (e.g.: $V^2/R$; $\sim$ 5mV and 50 Ohms).

### 1.1.1 Effects of Lowering the Impedance of the Load

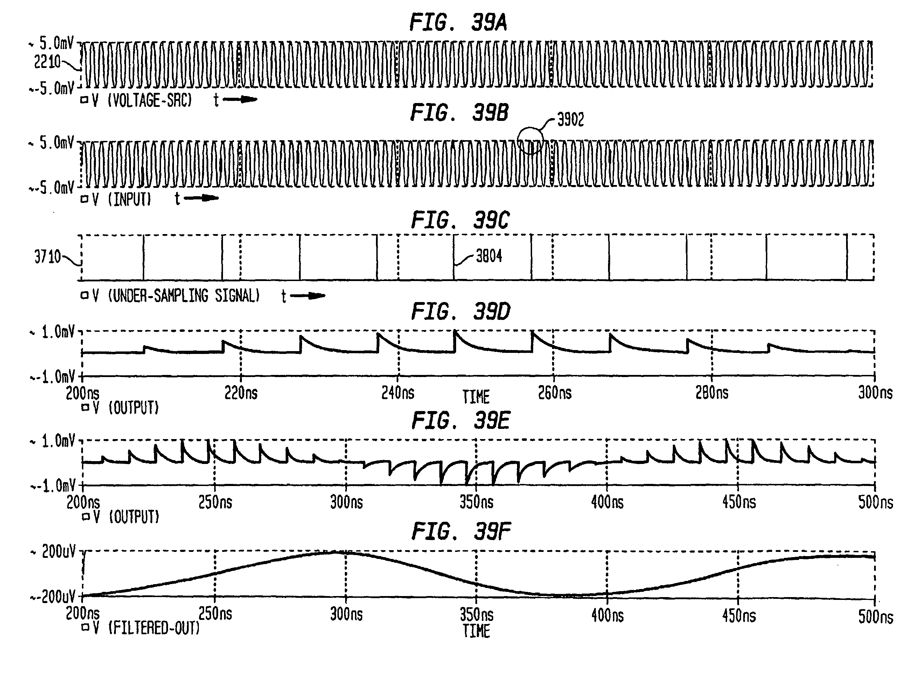

Effects of lowering the impedance of the load 2918 are now described. FIGS. 39A-E illustrate example timing diagrams for the under-sampling system 3702 when the load 2918 is a relatively low impedance load, one that is significant relative to the output drive impedance of the system for a given output frequency.

FIG. 39A illustrates an example input modulated carrier signal 2210.

FIG. 39C illustrates the example under-sampling signal 3710, including the pulses 3804 having negligible apertures that tend towards zero time in duration.

FIG.39B illustrates the negligible effects to the input modulated carrier signal 2210 when under-sampled, as measured at the terminal 3714 of the under-sampling system 3702. In FIG. 39B, negligible distortions 3902 correlate with the pulses 3804 of the under-sampling signal 3710 in FIG. 39C. In this example, the negligible distortions 3902 occur at different locations of subsequent cycles of the input modulated carrier signal 2210. As a result, the input modulated carrier signal 2210 will be down-converted. The negligible distortions 3902 represent negligible amounts of energy, in the form of charge that is transferred to the holding capacitance 3708.

When the load 2918 is a low impedance load, the holding capacitance 3708 is significantly discharged by the load between pulses 3804 (FIG. 39C). As a result, the holding capacitance 3708 cannot reasonably attain or "hold" the voltage of the original modulated carrier input signal 2210, as was seen in the case of FIG. 38D. Instead, the charge appears as the output illustrated in FIG. 39D.

FIG. 39E illustrates the output from FIG. 39D on a compressed time scale. The output in FIG. 39E can be filtered to produce the signal illustrated in FIG. 39F. The down-converted signal illustrated in FIG. 39F is substantially similar to the down-converted signal illustrated in FIG. 3 8F, except that the signal illustrated in FIG. 39F is substantially smaller in magnitude than the amplitude of the down-converted signal illustrated in FIG. 38F. This is because the low impedance of the load 2918 prevents the holding capacitance 3708 from reasonably attaining or "holding" the voltage of the original modulated carrier input signal 2210. As a result, the down-converted signal illustrated in FIG. 39F cannot provide optimal voltage reproduction, and has relatively negligible power available at the output (e.g.: $V^2/R$; ~ 200µV and 2KOhms), given the input modulated carrier signal 2210 would typically have a driving impedance, in an RF environment, of 50 Ohms (e.g.: $V^2/R$; ~ 5mV and 50 Ohms).

### 1.1.2 Effects of Increasing the Value of the Holding Capacitance

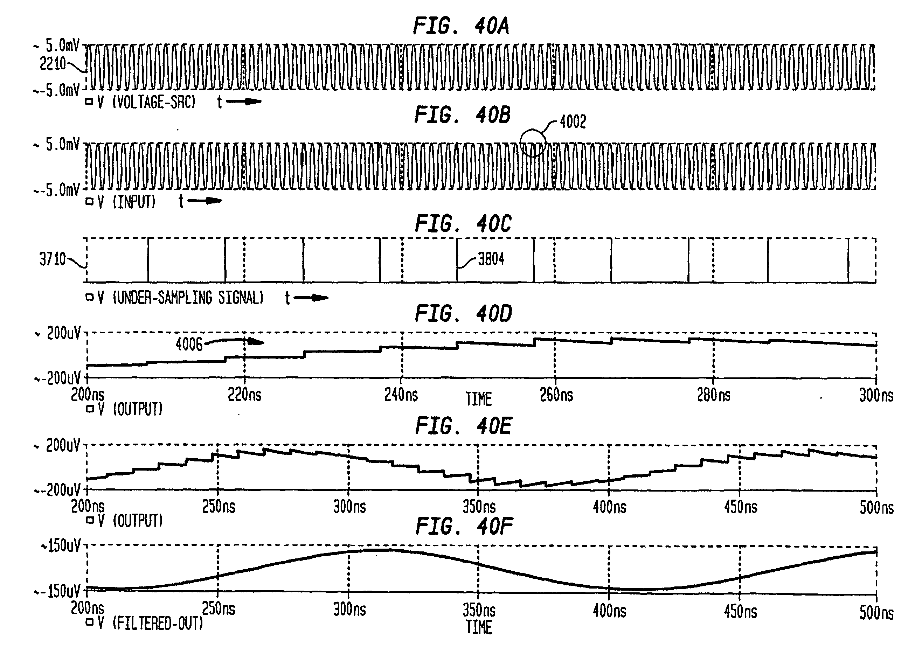

Effects of increasing the value of the holding capacitance 3708, while having to drive a low impedance load 2918, is now described. FIGS. 40A-F illustrate example timing diagrams for the under-sampling system 3702 when the holding capacitance 3708 has a larger value, in the range of 18pF for example.

FIG. 40 A illustrates the example input modulated carrier signal 2210.

FIG. 40C illustrates the example under-sampling signal 3710, including the pulses 3804 having negligible apertures that tend towards zero time in duration.

FIG. 40B illustrates the negligible effects to the input modulated carrier signal 2210 when under-sampled, as measured at the terminal 3714 of the under-sampling system 3702. In FIG. 40B, negligible distortions 4002 correlate with the pulses 3804 ofthe under-sampling signal 3710 in FIG. 40C. Upon close inspection, the negligible distortions 4002 occur at different locations of subsequent cycles of the input modulated carrier signal 2210. As a result, the input modulated carrier signal 2210 will be down-converted. The negligible distortions 4002 represent negligible amounts of energy, in the form of charge that is transferred to the holding capacitance 3708.

FIG. 40D illustrates the voltage measured at the terminal 3716, which is a result of the holding capacitance 3708 attempting to attain and "hold" the original input modulated carrier signal voltage, but failing to do so, during the negligible apertures of the pulses 3804 illustrated in FIG. 40C.

Recall that when the load 2918 is a low impedance load, the holding capacitance 3708 is significantly discharged by the load between pulses 4004 (FIG. 40C), this again is seen in FIGS. 40D and E. As a result, the holding capacitance 3708 cannot reasonably attain or "hold" the voltage of the original modulated carrier input signal 2210, as was seen in the case of FIG. 38D. Instead, the charge appears as the output illustrated in FIG. 40D.

FIG. 40E illustrates the down-converted signal 4006 on a compressed time scale. Note that the amplitude of the down-converted signal 4006 is significantly less than the amplitude of the down-converted signal illustrated in FIGS. 39D and 39E. This is due to the higher capacitive value of the holding capacitance 3708. Generally, as the capacitive value increases, it requires more charge to increase the voltage for a given aperture. Because of the negligible aperture of the pulses 4004 in FIG. 40C, there is insufficient time to transfer significant amounts of energy or charge from the input modulated carrier signal 2210 to the holding capacitance 3708. As a result, the amplitudes attained by the holding capacitance 3708 are significantly less than the amplitudes of the down-converted signal illustrated in FIGS. 39D and 39E.

In FIGS. 39E and 39F, the output signal, non-filtered or filtered, cannot provide optimal voltage reproduction, and has relatively negligible power available at the output (e.g.: $V^2/R$; ~ 150µV and 2KOhms), given the input modulated carrier signal 2210 would typically have a driving impedance, in an RF environment, of 50 Ohms (e.g.: $V^2/R$; ~ 5mV and 50 Ohms).

In summary, under-sampling systems, such as the under-sampling system 3702 illustrated in FIG. 37, are well suited for down-converting modulated carrier signals with relatively accurate voltage reproduction. Also, they have a negligible affect on the original input modulated carrier signal. As illustrated above, however, the under-sampling systems, such as the under-sampling system 3702 illustrated in FIG. 37, are not well suited for transferring energy or for driving lower impedance loads.

### 1.2 Introduction to Energy Transfer

The present invention transfers energy from a modulated carrier signal by utilizing an energy transfer signal instead of an under-sampling signal. Unlike under-sampling signals that have negligible aperture pulses, the energy transfer signal includes a train of pulses having non-negligible apertures that tend away from zero. This provides more time to transfer energy from a modulated carrier input signal. One direct benefit is that the input impedance of the system is reduced so that practical impedance matching circuits can be implemented to further improve energy transfer and thus overall efficiency. The non-negligible transferred energy significantly improves the signal to noise ratio and sensitivity to very small signals, as well as permitting the down-converted signal to drive lower impedance loads unassisted. Signals that especially benefit include low power ones typified by RF signals. One benefit of a non-negligible aperture is that phase noise within the energy transfer signal does not have as drastic of an effect on the down-converted output signal as under-sampling signal phase noise or conventional sampling signal phase noise does on their respective outputs.

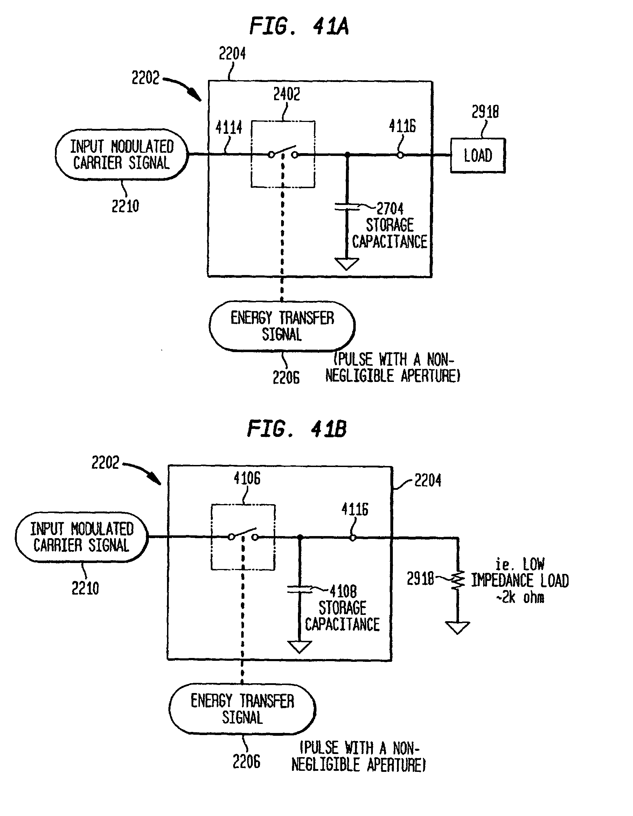

FIG. 41A illustrates an exemplary implementation of the energy transfer system 2202 for down-converting the input modulated carrier signal 2210. In FIG. 41A, the energy transfer module 2204 includes a switching module 2402 and a storage module illustrated as a storage capacitance 2704. The terms storage module and storage capacitance, as used herein, are distinguishable from the terms holding module and holding capacitance, respectively. Holding modules and holding capacitances, as used above, identify systems that store negligible amounts of energy from an under-sampled input modulated carrier signal with the intent of "holding" a voltage value. Storage modules and storage capacitances, on the other hand, refer to systems that store non-negligible amounts of energy from an input modulated carrier signal.

The energy transfer module 2204 receives the energy transfer signal 2206, which controls the switch module 2402. The energy transfer signal 2206 includes a train of energy transfer pulses having non-negligible pulse widths that tend away from zero time in duration. The non-negligible pulse widths can be any non-negligible amount. For example, the non-negligible pulse widths can be ½ of a period of the input modulated carrier signal. Alternatively, the non-negligible pulse widths can be any other fraction of a period of the input modulated carrier signal, or a multiple of a period plus a fraction. In an example embodiment, the input modulated carrier signal is approximately 900 MHZ and the non-negligible pulse width is approximately 550 pico seconds. Any other suitable non-negligible pulse duration can be used.

In an energy transfer environment, the storage module, illustrated in FIG. 41 as the storage capacitance 2704, preferably has the capacity to handle the power being transferred, and to allow it to accept a non-negligible amount of power during a non-negligible aperture period. This allows the storage capacitance 2704 to store energy transferred from the input modulated carrier signal 2210, without substantial concern for accurately reproducing the original, unaffected voltage level of the input modulated carrier signal 2210. For example, in an embodiment, the storage capacitance 2704 has a value in the range of 18pF. Other suitable capacitance values and storage modules can be used.

One benefit of the energy transfer module 2204 is that, even when the input modulated carrier signal 2210 is a very small signal, the energy transfer module 2204 transfers enough energy from the input modulated carrier signal 2210 that the input modulated carrier signal can be efficiently down-converted.

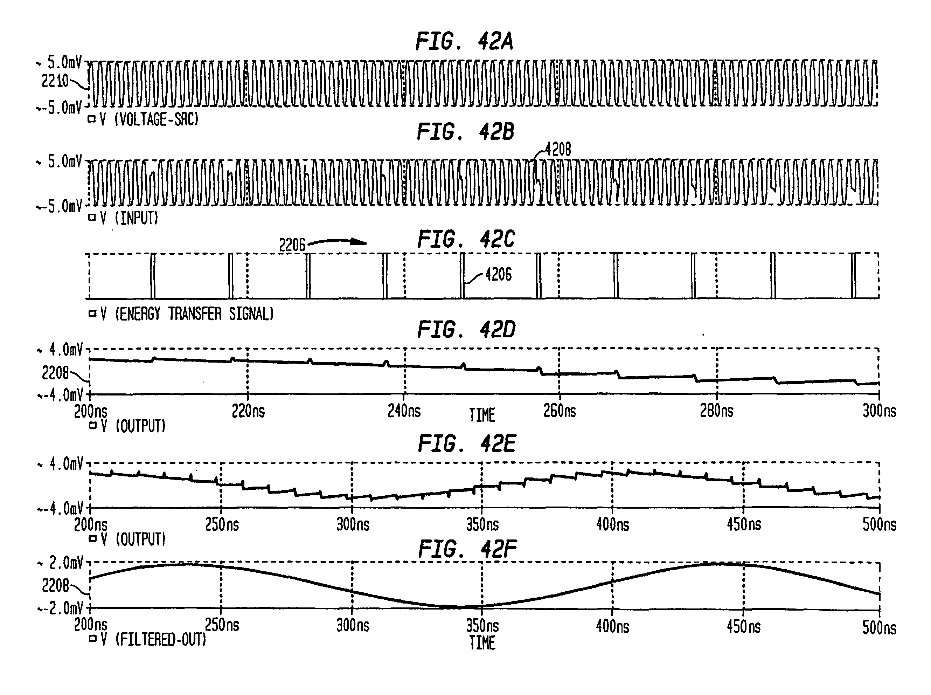

The energy transfer module 2204 is coupled to the load 2918. Recall from the overview of under-sampling that loads can be classified as high impedance loads or low impedance loads. A high impedance load is one that is relatively insignificant to an output drive impedance ofthe system for a given output frequency. A low impedance load is one that is relatively significant. Another benefit of the energy transfer module 2204 is that the non-negligible amounts of transferred energy permit the energy transfer module 2204 to effectively drive loads that would otherwise be classified as low impedance loads in under-sampling systems and conventional sampling systems. In other words, the non-negligible amounts of transferred energy ensure that, even for lower impedance loads, the storage capacitance 2704 accepts and maintains sufficient energy or charge to drive the load 2918. This is illustrated below in the timing diagrams of FIGS. 42A-F. FIG. 41B illustrates the load 2918 as a relatively low impedance load of 2K Ohm.

FIGS. 42A-F illustrate example timing diagrams for the energy transfer module 2204 in FIG. 41. FIG. 42A illustrates an example input modulated carrier signal 2210.

FIG. 42C illustrates an example energy transfer signal 2206, including energy transfer pulses 4206 having non-negligible apertures that tend away from zero time in duration.

FIG. 42B illustrates the effects to the input modulated carrier signal 2210, as measured at a terminal 4114 in FIG. 41A, when non-negligible amounts of energy are transfered from it. In FIG. 42B, non-negligible distortions 4208 correlate with the energy transfer pulses 4206 in FIG. 42C. In this example, the non-negligible distortions 4208 occur at different locations of subsequent cycles of the input modulated carrier signal 2210. The non-negligible distortions 4208 represent non-negligible amounts of transferred energy, in the form of charge that is transferred to the storage capacitance 2704.

FIG. 42D illustrates a down-converted signal 2208 that is formed by energy transferred from the input modulated carrier signal 2210.

FIG. 42E illustrates the down-converted signal 2208 on a compressed time scale. The down-converted signal 2208 illustrated in FIG. 42E can be filtered to produce the down-converted signal 2208 illustrated in FIG. 42F. The down-converted signal 2208 illustrated in FIG. 42F is similar to the down-converted signal illustrated in FIG. 3 8F, except that the down-converted signal 2208 illustrated in FIG. 42F has substantially more power (e.g.: $V^2/R$; approximately ($\sim$) 2mV and 2K Ohms) than the down-converted signal illustrated in FIG. 38F (e.g.: $V^2/R$; $\sim$ 5mV and 1M Ohms). As a result, the down-converted signals 2208 illustrated in FIGS. 42E and 42F can efficiently drive lower impedance loads, given the input modulated carrier signal 2210 would typically have a driving impedance, in an RF environment, of 50 Ohms ($V^2/R$; $\sim$ 5mV and 50 Ohms).

### 2. Down-Converting a Modulated Carrier Signal to an IF Modulated Carrier Signal by Transferring Energy from the Modulated Carrier Signal at an Aliasing Rate

The invention down-converts a modulated carrier signal to an IF signal by transferring energy from the modulated carrier signal at an aliasing rate.

This embodiment can be implemented with any type of modulated carrier signal. The invention is described herein using the modulated carrier signal $F_{MC}$ in FIG. 1 as an example. In the example, the modulated carrier signal $F_{MC}$ is down-converted to an intermediate frequency (IF) signal $F_{IF}$. The intermediate frequency signal $F_{IF}$ can be demodulated to a baseband signal $F_{DMB}$ using conventional demodulation techniques.

The following sections describe methods for down-converting a modulated carrier signal to an IF signal $F_{IF}$ by transferring energy from the modulated carrier signal at an aliasing rate. Exemplary structural embodiments for implementing the methods are also described.

The following sections include a high level discussion, example embodiments, and implementation examples.

### 2.1 High Level Description

This section (including its subsections) provides a high-level description of down-converting a modulated carrier signal to an IF signal $F_{IF}$ by transferring energy, according to the invention. In particular, an operational process of down-converting the modulated carrier signal $F_{MC}$ to the IF modulated carrier signal $F_{IF}$, by transferring energy, is described at a high-level. Also, a structural implementation for implementing this process is described at a high-level. The process described in this section can be achieved using any number of structural implementations, one of which is described in this section. The details of such structural implementations will be apparent to persons skilled in the relevant art(s) based on the teachings contained herein.

### 2.1.1 Operational Description

FIG. 12 depicts the flowchart 1207 that illustrates an exemplary method for down-converting a modulated carrier signal to an intermediate signal $F_{IF}$, by transferring energy from the modulated carrier signal at an aliasing rate. Any and all combinations of modulation techniques are valid for this invention. For ease of discussion, the digital AM carrier signal 616 is used to illustrate a high level operational description of the invention. Subsequent sections provide detailed flowcharts and descriptions for AM, FM and PM example embodiments. Upon reading the disclosure and examples therein, one skilled in the relevant art(s) will understand that the invention can be implemented to down-convert any type of modulated carrier signal, including any form of modulated carrier signal and unmodulated carrier signals.

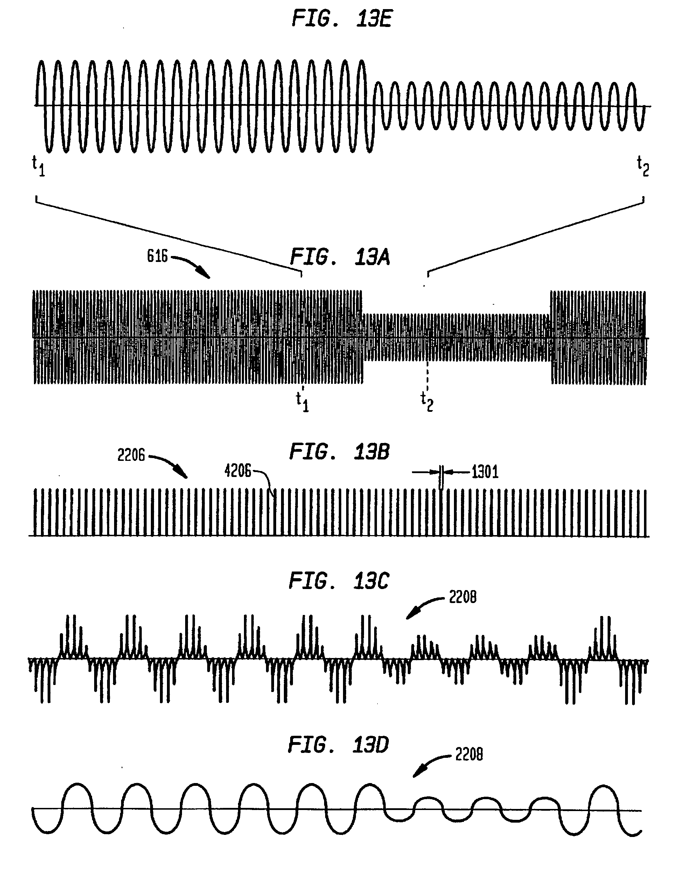

The process begins at step 1208, which includes receiving a modulated carrier signal. Step 1208 is illustrated by the digital AM carrier signal 616. The digital AM carrier signal 616 of FIG. 6C is re-illustrated in FIG. 13A for convenience. The digital AM carrier signal 616 represents the modulated carrier signal 2210. FIG. 13E illustrates a portion of the digital AM carrier signal 616 on an expanded time scale.

Step 1210 includes receiving an energy transfer signal having an aliasing rate $F_{AR}$. FIG. 13B illustrates the example energy transfer signal 2206. The energy transfer signal 2206 includes a train of energy transfer pulses 4206 having non-negligible apertures 1301 that tend away from zero time duration. Generally, the apertures 1301 can be any time duration other than the period of the modulated carrier signal. For example, the apertures 1301 can be greater or less than a period of the modulated carrier signal. Thus, the apertures 1301 can be approximately 1/10, ¼, ½, 3/4, etc., or any other fraction of the period of the modulated carrier signal. Alternatively, the apertures 1301 can be approximately equal to one or more periods of the modulated carrier signal plus 1/10, ¼, ½, 3/4, etc., or any other fraction of a period of the modulated carrier signal. The apertures 1301 can be optimized based on one or more of a variety of criteria, as described in sections below.

The energy transfer pulses 4206 repeat at the aliasing rate. A suitable aliasing rate can be determined or selected as described below. Generally, when down-converting a modulated carrier signal to an intermediate signal, the aliasing rate is substantially equal to a difference frequency, which is described below, or substantially equal to a harmonic or, more typically, a sub-harmonic of the difference frequency.

Step 1212 includes transferring energy from the modulated carrier signal at the aliasing rate to down-convert the modulated carrier signal to the intermediate signal $F_{IF}$. FIG. 13C illustrates transferred energy, which is transferred from the modulated carrier signal during the energy transfer pulses 4206. Because a harmonic of the aliasing rate occurs at an off-set of the frequency of the AM signal 616, the pulses 4206 "walk through" the AM signal 616 at the off-set frequency. By "walking through" the AM signal 616, the transferred energy forms an AM intermediate signal 2208 that is similar to the AM carrier signal 616, except that the AM intermediate signal 2208 has a lower frequency than the AM carrier signal 616. The AM carrier signal 616 can be down-converted to any frequency below the AM carrier signal 616 by adjusting the aliasing rate $F_{AR}$, as described below.

FIG. 13D depicts the AM intermediate signal 2208 as a filtered output signal 2208. In an alternative embodiment, the invention outputs a stair step, or non-filtered output signal. The choice between filtered, partially filtered and non-filtered output signals is generally a design choice that depends upon the application of the invention.

The intermediate frequency of the down-converted signal $F_{IF}$ 2208 can be determined from EQ. (2), which is reproduced below for convenience.

$$F_C = n \cdot F_{AR} \pm F_{IF} \qquad \text{EQ. (2)}$$

A suitable aliasing rate $F_{AR}$ can be determined in a variety of ways. An example method for determining the aliasing rate $F_{AR}$, is provided below. After reading the description herein, one skilled in the relevant art(s) will understand how to determine appropriate aliasing rates for modulated carrier signals , including ones in addition to the modulated carrier signals specifically illustrated herein.

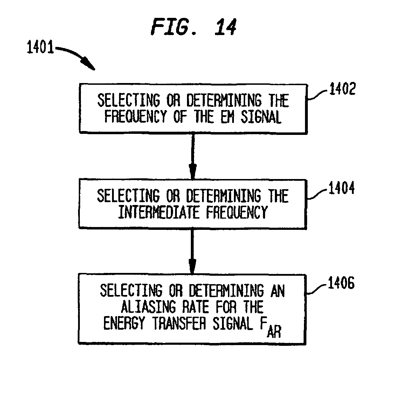

In FIG. 14, a flowchart 1401 illustrates an example process for determining an aliasing rate $F_{AR}$. But a designer may choose, or an application may dictate, that the values be determined in an order that is different than the illustrated order. The process begins at step 1402, which includes determining, or selecting, the frequency of the modulated carrier signal. The frequency of the AM carrier signal 616 can be, for example, 901 MHZ.

Step 1404 includes determining, or selecting, the intermediate frequency. This is the frequency to which the modulated carrier signal will be down-converted The intermediate frequency can be determined, or selected, to match a frequency requirement of a down-stream demodulator. The intermediate frequency can be, for example, 1 MHZ.

Step 1406 includes determining the aliasing rate or rates that will down-convert the modulated carrier signal to the IF specified in step 1404.

EQ. (2) can be rewritten as EQ. (3):

$$n \cdot F_{AR} = F_C \pm F_{IF} \qquad \text{EQ. (3)}$$

Which can be rewritten as EQ. (4):

$$n = \frac{F_C \pm F_{IF}}{F_{AR}} \qquad \text{EQ. (4)}$$

or as EQ. (5):

$$F_{AR} = \frac{F_C \pm F_{IF}}{n} \qquad \text{EQ. (5)}$$

$(F_C \pm F_{IF})$ can be defined as a difference value $F_{DIFF}$, as illustrated in EQ. (6):

$$(F_C \pm F_{IF}) = F_{DIFF} \qquad \text{EQ. (6)}$$

EQ. (4) can be rewritten as EQ. (7):

$$n = \frac{F_{DIFF}}{F_{AR}} \qquad \text{EQ. (7)}$$

From EQ. (7), it can be seen that, for a given n and a constant $F_{AR}$, $F_{DIFF}$ is constant. For the case of $F_{DIFF}$ = $F_C$ - $F_{IF}$, and for a constant $F_{DIFF}$, as $F_C$ increases, $F_{IF}$ necessarily increases. For the case of $F_{DIFF}$ = $F_C$ + $F_{IF}$, and for a constant $F_{DIFF}$, as $F_C$ increases, $F_{IF}$ necessarily decreases. In the latter case of $F_{DIFF}$ = $F_C$ + $F_{IF}$, any phase or frequency changes on $F_C$ correspond to reversed or inverted phase or frequency changes on $F_{IF}$. This is mentioned to teach the reader that if $F_{DIFF}$ = $F_C$ + $F_{IF}$ is used, the above effect will occur to the phase and frequency response of the modulated intermediate signal $F_{IF}$.

EQs. (2) through (7) can be solved for any valid n. A suitable n can be determined for any given difference frequency $F_{DIFF}$ and for any desired aliasing rate $F_{AR(Desired)}$. EQs. (2) through (7) can be utilized to identify a specific harmonic closest to a desired aliasing rate $F_{AR(Desired)}$ that will generate the desired intermediate signal $F_{IF}$.

An example is now provided for determining a suitable n for a given difference frequency $F_{DIFF}$ and for a desired aliasing rate $F_{AR(Desired)}$. For ease of illustration, only the case of ($F_C$ - $F_{IF}$) is illustrated in the example below.

$$n = \frac{F_C - F_{IF}}{F_{AR(Desired)}} = \frac{F_{DIFF}}{F_{AR(Desired)}}$$

The desired aliasing rate $F_{AR(Desired)}$ can be, for example, 140 MHZ. Using the previous examples, where the carrier frequency is 901 MHZ and the IF is 1 MHZ, an initial value of n is determined as:

$$n = \frac{901 \text{ MHZ} - 1 \text{ MHZ}}{140 \text{ MHZ}} = \frac{900}{140} = 6.4$$

The initial value 6.4 can be rounded up or down to the valid nearest n, which was defined above as including (0.5, 1, 2, 3, ...). In this example, 6.4 is rounded down to 6.0, which is inserted into EQ. (5) for the case of ($F_C$ - $F_{IF}$) = $F_{DIFF}$.:

$$F_{AR} = \frac{F_c - F_{IF}}{n}$$

$$F_{AR} = \frac{901 \text{ MHZ} - 1 \text{ MHZ}}{6} = \frac{900 \text{ MHZ}}{6} = 150 \text{ MHZ}$$

In other words, transferring energy from a 901 MHZ modulated carrier signal at 150 MHZ generates an intermediate signal at 1 MHZ. The intermediate signal will also substantially include the modulation. The modulated intermediate signal can be demodulated through any conventional demodulation technique.

Alternatively, instead of starting from a desired aliasing rate, a list of suitable aliasing rates can be determined from the modified form of EQ. (5), by solving for various values of n. Example solutions are listed below.

$$F_{AR} = \frac{(F_C \cdot F_{IF})}{n} = \frac{F_{DIFF}}{n} = \frac{901 \text{ MHZ} - 1 \text{ MHZ}}{n} = \frac{900 \text{ MHZ}}{n}$$

Solving for n = 0.5, 1, 2, 3, 4, 5 and 6:

900MHZ/0.5 = 1.8 GHZ (i.e., second harmonic);
900MHZ/1 = 900 MHZ (i.e., fundamental frequency);
900MHZ/2 = 450 MHZ (i.e., second sub-harmonic);
900MHZ/3 = 300 MHZ (i.e., third sub-harmonic);
900MHZ/4 = 225 MHZ (i.e., fourth sub-harmonic);
900 MHZ/5 = 180 MHZ (i.e., fifth sub-harmonic); and
900 MHZ/6 = 150 MHZ (i.e., sixth sub-harmonic).

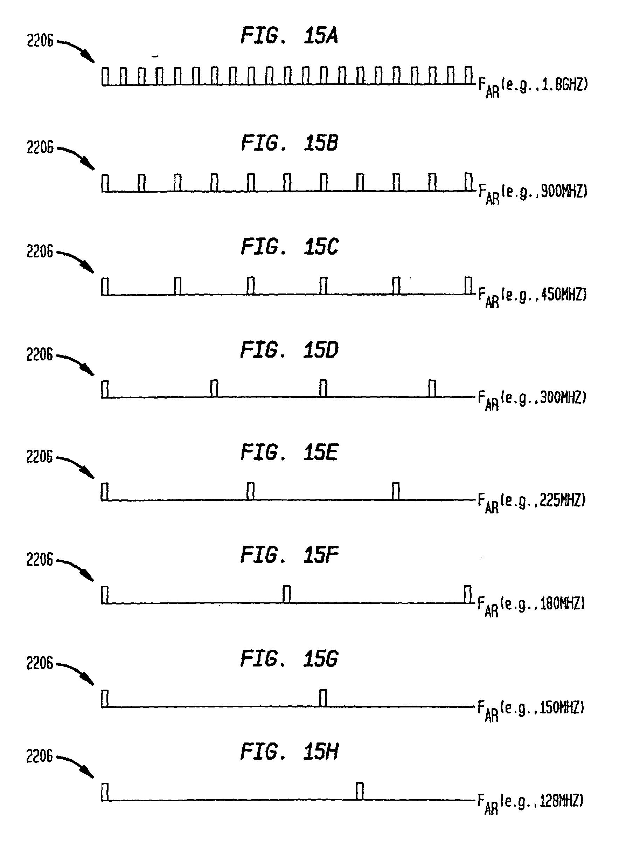

Example energy transfer signals 2206 are illustrated in FIGS. 15A-15H.

The steps described above can be performed for the case of ($F_C$+$F_{IF}$) in a similar fashion. The results can be compared to the results obtained from the case of ($F_C$-$F_{IF}$) to determine which provides better result for an application.

In an embodiment, the invention down-converts a modulated carrier signal to a relatively standard IF in the range of, for example, 100KHZ to 200 MHZ. In another embodiment, referred to herein as a small off-set implementation, the invention down-converts a modulated carrier signal to a relatively low frequency of, for example, less than 100 KHZ. In another embodiment, referred to herein as a large off-set implementation, the invention down-converts a modulated carrier signal to a relatively higher IF signal, such as, for example, above 200 MHZ.

The various off-set implementations provide selectivity for different applications. Generally, lower data rate applications can operate at lower intermediate frequencies. But higher intermediate frequencies can allow more information to be supported for a given modulation technique.

In accordance with the invention, a designerpicks an optimum information bandwidth for an application and an optimum intermediate frequency to support the baseband signal. The intermediate frequency should be high enough to support the bandwidth of the modulating baseband signal $F_{MB}$.

Generally, as the aliasing rate approaches a harmonic or sub-harmonic frequency of the modulated carrier signal, the frequency of the down-converted IF signal decreases. Similarly, as the aliasing rate moves away from a harmonic or sub-harmonic frequency of the modulated carrier signal, the IF increases.

Aliased frequencies occur above and below every harmonic ofthe aliasing frequency. In order to avoid mapping other aliasing frequencies in the band of the aliasing frequency (IF) of interest, the IF of interest should not be near one half the aliasing rate.

As described in example implementations below, an aliasing module, including a universal frequency translator (UFT) module built in accordance with the invention provides a wide range of flexibility in frequency selection and can thus be implemented in a wide range of applications. Conventional systems cannot easily offer, or do not allow, this level of flexibility in frequency selection.

### 2.1.2 Structural Description

Recall that FIG. 22 illustrates a block diagram of an energy transfer system 2202 according to an embodiment of the invention. Operation of the energy transfer system 2202 is now described in detail with reference to the flowchart 1207 and to the timing diagrams illustrated in FIGS. 13A-E. In step 1208, the energy transfer module 2204 receives the AM carrier signal 616. In step 1210, the energy transfer module 2204 receives the energy transfer signal 2206 illustrated in FIG. 13B. In step 1212, the energy transfer module 2204 transfers energy from the AM carrier signal 616 of FIGS. 13A and 13E at the aliasing rate to down-convert the AM carrier signal 616 to the intermediate signal 2208 of FIGS. 13C and 13D.

Example implementations of the energy transfer system 2202 are provided in sections below.

### 2.2 Example Embodiments

The method for down-converting the modulated carrier signal 2210 by transferring energy can be implemented with any type of modulated carrier signal, including modulated carrier signals and unmodulated carrier signals. For example, the method of the flowchart 1207 can be implemented to down-convert AM signals, FM signals, PM signals, etc., or any combination thereof. Operation of the flowchart 1207 of FIG. 12 is described below for down-converting AM, FM and PM.

### 2.2.1 First Example Embodiment: Amplitude Modulation

### 2.2.1.1 Operational Description

Operation of the exemplary process of the flowchart 1207 in FIG. 12 is described below for the analog AM carrier signal 516, illustrated in FIG. 5C, and for the digital AM carrier signal 616, illustrated in FIG. 6C.

### 2.2.1.1.1 Analog AM Carrier Signal

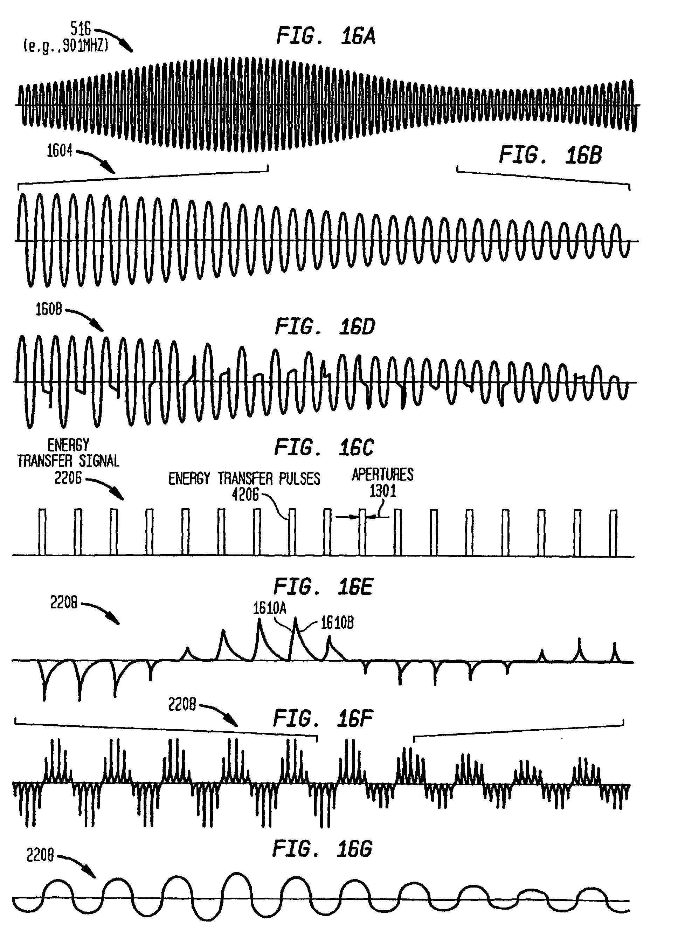

A process for down-converting the analog AM carrier signal 516 in FIG. 5C to an analog AM intermediate signal is now described for the flowchart 1207 in FIG. 12. In this example, the analog AM carrier signal 516 represents the modulated carrier signal 2210. The analog AM carrier signal 516 is re-illustrated in FIG. 16A for convenience. For this example, the analog AM carrier signal 516 oscillates at approximately 901 MHZ. In FIG. 16B, an analog AM carrier signal 1604 illustrates a portion of the analog AM carrier signal 516 on an expanded time scale. The process begins at step 1208, which includes receiving the modulated carrier signal. This is represented by the analog AM carrier signal 516.

Step 1210 includes receiving an energy transfer signal having an aliasing rate $F_{AR}$. FIG. 16C illustrates the example energy transfer signal 2206 on approximately the same time scale as FIG. 16B. The energy transfer signal 2206 includes the train of energy transfer pulses 4206 having non-negligible apertures 1301 that tend away from zero time in duration. The energy transfer pulses 4206 repeat at the aliasing rate $F_{AR}$, which is determined or selected as previously described. Generally, when down-converting to an intermediate signal, the aliasing rate $F_{AR}$ is substantially equal to a harmonic or, more typically, a sub-harmonic of the difference frequency $F_{DIFF}$.

Step 1212 includes transferring energy from the modulated carrier signal at the aliasing rate to down-convert the modulated carrier signal to an intermediate signal $F_{IF}$. In FIG. 16D, an affected analog AM carrier signal 1608 illustrates effects of transferring energy from the analog AM carrier signal 516 at the aliasing rate $F_{AR}$. The affected analog AM carrier signal 1608 is illustrated on substantially the same time scale as FIGS. 16B and 16C.

FIG 16E illustrates a down-converted AM intermediate signal 2208, which is generated by the down-conversion process. The AM intermediate signal 2208 is illustrated with an arbitrary load impedance. Load impedance optimizations are discussed in sections below.

The down-converted signal 2208 includes portions 1610A, which correlate with the energy transfer pulses 4206 in FIG. 16C, and portions 1610B, which are between the energy transfer pulses 4206. Portions 1610A represent energy transferred from the AM analog signal 516 to a storage device, while simultaneously driving an output load. The portions 1610A occur when a switching module is closed by the energy transfer pulses 4206. Portions 1610B represent energy stored in a storage device continuing to drive the load. Portions 161 0B occur when the switching module is opened after energy transfer pulses 4206.

Because a harmonic of the aliasing rate is off-set from the analog AM carrier signal 516, the energy transfer pulses 4206 "walk through" the analog AM carrier signal 516 at the difference frequency $F_{DIFF}$. In other words, the energy transfer pulses 4206 occur at different locations of subsequent cycles of the AM carrier signal 516. As a result, the energy transfer pulses 4206 capture varying amounts of energy from the analog AM carrier signal 516, as illustrated by portions 1610A, which provides the AM intermediate signal 2208 with an oscillating frequency $F_{IF}$.

In FIG. 16F, the AM intermediate signal 2208 of FIG. 16E is illustrated on a compressed time scale. In FIG. 16G, the AM intermediate signal 2208 is illustrated as a filtered version of the AM intermediate signal 2208 illustrated in FIG. 16F. The AM intermediate signal 2208 is substantially similar to the AM carrier signal 516, except that the AM intermediate signal 2208 is at the intermediate frequency. The AM intermediate signal 2208 can be demodulated through any conventional demodulation technique.

The present invention can output the unfiltered AM intermediate signal 2208 of FIG. 16F, the filtered AM intermediate signal 2208 of FIG. 16G, a partially filtered AM intermediate signal, a stair step output signal, etc. The choice between these embodiments is generally a design choice that depends upon the application of the invention.

The signals referred to herein illustrate frequency down-conversion in accordance with the invention. For example, the AM intermediate signals 2208 in FIGS. 16F and 16G illustrate that the AM carrier signal 516 was successfully down-converted to an intermediate signal by retaining enough baseband information for sufficient reconstruction.

### 2.2.1.1.2 Digital AM Carrier Signal

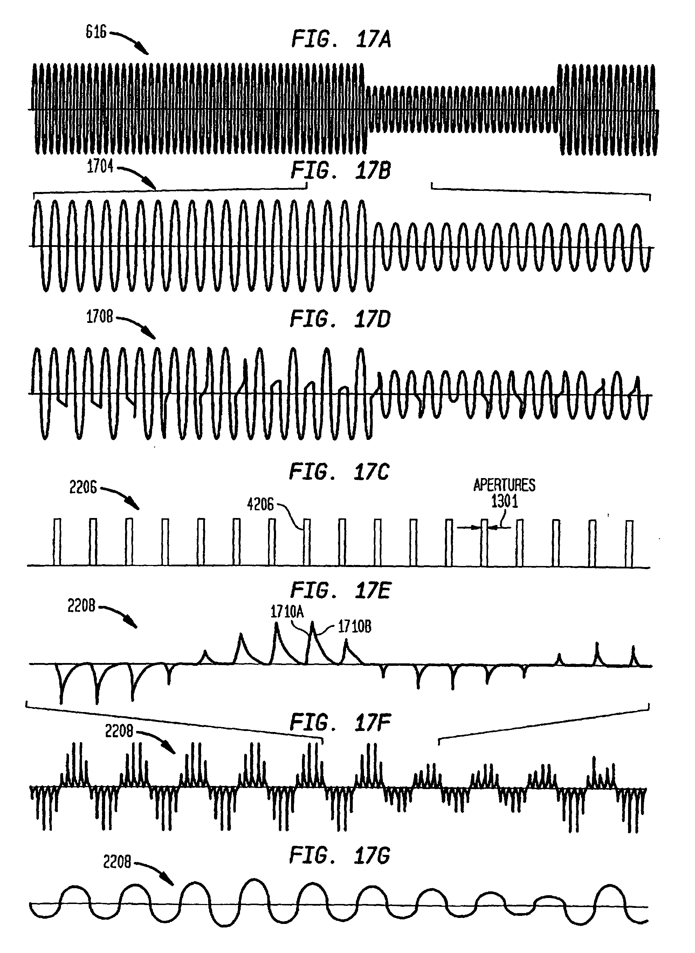

A process for down-converting the digital AM carrier signal 616 to a digital AM intermediate signal is now described for the flowchart 1207 in FIG. 12. In this example, the digital AM carrier signal 616 represents the modulated carrier signal 2210. The digital AM carrier signal 616 is re-illustrated in FIG. 17A for convenience. For this example, the digital AM carrier signal 616 oscillates at approximately 901 MHZ. In FIG. 17B, a digital AM carrier signal 1704 illustrates a portion of the digital AM carrier signal 616 on an expanded time scale.

The process begins at step 1208, which includes receiving a modulated carrier signal. This is represented by the digital AM carrier signal 616.

Step 1210 includes receiving an energy transfer signal having an aliasing rate $F_{AR}$. FIG. 17C illustrates the example energy transfer signal 2206 on substantially the same time scale as FIG. 17B. The energy transfer signal 2206 includes the train of energy transfer pulses 4206 having non-negligible apertures 1301 that tend away from zero time in duration. The energy transfer pulses 4206 repeat at the aliasing rate, which is determined or selected as previously described. Generally, when down-convertingto an intermediate signal, the aliasing rate is substantially equal to a harmonic or, more typically, a sub-harmonic of the difference frequency $F_{DIFF}$.

Step 1212 includes transferring energy from the modulated carrier signal at the aliasing rate to down-convert the modulated carrier signal to the intermediate signal $F_{IF}$. In FIG. 17D, an affected digital AM carrier signal 1708 illustrates effects of transferring energy from the digital AM carrier signal 616 at the aliasing rate $F_{AR}$. The affected digital AM carrier signal 1708 is illustrated on substantially the same time scale as FIGS. 17B and 17C.

FIG 17E illustrates a down-converted AM intermediate signal 2208, which is generated by the down-conversion process. The AM intermediate signal 2208 is illustrated with an arbitrary load impedance. Load impedance optimizations are discussed in sections below.

The down-converted signal 2208 includes portions 1710A, which correlate with the energy transfer pulses 4206 in FIG. 17C, and portions 1710B, which are between the energy transfer pulses 4206. Portions 1710A represent energy transferred from the digital AM carrier signal 616 to a storage device, while simultaneously driving an output load. The portions 1710A occur when a switching module is closed by the energy transfer pulses 4206. Portions 1710B represent energy stored in a storage device continuing to drive the load. Portions 1710B occur when the switching module is opened after energy transfer pulses 4206.

Because a harmonic of the aliasing rate is off-set from the frequency of the digital AM carrier signal 616, the energy transfer pulses 4206 "walk through" the digital AM signal 616 at the difference frequency $F_{DIFF}$. In other words, the energy transfer pulse 4206 occur at different locations of subsequent cycles of the digital AM carrier signal 616. As a result, the energy transfer pulses 4206 capture varying amounts of energy from the digital AM carrier signal 616, as illustrated by portions 1710, which provides the AM intermediate signal 2208 with an oscillating frequency $F_{IF}$.

In FIG. 17F, the digital AM intermediate signal 2208 of FIG. 17E is illustrated on a compressed time scale. In FIG. 17G, the AM intermediate signal 2208 is illustrated as a filtered version of the AM intermediate signal 2208 illustrated in FIG. 17F. The AM intermediate signal 2208 is substantially similar to the AM carrier signal 616, except that the AM intermediate signal 2208 is at the intermediate frequency. The AM intermediate signal 2208 can be demodulated through any conventional demodulation technique.

The present invention can output the unfiltered AM intermediate signal 2208 of FIG. 17F, the filtered AM intermediate signal 2208 of FIG. 17G, a partially filtered AM intermediate signal, a stair step output signal, etc. The choice between these embodiments is generally a design choice that depends upon the application of the invention.

The signals referred to herein illustrate frequency down-conversion in accordance with the invention. For example, the AM intermediate signals 2208 in FIGS. 17F and 17G illustrate that the AM carrier signal 616 was successfully down-converted to an intermediate signal by retaining enough baseband information for sufficient reconstruction.

### 2.2.1.2 Structural Description

The operation of the energy transfer system 2202 is now described for the analog AM carrier signal 516, with reference to the flowchart 1207 and to the timing diagrams in FIGS. 16A-G. In step 1208, the energy transfer module 2204 receives the analog AM carrier signal 516. In step 1210, the energy transfer module 2204 receives the energy transfer signal 2206. In step 1212, the energy transfer module 2204 transfers energy from the analog AM carrier signal 516 at the aliasing rate of the energy transfer signal 2206, to down-convert the analog AM carrier signal 516 to the AM intermediate signal 2208.

The operation of the energy transfer system 2202 is now described for the digital AM carrier signal 616, with reference to the flowchart 1207 and the timing diagrams in FIGS. 17A-G. In step 1208, the energy transfer module 2204 receives the digital AM carrier signal 616. In step 1210, the energy transfer module 2204 receives the energy transfer signal 2206. In step 1212, the energy transfer module 2204 transfers energy from the digital AM carrier signal 616 at the aliasing rate of the energy transfer signal 2206, to down-convert the digital AM carrier signal 616 to the AM intermediate signal 2208.

Example embodiments of the energy transfer module 2204 are disclosed in sections below.

### 2.2.2 Second Example Embodiment: Frequency Modulation

### 2.2.2.1 Operational Description

Operation of the exemplary process of the flowchart 1207 in FIG. 12 is described below for the analog FM carrier signal 716, illustrated in FIG. 7C, and for the digital FM carrier signal 816, illustrated in FIG. 8C.

### 2.2.2.1.1 Analog FM Carrier Signal

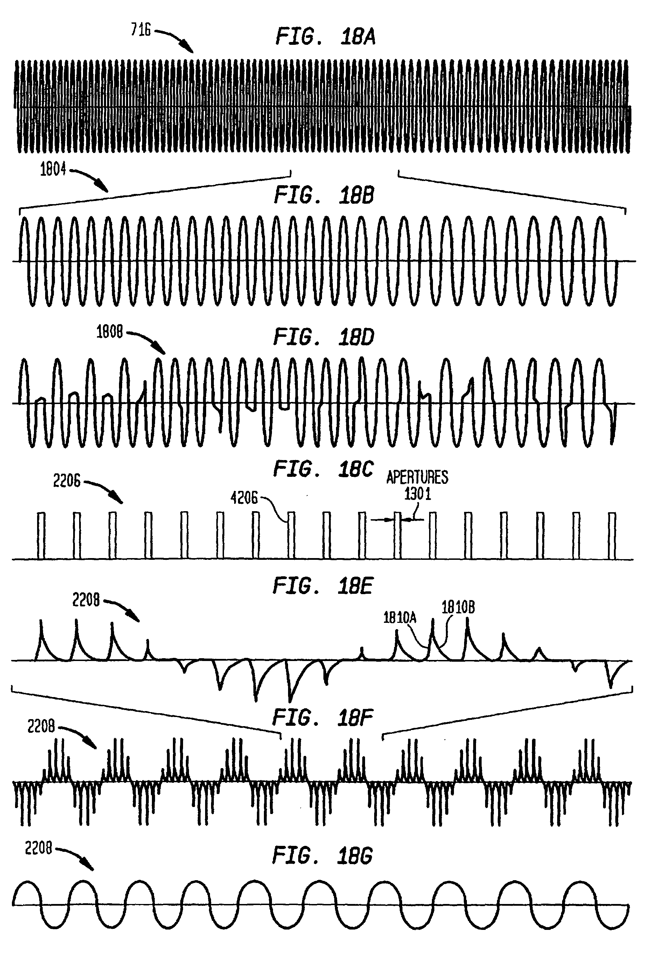

A process for down-converting the analog FM carrier signal 716 in FIG. 7C to an FM intermediate signal is now described for the flowchart 1207 in FIG. 12. In this example, the analog FM carrier signal 716 represents the modulated carrier signal 2210. The analog FM carrier signal 716 is re-illustrated in FIG. 18A for convenience. For this example, the analog FM carrier signal 716 oscillates around approximately 901 MHZ. In FIG. 18B, an analog FM carrier signal 1804 illustrates a portion of the analog FM carrier signal 716 on an expanded time scale.

The process begins at step 1208, which includes receiving a modulated carrier signal. This is represented by the analog FM carrier signal 716.

Step 1210 includes receiving an energy transfer signal having an aliasing rate $F_{AR}$. FIG. 18C illustrates the example energy transfer signal 2206 on approximately the same time scale as FIG. 18B. The energy transfer signal 2206 includes the train of energy transfer pulses 4206 having non-negligible apertures 1301 that tend away from zero time in duration. The energy transfer pulses 4206 repeat at the aliasing rate $F_{AR}$, which is determined or selected as previously described. Generally, when down-converting to an intermediate signal, the aliasing rate $F_{AR}$ is substantially equal to a harmonic or, more typically, a sub-harmonic of the difference frequency $F_{DIFF}$.

Step 1212 includes transferring energy from the modulated carrier signal at the aliasing rate to down-convert the modulated carrier signal to an intermediate signal $F_{IF}$. In FIG. 18D, an affected analog FM carrier signal 1808 illustrates effects of transferring energy from the analog FM carrier signal 716 at the aliasing rate $F_{AR}$. The affected analog FM carrier signal 1808 is illustrated on substantially the same time scale as FIGS. 18B and 18C.

FIG 18E illustrates a down-converted FM intermediate signal 2208, which is generated by the down-conversion process. The FM intermediate signal 2208 is illustrated with an arbitrary load impedance. Load impedance optimizations are discussed in Sections below.

The down-converted signal 2208 includes portions 1810A, which correlate with the energy transfer pulses 4206 in FIG. 18C, and portions 1810B, which are between the energy transfer pulses 4206. Portions 1810A represent energy transferred from the analog FM carrier signal 716 to a storage device, while simultaneously driving an output load. The portions 1810A occur when a switching module is closed by the energy transfer pulses 4206. Portions 1810B represent energy stored in a storage device continuing to drive the load. Portions 1810B occur when the switching module is opened after energy transfer pulses 4206.

Because a harmonic of the aliasing rate is off-set from the frequency of the analog FM carrier signal 716, the energy transfer pulses 4206 "walk through" the analog FM carrier signal 716 at the difference frequency $F_{DIFF}$. In other words, the energy transfer pulse 4206 occur at different locations of subsequent cycles of the analog FM carrier signal 716. As a result, the energy transfer pulses 4206 capture varying amounts of energy from the analog FM carrier signal 716, as illustrated by portions 1810, which provides the FM intermediate signal 2208 with an oscillating frequency $F_{IF}$.

In FIG. 18F, the analog FM intermediate signal 2208 of FIG. 18E is illustrated on a compressed time scale. In FIG. 18G, the FM intermediate signal 2208 is illustrated as a filtered version of the FM intermediate signal 2208 illustrated in FIG. 18F. The FM intermediate signal 2208 is substantially similar to the analog FM carrier signal 716, except that the FM intermediate signal 2208 is at the intermediate frequency. The FM intermediate signal 2208 can be demodulated through any conventional demodulation technique.

The present invention can output the unfiltered FM intermediate signal 2208 of FIG. 18F, the filtered FM intermediate signal 2208 of FIG. 18G, a partially filtered FM intermediate signal, a stair step output signal, etc. The choice between these embodiments is generally a design choice that depends upon the application of the invention.

The signals referred to herein illustrate frequency down-conversion in accordance with the invention. For example, the FM intermediate signals 2208 in FIGS. 18F and 18G illustrate that the FM carrier signal 716 was successfully down-converted to an intermediate signal by retaining enough baseband information for sufficient reconstruction.

#### 2.2.2.1.2 Digital FM Carrier Signal

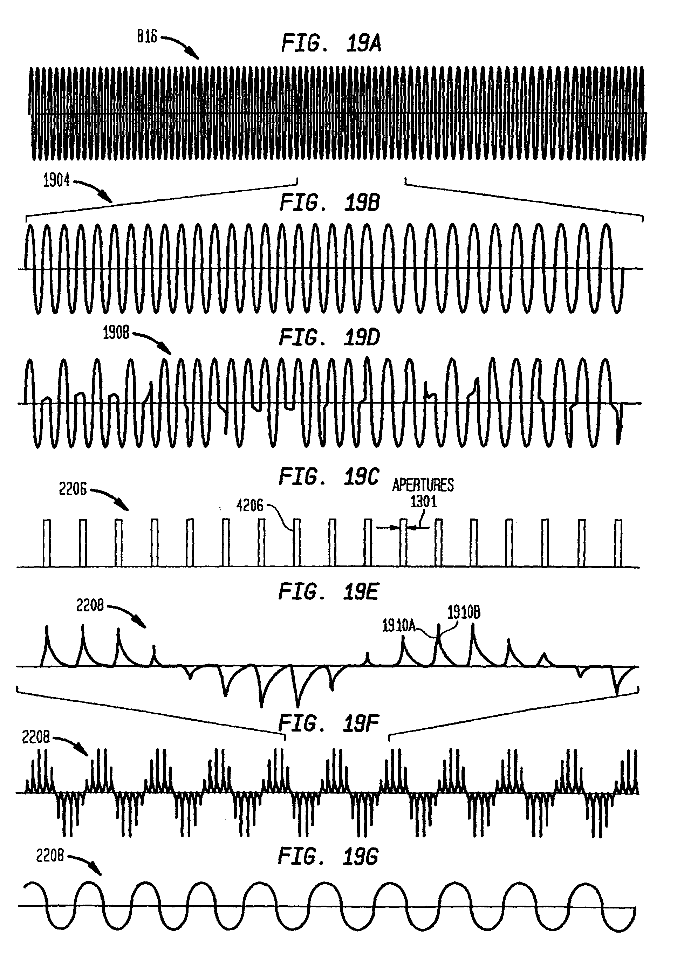

A process for down-converting the digital FM carrier signal 816 in FIG. 8C is now described for the flowchart 1207 in FIG. 12. The digital FM carrier signal 816 is re-illustrated in FIG. 19A for convenience. In this example, the digital FM carrier signal 816 represents the modulated carrier signal 2210. For this example, the digital FM carrier signal 816 oscillates at approximately 901 MHZ. In FIG. 19B, a digital FM carrier signal 1904 illustrates a portion of the digital FM carrier signal 816 on an expanded time scale.

The process begins at step 1208, which includes receiving a modulated carrier signal. This is represented by the digital FM carrier signal 816.

Step 1210 includes receiving an energy transfer signal having an aliasing rate $F_{AR}$. FIG. 19C illustrates the example energy transfer signal 2206 on substantially the same time scale as FIG. 19B. The energy transfer signal 2206 includes the train of energy transfer pulses 4206 having non-negligible apertures 1301 that tend away from zero time in duration. The energy transfer pulses 4206 repeat at the aliasing rate, which is determined or selected as previously described. Generally, when down-converting to an intermediate signal, the aliasing rate $F_{AR}$ is substantially equal to a harmonic or, more typically, a sub-harmonic of the difference frequency $F_{DIFF}$.

Step 1212 includes transferring energy from the modulated carrier signal at the aliasing rate to down-convert the modulated carrier signal to the an intermediate signal $F_{IF}$. In FIG. 19D, an affected digital FM carrier signal 1908 illustrates effects of transferring energy from the digital FM carrier signal 816 at the aliasing rate $F_{AR}$. The affected digital FM carrier signal 1908 is illustrated on substantially the same time scale as FIGS. 19B and 19C.

FIG 19E illustrates a down-converted FM intermediate signal 2208, which is generated by the down-conversion process. The down-converted signal 2208 includes portions 1910A, which correlate with the energy transfer pulses 4206 in FIG. 19C, and portions 1910B, which are between the energy transfer pulses 4206. Down-converted signal 2208 is illustrated with an arbitrary load impedance. Load impedance optimizations are discussed in sections below.

Portions 1910A represent energy transferred from the digital FM carrier signal 816 to a storage device, while simultaneously driving an output load. The portions 1910A occur when a switching module is closed by the energy transfer pulses 4206.

Portions 1910B represent energy stored in a storage device continuing to drive the load. Portions 1910B occur when the switching module is opened after energy transfer pulses 4206.

Because a harmonic of the aliasing rate is off-set from the frequency of the digital FM carrier signal 816, the energy transfer pulses 4206 "walk through" the digital FM carrier signal 816 at the difference frequency $F_{DIFF}$. In other words, the energy transfer pulse 4206 occur at different locations of subsequent cycles of the digital FM carrier signal 816. As a result, the energy transfer pulses 4206 capture varying amounts of energy from the digital FM carrier signal 816, as illustrated by portions 1910, which provides the FM intermediate signal 2208 with an oscillating frequency $F_{IF}$.

In FIG. 19F, the digital FM intermediate signal 2208 of FIG. 19E is illustrated on a compressed time scale. In FIG. 19G, the FM intermediate signal 2208 is illustrated as a filtered version of the FM intermediate signal 2208 illustrated in FIG. 19F. The FM intermediate signal 2208 is substantially similar to the digital FM carrier signal 816, except that the FM intermediate signal 2208 is at the intermediate frequency. The FM intermediate signal 2208 can be demodulated through any conventional demodulation technique.

The present invention can output the unfiltered FM intermediate signal 2208 of FIG. 19F, the filtered FM intermediate signal 2208 of FIG. 19G, a partially filtered FM intermediate signal, a stair step output signal, etc. The choice between these embodiments is generally a design choice that depends upon the application of the invention.

The signals referred to herein illustrate frequency down-conversion in accordance with the invention. For example, the FM intermediate signals 2208 in FIGS. 19F and 19G illustrate that the FM carrier signal 816 was successfully down-converted to an intermediate signal by retaining enough baseband information for sufficient reconstruction.

### 2.2.2.2 Structural Description

The operation of the energy transfer system 2202 is now described for the analog FM carrier signal 716, with reference to the flowchart 1207 and the timing diagrams in FIGS. 18A-G. In step 1208, the energy transfer module 2204 receives the analog FM carrier signal 716. In step 1210, the energy transfer module 2204 receives the energy transfer signal 2206. In step 1212, the energy transfer module 2204 transfers energy from the analog FM carrier signal 716 at the aliasing rate of the energy transfer signal 2206, to down-convert the analog FM carrier signal 716 to the FM intermediate signal 2208.

The operation of the energy transfer system 2202 is now described for the digital FM carrier signal 816, with reference to the flowchart 1207 and the timing diagrams in FIGS. 19A-G. In step 1208, the energy transfer module 2204 receives the digital FM carrier signal 816. In step 1210, the energy transfer module 2204 receives the energytransfer signal 2206. In step 1212, the energy transfer module 2204 transfers energy from the digital FM carrier signal 816 at the aliasing rate of the energy transfer signal 2206, to down-convert the digital FM carrier signal 816 to the FM intermediate signal 2208.

Example embodiments of the energy transfer module 2204 are disclosed in sections below.

### 2.2.3 Third Example Embodiment: Phase Modulation

### 2.2.3.1 Operational Description

Operation of the exemplary process of the flowchart 1207 in FIG. 12 is described below for the analog PM carrier signal 916, illustrated in FIG. 9C, and for the digital PM carrier signal 1016, illustrated in FIG. 10C.

### 2.2.3.1.1 Analog PM Carrier Signal

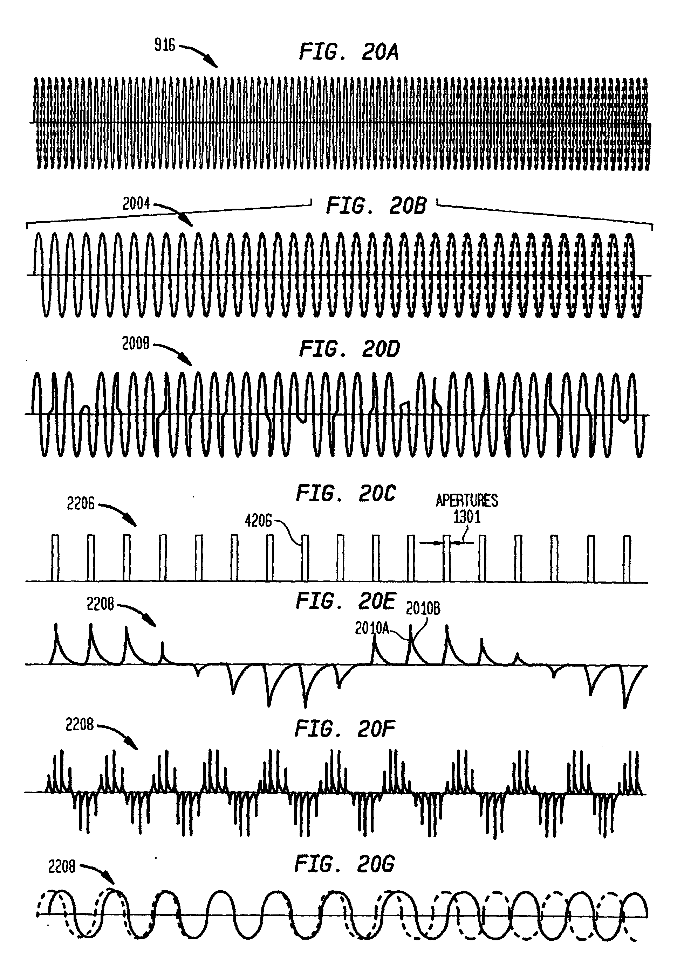

A process for down-converting the analog PM carrier signal 916 in FIG. 9C to an analog PM intermediate signal is now described for the flowchart 1207 in FIG. 12. The analog PM carrier signal 916 is re-illustrated in FIG. 20A for convenience. In this example, the analog PM carrier signal 916 represents the modulated carrier signal 2210. For this example, the analog PM carrier signal 916 oscillates at approximately 901 MHZ. In FIG. 20B, an analog PM carrier signal 2004 illustrates a portion of the analog PM carrier signal 916 on an expanded time scale.

The process begins at step 1208, which includes receiving a modulated carrier signal. This is represented by the analog PM carrier signal 916.

Step 1210 includes receiving an energy transfer signal having an aliasing rate $F_{AR}$. FIG. 20C illustrates the example energy transfer signal 2206 on approximately the same time scale as FIG. 20B. The energy transfer signal 2206 includes the train of energy transfer pulses 4206 having non-negligible apertures 1301 that tend away from zero time in duration. The energy transfer pulses 4206 repeat at the aliasing rate, which is determined or selected as previously described. Generally, when down-converting to an intermediate signal, the aliasing rate $F_{AR}$ is substantially equal to a harmonic or, more typically, a sub-harmonic of the difference frequency $F_{DIFF}$.

Step 1212 includes transferring energy from the modulated carrier signal at the aliasing rate to down-convert the modulated carrier signal to the IF signal $F_{IF}$. In FIG. 20D, an affected analog PM carrier signal 2008 illustrates effects of transferring energy from the analog PM carrier signal 916 at the aliasing rate $F_{AR}$. The affected analog PM carrier signal 2008 is illustrated on substantially the same time scale as FIGS. 20B and 20C.

FIG 20E illustrates a down-converted PM intermediate signal 2208, which is generated by the down-conversion process. The down-converted PM intermediate signal 2208 includes portions 2010A, which correlate with the energy transfer pulses 4206 in FIG. 20C, and portions 2010B, which are between the energy transfer pulses 4206. Down-converted signal 2208 is illustrated with an arbitrary load impedance. Load impedance optimizations are discussed in sections below.

Portions 2010A represent energy transferred from the analog PM carrier signal 916 to a storage device, while simultaneously driving an output load. The portions 2010A occur when a switching module is closed by the energy transfer pulses 4206.

Portions 2010B represent energy stored in a storage device continuing to drive the load. Portions 2010B occur when the switching module is opened after energy transfer pulses 4206.

Because a harmonic of the aliasing rate is off-set from the frequency of the analog PM carrier signal 716, the energy transfer pulses 4206 "walk through" the analog PM carrier signal 916 at the difference frequency $F_{DIFF}$. In other words, the energy transfer pulse 4206 occur at different locations of subsequent cycles of the analog PM carrier signal 916. As a result, the energy transfer pulses 4206 capture varying amounts of energy from the analog PM carrier signal 916, as illustrated by portions 2010, which provides the PM intermediate signal 2208 with an oscillating frequency $F_{IF}$.

In FIG. 20F, the analog PM intermediate signal 2208 of FIG. 20G is illustrated on a compressed time scale. In FIG. 20G, the PM intermediate signal 2208 is illustrated as a filtered version of the PM intermediate signal 2208 illustrated in FIG. 16F. The PM intermediate signal 2208 is substantially similar to the analog PM carrier signal 916, except that the PM intermediate signal 2208 is at the intermediate frequency. The PM intermediate signal 2208 can be demodulated through any conventional demodulation technique.

The present invention can output the unfiltered PM intermediate signal 2208 of FIG. 20F, the filtered PM intermediate signal 2208 ofFIG. 20G, a partially filtered PM intermediate signal, a stair step output signal, etc. The choice between these embodiments is generally a design choice that depends upon the application of the invention.

The signals referred to herein illustrate frequency down-conversion in accordance with the invention. For example, the PM intermediate signals 2208 in FIGS. 20F and 20G illustrate that the PM carrier signal 916 was successfully down-converted to an intermediate signal by retaining enough baseband information for sufficient reconstruction.

### 2.2.3.1.2 Digital PM Carrier Signal

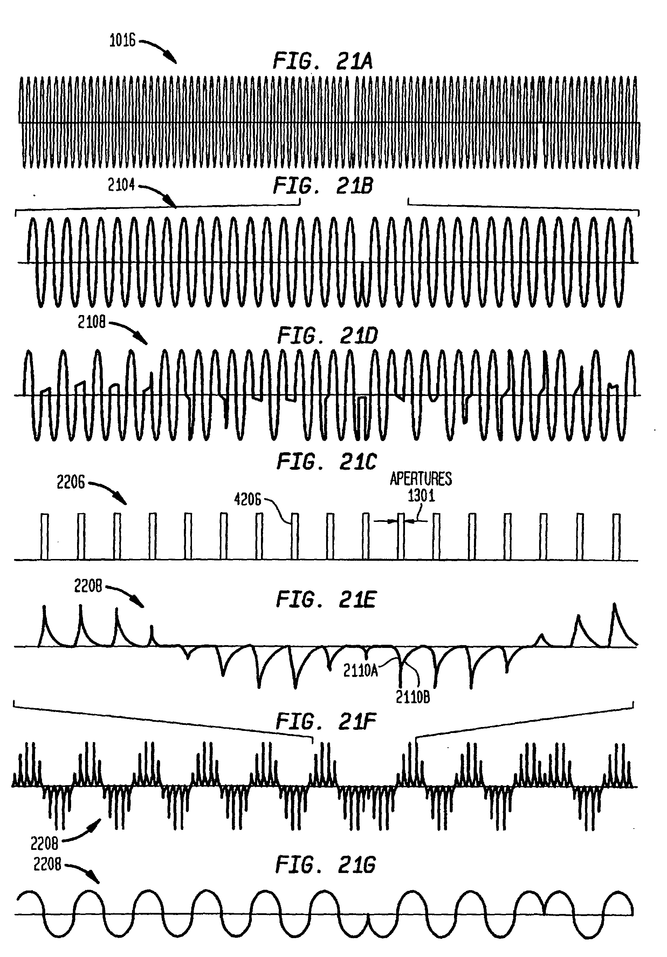

A process for down-converting the digital PM carrier signal 1016 in FIG. 10C to a digital PM signal is now described for the flowchart 1207 in FIG. 12. The digital PM carrier signal 1016 is re-illustrated in FIG. 21A for convenience. In this example, the digital PM carrier signal 1016 represents the modulated carrier signal 2210. For this example, the digital PM carrier signal 1016 oscillates at approximately 901 MHZ. In FIG. 21B, a digital PM carrier signal 2104 illustrates a portion of the digital PM carrier signal 1016 on an expanded time scale.

The process begins at step 1208, which includes receiving a modulated carrier signal. This is represented by the digital PM carrier signal 1016.

Step 1210 includes receiving an energy transfer signal having an aliasing rate $F_{AR}$. FIG. 21C illustrates the example energy transfer signal 2206 on substantially the same time scale as FIG. 21B. The energy transfer signal 2206 includes the train of energy transfer pulses 4206 having non-negligible apertures 2109 that tend away from zero time in duration. The energy transfer pulses 4206 repeat at an aliasing rate, which is determined or selected as previously described. Generally, when down-converting to an intermediate signal, the aliasing rate $F_{AR}$ is substantially equal to a harmonic or, more typically, a sub-harmonic of the difference frequency $F_{DIFF}$.

Step 1212 includes transferring energy from the modulated carrier signal at the aliasing rate to down-convert the modulated carrier signal to an intermediate signal $F_{IF}$. In FIG. 21D, an affected digital PM carrier signal 2108 illustrates effects of transferring energy from the digital PM carrier signal 1016 at the aliasing rate $F_{AR}$. The affected digital PM carrier signal 2108 is illustrated on substantially the same time scale as FIGS. 21B and 21C.

FIG 21E illustrates a down-converted PM intermediate signal 2208, which is generated by the down-conversion process. The down-converted PM intermediate signal 2208 includes portions 2110A, which correlate with the energy transfer pulses 4206 in FIG. 21C, and portions 2110B, which are between the energy transfer pulses 4206.

Down-converted signal 2208 is illustrated with an arbitrary load impedance. Load impedance optimizations are discussed in sections below.

Portions 2110A represent energy transferred from the digital PM carrier signal 1016 to a storage device, while simultaneously driving an output load. The portions 2110A occur when a switching module is closed by the energy transfer pulses 4206.

Portions 2110B represent energy stored in a storage device continuing to drive the load. Portions 2110B occur when the switching module is opened after energy transfer pulses 4206.

Because a harmonic of the aliasing rate is off-set from the frequency of the digital PM carrier signal 716, the energy transfer pulses 4206 "walk through" the digital PM carrier signal 1016 at the difference frequency $F_{DIFF}$. In other words, the energy transfer pulse 4206 occur at different locations of subsequent cycles of the digital PM carrier signal 1016. As a result, the energy transfer pulses 4206 capture varying amounts of energy from the digital PM carrier signal 1016, as illustrated by portions 2110, which provides the PM intermediate signal 2208 with an oscillating frequency $F_{IF}$.

In FIG. 21F, the digital PM intermediate signal 2208 of FIG. 21E is illustrated on a compressed time scale. In FIG. 21G, the PM intermediate signal 2208 is illustrated as a filtered version of the PM intermediate signal 2208 illustrated in FIG. 21F. The PM intermediate signal 2208 is substantially similar to the digital PM carrier signal 1016, except that the PM intermediate signal 2208 is at the intermediate frequency. The PM intermediate signal 2208 can be demodulated through any conventional demodulation technique.

The present invention can output the unfiltered PM intermediate signal 2208 of FIG. 21F, the filtered PM intermediate signal 2208 of FIG. 21G, apartially filtered PM intermediate signal, a stair step output signal, etc. The choice between these embodiments is generally a design choice that depends upon the application of the invention.

The signals referred to herein illustrate frequency down-conversion in accordance with the invention. For example, the PM intermediate signals 2208 in FIG. 21F and FIG. 21G illustrate that the PM carrier signal 1016 was successfully down-converted to an intermediate signal by retaining enough baseband information for sufficient reconstruction.

### 2.2.3.2 Structural Description

Operation of the energy transfer system 2202 is now described for the analog PM carrier signal 916, with reference to the flowchart 1207 and the timing diagrams in FIGS. 20A-G. In step 1208, the energy transfer module 2204 receives the analog PM carrier signal 916. In step 1210, the energy transfer module 2204 receives the energy transfer signal 2206. In step 1212, the energy transfer module 2204 transfers energy from the analog PM carrier signal 916 at the aliasing rate of the energy transfer signal 2206, to down-convert the analog PM carrier signal 916 to the PM intermediate signal 2208.

Operation of the energy transfer system 2202 is now described for the digital PM carrier signal 1016, with reference to the flowchart 1207 and the timing diagrams in FIGS. 21A-G. In step 1208, the energy transfer module 2204 receives the digital PM carrier signal 1016. In step 1210, the energy transfer module 2204 receives the energy transfer signal 2206. In step 1212, the energy transfer module 2204 transfers energy from the digital PM carrier signal 1016 at the aliasing rate of the energy transfer signal 2206, to down-convert the digital PM carrier signal 1016 to the PM intermediate signal 2208.

Example embodiments of the energy transfer module 2204 are disclosed in sections below.

### 3. Implementation Examples

Exemplary operational and/or structural implementations related to the method(s), structure(s), and/or embodiments described above are presented in this section (and its subsections).

Recall that the energy transfer system 2202 of FIG. 22 includes the energy transfer module 2204, which receives the modulated carrier signal 2210 and the energy transfer signal 2206. The energy transfer signal 2206 includes a train of energy transfer pulses having non-negligible apertures that tend away from zero time in duration. The energy transfer pulses repeat at an aliasing rate $F_{AR}$. The energy transfer module 2204 transfers energy from the modulated carrier signal 2210 at the aliasing rate of the energy transfer signal 2206, as described in the sections above with respect to the flowchart 1207 in FIG. 12. The energy transfer module 2204 outputs the down-converted signal 2208, which includes non-negligible amounts of energy transferred from the modulated carrier signal 2210.

FIG. 23A illustrates an exemplary gated transfer system 2302, which is an example of the energy transfer system 2202. The gated transfer system 2302 includes a gated transfer module 2304, which is an example of the energy transfer module 2204. The gated transfer system 2302 is described below.

FIG. 23B illustrates an exemplary inverted gated transfer system 2306, which is an alternative example of the energy transfer system 2202. The inverted gated transfer system 2306 includes an inverted gated transfer module 2308, which is an example of the energy transfer module 2204. The inverted gated transfer system 2306 is described below.

### 3.1 The Energy Transfer System as a Gated Transfer System

FIG. 23A illustrates the exemplary gated transfer system 2302, which is an exemplary implementation of the energy transfer system 2202. The gated transfer system 2302 includes the gated transfer module 2304, which receives the modulated carrier signal 2210 and the energy transfer signal 2206. The energy transfer signal 2206 includes a train of energy transfer pulses having non-negligible apertures that tend away from zero time in duration. The energy transfer pulses repeat at an aliasing rate $F_{AR}$.

The gated transfer module 2304 transfers energy from the modulated carrier signal 2210 at the aliasing rate of the energy transfer signal 2206, as described in the sections above with respect to the flowchart 1207 in FIG. 12. The gated transfer module 2304 outputs the down-converted signal 2208, which includes non-negligible amounts of energy transferred from the modulated carrier signal 2210.

### 3.1.1 The Gated Transfer System as a Switch Module and a Storage Module

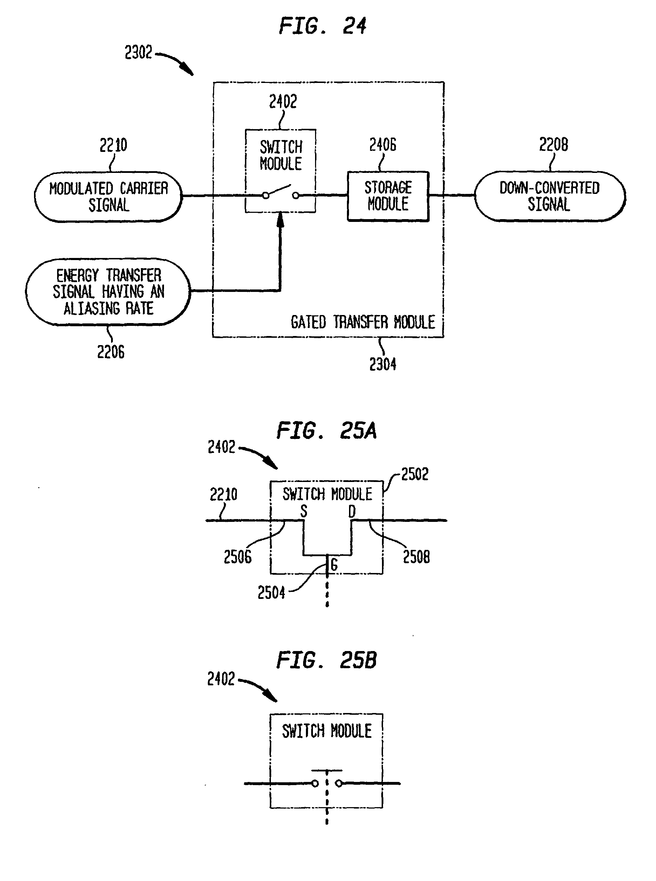

FIG. 24 illustrates an example embodiment of the gated transfer module 2304 as including a switch module 2402 and a storage module 2406. Operation of the switch module 2402 and the storage module 2406 is now described for down-converting the modulated carrier signal 2210 to an intermediate signal, with reference to the flowchart 1207 and the example timing diagrams in FIG. 42A-F.

In step 1208, the switch module 2402 receives the modulated carrier signal 2210 (FIG. 42A). In step 1210, the switch module 2402 receives the energy transfer signal 2206 (FIG. 42C). In step 1212, the switch module 2402 and the storage module 2406 cooperate to transfer energy from the modulated carrier signal 2210 and down-convert it to an intermediate signal. More specifically, during step 1212, the switch module 2402 closes during each energy transfer pulse to couple the modulated carrier signal 2210 to the storage module 2406. In an embodiment, the switch module 2402 closes on rising edges of the energy transfer pulses. In an alternative embodiment, the switch module 2402 closes on falling edges of the energy transfer pulses. While the modulated carrier signal 2210 is coupled to the storage module 2406, non-negligible amounts of energy are transferred from the modulated carrier signal 2210 to the storage module 2406. FIG. 42B illustrates the modulated carrier signal 2210 after the energy is transferred from it. FIG. 42D illustrates the transferred energy stored in the storage module 2406. The storage module 2406 outputs the transferred energy as the down-converted signal 2208. The storage module 2406 can output the down-converted signal 2208 as an unfiltered signal such as signal shown in FIG. 42E, or as a filtered down-converted signal (FIG. 42F).

### 3.1.2 The Gated Transfer System as Break-Before-Make Module

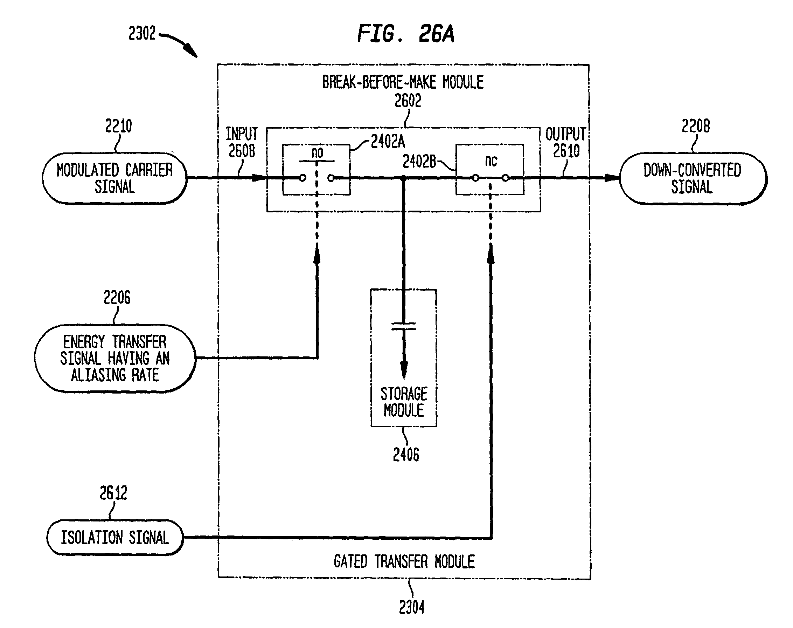

FIG. 26A illustrates an example embodiment of the gated transfer module 2304 as including a break-before-make module 2602 and the storage module 2406, which is illustrated here as including a capacitance. Preferably, the break before make module 2602 and the storage module 2406 transfer energy from the modulated carrier signal 2210 to down-convert it in the manner shown in the operational flowchart 1207 in FIG. 12.

In FIG. 26A, the break-before-make module 2602 includes a normally open switch 2402A and a normally closed switch 2402B. The normally open switch 2402A is controlled by the energy transfer signal 2206. The normally closed switch 2402B is controlled by an isolation signal 2612. In an embodiment, the isolation signal 2612 is generated from the energy transfer signal 2206. Alternatively, the energy transfer signal 2206 is generated from the isolation signal 2612. Alternatively, the isolation signal 2612 is generated independently from the energy transfer signal 2206. The break-before-make module 2602 substantially isolates an input 2608 from an output 2610.

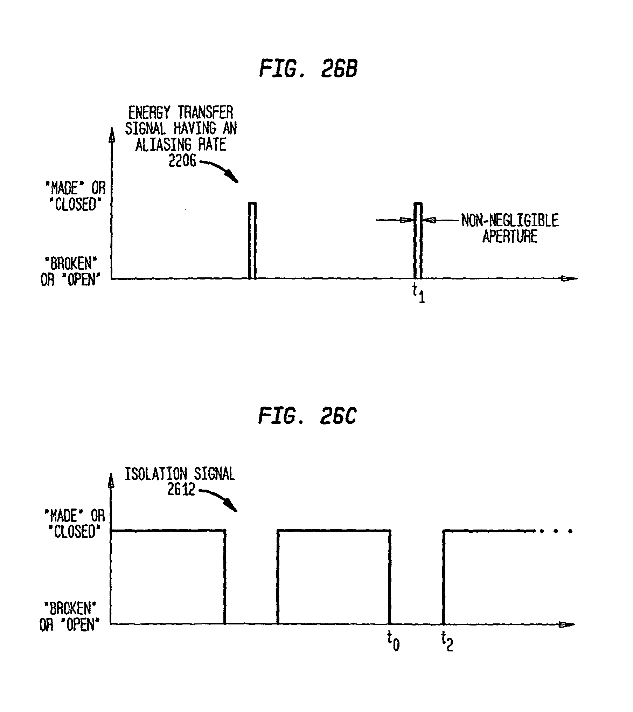

FIG. 26B illustrates an example timing diagram of the energy transfer signal 2206, which controls the normally open switch 2402A. FIG. 26C illustrates an example timing diagram of the isolation signal 2612, which controls the normally closed switch 2402B. Operation of the break-before-make module 2602 is now described with reference to the example timing diagrams in FIGS. 26B and 26C.

Prior to time t0, the normally open switch 2402A and the normally closed switch 2402B are at their normal states.

At time t0, the isolation signal 2612 in FIG. 26C opens the normally closed switch 2402B. Thus, just after time t0, the normally open switch 2402A and the normally closed switch 2402B are open and the input 2608 is isolated from the output 2610.

At time t1, the energy transfer signal 2206 in FIG. 26B closes the normally open switch 2402A for the non-negligible duration of a pulse. This couples the modulated carrier signal 2210 to the storage module 2406.

Prior to t2, the energy transfer signal 2206 in FIG. 26B opens the normally open switch 2402A. This de-couples the modulated carrier signal 2210 from the storage module 2406.

At time t2, the isolation signal 2612 in FIG. 26C closes the normally closed switch 2402B. This couples the storage module 2406 to the output 2610.

The break-before-make gated transfer system 2302 down-converts the modulated carrier signal 2210 in a manner similar to that described with reference to the gated transfer system 2302 in FIG. 24.

### 3.1.3 Example Implementations of the Switch Module

The switch module 2402 in FIGS. 24 and 26A can be any type of switch device(s) that preferably has a relatively low impedance when closed and a relatively high impedance when open. The switch module 2402 can be implemented with normally open and/or normally closed switches. The switch module 2402 need not be ideal switch modules.

FIG. 25B illustrates a functional block diagram ofthe switch module 2402. The switch module 2402 can be implemented with any type of suitable switch device, including, but not limited, to mechanical switch devices and electrical switch devices, optical switch devices, etc., and combinations thereof. Such devices include, but are not limited to transistor switch devices, diode switch devices, relay switch devices, optical switch devices, micro-machine switch devices, etc., or combinations thereof.

In an embodiment, the switch module 2402 can be implemented as a transistor, such as, for example, a field effect transistor (FET), a bi-polar transistor, or any other suitable circuit switching device.

In FIG. 25A, the switch module 2402 is illustrated as a FET 2502. The FET 2502 can be any type of FET, including, but not limited to, a MOSFET, a JFET, a GaAsFET, etc.. The FET 2502 includes a gate 2504, a source 2506 and a drain 2508. The gate 2504 receives the energy transfer signal 2206 to control the switching action between the source 2506 and the drain 2508. In an embodiment, the source 2506 and the drain 2508 are interchangeable.

It should be understood that the illustration of the switch module 2402 as a FET 2502 in FIG. 25A is for example purposes only. Any device having switching capabilities could be used to implement the switch module 2402, as will be apparent to persons skilled in the relevant art(s) based on the discussion contained herein.

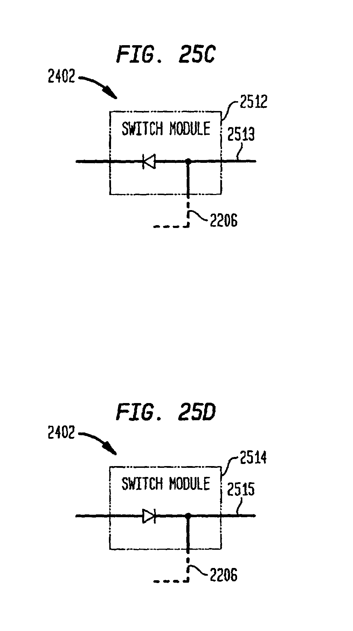

In FIG. 25C, the switch module 2402 is illustrated as a diode switch 2512, which operates as a two lead device when the energy transfer signal 2206 is coupled to the output 2513.

In FIG. 25D, the switch module 2402 is illustrated as a diode switch 2514, which operates as a two lead device when the energy transfer signal 2206 is coupled to the output 2515.

### 3.1.4 Example Implementations of the Storage Module

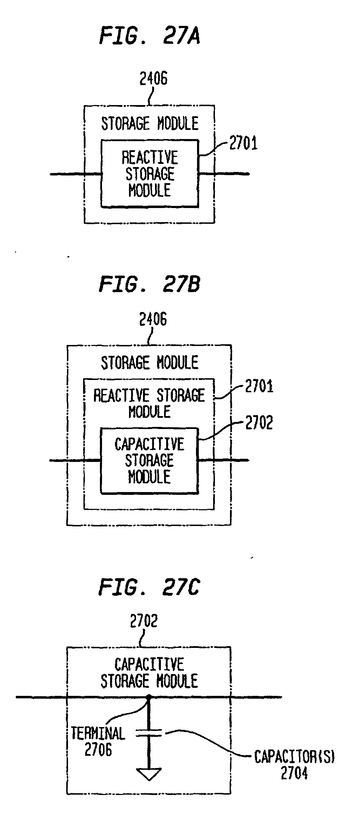

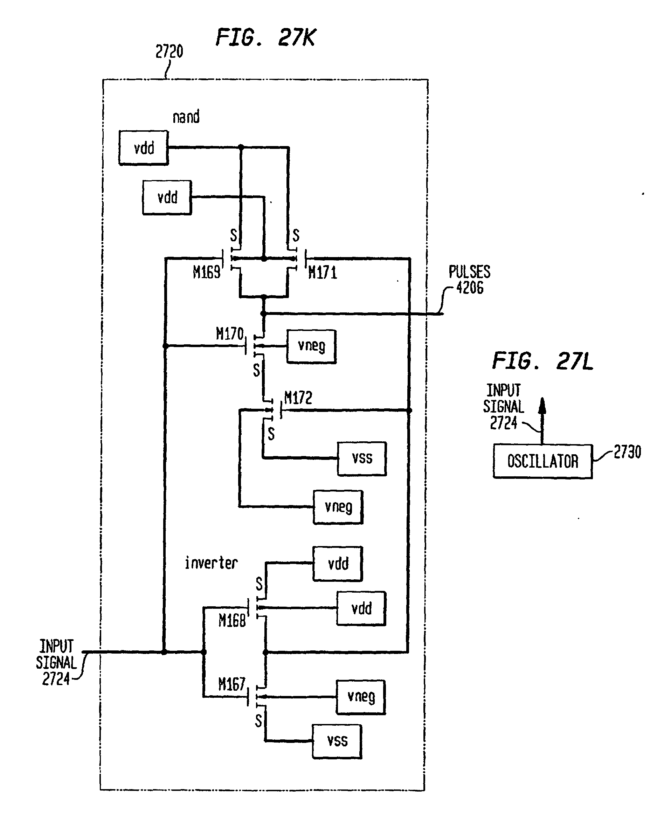

The storage module 2406 in FIGS. 24 and 26A stores non-negligible amounts of energy from the modulated carrier signal 2210. In an exemplary embodiment, the storage module 2406 is implemented with a reactive storage module 2701 in FIG. 27A, although the invention is not limited to this embodiment. A reactive storage module is a storage module that employs one or more reactive electrical components to store energy transferred from the modulated carrier signal 2210. Reactive electrical components include, but are not limited to, capacitors and inductors.

In an embodiment, the reactive storage module 2701 includes one or more capacitive storage elements, illustrated in FIG. 27B as a capacitive storage module 2702. In FIG. 27C, the capacitive storage module 2702 is illustrated as one or more capacitors illustrated generally as capacitor(s) 2704.

The goal of the storage module 2406 is to store non-negligible amounts of energy transferred from the modulated carrier signal 2210. Amplitude reproduction of the original, unaffected modulated carrier input signal is not necessarily important. In an energy transfer environment, the storage module preferably has the capacity to handle the power being transferred, and to allow it to accept a non-negligible amount ofpower during a non-negligible aperture period.

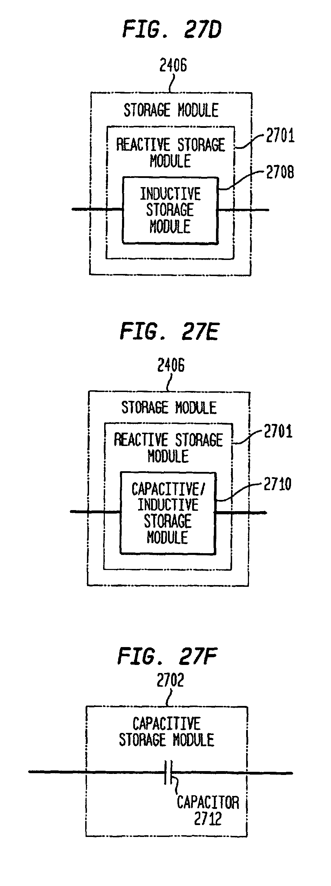

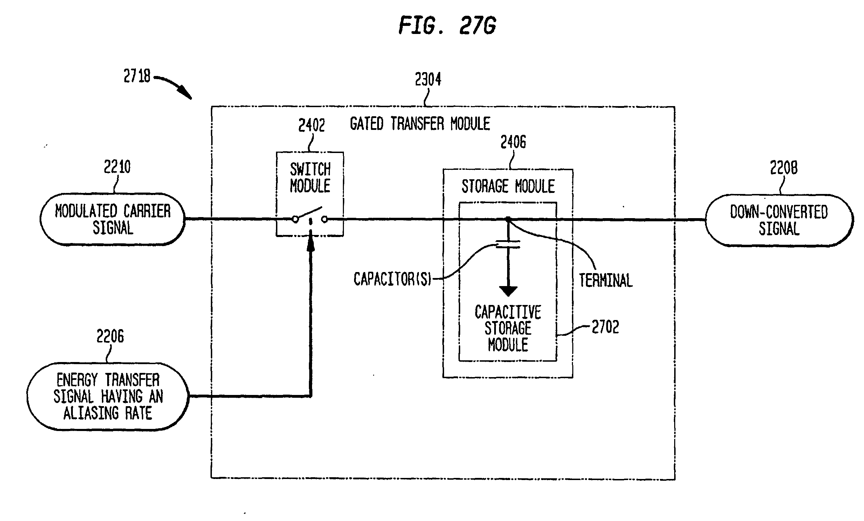

A terminal 2706 serves as an output of the capacitive storage module 2702. The capacitive storage module 2702 provides the stored energy at the terminal 2706. FIG. 27F illustrates the capacitive storage module 2702 as including a series capacitor 2712, which can be utilized in an inverted gated transfer system described below.

In an alternative embodiment, the storage module 2406 includes one or more inductive storage elements, illustrated in FIG. 27D as an inductive storage module 2708.

In an alternative embodiment, the storage module 2406 includes a combination of one or more capacitive storage elements and one or more inductive storage elements, illustrated in FIG. 27E as a capacitive/inductive storage module 2710.

FIG. 27G illustrates the gated transfer module 2304 as an integrated gated transfer system 2718 that can be implemented to down-convert the modulated carrier signal 2210 as illustrated in, and described with reference to FIGS. 42A-F.

### 3.1.5 Optional Energy Transfer Signal Module

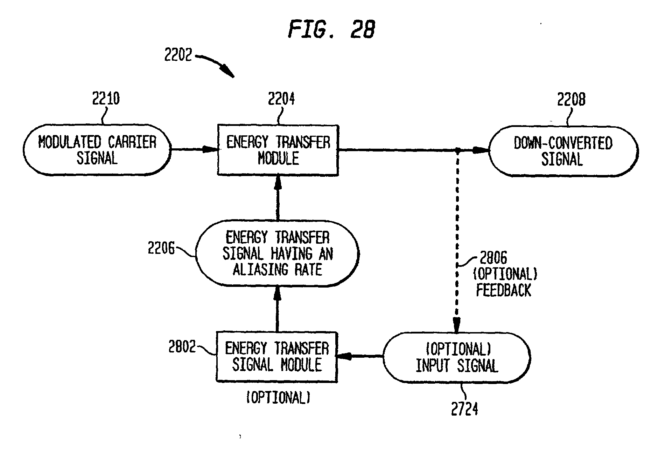

FIG. 28 illustrates the energy transfer system 2202 including an optional energy transfer signal module 2802, which can perform any of a variety of functions or combinations of functions including, but not limited to, generating the energy transfer signal 2206.

In an embodiment, the optional energy transfer signal module 2802 includes an aperture generator, an example of which is illustrated in FIG. 27J as an aperture generator 2720. The aperture generator 2720 generates non-negligible aperture pulses 4206 from an input signal 2724. The input signal 2724 can be any type of periodic signal, including, but not limited to, a sinusoid, a square wave, a saw-tooth wave, etc. Systems for generating the input signal 2724 are described below.

The width or aperture of the pulses 4206 is determined by delay through the branch 2722 of the aperture generator 2720. Generally, as the desired pulse width increases, the difficulty in meeting the requirements of the aperture generator 2720 decrease. In other words, to generate non-negligible aperture pulses for a given modulated carrier input frequency, the components utilized in the example aperture generator 2720 do not require as fast reaction times as those that are required in an under-sampling system operating with the same modulated carrier input frequency.

The example logic and implementation shown in the aperture generator 2720 are provided for illustrative purposes only, and are not limiting. The actual logic employed can take many forms. The example aperture generator 2720 includes an optional inverter 2728, which is shown for polarity consistency with other examples provided herein.

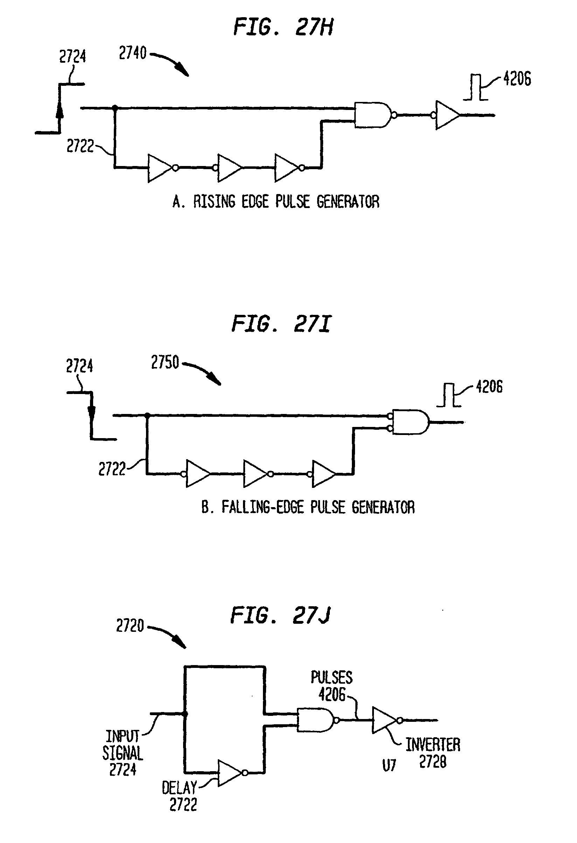

An example implementation of the aperture generator 2720 is illustrated in FIG. 27K. Additional examples of aperture generation logic are provided in FIGS. 27H and 27I. FIG. 27H illustrates a rising edge pulse generator 2740, which generates the pulses 4206 on rising edges of the input signal 2724. FIG. 27I illustrates a falling edge pulse generator 2750, which generates the pulses 4206 on falling edges of the input signal 2724. The rising edge pulse generator 2740 and the falling edge pulse generator 2750 are examples of the aperture generator 2720.

In an embodiment, the input signal 2724 is generated externally of the energy transfer signal module 2802, as illustrated in FIG. 28. Alternatively, the input signal 2724 is generated internally by the energy transfer signal module 2802. The input signal 2724 can be generated by an oscillator, as illustrated in FIG. 27L by an oscillator 2730. The oscillator 2730 can be internal to the energy transfer signal module 2802 or external to the energy transfer signal module 2802. The oscillator 2730 can be external to the energy transfer system 2202. The output of the oscillator 2730 may be any periodic waveform.

The type of down-conversion performed by the energy transfer system 2202 illustrated in FIG. 28 depends upon the aliasing rate of the energy transfer signal 2206, which is determined by the frequency of the pulses 4206. The frequency of the pulses 4206 is determined by the frequency of the input signal 2724. For example, when the frequency of the input signal 2724 is substantially equal to a harmonic or a sub-harmonic of a difference frequency, the modulated carrier signal 2210 is down-converted to the intermediate signal 2208.

The optional energy transfer signal module 2802 can be implemented in hardware, software, firmware, or any combination thereof.

### 3.2 The Energy Transfer System as an Inverted Gated Transfer System

FIG. 23B illustrates the exemplary inverted gated transfer system 2306, which is an exemplary implementation of the energy transfer system 2202. The inverted gated transfer system 2306 includes an inverted gated transfer module 2308, which receives the modulated carrier signal 2210 and the energy transfer signal 2206. The energy transfer signal 2206 includes a train of energy transfer pulses having non-negligible apertures that tend away from zero time in duration. The energy transfer pulses repeat at an aliasing rate $F_{AR}$. The inverted gated transfer module 2308 transfers energy from the modulated carrier signal 2210 at the aliasing rate of the energy transfer signal 2206, as described in the sections above with respect to the flowchart 1207 in FIG. 12. The inverted gated transfer module 2308 outputs the down-converted signal 2208, which includes non-negligible amounts of energy transferred from the modulated carrier signal 2210.

### 3.2.1 The Inverted Gated Transfer System as a Switch Module and a Storage Module

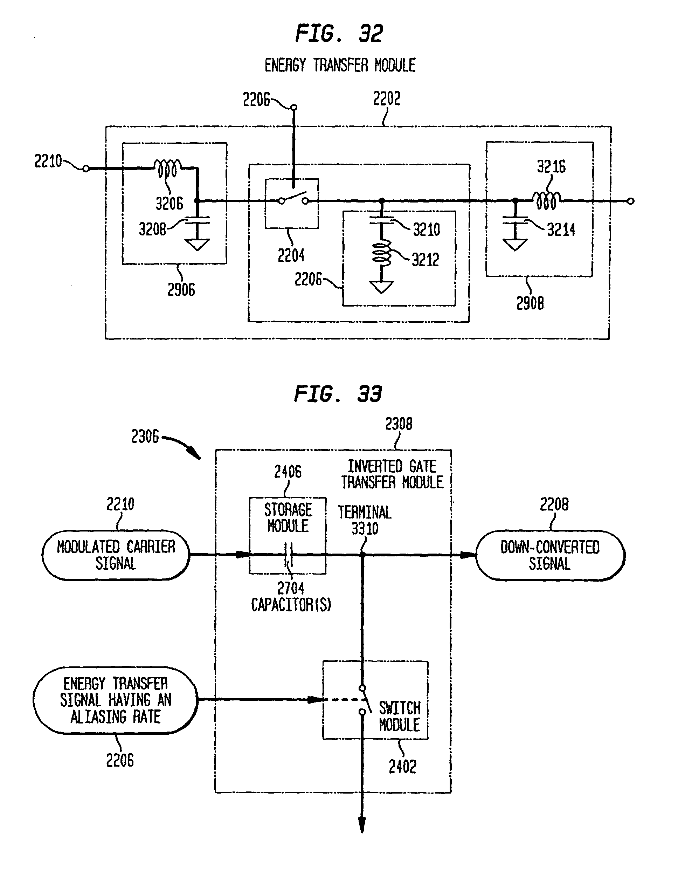

FIG. 33 illustrates an example embodiment of the inverted gated transfer module 2308 as including the switch module 2402 and the storage module 2406. The switch module 2402 and the storage module 2406 transfer energy from the modulated carrier signal 2210 to down-convert it in the manner shown in the operational flowchart 1207 in FIG. 12.

The switch module 2402 can be implemented as described above with reference to FIGS. 25A-D. The storage module 2406 can be implemented as described above with reference to FIGS. 27A-F.

In the illustrated embodiment, the storage module 2206 includes one or more capacitors 3308. The capacitor (s) 2704 are selected to pass higher frequency components of the modulated carrier signal 2210 through to a terminal 3310, regardless of the state of the switch module 2402. The capacitor 2704 stores non-negligible amounts of energy from the modulated carrier signal 2210. Thereafter, the signal at the terminal 3310 is off-set by an amount related to the energy stored in the capacitor 2704.

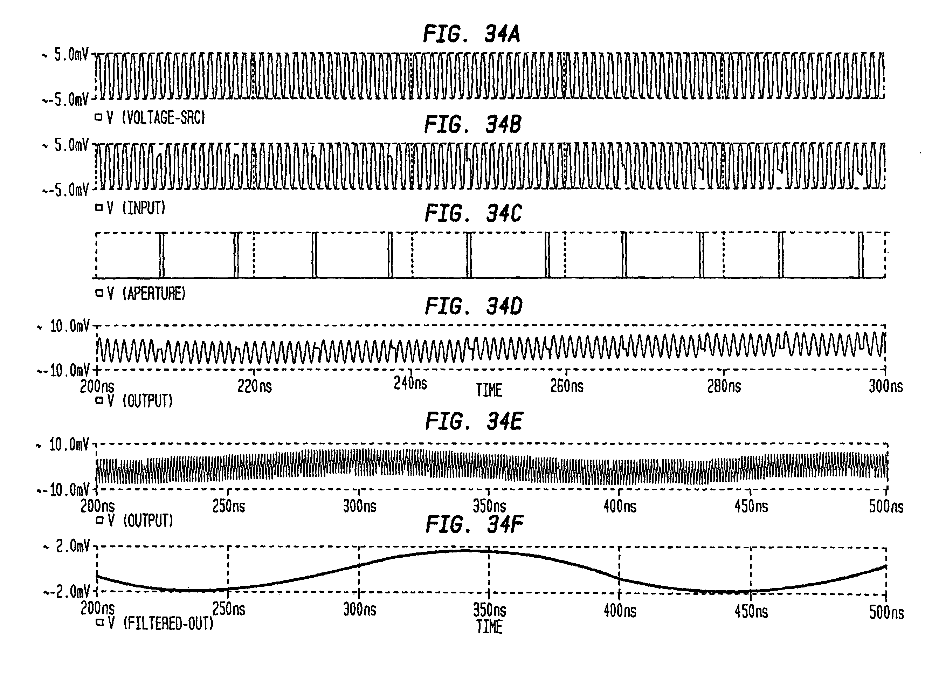

Operation of the inverted gated transfer system 2306 illustrated in FIG. 33, is illustrated in FIGS. 34A-F. FIG. 34A illustrates the modulated carrier signal 2210. FIG. 34B illustrates the modulated carrier signal 2210 after transferring energy from it. FIG. 34C illustrates the energy transfer signal 2206, which includes a train of energy transfer pulses having non-negligible apertures.

FIG. 34D illustrates an example down-converted signal 2208. FIG. 34E illustrates the down-converted signal 2208 on a compressed time scale. Since the storage module 2406 is a series element, the higher frequencies (e.g., RF) of the modulated carrier signal 2210 can be seen on the down-converted signal. This can be filtered as illustrated in FIG. 34F.

The inverted gated transfer system 2306 illustrated in FIG. 33 can be used to down-convert any type of modulated carrier signal, including modulated carrier signals and unmodulated carrier signals.


### 3.3 Rail to Rail Operation for Improved Dynamic Range


### 3.3.1 Introduction

FIG. 68A illustrates the energy transfer module 2204 as a universal frequency translator ("UFT") based energy transfer module 6800. The energy transfer module 6800 includes a universal frequency translator ("UFT") module 6804 and the storage module 2406. As shown in FIG. 68A, UFT module 6804 is implemented as a n-channel FET 6806, and storage module 2406 is implemented as a capacitor 2704, although the invention is not limited to this embodiment.

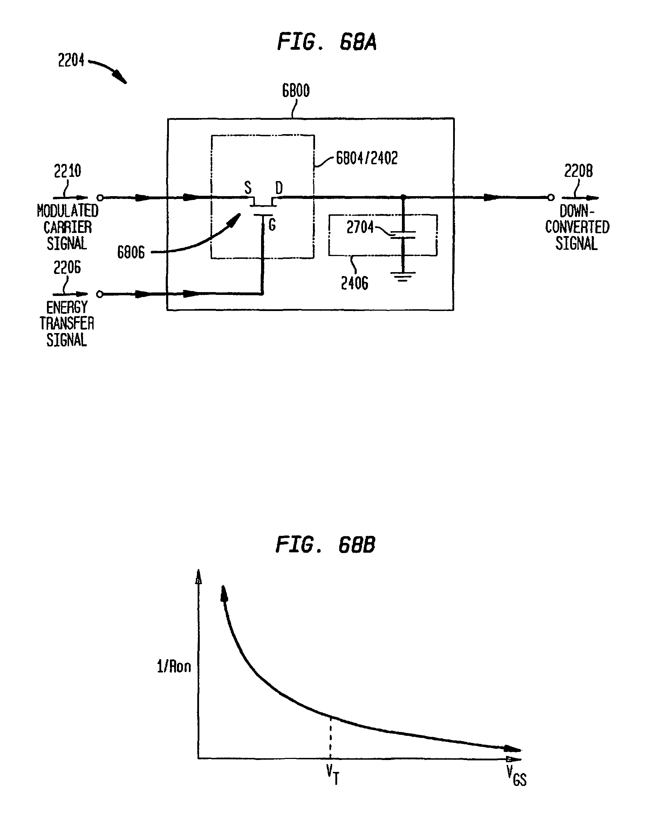

FET 6806 receives the modulated carrier signal 2210 and the energy transfer signal 2206. The energy transfer signal 2206 includes a train of pulses having non-negligible apertures that repeat at an aliasing rate. The aliasing rate may be harmonic or sub-harmonic ofthe modulated carrier signal 2210. FET 6806 samples modulated carrier signal 2210 at the aliasing rate of energy transfer signal 2206 to generate down-converted signal 2208. In one embodiment, energy transfer signal 2206 controls the gate of FET 6806 so that FET 6806 conducts (or turns on) when the FET gate-to-source voltage ($V_{GS}$) exceeds a threshold voltage ($V_T$). When the FET 6806 conducts, a channel is created from source to drain of FET 6806 so that charge is transferred from the modulated carrier signal 2210 to the capacitor 2704. More specifically, the FET 6806 conductance (1/R) vs $V_{GS}$ is a continuous function that reaches an acceptable level at $V_T$, as illustrated in FIG. 68B. The charge stored by capacitor 2704 during successive samples forms down-converted signal 2208.

As stated above, n-channel FET 6806 conducts when $V_{GS}$ exceeds the threshold voltage $V_T$. As shown in FIG. 68A, the gate voltage of FET 6806 is determined by energy transfer signal 2206, and the source voltage is determined by the input modulated carrier signal 2210. Energy transfer signal 2206 is preferably a plurality of pulses whose amplitude is predictable and set by a system designer. However, the modulated carrier signal 2210 is typically received over a communications medium by a coupling device (such as antenna). Therefore, the amplitude of modulated carrier signal 2210 may be variable and dependent on a number of factors including the strength of the transmitted signal, and the attenuation of the communications medium. Thus, the source voltage on FET 6806 is not entirely predictable and will affect $V_{GS}$ and the conductance of FET 6806, accordingly.

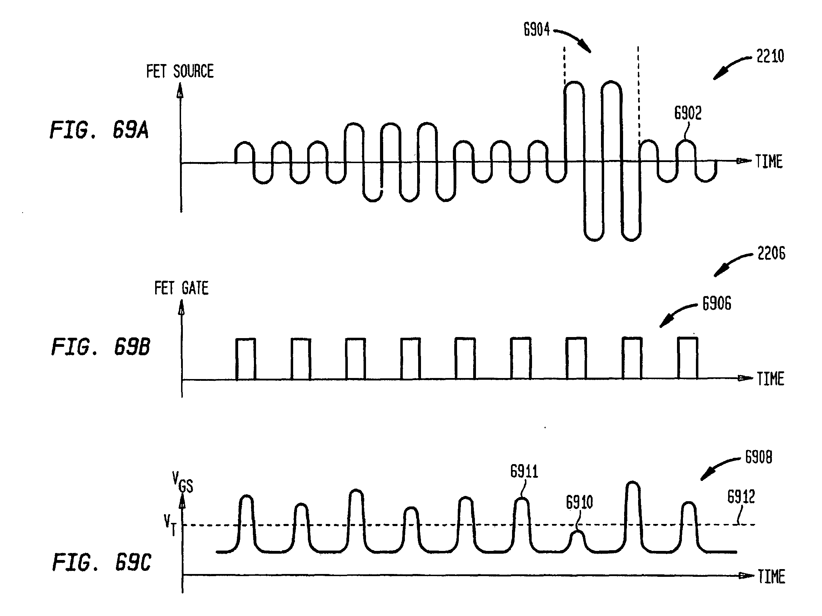

For example, FIG. 69A illustrates an modulated carrier signal 2210, that appears on the source of FET 6806. The modulated carrier signal 2210 has a section 6904 with a relatively high amplitude as shown. FIG. 69B illustrates the energy transfer signal 6906 as an example of energy transfer signal 2206 that controls the gate of FET 6806. FIG. 69C illustrates $V_{GS}$ 6908, which is the difference between the gate and source voltages shown in FIGs. 69B and 69A, respectively. FET 6806 has an inherent threshold voltage $V_T$ 6912 shown in FIG. 69C, above which FET 6806 conducts. It is preferred that $V_{GS} > V_T$ during each pulse of energy transfer signal 6906, so that FET 6806 conducts and charge is transferred from the modulated carrier signal 2210 to the capacitor 2704 during each pulse of energy transfer signal 6906. As shown in FIG. 69C, the high amplitude section 6904 of modulated carrier signal 2210 causes a $V_{GS}$ pulse 6910 that does exceed the $V_T$ 6912, and therefore FET 6806 will not fully conduct as is desired. Therefore, the resulting sample ofmodulated carrier signal 2210 may be degraded, which potentially negatively affects the down-converted signal 2208.

As stated earlier, the conductance ofET 6806 vs $V_{GS}$ is mathematically continuous and is not a hard cutoff. In other words, FET 6806 will marginally conduct when controlled by pulse 6910, even though pulse 6910 is below $V_T$ 6912. However, the insertion loss of FET 6806 will be increased when compared with a $V_{GS}$ pulse 6911, which is greater than $V_T$ 6912. The performance reduction caused by a large amplitude input signal is often referred to as clipping or compression. Clipping causes distortion in the down-converted signal 2208, which adversely affects the faithful down-conversion of input modulated carrier signal 2210. Dynamic range is a figure of merit associated with the range of input signals that can be faithfully down-converted without introducing distortion in the down-converted signal. The higher the dynamic range of a down-conversion circuit, the larger the input signals that can down-converted without introducing distortion in the down-converted signal.

### 3.3.2 Complementary UFT Structure for Improved Dynamic Range

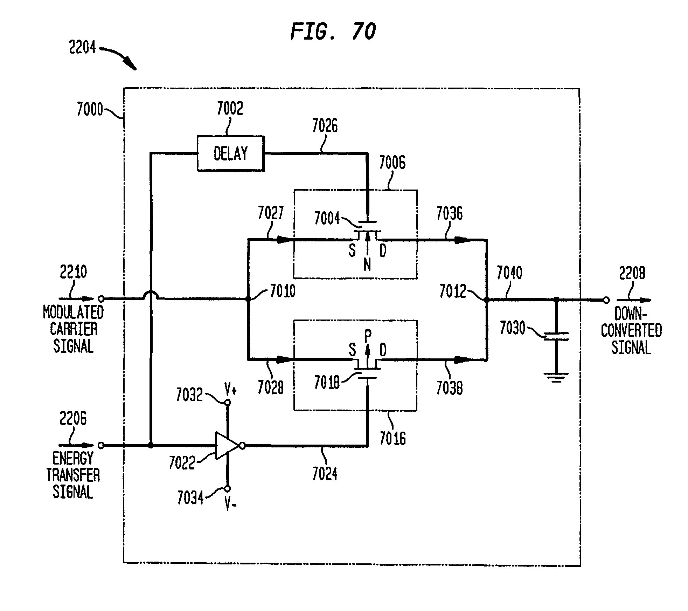

FIG. 70 illustrates the energy transfer module 2204 as a complementary UFT energy transfer module 7000. Energy transfer module 7000 is able to down-convert input signals over a larger amplitude range as compared to energy transfer module 6800, and therefore energy transfer module 7000 has an improved dynamic range when compared with energy transfer module 6800. The dynamic range improvement occurs because energy transfer module 7000 includes two UFT modules that are implemented with complementary FET devices. In other words, one FET is n-channel, and the other FET is p-channel, so that at least one FET is always conducting during an energy transfer signal pulse, assuming the input signal does not exceed the power supply constraints. Energy transfer module 7000 includes: delay 7002; UFT modules 7006, 7016; nodes 7010, 7012; and inverter 7022. Inverter 7022 is tied to voltage supplies $V_+$ 7032 and $V_-$ 7034. UFT module 7006 comprises n-channel FET 7004, and UFT module 7016 comprises p-channel FET 7018.

As stated, energy transfer module 7000 operates two complementary FETs to extend the dynamic range and reduce any distortion effects. This requires that two complementary energy transfer signals 7024, 7026 be generated from energy transfer signal 2206 to control the sampling by FETs 7018, 7004, respectively. To do so, inverter 7022 receives and inverts energy transfer signal 2206 to generate energy transfer signal 7024 that controls p-channel FET 7018. Delay 7002 delays energy transfer signal 2206 to generate energy transfer signal 7026, where the amount of time delay is approximately equivalent to that associated with inverter 7022. As such, energy transfer signals 7024 and 7026 are approximately complementary in amplitude.

Node 7010 receives modulated carrier signal 2210, and couples modulated carrier signals 7027, 7028 to the sources of n-channel FET 7004 and p-channel FET 7018, respectively, where modulated carrier signals 7027, 7028 are substantially replicas of modulated carrier signal 2210. N-channel FET 7004 samples modulated carrier signal 7027 as controlled by energy transfer signal 7026, and produces samples 7036 at the drain of FET 7004. Likewise, p-channel FET 7018 samples modulated carrier signal 7028 as controlled by energy transfer signal 7024, and produces samples 7038 at the drain ofFET 7018. Node 7012 combines the resulting charge samples into charge samples 7040, which are stored by capacitor 7030. The charge stored by capacitor 7030 during successive samples forms down-converted signal 2208. Energy transfer module 7000 offers improved dynamic range over energy transfer module 6800 because n-channel FET 7004 and p-channel FET 7018 are complementary devices. Therefore, if one device is cutoff because of a large input modulated carrier signal 2210, the other device will conduct and sample the input signal, as long as the input signal is between the power supply voltages $V_+$ 7032 and $V_-$ 7034. This is often referred to as rail-to-rail operation as will be understood by those skilled in the arts.

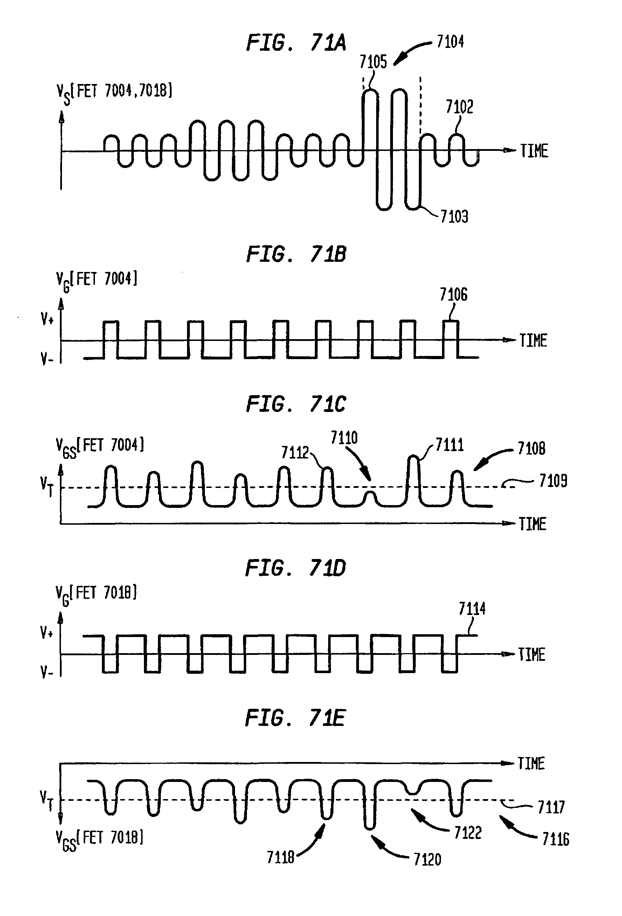

For example, FIG. 71A illustrates modulated carrier signal 7102 which is an example of modulated carrier signals 7027, 7028 that are coupled to the sources ofn-channel FET 7004 and p-channel FET 7018, respectively. As shown, modulated carrier signal 7102 has a section 7104 with a relatively high amplitude including pulses 7103, 7105. FIG. 71B illustrates an energy transfer signal 7106 as an example of the energy transfer signal 7026 that controls the gate ofn-channel FET 7004. Likewise for the p-channel FET, FIG. 71D illustrates an energy transfer signal 7114 as an example of the energy transfer signal 7024 that controls the gate of p-channel FET 7018. Energy transfer signal 7114 is the amplitude complement of energy transfer signal 2724.

FIG. 71C illustrates $V_{GS}$ 7108, which is the difference between the gate and source voltages on n-channel FET 7004 that are depicted in FIGs. 71B and 71A, respectively. FIG. 71C also illustrates the inherent threshold voltage $V_T$ 7109 for FET 7004, above which FET 7004 conducts. Likewise for the p-channel FET, FIG. 71E illustrates $V_{GS}$ 7116, which is the difference between the gate and source voltages for p-channel FET 7018 that are depicted in FIGs. 71D and 71A, respectively. FIG. 71E also illustrates the inherent threshold voltage $V_T$ 7117 for FET 7018, below which FET 7018 conducts.

As stated, n-channel FET 7004 conducts when $V_{GS}$ 7108 exceeds $V_T$ 7109, and p-channel FET 7018 conducts when $V_{GS}$ 7116 drops below $V_T$ 7117. As illustrated by FIG. 71C, n-channel FET 7004 conducts over the range of modulated carrier signal 7102 depicted in FIG. 71A, except for the modulated carrier signal pulse 7105 that results in a corresponding $V_{GS}$ pulse 7110 (FIG. 71C) that does not exceed $V_T$ 7109. However, p-channel FET 7018 does conduct because the same modulated carrier signal pulse 7105 causes a $V_{GS}$ pulse 7120 (FIG. 71E) that drops well below that of $V_T$ 7117 for the p-channel FET. Therefore, the sample of the modulated carrier signal 7102 is properly taken by p-channel FET 7018, and no distortion is introduced in down-converted signal 2208. Similarly, modulated carrier signal pulse 7103 results in $V_{GS}$ pulse 7122 (FIG. 71E) that is inadequate for the p-channel FET 7018 to fully conduct. However, n-channel FET 7004 does fully conduct because the same modulated carrier signal pulse 7103 results in a $V_{GS}$ 7111 (FIG. 71C) that greatly exceeds $V_T$ 7109.

As illustrated above, energy transfer module 7000 offers an improvement in dynamic range over energy transfer module 6800 because of the complimentary FET structure. Any input signal that is within the power supply voltages $V_+$ 7032 and $V_-$ 7034 will cause either FET 7004 or FET 7018 to conduct, or cause both FETs to conduct, as is demonstrated by FIGs. 71A-71E. This occurs because any input signal that produces a $V_{GS}$ that cuts-off the n-channel FET 7004 will push the p-channel FET 7018 into conduction. Likewise, any input signal that cuts-off the p-channel FET 7018 will push the n-channel FET 7004 into conduction, and therefore prevent any distortion of the down-converted output signal.

### 3.3.3 Biased Configurations

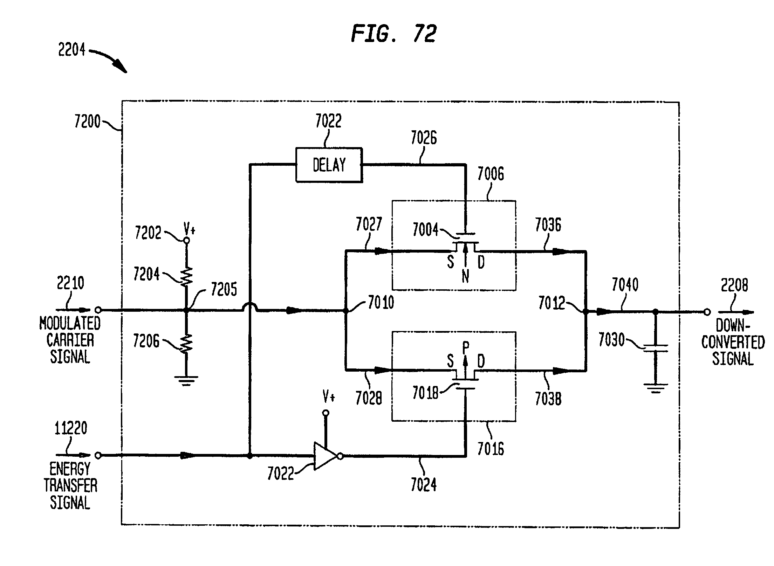

FIG. 72 illustrates the energy transfer module 2204 as an energy transfer module 7200, which is an alternate embodiment of the energy transfer module 7000. The energy transfer module 7200 includes positive voltage supply ($V_+$) 7202, resistors 7204, 7206, and the elements in energy transfer module 7000. $V_+$ 7202 and resistors 7204,11406 produce a positive DC voltage at node 7205. This allows node 7205 to drive a coupled circuit that requires a positive voltage supply, and enables unipolar supply operation of energy transfer module 7200. The positive supply voltage also has the effect of raising the DC level of the input modulated carrier signal 2210. As such, any input signal that is within the power supply voltages $V_+$ 7202 and ground will cause either FET 7004 or FET 7018 to conduct, or cause both FETs to conduct, as will be understood by those skilled in the arts based on the discussion herein.

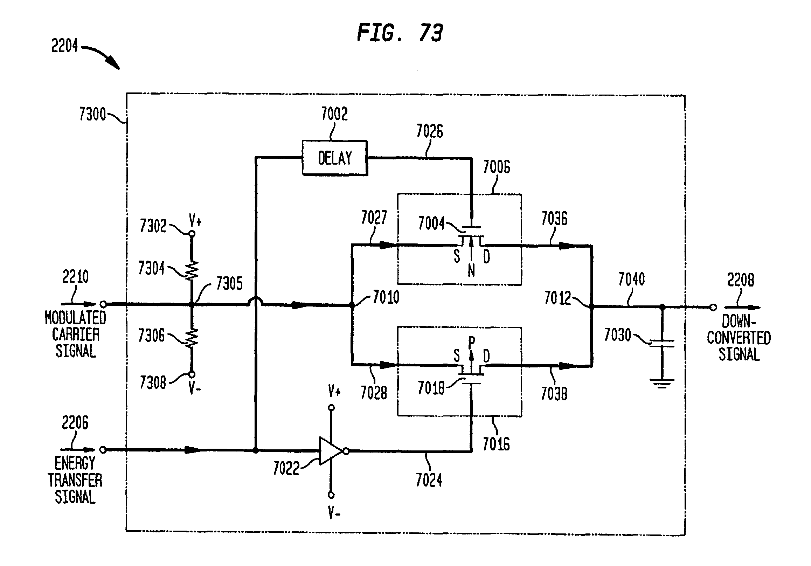

FIG. 73 illustrates the energy transfer module 2204 as an energy transfer module 7300, which is an alternate biased configuration of energy transfer module 7000. Energy transfer module 7300 includes positive voltage supply 7302, negative voltage supply 7308, resistors 7304, 7306, and the elements in energy transfer module 7000. The use of both a positive and negative voltage supply allows for node 7305 to be biased anywhere between $V_+$ 7302 and $V_-$ 7308. This allows node 7305 to drive a coupled circuit that requires either a positive or negative supply voltage. Furthermore, any input signal that is within the power supply voltages $V_+$ 7302 and $V_-$ 7308 will cause either FET 7004 or FET 7018 to conduct, or cause both FETs to conduct, as will be understood by those skilled in the arts based on the discussion herein.

### 3.3.4 Simulation Examples

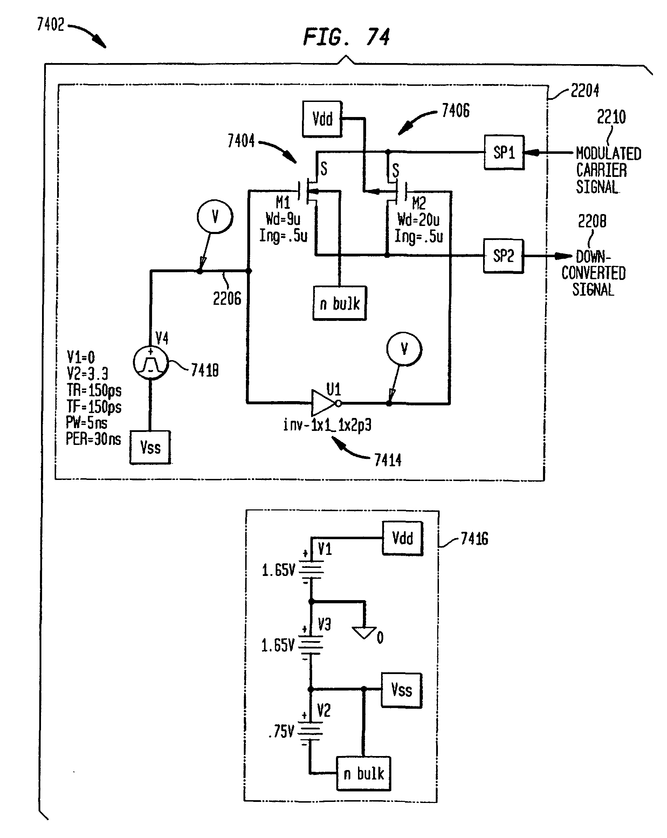

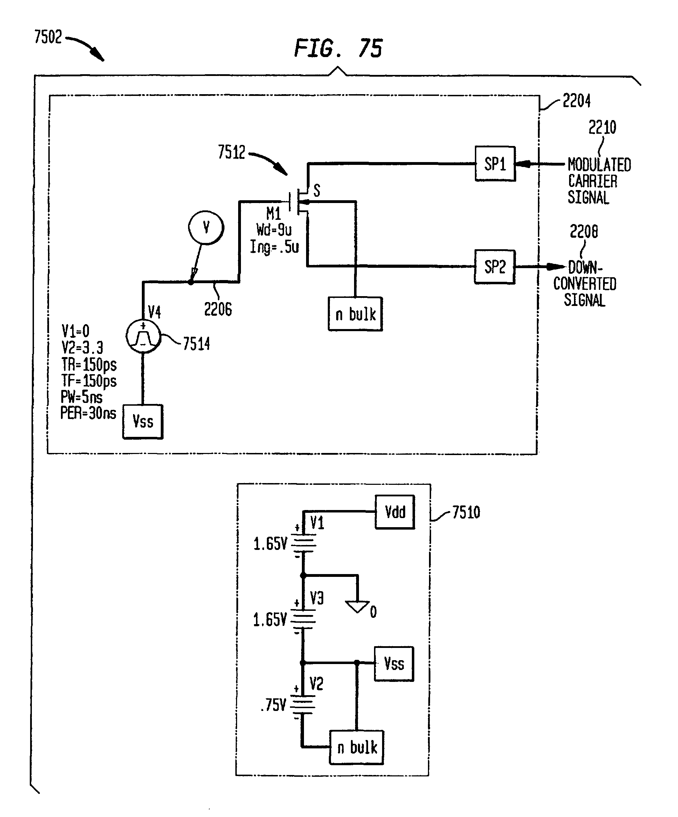

As stated, an energy transfer module with a complementary FET structure offers improved dynamic range when compared with a single (or unipolar) FET configuration. This is further illustrated by comparing the signal waveforms associated energy transfer system7402 (of FIG. 74) which has a complementary FET structure, with that of energy transfer system 7502 (of FIG. 75) which has a single (or unipolar) FET structure. Energy transfer system 7402 and energy transfer system 7502 are example implementations of the energy transfer system 2202.

Energy transfer system 7402 (FIG. 74) down-converts modulated carrier signal 2210 using energy transfer signal 2206 to generate down-converted signal 2208. Within the energy transfer module 7402, the energy transfer module 2204 has a complementary FET structure and includes n-channel FET 7404, p-channel FET 7406, inverter 7414, and energy transfer signal generator 7418. Energy transfer module 2204 is biased by supply circuit 7416 as is shown. Energy transfer system 7502 (FIG. 75) down-converts modulated carrier signal 2210 using energy transfer signal 2206 to generate down-converted signal 2208. Within the energy transfer system 7502, the energy transfer module 2204 includes a single FET structure comprising n-channel FET 7512 and an energy transfer signal generator 7514, and is biased using voltage supply circuit 7510.

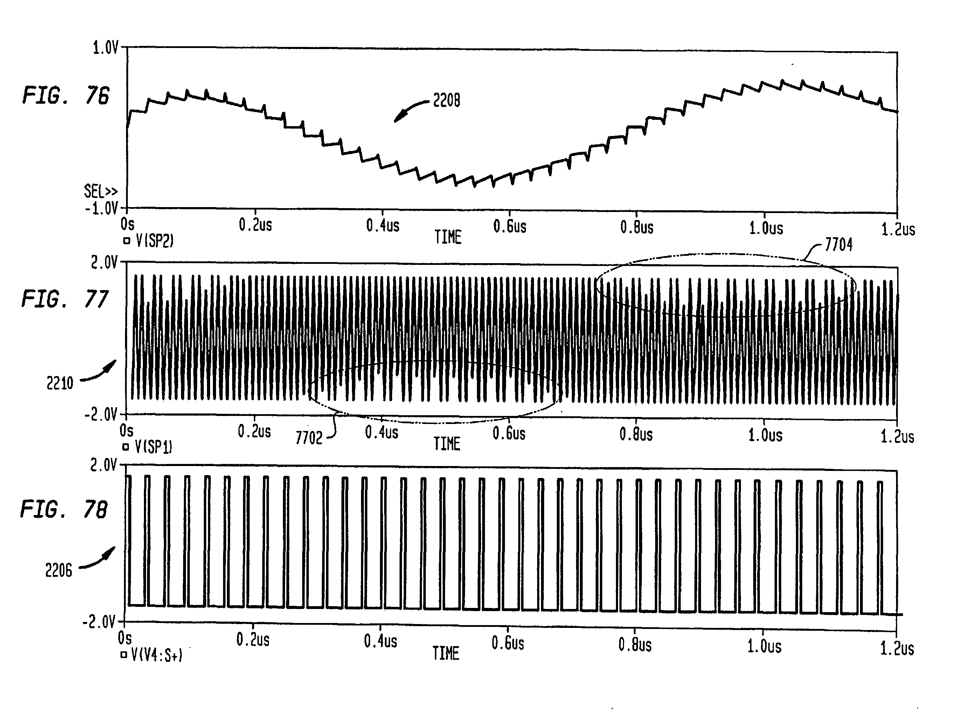

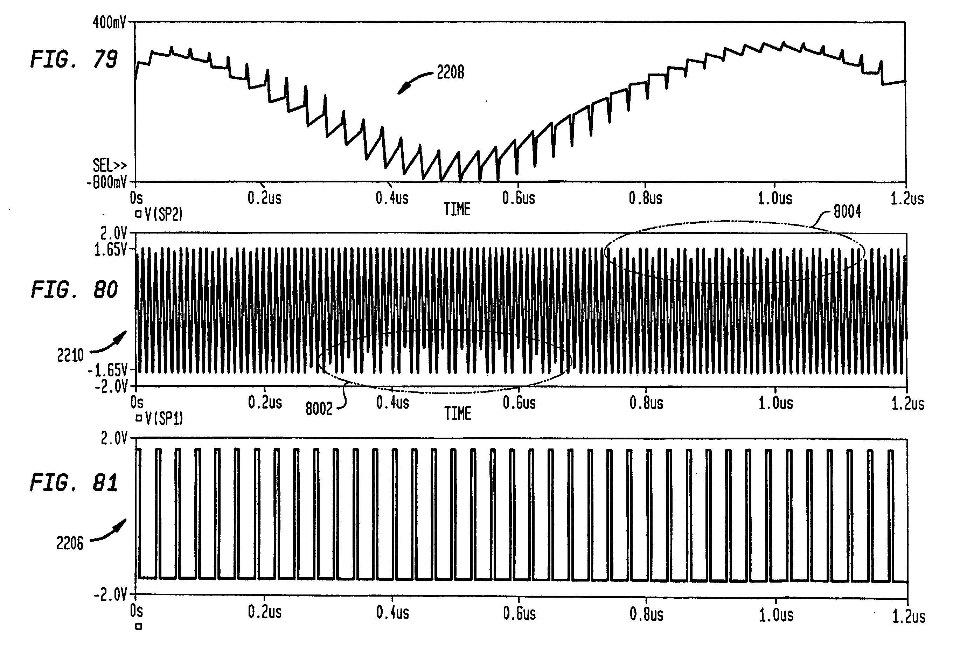

FIGS. 76-78 are signal waveforms that correspond to energy transfer system 7402, and FIGs. 79-81 are signal waveforms that correspond to energy transfer system 7502. FIGS. 76, 79 are down-converted signals 2208, for energy transfer systems 7404 and 7502, respectively. FIGS. 77, 80 are the sampled modulated carrier signal 2210, for energy transfer systems 7404 and 7502, respectively. FIGS. 78, 81 are the energy transfer signals 2206, for energy transfer systems 7404 and 7502, respectively. The energy transfer signals 2206 for energy transfer systems 7404 and 7502 are identical in order that a proper comparison between systems 7402 and 7502 can be made.

Modulated carrier signals 2210 in FIGS. 77, 80, are relatively large input signals that approach the power supply voltages of $\pm$ 1.65 volts. In FIG. 77, sections 7702 and 7704 of signal 2210 depict energy transfer from modulated carrier signal 2210 to down-converted signal 2208 during energy transfer pulses 2206 by energy transfer module 7402. More specifically, section 7702 depicts energy transfer near the -1.65v supply, and section 7704 depicts energy transfer near the +1.65v supply. The symmetrical quality of the energy transfer near the voltage supply rails indicates that at least one of complementary FETs 7404, 7406 are appropriately sampling the modulated carrier signal during each of the energy transfer pulses 2206. This results in a down-converted signal 2208 that has minimal high frequency noise, and is centered between -1.0v and 1.0v (i.e. has negligible DC voltage component).

Similarly in FIG. 80, sections 8002 and 8004 illustrate the energy transfer from modulated carrier signal 2210 to down-converted signal 2208 by energy transfer system 7502 (single FET configuration). More specifically, section 8002 depicts energy transfer near the - 1.65v supply, and section 8004 depicts energy transfernearthe +1.65v supply. Bycomparing sections 8002, 8004 with sections 7702, 7704 of FIG. 77, it is clear that the energy transfer in sections 8002, 8004 is not as symmetrical near the power supply rails as that of sections 7702, 7704. This is evidence that the modulated carrier signal 2210 in FIG. 75 is partially pinching off single FET 7512 over part of the signal 2210 trace. This results in a down-converted signal 2208 that has more high frequency noise when compared to down-converted signal 2208 in FIG. 76, and has a substantial negative DC voltage component.

In summary, down-converted signal 2208 in FIG. 79 reflects distortion introduced by a relatively large modulated carrier signal that is pinching-off the single FET 7512 in energy transfer system 7502. Down-converted signal 2208 in FIG. 76 that is produced by energy transfer system 7402 is relatively distortion free. This occurs because the complementary FET configuration in energy transfer system 7402 is able to handle input signals with large amplitudes without introducing distortion in the down-converted signal 2208. Therefore, the complementary FET configuration in the energy transfer system 7402 offers improved dynamic range when compared with the single FET configuration of the energy transfer system 7502.

### 3.4 Optimized Switch Structures

### 3.4.1 Splitter in CMOS

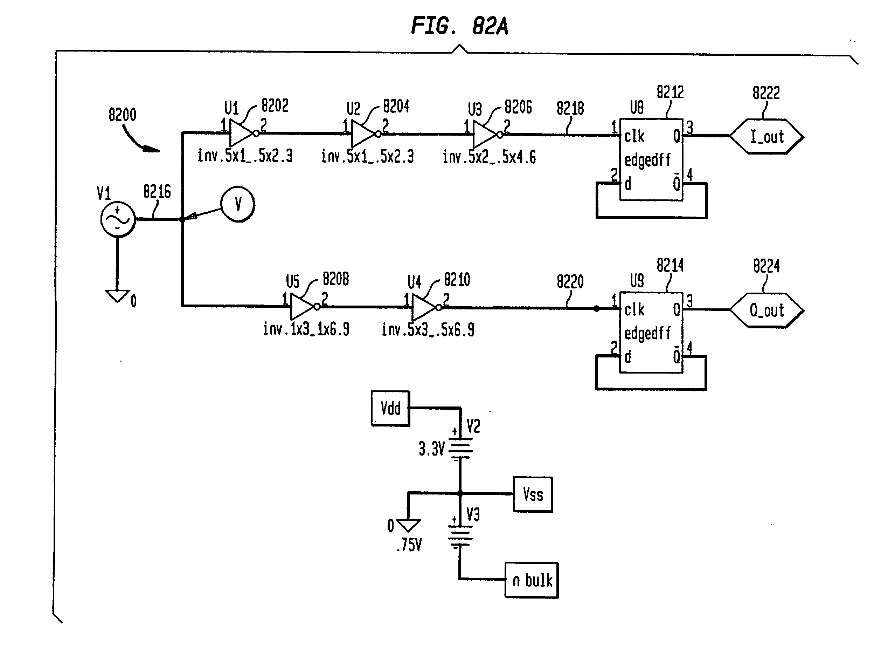

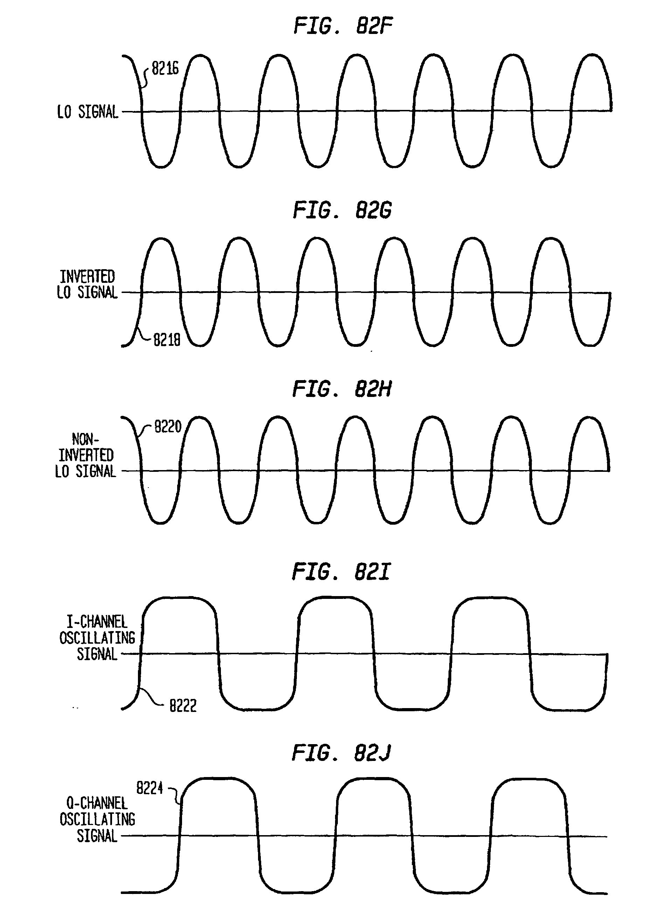

FIG. 82A illustrates an embodiment of a splitter circuit 8200 implemented in CMOS. In an embodiment, splitter circuit 8200 is used to split a local oscillator (LO) signal 8216 into two oscillating signals 8222, 8224 that are approximately 90° out of phase. The first oscillating signal 8222 is called the I-channel oscillating signal. The second oscillating signal 8224 is called the Q-channel oscillating signal. The Q-channel oscillating signal 8224 lags the phase of the I-channel oscillating signal 8222 by approximately 90°. Splitter circuit 8200 includes a first I-channel inverter 8202, a second I-channel inverter 8204, a third I-channel inverter 8206, a first Q-channel inverter 8208, a second Q-channel inverter 8210, an I-channel flip-flop 8212, and a Q-channel flip-flop 8214.

FIGS. 82F-J are example waveforms used to illustrate signal relationships of splitter circuit 8200. The waveforms shown in FIGS. 82F-J reflect ideal delay times through splitter circuit 8200 components. LO signal 8216 is shown in FIG. 82F. First, second, and third I-channel inverters 8202, 8204, and 8206 invert LO signal 8216 three times, outputting inverted LO signal 8218, as shown in FIG. 82G. First and second Q-channel inverters 8208 and 8210 invert LO signal 8216 twice, outputting non-inverted LO signal 8220, as shown in FIG. 82H. The delay through first, second, and third I-channel inverters 8202, 8204, and 8206 is substantially equal to that through first and second Q-channel inverters 8208 and 8210, so that inverted LO signal 8218 and non-inverted LO signal 8220 are approximately 180° out of phase. The operating characteristics of the inverters may be tailored to achieve the proper delay amounts, as would be understood by persons skilled in the relevant art(s).

I-channel flip-flop 8212 inputs inverted LO signal 8218. Q-channel flip-flop 8214 inputs non-inverted LO signal 8220. In the current embodiment, I-channel flip-flop 8212 and Q-channel flip-flop 8214 are edge-triggered flip-flops. When either flip-flop receives a rising edge on its input, the flip-flop output changes state. Hence, I-channel flip-flop 8212 and Q-channel flip-flop 8214 each output signals that are approximately half of the input signal frequency. Additionally, as would be recognized by persons skilled in the relevant art(s), because the inputs to I-channel flip-flop 8212 and Q-channel flip-flop 8214 are approximately 180° out of phase, their resulting outputs are signals that are approximately 90° out of phase. I-channel flip-flop 8212 outputs I-channel oscillating signal 8222, as shown in FIG. 82I. Q-channel flip-flop 8214 outputs Q-channel oscillating signal 8224, as shown in FIG. 82J. Q-channel oscillating signal 8224 lags the phase of I-channel oscillating signal 8222 by 90°, also as shown in a comparison of FIGS. 82I and 82J.

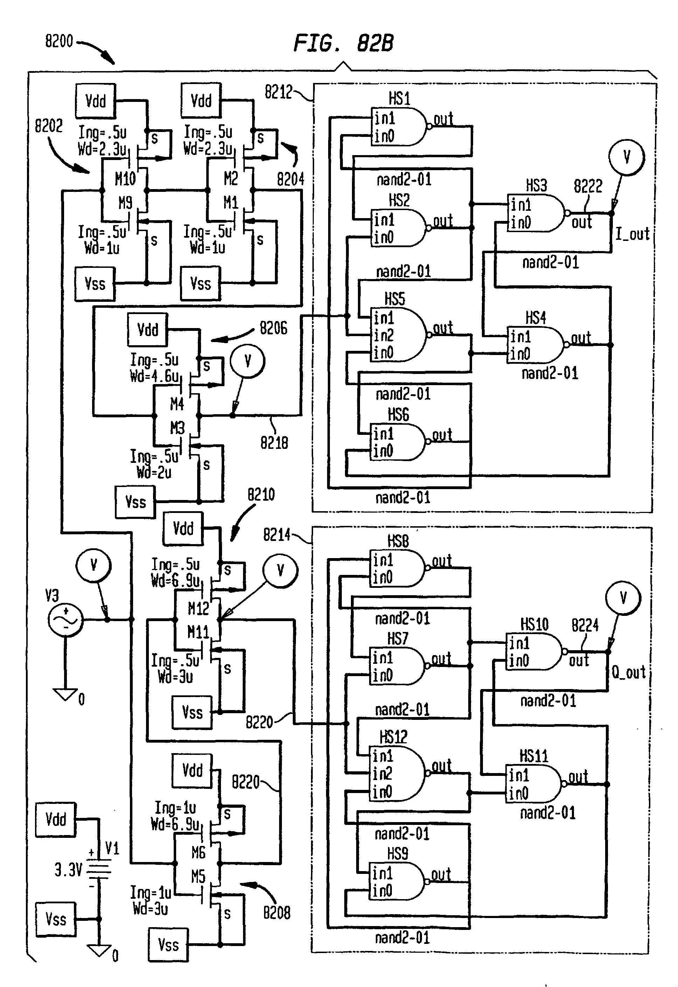

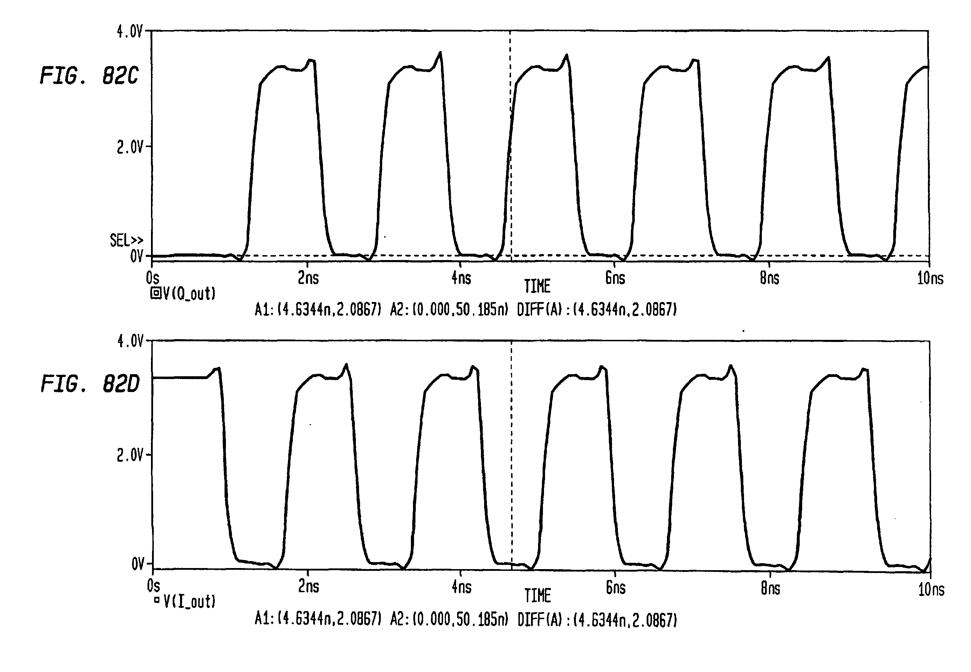

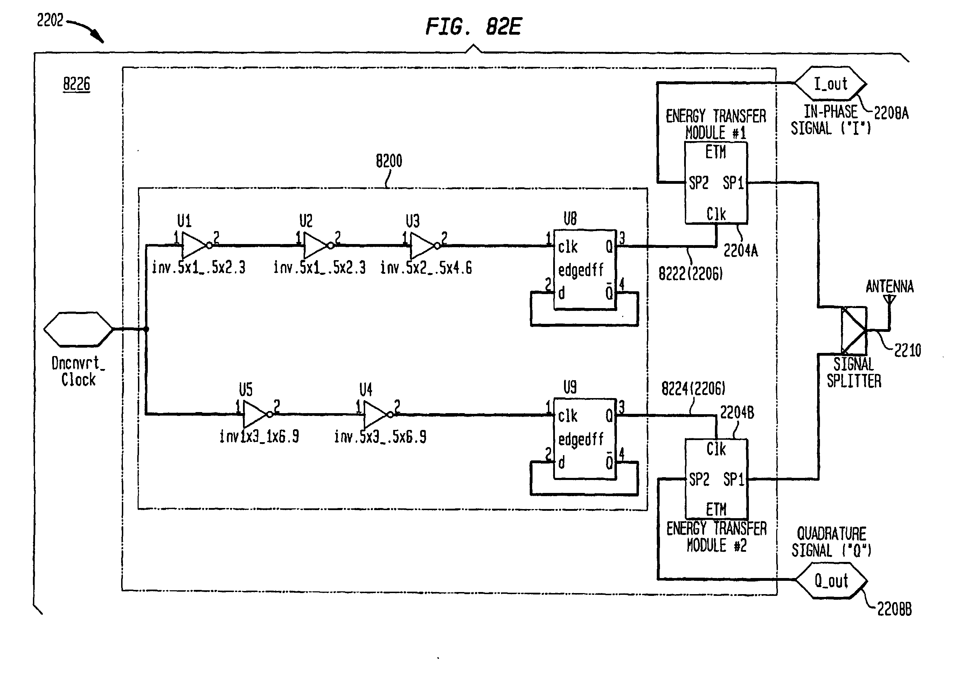

FIG. 82B illustrates a more detailed circuit embodiment of the splitter circuit 8200 of FIG. 82. The circuit blocks of FIG. 82B that are similar to those of FIG. 82A are indicated by corresponding reference numbers. FIGS. 82C-D show example output waveforms relating to the splitter circuit 8200 of FIG. 82B. FIG. 82C shows I-channel oscillating signal 8222. FIG. 82D shows Q-channel oscillating signal 8224. As is indicated by a comparison of FIGS. 82C and 82D, the waveform of Q-channel oscillating signal 8224 of FIG. 82D lags the waveform of I-channel oscillating signal 8222 of FIG. 82C by approximately 90°.

It should be understood that the illustration of the splitter circuit 8200 in FIGS. 82A and 82B is for example purposes only. Splitter circuit 8200 may be comprised of an assortment of logic and semiconductor devices of a variety of types, as will be apparent to persons skilled in the relevant art(s) based on the discussion contained herein.

### 3.4.2 I/Q Circuit

FIG. 82E illustrates an example embodiment of the energy transfer system 2202 as a complete I/Q circuit 8226 in CMOS. I/Q circuit 8226 includes a splitter circuit 8200 as described in detail above. Further description regarding I/Q circuit implementations are provided herein, including the applications referenced above.

### 3.5 Example I and Q Implementations

#### 3.5.1 Switches of Different Sizes

In an embodiment, the switch module 2402 discussed herein can be implemented as a series of switches operating in parallel as a single switch. The series of switches can be transistors, such as, for example, field effect transistors (FET), bi-polar transistors, or any other suitable circuit switching devices. The series of switches can be comprised of one type of switching device, or a combination of different switching devices.

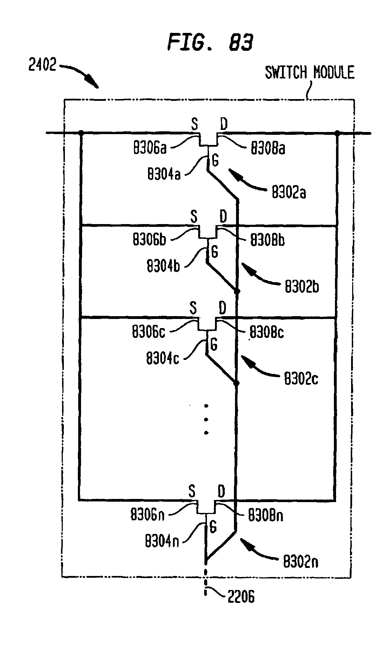

For example, FIG. 83 illustrates the switch module 2402 as a series of FETs 8302a-n. The FETs 8302a-n can be any type ofFET, including, but not limited to, a MOSFET, a JFET, a GaAsFET, etc. Each of FETs 8302a-n includes a gate 8304a-n, a source 8306a-n, and a drain 8308a-n, similarly to that ofFET 2802 ofFIG. 28A. The series ofFETs 8302a-n operate in parallel. Gates 8304a-n are coupled together, sources 8306a-n are coupled together, and drains 8308a-n are coupled together. Each of gates 8304a-n receives the energy transfer signal 2206 to control the switching action between corresponding sources 8306a-n and drains 8308a-n. Generally, the corresponding sources 8306a-n and drains 8308a-n of each ofFETs 8302a-n are interchangeable. There is no numerical limit to the number of FETs. Any limitation would depend on the particular application, and the "a-n" designation is not meant to suggest a limit in any way.

In an embodiment, FETs 8302a-n have similar characteristics. In another embodiment, one or more ofFETs 8302a-n have different characteristics than the other FETs. For example, FETs 8302a-n may be of different sizes. In CMOS, generally, the larger size a switch is (meaning the larger the area under the gate between the source and drain regions), the longer it takes for the switch to turn on. The longer turn on time is due in part to a higher gate to channel capacitance that exists in larger switches. Smaller CMOS switches turn on in less time, but have a higher channel resistance. Larger CMOS switches have lower channel resistance relative to smaller CMOS switches. Different turn on characteristics for different size switches provides flexibility in designing an overall switch module structure. By combining smaller switches with larger switches, the channel conductance of the overall switch structure can be tailored to satisfy given requirements.

In an embodiment, FETs 8302a-n are CMOS switches of different relative sizes. For example, FET 8302a may be a switch with a smaller size relative to FETs 8302b-n. FET 8302b may be a switch with a larger size relative to FET 8302a, but smaller size relative to FETs 8302c-n. The sizes of FETs 8302c-n also may be varied relative to each other. For instance, progressively larger switch sizes may be used. By varying the sizes ofFETs 8302a-n relative to each other, the turn on characteristic curve of the switch module can be correspondingly varied. For instance, the turn on characteristic of the switch module can be tailored such that it more closely approaches that of an ideal switch. Alternately, the switch module could be tailored to produce a shaped conductive curve.

By configuring FETs 8302a-n such that one or more of them are of a relatively smaller size, their faster turn on characteristic can improve the overall switch module turn on characteristic curve. Because smaller switches have a lower gate to channel capacitance, they can turn on more rapidly than larger switches.

By configuring FETs 8302a-n such that one or more of them are of a relatively larger size, their lower channel resistance also can improve the overall switch module turn on characteristics. Because larger switches have a lower channel resistance, they can provide the overall switch structure with a lower channel resistance, even when combined with smaller switches. This improves the overall switch structure's ability to drive a wider range of loads. Accordingly, the ability to tailor switch sizes relative to each other in the overall switch structure allows for overall switch structure operation to more nearly approach ideal, or to achieve application specific requirements, or to balance trade-offs to achieve specific goals, as will be understood by persons skilled in the relevant arts(s) from the teachings herein.

It should be understood that the illustration of the switch module 2402 as a series of FETs 8302a-n in FIG. 83 is for example purposes only. Any device having switching capabilities could be used to implement the switch module 2402, as will be apparent to persons skilled in the relevant art(s) based on the discussion contained herein.

#### 3.5.2 Reducing Overall Switch Area

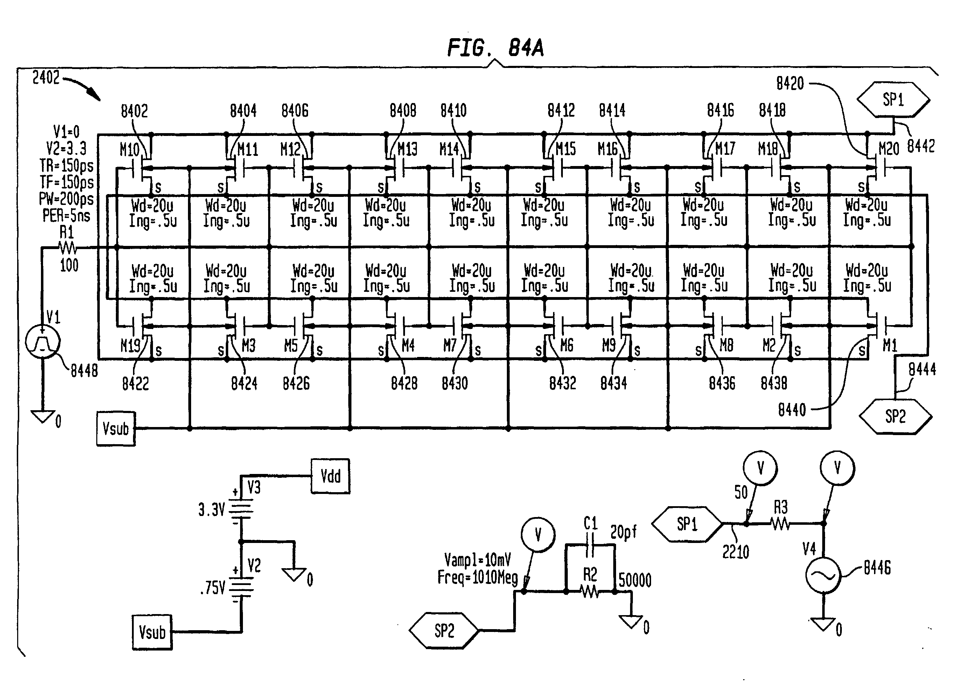

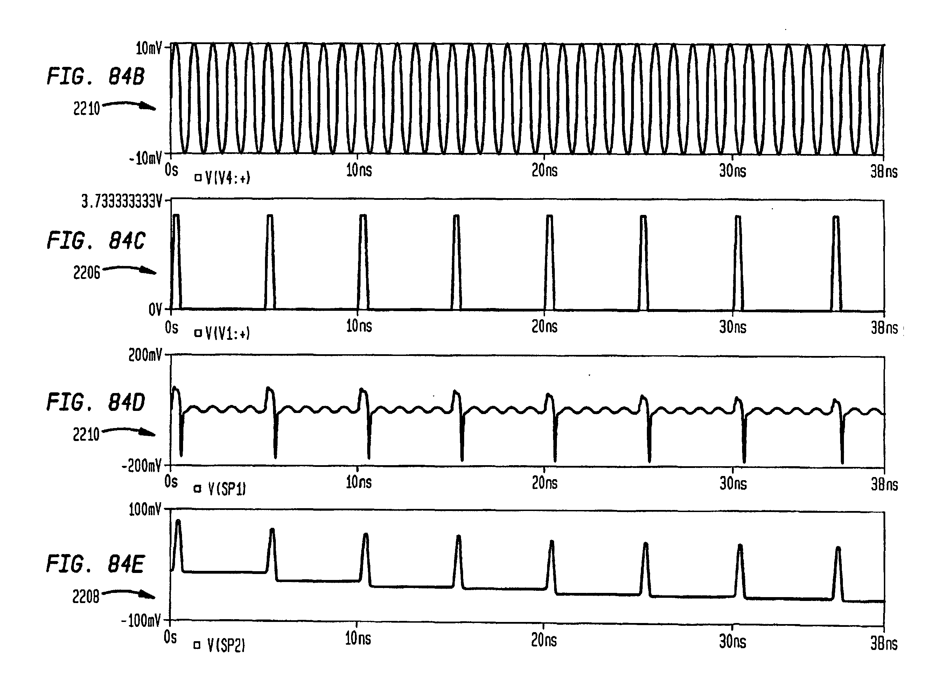

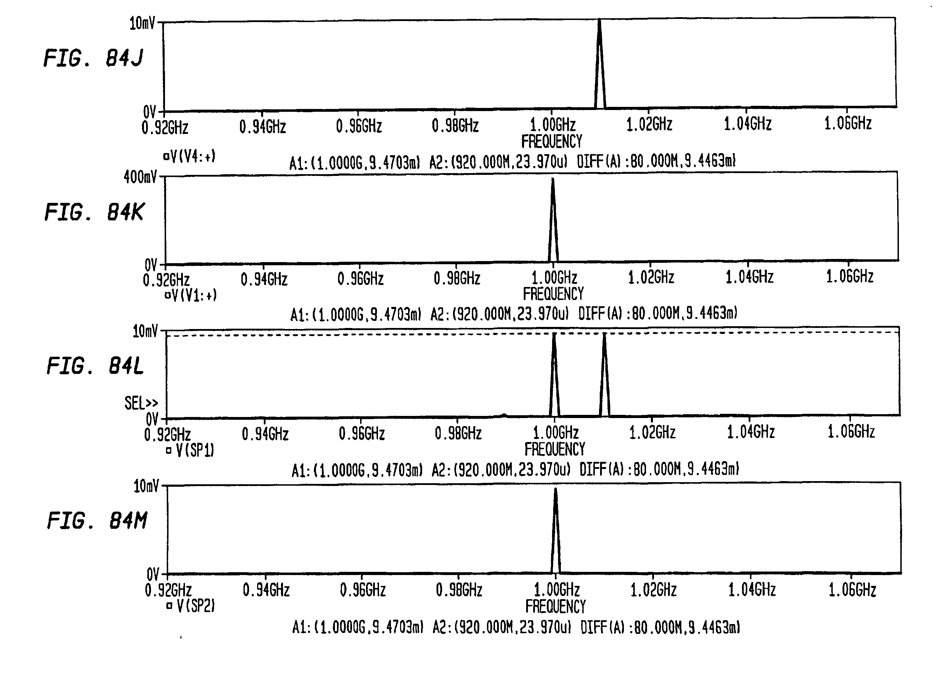

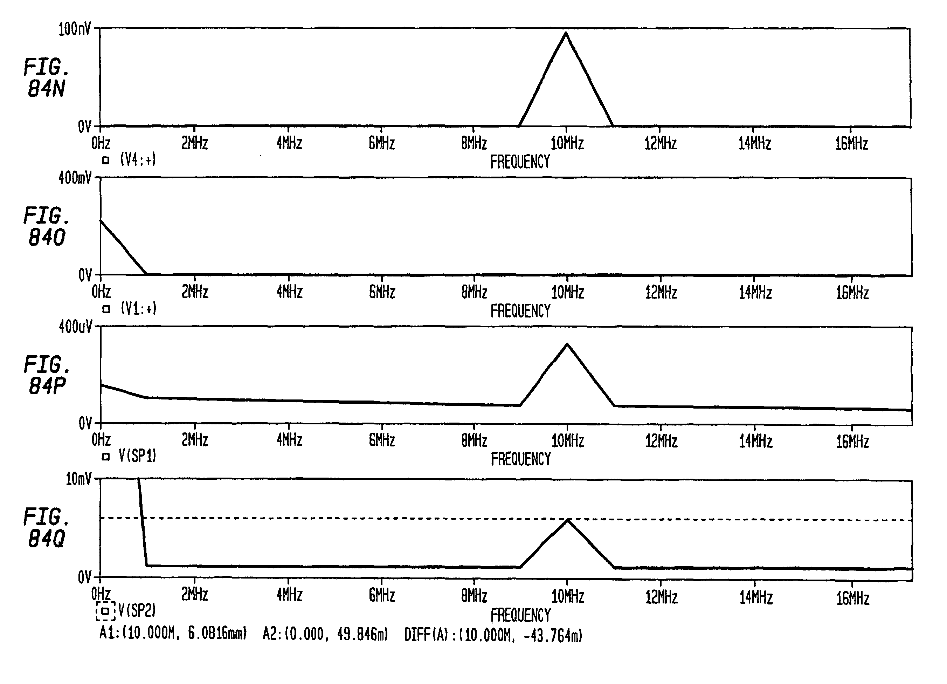

Circuit performance also can be improved by reducing overall switch area. As discussed above, smaller switches (i.e., smaller area under the gate between the source and drain regions) have a lower gate to channel capacitance relative to larger switches. The lower gate to channel capacitance allows for lower circuit sensitivity to noise spikes. FIG. 84A illustrates an embodiment of the switch module 2402, with a large overall switch area. The switch module 2402 of FIG. 84A includes twenty FETs 8402-8440. As shown, FETs 8402-8440 are the same size ("Wd" and "Ing" parameters are equal). Input source 8446 produces the input modulated carrier signal 2210. Pulse generator 8448 produces the energy transfer signal 2206 for FETs 8402-8440. Capacitor C 1 is the storage element for the input modulated carrier signal 2210 being sampled by FETs 8402-8440. FIGS. 84B-84Q illustrate example waveforms related to the switch module of FIG. 84A. FIG. 84B shows a received 1.01 GHz modulated carrier signal 2210 to be sampled and downconverted to a 10 MHZ intermediate frequency signal 2208. FIG. 84C shows the energy transfer signal 2206 having an aliasing rate of 200 MHZ, which is applied to the gate of each of the twenty FETs 8402-8440. The energy transfer signal 2206 includes a train of energy transfer pulses having non-negligible apertures that tend away from zero time in duration. The energy transfer pulses repeat at the aliasing rate. FIG. 84D illustrates the affected received modulated carrier signal 2210, showing effects of transferring energy at the aliasing rate, at point 8442 of FIG. 84A. FIG. 84E illustrates a down-converted signal 2208 at point 8444 of FIG. 84A, which is generated by the down-conversion process.

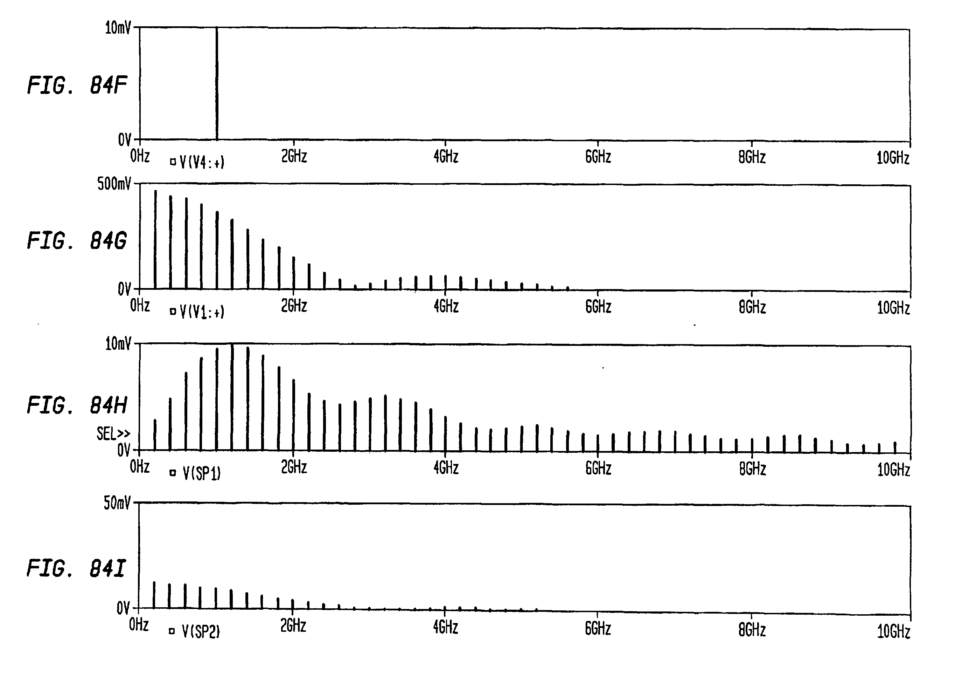

FIG. 84F illustrates the frequency spectrum of the received 1.01 GHz modulated carrier signal 2210. FIG. 84G illustrates the frequency spectrum of the received energy transfer signal 2206. FIG. 84H illustrates the frequency spectrum of the affected received modulated carrier signal 2210 at point 8442 of FIG. 84A. FIG. 84I illustrates the frequency spectrum of the down-converted signal 2208 at point 8444 of FIG. 84A.

FIGS. 84J-84M respectively further illustrate the frequency spectrums of the received 1.01 GHz modulated carrier signal 2210, the received energy transfer signal 2206, the affected received modulated carrier signal 2210 at point 8442 of FIG. 84A, and the down-converted signal 2208 at point 8444 of FIG. 84A, focusing on a narrower frequency range centered on 1.00 GHz. As shown in FIG. 84L, a noise spike exists at approximately 1.0 GHz on the affected received modulated carrier signal 2210 at point 8442 of FIG. 84A. This noise spike may be radiated by the circuit, causing interference at 1.0 GHz to nearby receivers. FIGS. 84N-84Q respectively illustrate the frequency spectrums of the received 1.01 GHz modulated carrier signal 2210, the received energy transfer signal 2206, the affected received modulated carrier signal 2210 at point 8442 of FIG. 84A, and the down-converted signal 2208 at point 8444 of FIG. 84A, focusing on a narrow frequency range centered near 10.0 MHZ. In particular, FIG. 84Q shows that an approximately 5 mV signal was downconverted at approximately 10 MHZ.

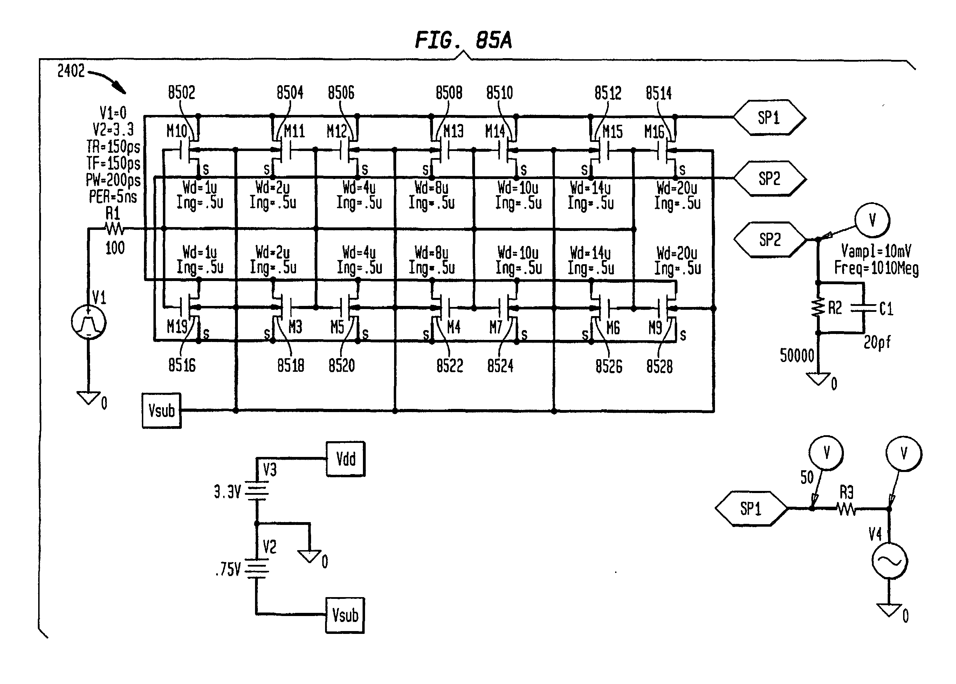

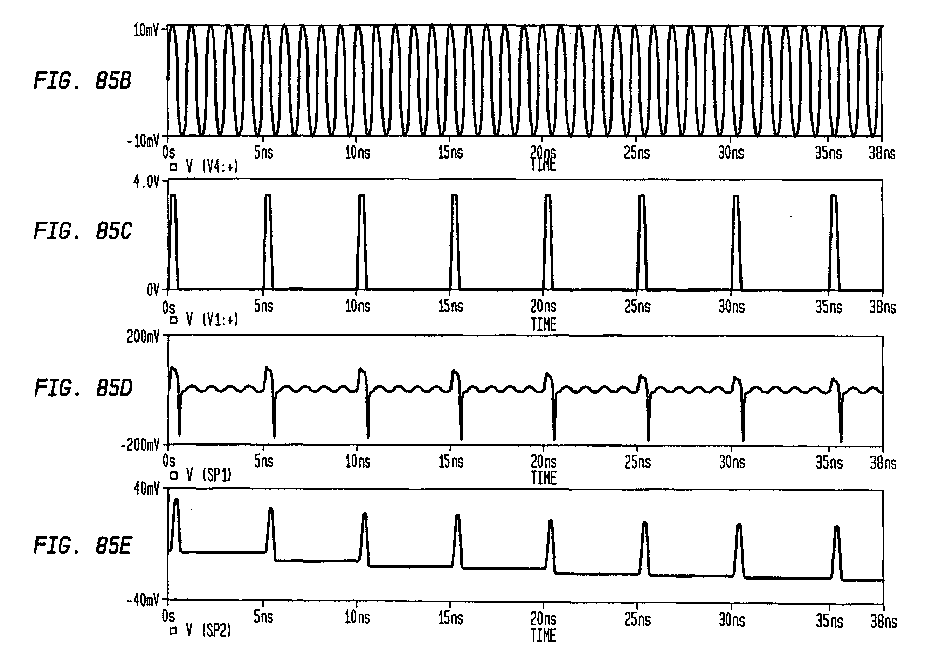

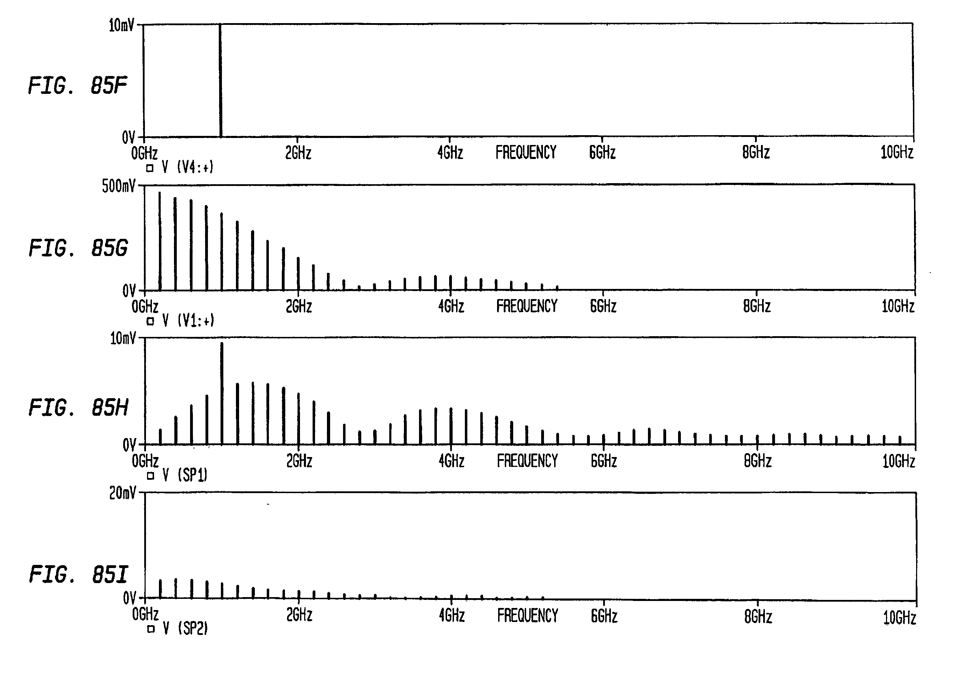

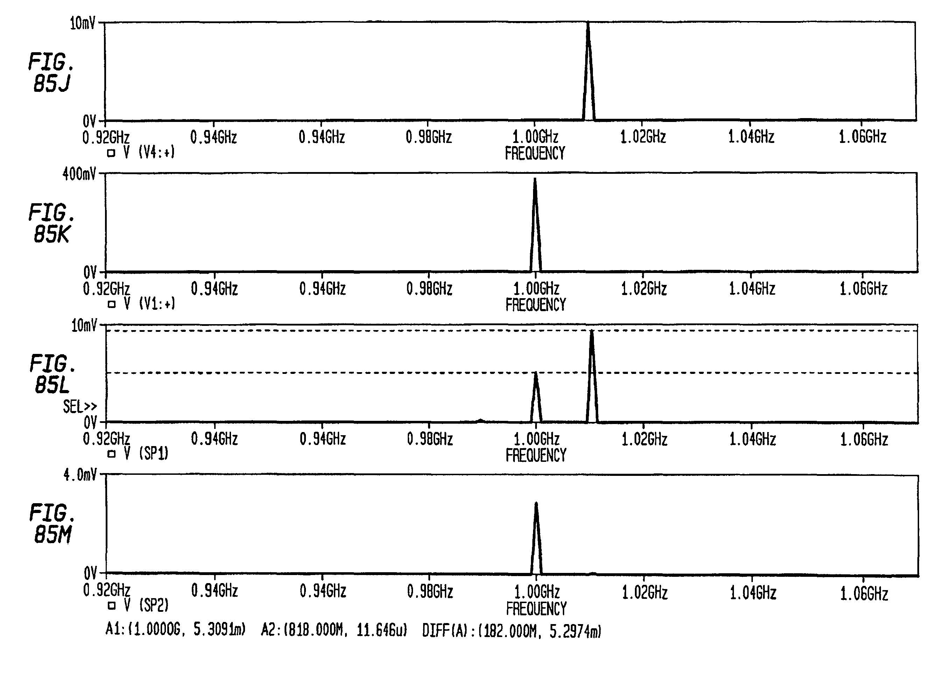

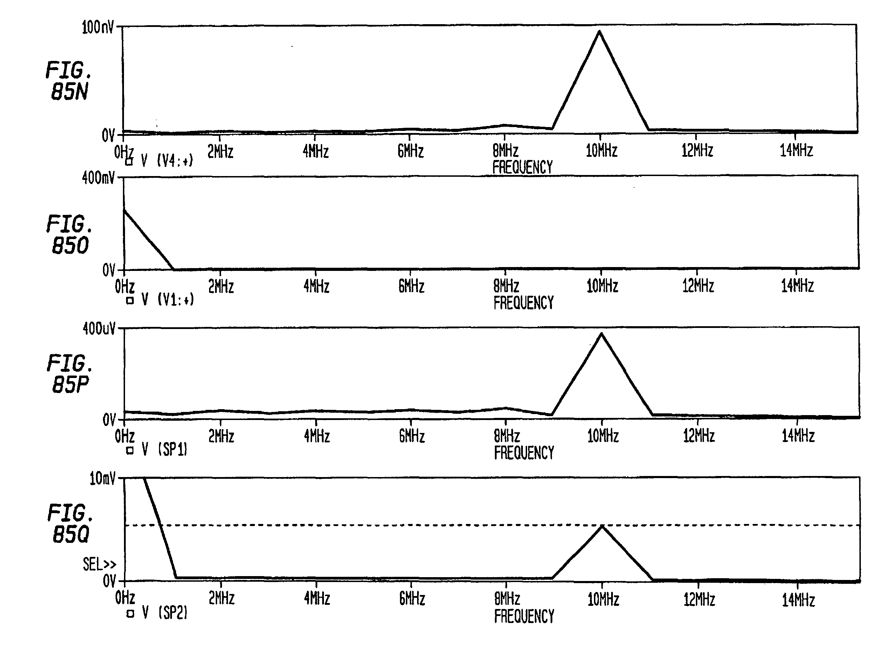

FIG 85A illustrates an alternative embodiment of the switch module 2402, this time with fourteen FETs 8502-8528 shown, rather than twenty FETs 8402-8440 as shown in FIG. 84A. Additionally, the FETs are of various sizes (some "Wd" and "Ing" parameters are different between FETs).

FIGS. 85B-85Q, which are example waveforms related to the switch module 2402 of FIG. 85A, correspond to the similarly designated figures of FIGS. 84B-84Q. As FIG. 85L shows, a lower level noise spike exists at 1.0 GHz than at the same frequency of FIG. 84L. This correlates to lower levels of circuit radiation. Additionally, as FIG. 85Q shows, the lower level noise spike at 1.0 GHz was achieved with no loss in conversion efficiency. This is represented in FIG. 85Q by the approximately 5 mV signal downconverted at approximately 10 MHZ. This voltage is substantially equal to the level downconverted by the circuit of FIG. 84A. In effect, by decreasing the number of switches, which decreases overall switch area, and by reducing switch area on a switch-by-switch basis, circuit parasitic capacitance can be reduced, as would be understood by persons skilled in the relevant art(s) from the teachings herein. In particular this may reduce overall gate to channel capacitance, leading to lower amplitude noise spikes and reduced unwanted circuit radiation.

It should be understood that the illustration of the switches above as FETs in FIGSs. 84A-84Q and 85A-85Q is for example purposes only. Any device having switching capabilities could be used to implement the switch module 2402, as will be apparent to persons skilled in the relevant art(s) based on the discussion contained herein.

### 3.5.3 Charge Injection Cancellation

In embodiments wherein the switch modules 2402 discussed herein are comprised of a series of switches in parallel, in some instances it may be desirable to minimize the effects of charge injection. Minimizing charge injection is generally desirable in order to reduce the unwanted circuit radiation resulting therefrom. In an embodiment, unwanted charge injection effects can be reduced through the use of complementary n-channel MOSFETs and p-channel MOSFETs. N-channel MOSFETs and p-channel MOSFETs both suffer from charge injection. However, because signals of opposite polarity are applied to their respective gates to turn the switches on and off, the resulting charge injection is of opposite polarity. Resultingly, n-channel MOSFETs and p-channel MOSFETs may be paired to cancel their corresponding charge injection. Hence, in an embodiment, the switch module may be comprised of n-channel MOSFETs and p-channel MOSFETS, wherein the members of each are sized to minimize the undesired effects of charge injection.

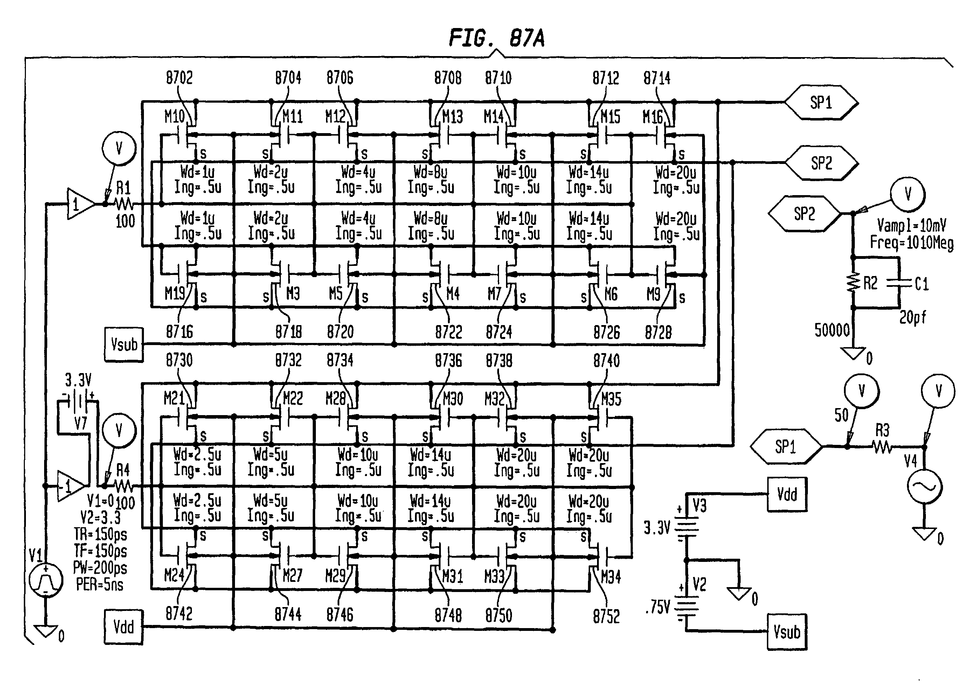

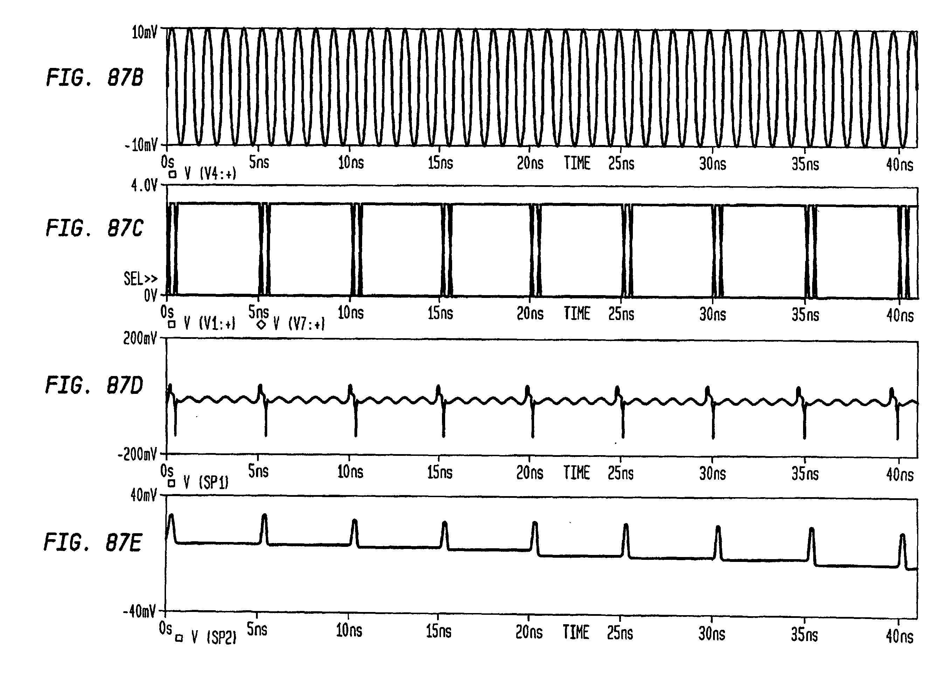

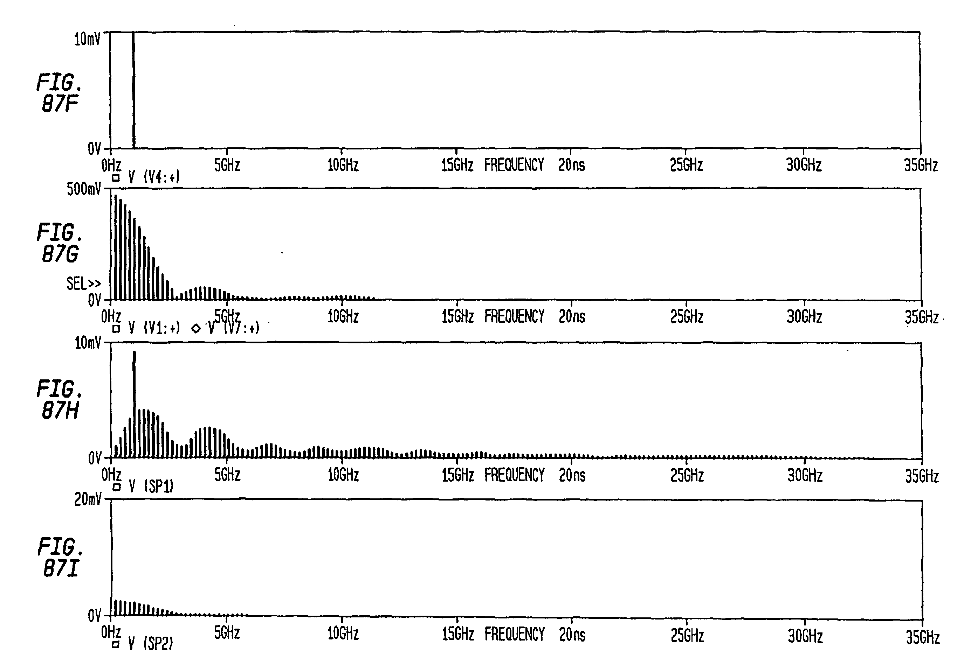

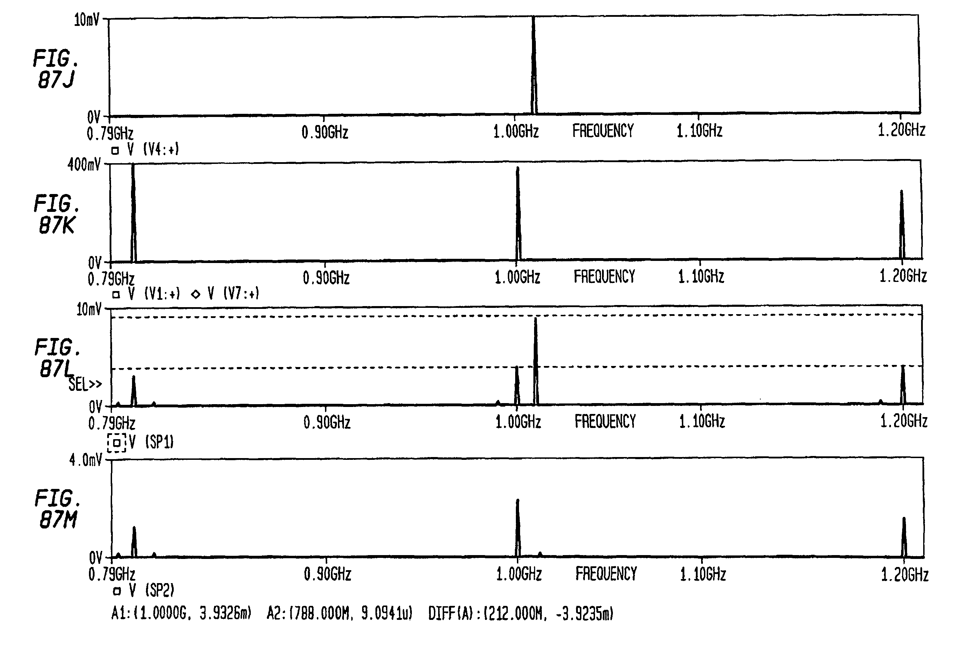

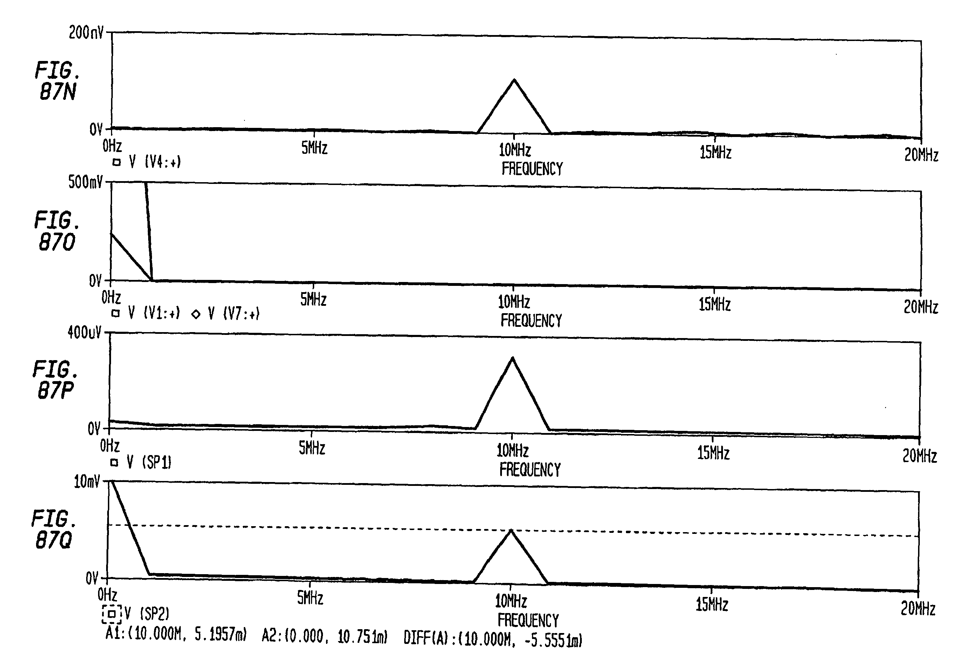

FIG 87A illustrates an alternative embodiment of the switch module 2402, this time with fourteen n-channel FETs 8702-8728 and twelve p-channel FETs 8730-8752 shown, rather than twenty FETs 8402-8440 as shown in FIG. 84A. The n-channel and p-channel FETs are arranged in a complementary configuration. Additionally, the FETs are of various sizes (some "Wd" and "Ing" parameters are different between FETs).

FIGS. 87B-87Q, which are example waveforms related to the switch module 2402 of FIG. 87A, correspond to the similarly designated figures of FIGS. 84B-84Q. As FIG. 87L shows, a lower level noise spike exists at 1.0 GHz than at the same frequency of FIG. 84L. This correlates to lower levels of circuit radiation. Additionally, as FIG. 87Q shows, the lower level noise spike at 1.0 GHz was achieved with no loss in conversion efficiency. This is represented in FIG. 87Q by the approximately 5 mV signal downconverted at approximately 10 MHZ. This voltage is substantially equal to the level downconverted by the circuit ofFIG. 84A. In effect, by arranging the switches in a complementary configuration, which assists in reducing charge injection, and by tailoring switch area on a switch-by-switch basis, the effects of charge injection can be reduced, as would be understood by persons skilled in the relevant art(s) from the teachings herein. In particular this leads to lower amplitude noise spikes and reduced unwanted circuit radiation.

It should be understood that the use of FETs in FIGSs. 87A-87Q in the above description is for example purposes only. From the teachings herein, it would be apparent to persons of skill in the relevant art(s) to manage charge injection in various transistor technologies using transistor pairs.

### 3.5.4 Overlapped Capacitance

The processes involved in fabricating semiconductor circuits, such as MOSFETs, have limitations. In some instances, these process limitations may lead to circuits that do not function as ideally as desired. For instance, a non-ideally fabricated MOSFET may suffer from parasitic capacitances, which in some cases may cause the surrounding circuit to radiate noise. By fabricating circuits with structure layouts as close to ideal as possible, problems of non-ideal circuit operation can be minimized.

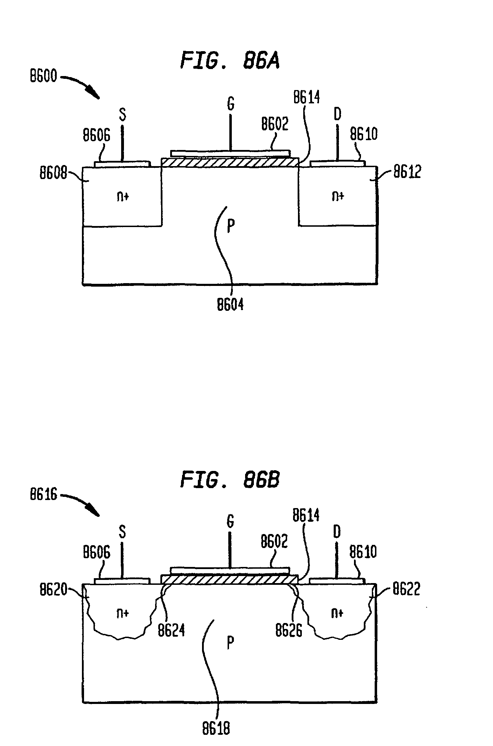

FIG. 86A illustrates a cross-section of an example n-channel enhancement-mode MOSFET 8600, with ideally shaped n+ regions. MOSFET 8600 includes a gate 8602, a channel region 8604, a source contact 8606, a source region 8608, a drain contact 8610, a drain region 8612, and an insulator 8614. Source region 8608 and drain region 8612 are separated by p-type material of channel region 8604. Source region 8608 and drain region 8612 are shown to be n+ material. The n+ material is typically implanted in the p-type material of channel region 8604 by an ion implantation/diffusion process. Ion implantation/diffusion processes are well known by persons skilled in the relevant art(s). Insulator 8614 insulates gate 8602 which bridges over the p-type material. Insulator 8614 generally comprises a metal-oxide insulator. The channel current between source region 8608 and drain region 8612 for MOSFET 8600 is controlled by a voltage at gate 8602.

Operation of MOSFET 8600 shall now be described. When a positive voltage is applied to gate 8602, electrons in the p-type material of channel region 8604 are attracted to the surface below insulator 8614, forming a connecting near-surface region of n-type material between the source and the drain, called a channel. The larger or more positive the voltage between the gate contact 8606 and source region 8608, the lower the resistance across the region between.

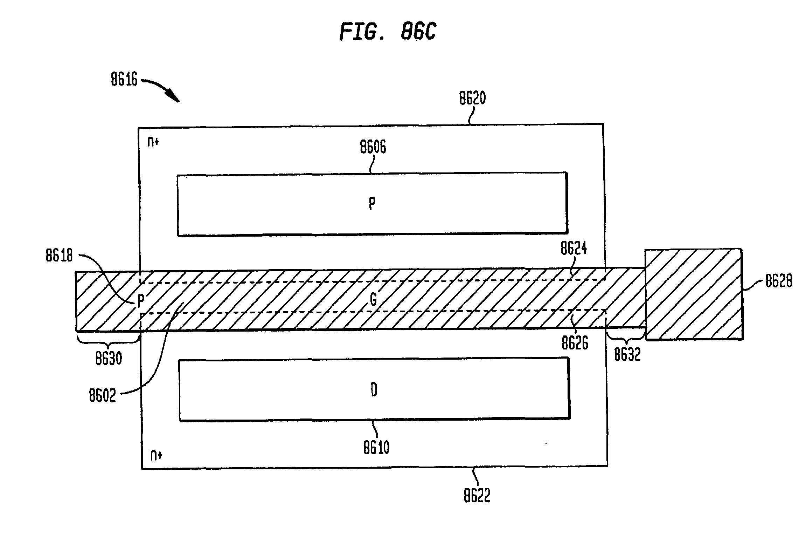

In FIG. 86A, source region 8608 and drain region 8612 are illustrated as having n+ regions that were formed into idealized rectangular regions by the ion implantation process. FIG. 86B illustrates a cross-section of an example n-channel enhancement-mode MOSFET 8616 with non-ideally shaped n+ regions. Source region 8620 and drain region 8622 are illustrated as being formed into irregularly shaped regions by the ion implantation process. Due to uncertainties in the ion implantation/diffusion process, in practical applications, source region 8620 and drain region 8622 do not form rectangular regions as shown in FIG. 86A. FIG. 86B shows source region 8620 and drain region 8622 forming exemplary irregular regions. Due to these process uncertainties, the n+ regions of source region 8620 and drain region 8622 also may diffuse further than desired into the p-type region of channel region 8618, extending underneath gate 8602. The extension of the source region 8620 and drain region 8622 underneath gate 8602 is shown as source overlap 8624 and drain overlap 8626. Source overlap 8624 and drain overlap 8626 are further illustrated in FIG. 86C. FIG. 86C illustrates a top-level view of an example layout configuration for MOSFET 8616. Source overlap 8624 and drain overlap 8626 may lead to unwanted parasitic capacitances between source region 8620 and gate 8602, and between drain region 8622 and gate 8602. These unwanted parasitic capacitances may interfere with circuit function. For instance, the resulting parasitic capacitances may produce noise spikes that are radiated by the circuit, causing unwanted electromagnetic interference.

As shown in FIG. 86C, an example MOSFET 8616 may include a gate pad 8628. Gate 8602 may include a gate extension 8630, and a gate pad extension 8632. Gate extension 8630 is an unused portion of gate 8602 required due to metal implantation process tolerance limitations. Gate pad extension 8632 is a portion of gate 8602 used to couple gate 8602 to gate pad 8628. The contact required for gate pad 8628 requires gate pad extension 8632 to be of non-zero length to separate the resulting contact from the area between source region 8620 and drain region 8622. This prevents gate 8602 from shorting to the channel between source region 8620 and drain region 8622 (insulator 8614 of FIG. 86B is very thin in this region). Unwanted parasitic capacitances may form between gate extension 8630 and the substrate (FET 8616 is fabricated on a substrate), and between gate pad extension 8632 and the substrate. By reducing the respective areas of gate extension 8630 and gate pad extension 8632, the parasitic capacitances resulting therefrom can be reduced. Accordingly, embodiments address the issues of uncertainty in the ion implantation/diffusion process. it will be obvious to persons skilled in the relevant art(s) how to decrease the areas of gate extension 8630 and gate pad extension 8632 in order to reduce the resulting parasitic capacitances.

It should be understood that the illustration of the n-channel enhancement-mode MOSFET is for example purposes only. The present invention is applicable to depletion mode MOSFETs, and other transistor types, as will be apparent to persons skilled in the relevant art(s) based on the discussion contained herein.

### 4. Optional Optimizations of Energy Transfer at an Aliasing Rate

The methods and systems described in sections above can be optimized with one or more of the optimization methods or systems described below.

### 4.1 Doubling the Aliasing Rate ($F_{AR}$) of the Energy Transfer Signal

In an embodiment, the optional energy transfer signal module 2802 in FIG. 28 generates aliasing pulses at twice the frequency of the input oscillating signal 2724. The input oscillating signal 2724 may be any suitable oscillating source.

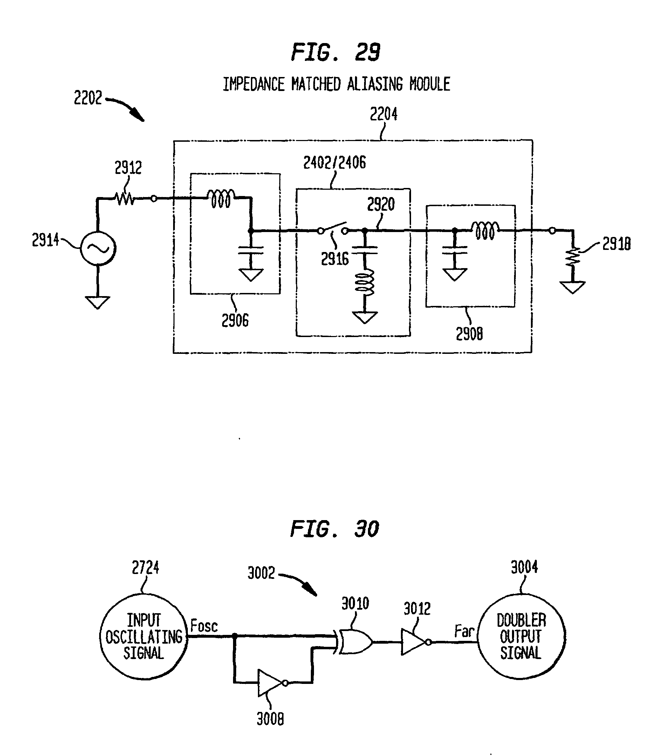

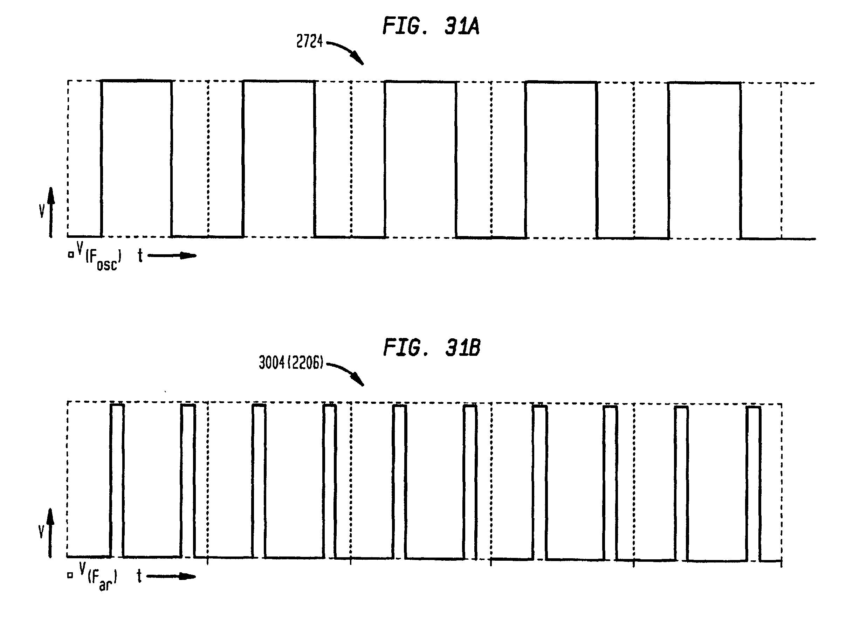

FIG. 30 illustrates a circuit 3002 that generates a doubler output signal 3004 (FIG. 31B) that may be used as an energy transfer signal 2206. The circuit 3002 generates pulses on both rising and falling edges of the input oscillating signal 2724 of FIG. 31A. The circuit 3002 can be implemented as a pulse generator and aliasing rate ($F_{AR}$) doubler. The doubler output signal 3004 can be used as the energy transfer signal 2206.

In the example of FIG. 30, the aliasing rate is twice the frequency of the input oscillating signal $F_{osc}$ 2724, as shown by EQ. (9) below.

$$F_{AR} = 2 \cdot F_{osc} \qquad \text{EQ. (9)}$$

The aperture width of the aliasing pulses is determined by the delay through a first inverter 3008 of FIG. 30. As the delay is increased, the aperture is increased. A second inverter 3012 is shown to maintain polarity consistency with examples described elsewhere. In an alternate embodiment inverter 3012 is omitted. Preferably, the pulses have non-negligible aperture widths that tend away from zero time. The doubler output signal 3004 may be further conditioned as appropriate to drive the switch module 2402 with non-negligible aperture pulses. The circuit 3002 may be implemented with integrated circuitry, discretely, with equivalent logic circuitry, or with any valid fabrication technology.

### 4.2 Differential Implementations

The invention can be implemented in a variety of differential configurations. Differential configurations are useful for reducing common mode noise. This can be very useful in receiver systems where common mode interference can be caused by intentional or unintentional radiators such as cellular phones, CB radios, electrical appliances etc.. Differential configurations are also useful in reducing any common mode noise due to charge injection of the switch in the switch module or due to the design and layout of the system in which the invention is used. Any spurious signal that is induced in equal magnitude and equal phase in both input leads of the invention will be substantially reduced or eliminated. Some differential configurations, including some of the configurations below, are also useful for increasing the voltage and/or for increasing the power of the down-converted signal 2208.

Differential systems are most effective when used with a differential front end (inputs) and a differential back end (outputs). They can also be utilized in the following configurations, for example:

a) A single-input front end and a differential back end; and
b) A differential front end and a single-output back end.

Examples of these system are provided below, with a first example illustrating a specific method by which energy is transferred from the input to the output differentially..

While an example of a differential energy transfer module is shown below, the example is shown for the purpose of illustration, not limitation. Alternate embodiments (including equivalents, extensions, variations, deviations etc.) of the embodiment described herein will be apparent to those skilled in the relevant art based on the teachings contained herein.

### 4.2.1 An Example Illustrating Energy Transfer Differentially

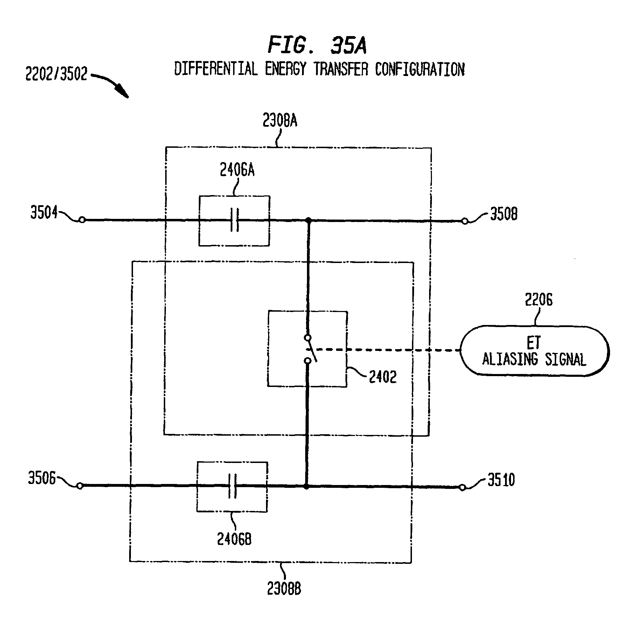

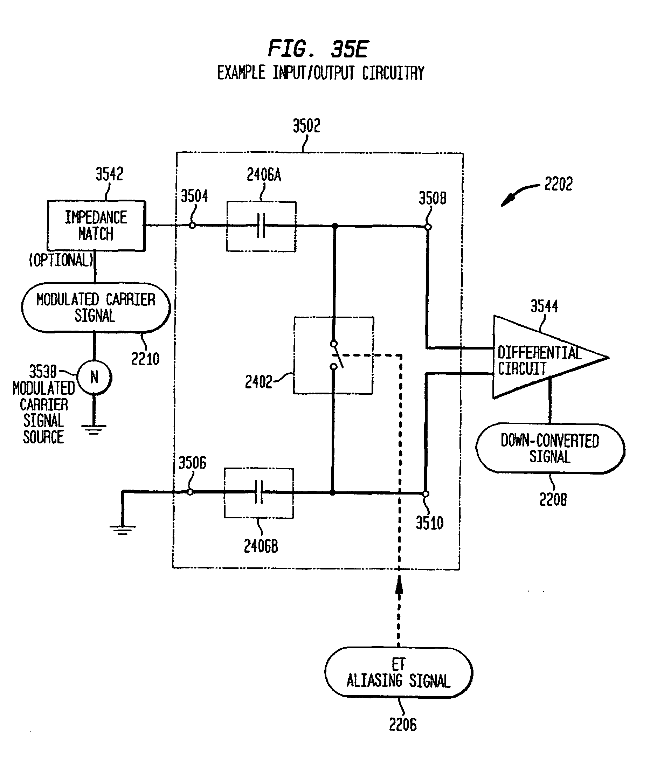

FIG. 35A illustrates the energy transfer system 2202 as a differential system 3502. The differential system 3502 includes an inverted gated transfer design similar to that described with reference to FIG. 33. The differential system 3502 includes inputs 3504 and 3506 and outputs 3508 and 3510. The differential system 3502 includes a first inverted gated transfer module 2308A, which includes a storage module 2406A and a switch module 2402. The differential system 3502 also includes a second inverted gated transfer module 2308B, which includes a storage module 2406B and a switch module 2402, which it shares in common with inverted gated transfer module 2308A.

One or both of the inputs 3504 and 3506 are coupled to a modulated carrier signal source. For example, the inputs can be coupled to a modulated carrier signal source, wherein the input voltages at the inputs 3504 and 3506 are substantially equal in amplitude but 180 degrees out of phase with one another. Alternatively, where dual inputs are unavailable, one of the inputs 3504 and 3506 can be coupled to ground.

In operation, when the switch module 2402 is closed, the storage modules 2406A and 2406B are in series and, provided they have similar capacitive values, accumulate charge of equal magnitude but opposite polarities. When the switch module 2402 is open, the voltage at the output 3508 is relative to the input 3504, and the voltage at the output 3510 is relative to the voltage at the input 3506.

Portions of the signals at the outputs 3508 and 3510 include signals resulting from energy stored in the storage modules 2406A and 2406B, respectively, when the switch module 2402 was closed. The portions of the signals at the outputs 3508 and 3510 resulting from the stored charge are generally equal in amplitude to one another but 180 degrees out of phase.

Portions of the signals at the outputs 3508 and 3510 also include ripple voltage or noise resulting from the switching action of the switch module 2402. But because the switch module is positioned between the two outputs 3508 and 3510, the noise introduced by the switch module appears at the outputs as substantially equal and in-phase with one another. As a result, the ripple voltage can be substantially canceled out by inverting the signal at one of the outputs 3508 or 3510 and adding it to the other remaining output. Additionally, any noise that is impressed with equal amplitude and equal phase onto the input terminals 3504 and 3506 by any other noise sources will tend to be canceled in the same way.

### 4.2.1.1 Differential Input-to-Differential Output

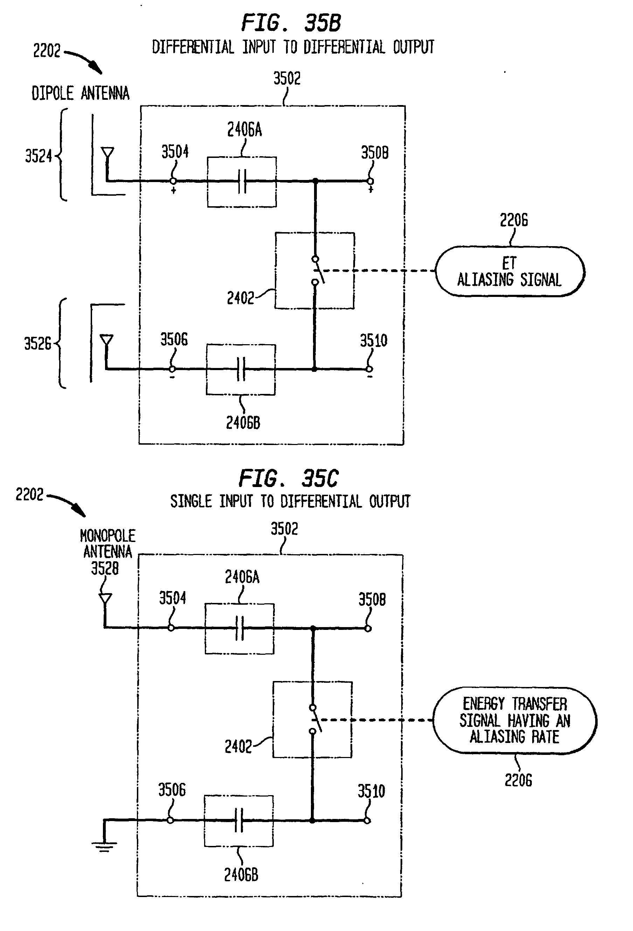

FIG. 35B illustrates the differential system 3502 wherein the inputs 3504 and 3506 are coupled to equal and opposite modulated carrier signal sources, illustrated here as dipole antennas 3524 and 3526. In this embodiment, when one of the outputs 3508 or 3510 is inverted and added to the other output, the common mode noise due to the switching module 2402 and other common mode noise present at the input terminals 3504 and 3506 tend to substantially cancel out.

### 4.2.1.2 Single Input-to-Differential Output

FIG. 35C illustrates the differential system 3502 wherein the input 3504 is coupled to a modulated carrier signal source such as a monopole antenna 3528 and the input 3506 is coupled to ground. In this configuration, the voltages at the outputs 3508 and 3510 are approximately one half the value of the voltages at the outputs in the implementation illustrated in FIG. 35B, given all other parameters are equal.

FIG. 35E illustrates an example single input to differential output receiver/down-converter system 3502. In the system 3502 of FIG. 35E, the input 3506 is coupled to ground as in FIG. 35C. The input 3504 is coupled to a modulated carrier signal source 3538 through an optional input impedance match 3542. The modulated carrier signal source impedance can be matched with an impedance match system 3542 as described in sections below.

The outputs 3508 and 3510 are coupled to a differential circuit 3544 such as a filter, which preferably inverts one of the outputs 3508 or 3510 and adds it to the other output 3508 or 3510. This substantially cancels common mode noise generated by the switch module 2402. The differential circuit 3544 preferably filters the higher frequency components of the modulated carrier signal 2210 that pass through the storage modules 2406A and 2406B. The resultant filtered signal is output as the down-converted signal 2208.

### 4.2.1.3 Differential Input-to-Single Output

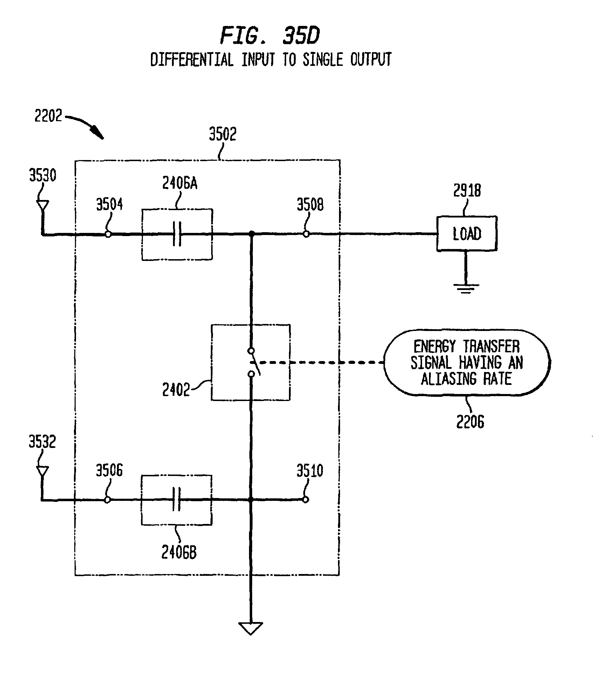

FIG. 35D illustrates the differential input to single output system 3502 wherein the inputs 3504 and 3506 are coupled to equal and opposite modulated carrier signal dipole antennas 3530 and 3532. In FIG. 35D, the common mode noise voltages are not canceled as in systems shown above. The output is coupled from terminal 3508 to a load 2918.

### 4.2.2 Specific Alternative Embodiments

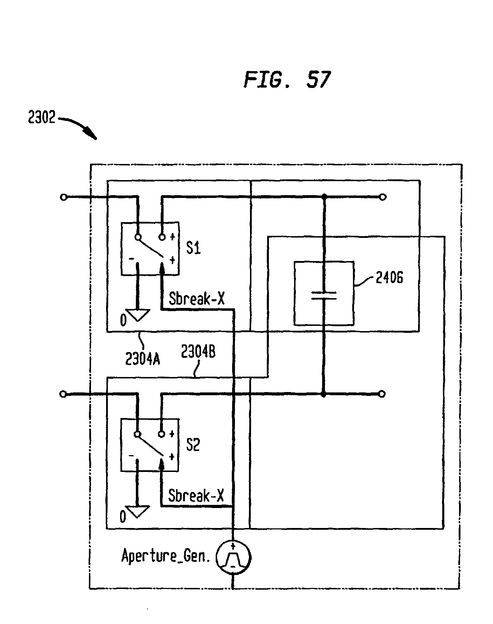

In specific alternative embodiments, the present invention is implemented using a plurality of gated transfer modules controlled by a common energy transfer signal with a storage module coupled between the outputs of the plurality of gated transfer modules. For example, FIG. 57 illustrates the energy transfer system 2202 as a differential system 5702 that includes first and second gated transfer modules 2304A and 2304B, and a storage module 2406 coupled between. Operation of the differential system 5702 will be apparent to one skilled in the relevant art(s), based on the description herein.

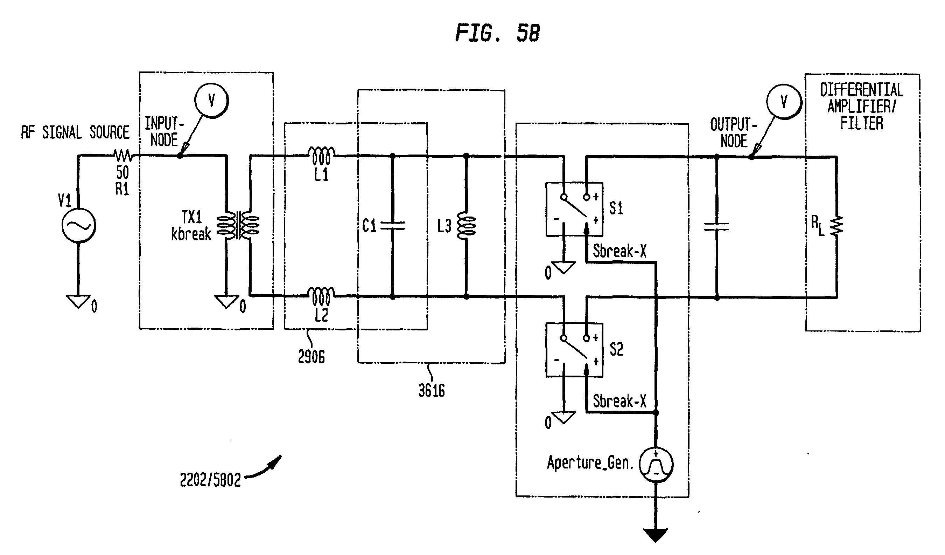

As described above, the gated transfer differential system 5702 can be implemented with a single input, differential inputs, a single output, differential outputs, and combinations thereof. For example, FIG. 58 illustrates the energy transfer system 2202 as an example single input-to-differential output system 5802.

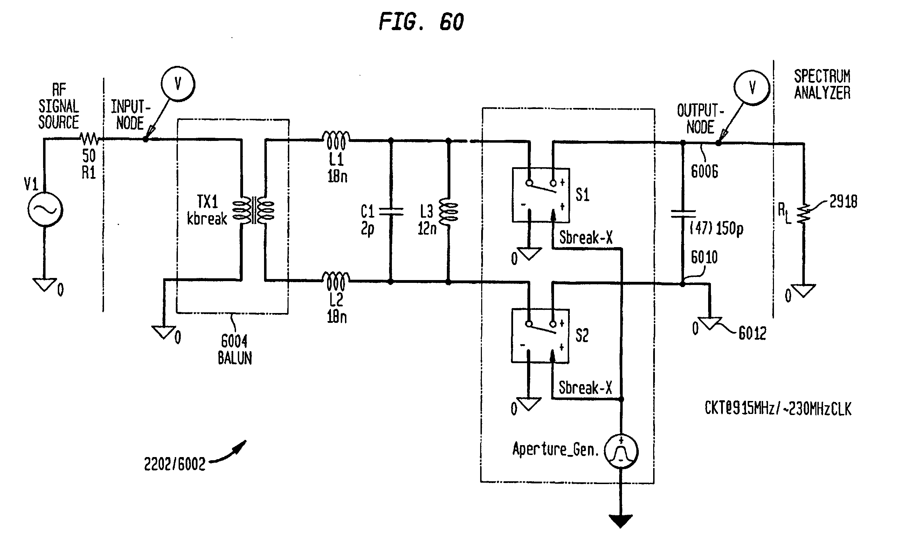

Where common-mode rejection is desired to protect the input from various common-mode effects, and where common mode rejection to protect the output is not necessary, a differential input-to-single output implementation can be utilized. FIG. 60 illustrates the energy transfer system 2202 as an example differential-to-single ended system 6002, where a balance/unbalance (balun) circuit 6004 is utilized to generate the differential input. Other input configurations are contemplated. A first output 6006 is coupled to a load 2918. A second output 6010 is coupled to ground point 6012.

Typically, in a balanced-to-unbalanced system, where a single output is taken from a differential system without the use of a balun, (i.e., where one of the output signals is grounded), a loss of about 6 db is observed. In the configuration of FIG. 60, however, the ground point 6012 simply serves as a DC voltage reference for the circuit. The system 6002 transfers charge from the input in the same manner as if it were full differential, with its conversion efficiency generally affected only by the parasitics of the circuit components used, such as the Rds(on) on FET switches if used in the switch module. In other words, the charge transfer still continues in the same manner of a single ended implementation, providing the necessary single-ended ground to the input circuitry when the aperture is active, yet configured to allow the input to be differential for specific common-mode rejection capability and/or interface between a differential input and a single ended output system.

### 4.2.3 Specific Examples of Optimizations and Configurations for Inverted and Non-Inverted Differential Designs

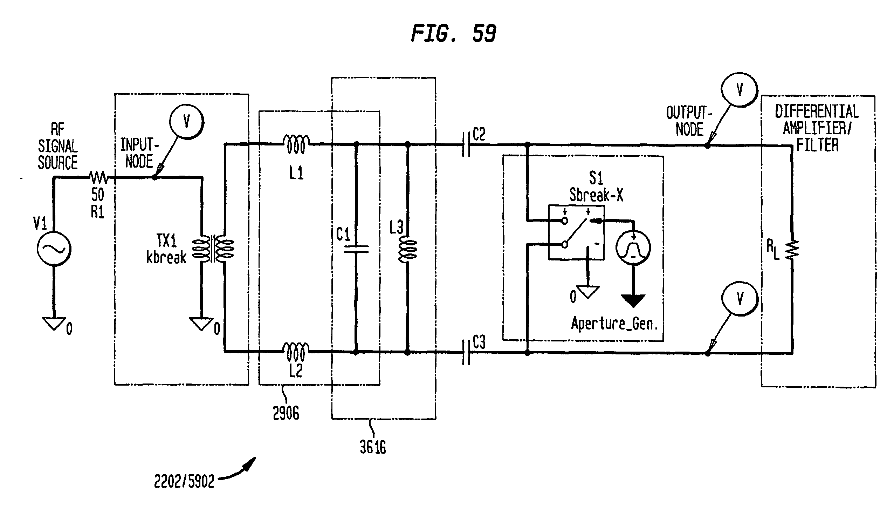

Gated transfer systems and inverted gated transfer systems can be implemented with any of the various optimizations and configurations disclosed through the specification, such as, for example, impedance matching, tanks and resonant structures, bypass networks, etc. For example, FIG. 58 illustrates the energy transfer system 2202 as a differential system 5802, which utilizes gated transfer modules with an input impedance matching system 2906 and a tank circuit 3616, which share a common capacitor. Similarly, FIG. 59 illustrates the energy transfer system 2202 as a differential system 5902, which utilizes an inverted gated transfer module with an input impedance matching system 2906 and a tank circuit 3616, which share a common capacitor.

### 4.3 Smoothing the Down-Converted Signal

The down-converted signal 2208 may be smoothed by filtering as desired. The differential circuit 3544 implemented as a filter in FIG 35E illustrates but one example. This may be accomplished in any of the described embodiments by hardware, firmware and software implementation as is well known by those skilled in the arts.

### 4.4 Impedance Matching

The energy transfer module 2204 has input and output impedances generally defined by (1) the duty cycle ofthe switch module, and (2) the impedance ofthe storage module 2406, at the frequencies of interest (e.g. at the modulated carrier input, and intermediate/baseband frequencies).

Starting with an aperture width of approximately ½ the period of the modulated carrier signal 2210 being down-converted as a preferred embodiment, this aperture width (e.g. the "closed time") can be decreased. As the aperture width is decreased, the characteristic impedance at the input and the output of the energy transfer module increases. Alternatively, as the aperture width increases from ½ the period of the modulated carrier signal being down-converted, the impedance of the energy transfer module decreases.

One of the steps in determining the characteristic input impedance of the energy transfer module could be to measure its value. In an embodiment, the energy transfer module's characteristic input impedance is 300 ohms. An impedance matching circuit can be utilized to efficiently couple an input modulated carrier signal that has a source impedance of, for example, 50 ohms, with the energy transfer module's impedance of, for example, 300 ohms. Matching these impedances can be accomplished in various manners, including providing the necessary impedance directly or the use of an impedance match circuit as described below.

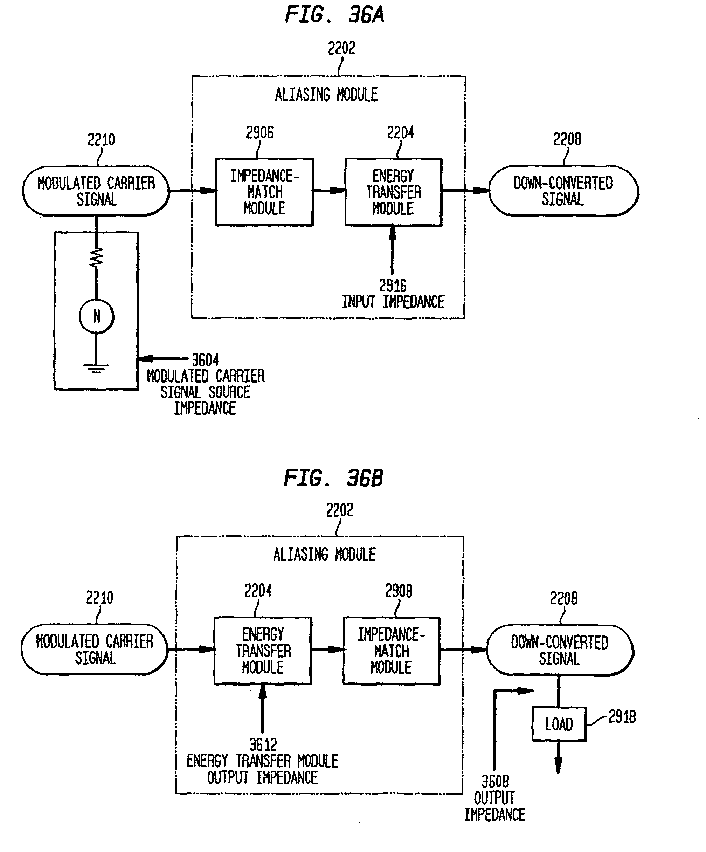

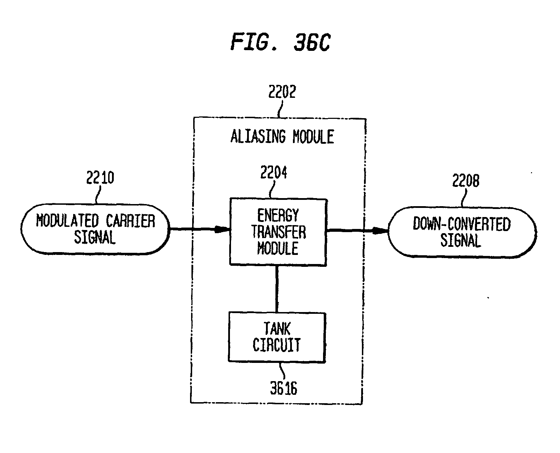

FIG. 36A illustrates an example implementation of the energy transfer system 2202 including an input impedance 2916 and input impedance match module 2906. FIG. 36B illustrates an example implementation of the energy transfer system 2202 including an output impedance 3608 and an output impedance match module 2908. FIG. 36C illustrates an example implementation of the energy transfer system 2202 including an example tank circuit 3616.

Referring to FIG. 29, a specific embodiment using an RF signal as an input, assuming that a source impedance 2912 is a relatively low impedance of approximately 50 Ohms, for example, and the input impedance 2916 is approximately 300 Ohms, an initial configuration for the input impedance match module 2906 can include an inductor 3206 and a capacitor 3208, configured as shown in FIG. 32. The configuration of the inductor 3206 and the capacitor 3208 is a possible configuration when going from a low impedance to a high impedance. Inductor 3206 and the capacitor 3208 constitute an L match, the calculation of the values which is well known to those skilled in the relevant arts.

The output characteristic impedance can be impedance matched to take into consideration the desired output frequencies. One of the steps in determining the characteristic output impedance of the energy transfer module could be to measure its value. Balancing the very low impedance of the storage module at the input modulated carrier frequency, the storage module should have an impedance at the desired output frequencies that is preferably greater than or equal to the load that is intended to be driven (for example, in an embodiment, storage module impedance at a desired 1MHz output frequency is 2K ohm and the desired load to be driven is 50 ohms). An additional benefit of impedance matching is that filtering of unwanted signals can also be accomplished with the same components.

In an embodiment, the energy transfer module's characteristic output impedance is 2K ohms. The output impedance match module 2908 can be utilized to efficiently couple the down-converted signal 2208 with an output impedance of, for example, 2K ohms, to a load of, for example, 50 ohms. Matching these impedances can be accomplished in various manners, including providing the necessary load impedance directly or the use of an impedance match circuit as described below.

When matching from a high impedance to a low impedance, a capacitor 3214 and an inductor 3216 can be configured as shown in FIG. 32. The capacitor 3214 and the inductor 3216 constitute an L match, the calculation of the component values being well known to those skilled in the relevant arts.

The configuration of the input impedance match module 2906 and the output impedance match module 2908 are considered to be initial starting points for impedance matching, in accordance with the present invention. In some situations, the initial designs may be suitable without further optimization. In other situations, the initial designs can be optimized in accordance with other various design criteria and considerations.

As other optional optimizing structures and/or components are utilized, their effect on the characteristic impedance of the energy transfer module should be taken into account in the match along with their own original criteria.

### 4.5 Tanks and Resonant Structures

Resonant tank and other resonant structures can be used to further optimize the energy transfer characteristics of the invention. For example, resonant structures, resonant about the input frequency, can be used to store energy from the input signal when the switch is open, a period during which one may conclude that the architecture would otherwise be limited in its maximum possible efficiency. Resonant tank and other resonant structures can include, but are not limited to, surface acoustic wave (SAW) filters, dielectric resonators, diplexers, capacitors, inductors, etc.

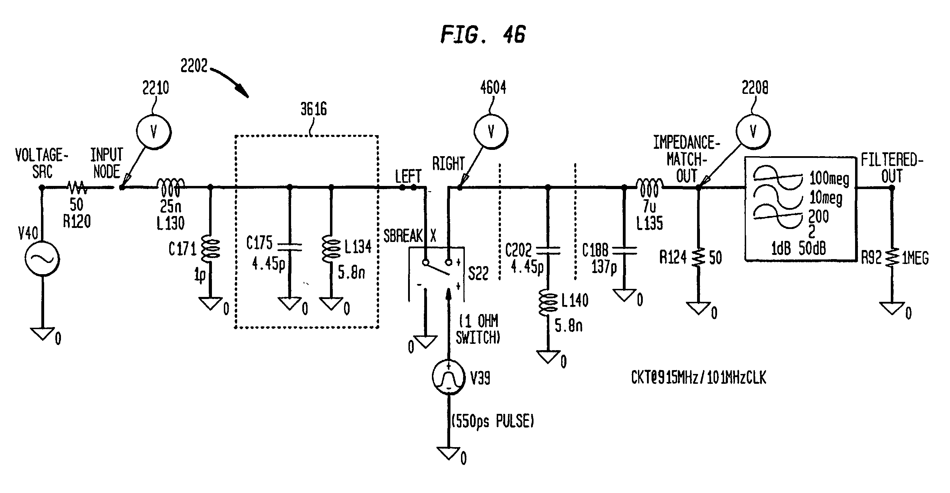

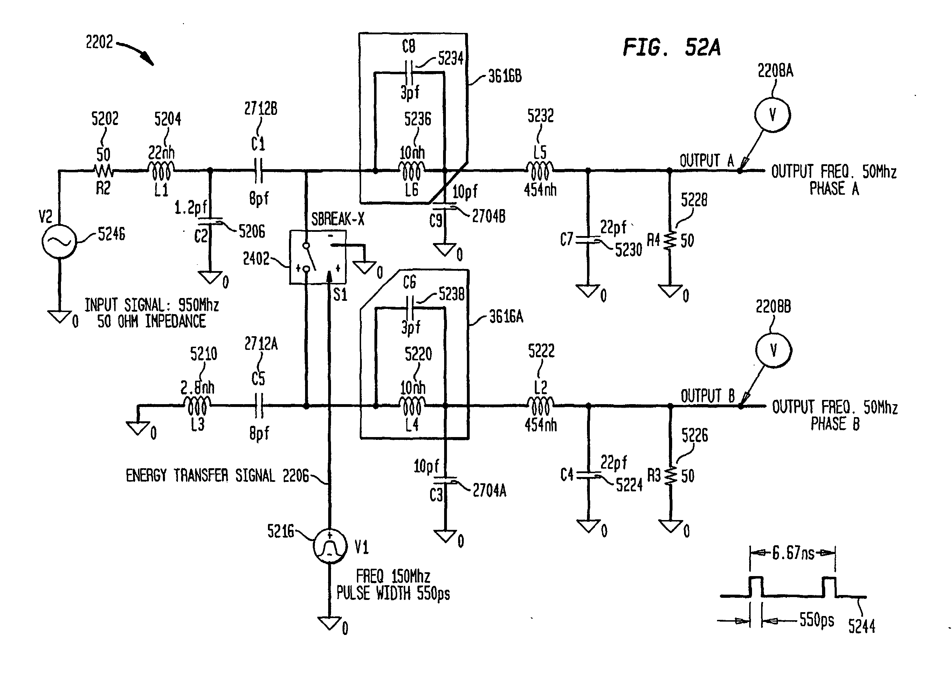

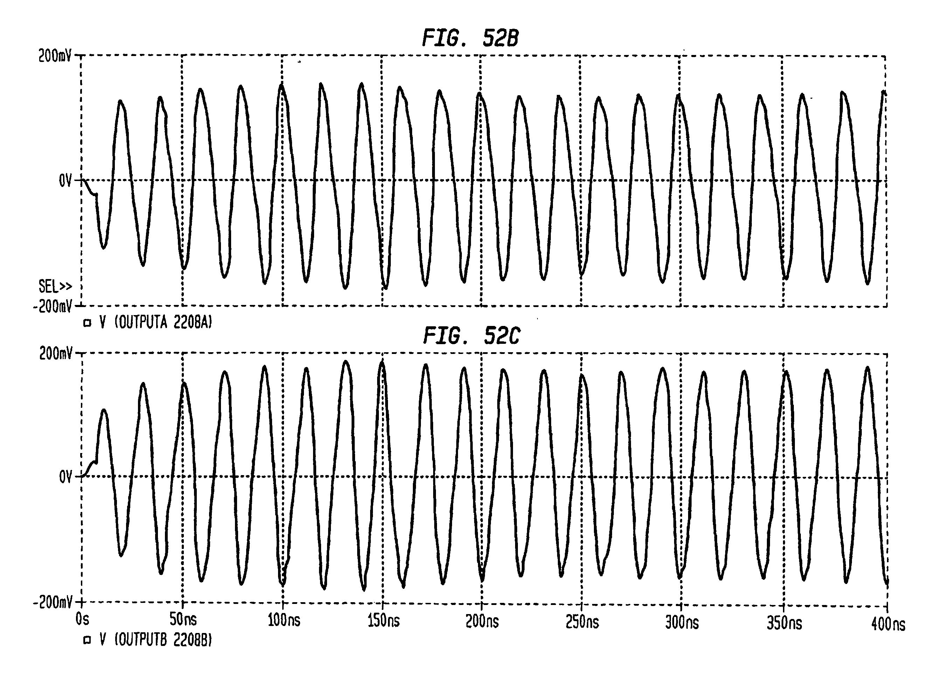

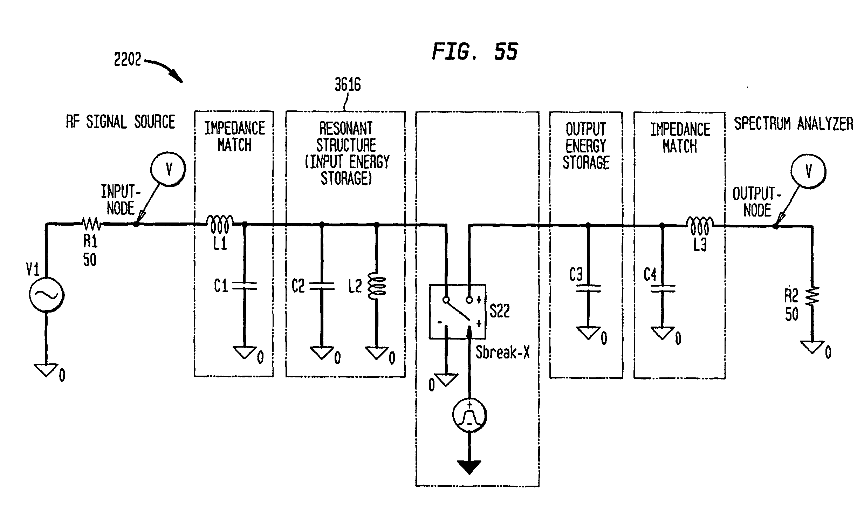

FIG. 36C illustrates an example implementation of the energy transfer system 2202 including an example tank circuit 3616. An example embodiment is shown in FIG. 52A. Two additional embodiments are shown in FIG. 46 and FIG. 55.

FIG. 52A illustrates parallel tank circuits in a differential implementation. A first parallel resonant or tank circuit 3616A consists of a capacitor 5238 and an inductor 5220. A second tank circuit 3616B consists of a capacitor 5234 and an inductor 5236.

As is apparent to one skilled in the relevant art(s), parallel tank circuits provide:

low impedance to frequencies below resonance;
low impedance to frequencies above resonance; and
high impedance to frequencies at and near resonance.

In the illustrated example of FIG. 52A, the first tank circuit 3616A and the second tank circuit 3616B resonate at approximately 920Mhz. At and near resonance, the impedance of these circuits is relatively high. Therefore, in the circuit configuration shown in FIG 52A, both tank circuits appear as relatively high impedance to the input frequency of 950Mhz, while simultaneously appearing as relatively low impedance to frequencies in the desired output range of 50Mhz.

The energy transfer signal 2206 controls the switch 2402. When the energy transfer signal 2206 controls the switch 2402 to open and close, high frequency signal components are not allowed to pass through tank circuit 3616A or tank circuit 3616B. However, the lower signal components (50Mhz in this embodiment) generated by the system are allowed to pass through tank circuit 3616A and tank circuit 3616B with little attenuation. The effect of tank circuit 3616A and tank circuit 3616B is to further separate the input and output signals from the same node thereby producing a more stable input and output impedance. Capacitors 2704A and 2704B act to store the 50Mhz output signal energy between energy transfer pulses.

Further energy transfer optimization is provided by placing an inductor 5210 in series with a storage capacitor 5212 as shown. In the illustrated example, the series resonant frequency of this circuit arrangement is approximately 1 GHz. This circuit increases the energy transfer characteristic of the system. The ratio of the impedance of inductor 5210 and the impedance of the storage capacitor 5212 is preferably kept relatively small so that the majority of the energy available will be transferred to storage capacitor 2704A during operation. Exemplary output signals 2208A and 2208B are illustrated in FIGs. 52B and 52C, respectively.

In FIG. 52A, circuit components 5204 and 5206 form an input impedance match. Circuit components 5232 and 5230 form an output impedance match into a 50 ohm resistor 5228. Circuit components 5222 and 5224 form a second output impedance match into a 50 ohm resistor 5226. Capacitors 2712A and 2712B act as storage capacitors for the embodiment. Voltage source 5246 and resistor 5202 generate a 950Mhz signal with a 50ohm output impedance, which are used as the input to the circuit Circuit element 5216 includes a 150Mhz oscillator and a pulse generator, which are used to generate the energy transfer signal 2206.

FIG. 46 illustrates a shunt tank circuit 3616 in a single-ended to-single-ended system 2202. Similarly, FIG. 55 illustrates a shunt tank circuit 3616 in a system 2202. The tank circuits 3616 in FIGS. 46 and 55 lower driving source impedance, which improves transient response. The tank circuits 3616 in FIGS. 46 and 55 are able store the energy from the input signal and provide a low driving source impedance to transfer that energy throughout the aperture of the closed switch. The transient nature of the switch aperture can be viewed as having a response that, in addition to including the input frequency, has large component frequencies above the input frequency, (i.e. higher frequencies than the input frequency are also able to effectivelypass through the aperture). Resonant circuits or structures, for example resonant tanks 3616 in FIGS. 46 and 55, can take advantage of this by being able to transfer energy throughout the switch's transient frequency response (i.e. the capacitor in the resonant tank appears as a low driving source impedance during the transient period of the aperture).

The example tank and resonant structures described above are for illustrative purposes and are not limiting. Alternate configurations can be utilized. The various resonant tanks and structures discussed can be combined or utilized independently as is now apparent.

### 4.6 Charge and Power Transfer Concepts

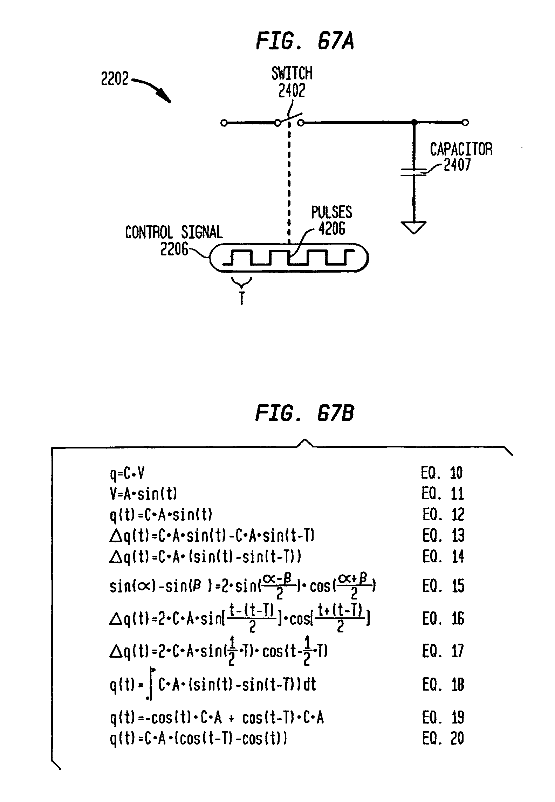

Concepts of charge transfer are now described with reference to FIGS. 67A-F. FIG. 67A illustrates the energy transfer system 2202, including a switch module 2402 and a capacitor 2704 having a capacitance C. The switch module 2402 is controlled by the energy transfer signal 2206, which includes pulses 4206 having apertures 1301, denoted here as T.

In FIG. 67B, Equation 10 illustrates that the charge q on a capacitor having a capacitance C, such as the capacitor 2704, is proportional to the voltage V across the capacitor, where:

q = Charge in Coulombs
C = Capacitance in Farads
V = Voltage in Volts
A = Input Signal Amplitude

Where the voltage V is represented by Equation 11, Equation 10 can be rewritten as Equation 12. The change in charge Δq over time t is illustrated as in Equation 13 as Δq(t), which can be rewritten as Equation 14. Using the sum-to-product trigonometric identity of Equation 15, Equation 14 can be rewritten as Equation 16, which can be rewritten as equation 17.

Note that the sin term in Equation 11 is a function of the aperture T only. Thus, Δq(t) is at a maximum when T is equal to an odd multiple of π (i.e., π, 3π, 5π,...). Therefore, the capacitor 2704 experiences the greatest change in charge when the aperture T has a value of π or a time interval representative of 180 degrees of the input sinusoid. Conversely, when T is equal to 2π, 4π, 6π, ..., minimal charge is transferred.

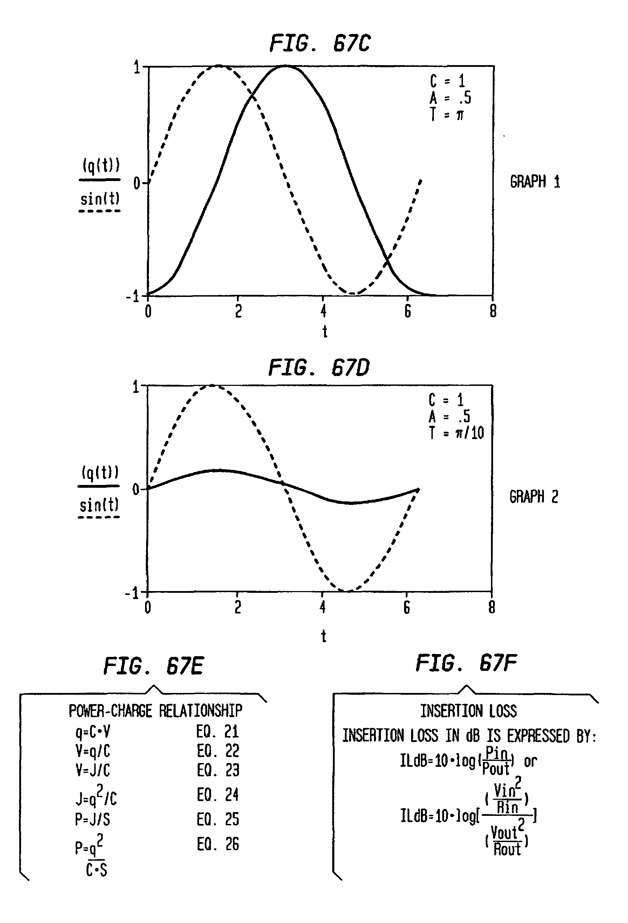

Equations 18, 19, and 20 solve for q(t) by integrating Equation 10, allowing the charge on the capacitor 2704 with respect to time to be graphed on the same axis as the input sinusoid sin(t), as illustrated in the graph of FIG. 67C. As the aperture T decreases in value or tends toward an impulse, the phase between the charge on the capacitor C or q(t) and sin(t) tend toward zero. This is illustrated in the graph of FIG. 67D, which indicates that the maximum impulse charge transfer occurs near the input voltage maxima. As this graph indicates, considerably less charge is transferred as the value of T decreases.

Power/charge relationships are illustrated in Equations 21-26 of FIG. 67E, where it is shown that power is proportional to charge, and transferred charge is inversely proportional to insertion loss.

Concepts of insertion loss are illustrated in FIG. 67F. Generally, the noise figure of a lossy passive device is numerically equal to the device insertion loss. Alternatively, the noise figure for any device cannot be less that its insertion loss. Insertion loss can be expressed by Equation 27 or 28.

From the above discussion, it is observed that as the aperture T increases, more charge is transferred from the input to the capacitor 2704, which increases power transfer from the input to the output. It has been observed that it is not necessary to accurately reproduce the input voltage at the output because relative modulated amplitude and phase information is retained in the transferred power.

### 4.7 Optimizing and Adjusting the Non-Negligible Aperture Width/Duration

### 4.7.1 Varying Input and Output Impedances

In an embodiment of the invention, the energy transfer signal 2206 of FIG.22 is used to vary the input impedance seen by the modulated carrier signal 2210 and to vary the output impedance driving a load. An example of this embodiment is described below using the gated transfer module 2304 shown in FIG. 27G, and in FIG. 41A. The method described below is not limited to the gated transfer module 2304, as it can be applied to all of the embodiments of energy transfer module 2204.

In FIG. 41A, when switch 2402 is closed, the impedance looking into circuit 2202 is substantially the impedance of storage module illustrated as the storage capacitance 2704, in parallel with the impedance of the load 2918. When the switch 2402 is open, the impedance at point 4114 approaches infinity. It follows that the average impedance at point 4114 can be varied from the impedance of the storage module illustrated as the storage capacitance 2704, in parallel with the load 2918, to the highest obtainable impedance when switch 2402 is open, by varying the ratio of the time that switch 2402 is open to the time switch 2402 is closed. Since the switch 2402 is controlled by the energy transfer signal 2206, the impedance at point 4114 can be varied by controlling the aperture width of the energy transfer signal, in conjunction with the aliasing rate.

An example method of altering the energy transfer signal 2206 of FIG. 22 is now described with reference to FIG. 30, where the circuit 3002 receives the input oscillating signal 2724 and outputs a pulse train shown as doubler output signal 3004. The circuit 3002 can be used to generate the energy transfer signal 2206. Example waveforms of 3004 are shown on FIG. 31B.

It can be shown that by varying the delay of the signal propagated by the inverter 3008, the width of the pulses in the doubler output signal 3004 can be varied. Increasing the delay of the signal propagated by inverter 3008, increases the width of the pulses. The signal propagated by inverter 3008 can be delayed by introducing a R/C low pass network in the output of inverter 3008. Other means of altering the delay of the signal propagated by inverter 3008 will be well known to those skilled in the art.

### 4.7.2 Real Time Aperture Control

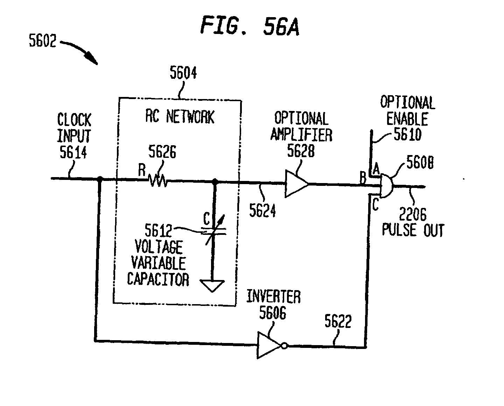

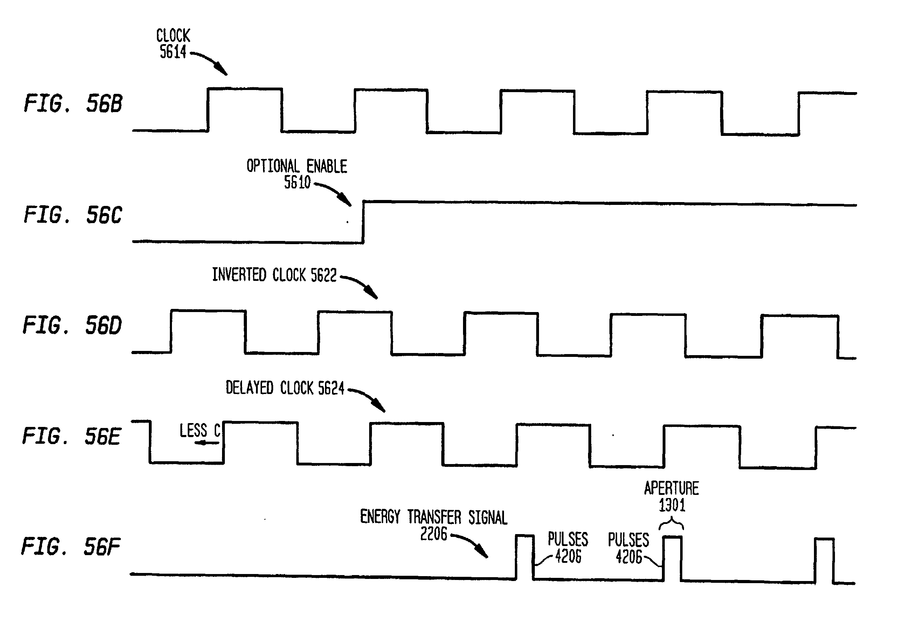

In an embodiment, the aperture width/duration is adjusted in real time. For example, referring to the timing diagrams in FIGS. 56B-F, a clock signal 5614 (FIG. 56B) is utilized to generate the energy transfer signal 2206 (FIG. 56F), which includes energy transfer pulses 4206, having variable apertures 1301. In an embodiment, the clock signal 5614 is inverted as illustrated by inverted clock signal 5622 (FIG. 56D). The clock signal 5614 is also delayed, as illustrated by delayed clock signal 5624 (FIG. 56E). The inverted clock signal 5614 and the delayed clock signal 5624 are then ANDed together, generating the energy transfer signal 2206, which is active - energy transfer pulses 4206 - when the delayed clock signal 5624 and the inverted clock signal 5622 are both active. The amount of delay imparted to the delayed clock signal 5624 substantially determines the width or duration of the apertures 1301. By varying the delay in real time, the apertures are adjusted in real time.

In an alternative implementation, the inverted clock signal 5622 is delayed relative to the original clock signal 5614, and then ANDed with the original clock signal 5614. Alternatively, the original clock signal 5614 is delayed then inverted, and the result ANDed with the original clock signal 5614.

FIG. 56A illustrates an exemplary real time aperture control system 5602 that can be utilized to adjust apertures in real time. The example real time aperture control system 5602 includes an RC circuit 5604, which includes a voltage variable capacitor 5612 and a resistor 5626. The real time aperture control system 5602 also includes an inverter 5606 and an AND gate 5608. The AND gate 5608 optionally includes an enable input 5610 for enabling/disabling the AND gate 5608. The real time aperture control system 5602 optionally includes an amplifier 5628.

Operation of the real time aperture control circuit is described with reference to the timing diagrams of FIGS. 56B-F. The real time control system 5602 receives the input clock signal 5614, which is provided to both the inverter 5606 and to the RC circuit 5604. The inverter 5606 outputs the inverted clock signal 5622 and presents it to the AND gate 5608. The RC circuit 5604 delays the clock signal 5614 and outputs the delayed clock signal 5624. The delay is determined primarily by the capacitance of the voltage variable capacitor 5612. Generally, as the capacitance decreases, the delay decreases.

The delayed clock signal 5624 is optionally amplified by the optional amplifier 5628, before being presented to the AND gate 5608. Amplification is desired, for example, where the RC constant of the RC circuit 5604 attenuates the signal below the threshold of the AND gate 5608.

The AND gate 5608 ANDs the delayed clock signal 5624, the inverted clock signal 5622, and the optional Enable signal 5610, to generate the energy transfer signal 2206. The apertures 1301 are adjusted in real time by varying the voltage to the voltage variable capacitor 5612.

In an embodiment, the apertures 1301 are controlled to optimize power transfer. For example, in an embodiment, the apertures 1301 are controlled to maximize power transfer. Alternatively, the apertures 1301 are controlled for variable gain control (e.g. automatic gain control - AGC). In this embodiment, power transfer is reduced by reducing the apertures 1301.

As can now be readily seen from this disclosure, many of the aperture circuits presented, and others, can be modified in the manner described above (e.g. circuits in FIGS. 27 H-K). Modification or selection of the aperture can be done at the design level to remain a fixed value in the circuit, or in an alternative embodiment, may be dynamically adjusted to compensate for, or address, various design goals such as receiving RF signals with enhanced efficiency that are in distinctively different bands of operation, e.g. RF signals at 900MHz and 1.8GHz.

### 4.8 Adding a Bypass Network

In an embodiment of the invention, a bypass network is added to improve the efficiency of the energy transfer module. Such a bypass network can be viewed as a means of synthetic aperture widening. Components for a bypass network are selected so that the bypass network appears substantially lower impedance to transients ofthe switch module (i.e., frequencies greater than the received modulated carrier signal) and appears as a moderate to high impedance to the input modulated carrier signal (e.g., greater that 100 Ohms at the RF frequency).

The time that the input signal is now connected to the opposite side of the switch module is lengthened due to the shaping caused by this network, which in simple realizations may be a capacitor or series resonant inductor-capacitor. A network that is series resonant above the input frequency would be a typical implementation. This shaping improves the conversion efficiency of an input signal that would otherwise, if one considered the aperture of the energy transfer signal only, be relatively low in frequency to be optimal.

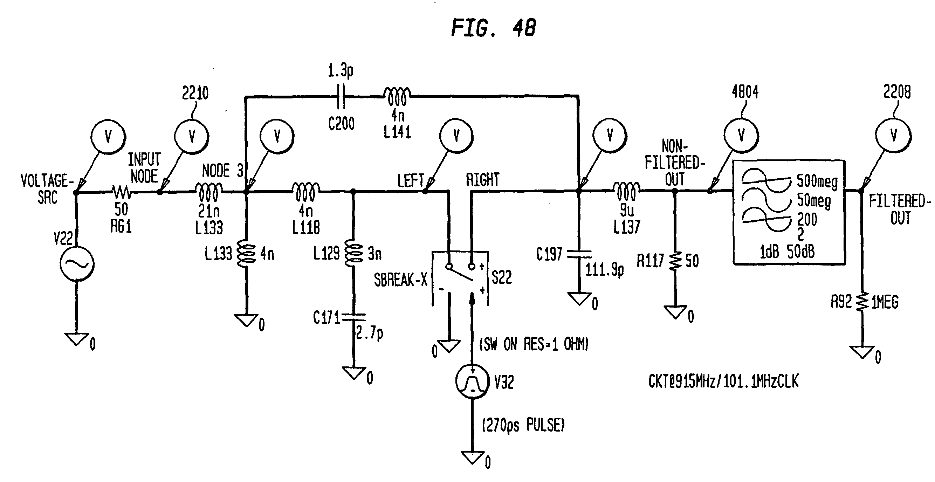

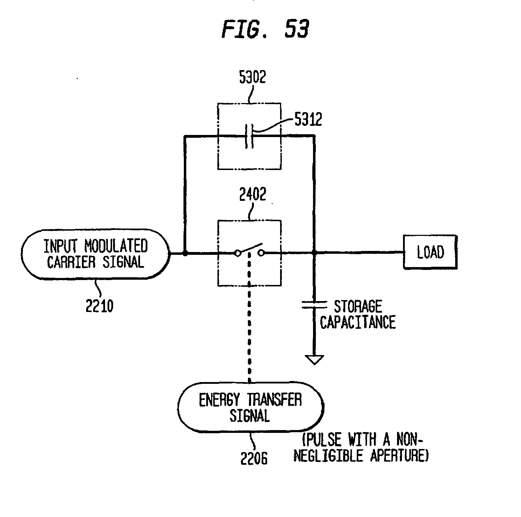

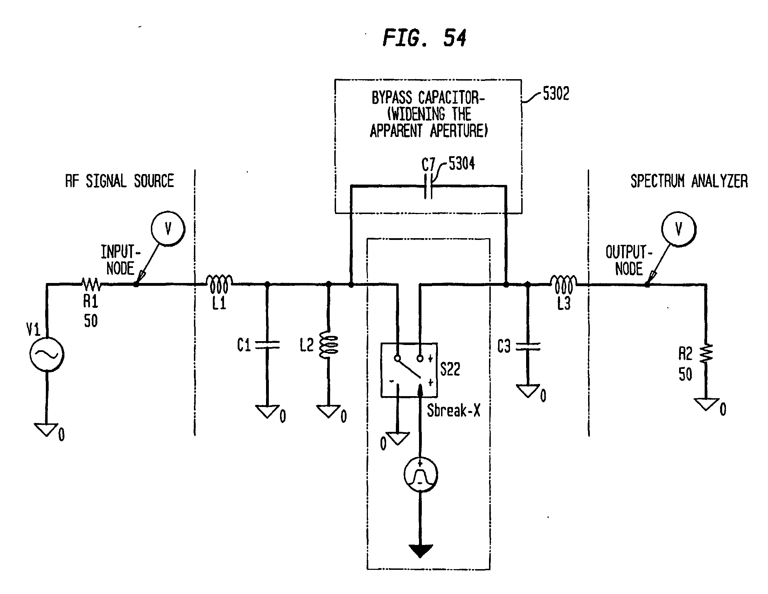

For example, referring to FIG. 53 a bypass network 5302 (shown in this instance as capacitor 5312), is shown bypassing switch module 2402. In this embodiment the bypass network increases the efficiency of the energy transfer module when, for example, less than optimal aperture widths were chosen for a given input frequency on the energy transfer signal 2206. The bypass network 5302 could be of different configurations than shown in FIG 53. Such an alternate is illustrated in FIG. 48. Similarly, FIG. 54 illustrates another example bypass network 5302, including a capacitor 5404.

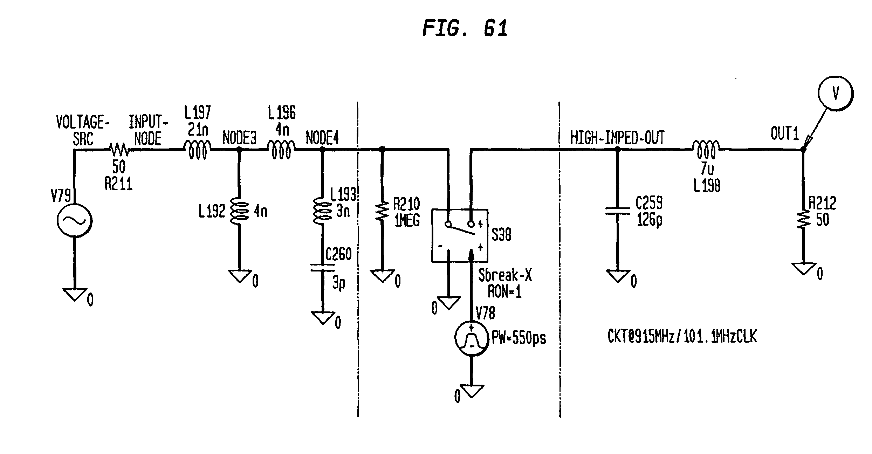

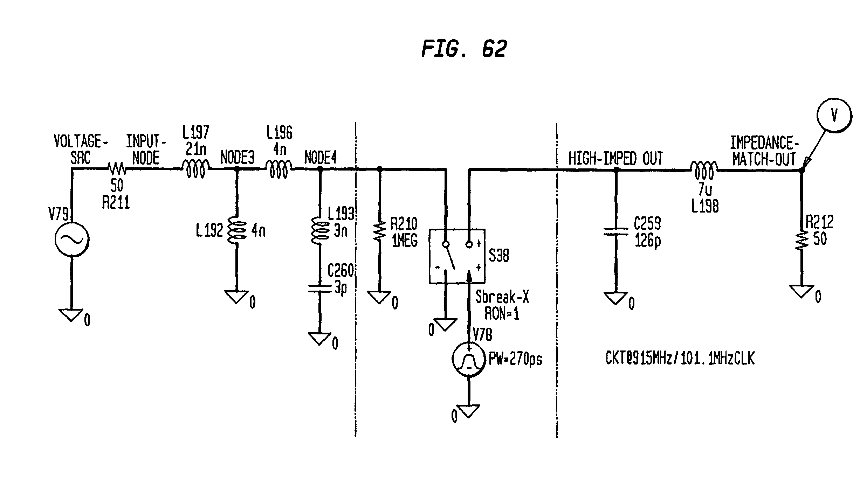

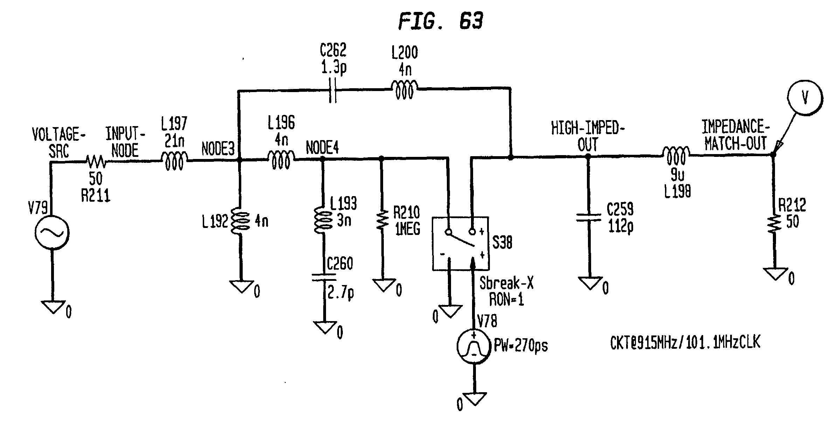

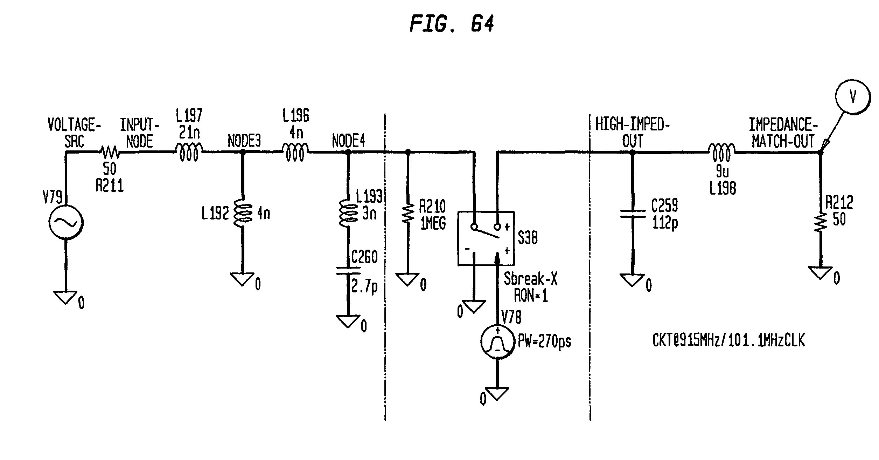

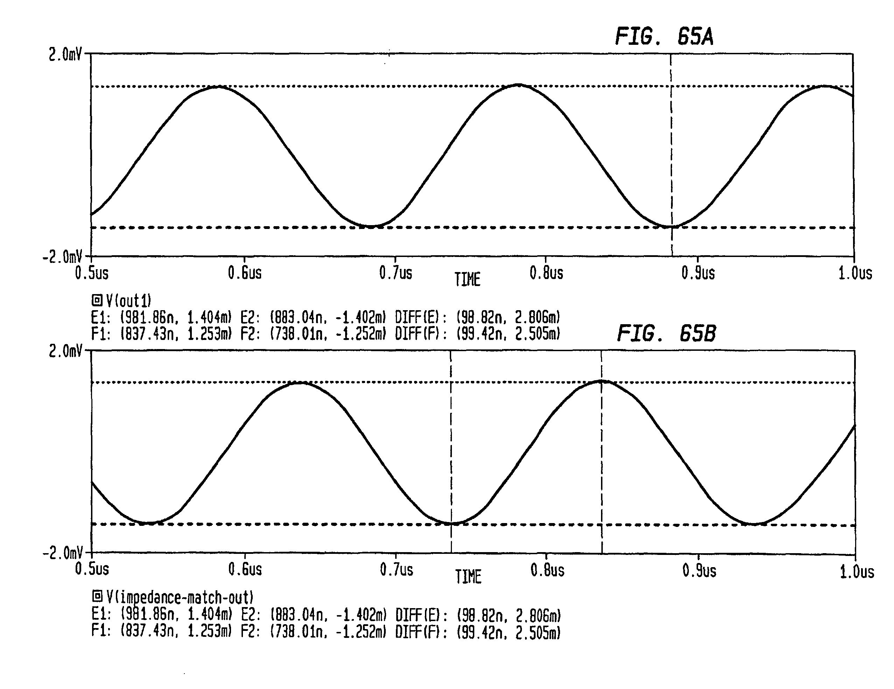

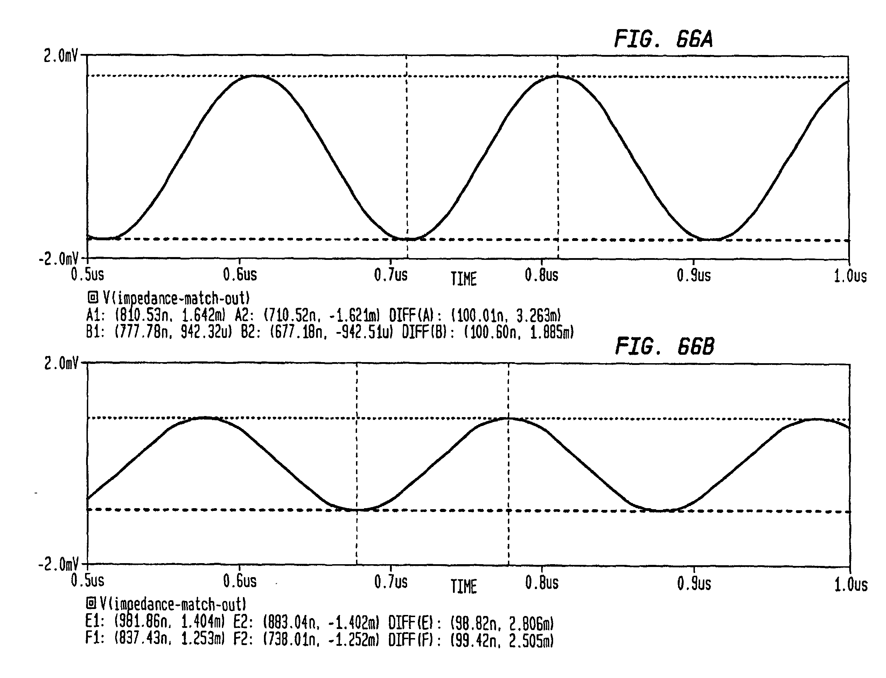

The following discussion will demonstrate the effects of a minimized aperture and the benefit provided by a bypassing network. Beginning with an initial circuit having a 550ps aperture in FIG. 61, its output is seen to be 2.8mVpp applied to a 50 ohm load in FIG. 65A. Changing the aperture to 270ps as shown in FIG. 62 results in a diminished output of 2.5Vpp applied to a 50 ohm load as shown in FIG. 65B. To compensate for this loss, a bypass network may be added, a specific implementation is provided in FIG. 63. The result of this addition is that 3.2Vpp can now be applied to the 50 ohm load as shown in FIG. 66A. The circuit with the bypass network in FIG. 63 also had three values adjusted in the surrounding circuit to compensate for the impedance changes introduced by the bypass network and narrowed aperture. FIG. 64 verifies that those changes added to the circuit, but without the bypass network, did not themselves bring about the increased efficiency demonstrated by the embodiment in FIG. 63 with the bypass network. FIG. 66B shows the result of using the circuit in FIG. 64 in which only 1.88Vpp was able to be applied to a 50 ohm load.

### 4.9 Modifying the Energy Transfer Signal Utilizing Feedback

FIG. 28 shows an embodiment of the energy transfer system 2202 which uses down-converted signal 2208 as feedback 2806 to control various characteristics of the energy transfer module 2204 to modify the down-converted signal 2208.

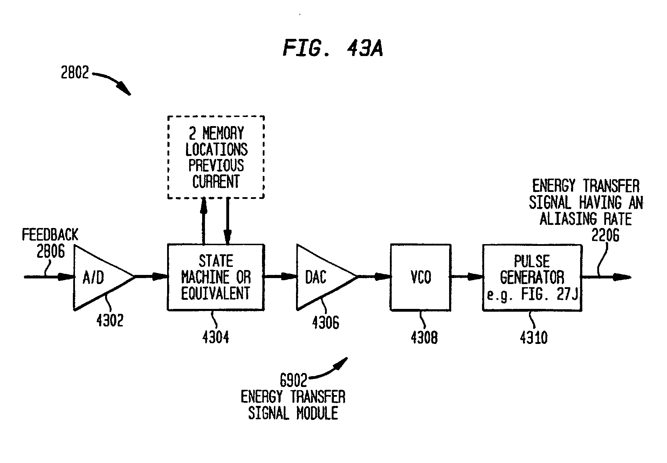

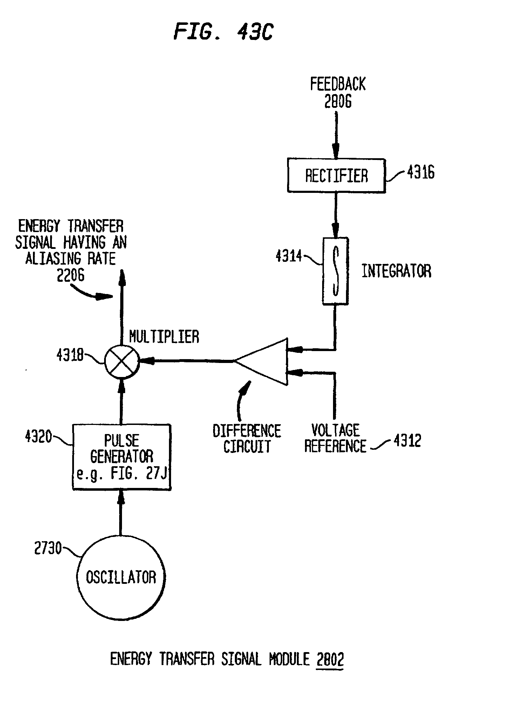

Generally, the amplitude of the down-converted signal 2208 varies as a function of the frequency and phase differences between the modulated carrier signal 2210 and the energy transfer signal 2206. In an embodiment, the down-converted signal 2208 is used as the feedback 2806 to control the frequency and phase relationship between the modulated carrier signal 2210 and the energy transfer signal 2206. This can be accomplished using the example logic in FIG 43A. The example circuit in FIG. 43A can be included in the energy transfer signal module 2802.

In the example of FIG. 43A, a state machine 4304 reads an analog to digital converter, A/D 4302, and controls a digital to analog converter, DAC 4306. In an embodiment, the state machine 4304 includes 2 memory locations, *Previous* and *Current,* to store and recall the results of reading A/D 4302. In an embodiment, the state machine 4304 utilizes at least one memory flag.

The DAC 4306 controls an input to a voltage controlled oscillator, VCO 4308. VCO 4308 controls a frequency input of a pulse generator 4310, which, in an embodiment, is substantially similar to the pulse generator shown in FIG. 27J. The pulse generator 4310 generates energy transfer signal 2206.

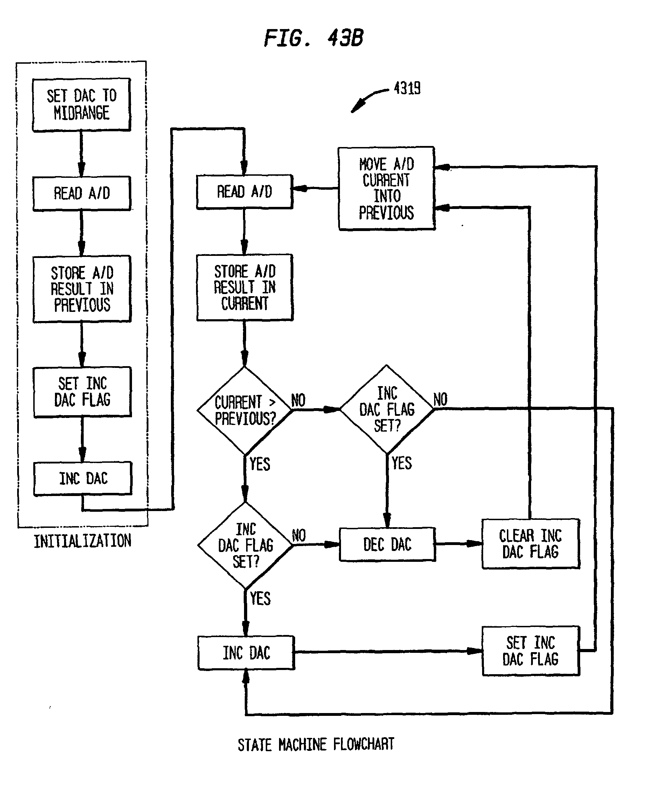

In an embodiment, the state machine 4304 operates in accordance with a state machine flowchart 4319 in FIG. 43B. The result of this operation is to modify the frequency and phase relationship between the energy transfer signal 2206 and the modulated carrier signal 2210, to substantially maintain the amplitude of the down-converted signal 2208 at an optimum level.

The amplitude of the down-converted signal 2208 can be made to vary with the amplitude of the energy transfer signal 2206. In an embodiment where the switch module 2402 is a FET as shown in FIG 25A, wherein the gate 2504 receives the energy transfer signal 2206, the amplitude of the energy transfer signal 2206 can determine the "on" resistance of the FET, which affects the amplitude of the down-converted signal 2208. The energy transfer signal module 2802, as shown in FIG. 43C, can be an analog circuit that enables an automatic gain control function.

### 5. Example Energy Transfer Downconverters

Example implementations are described below for illustrative purposes. The invention is not limited to these examples.

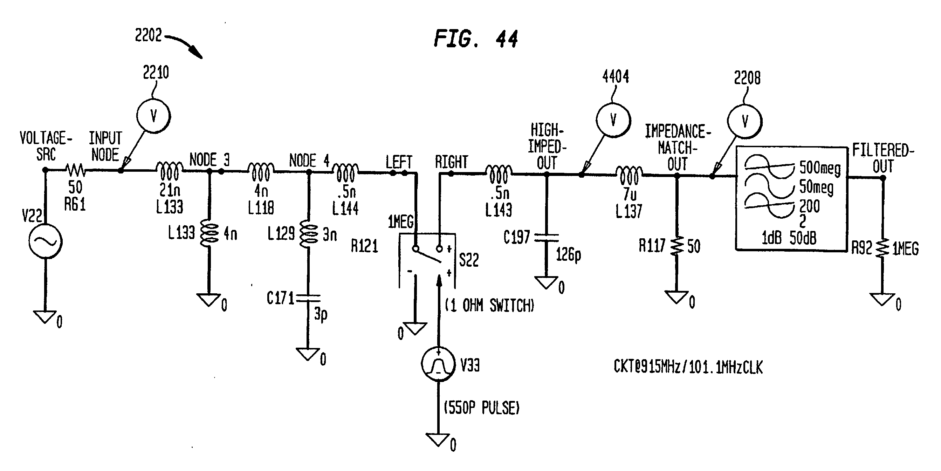

FIG. 44 is a schematic diagram of an exemplary energy transfer system 2202 circuit to down convert a 915 MHz signal to a 5 MHz signal using a 101.1 MHz clock.

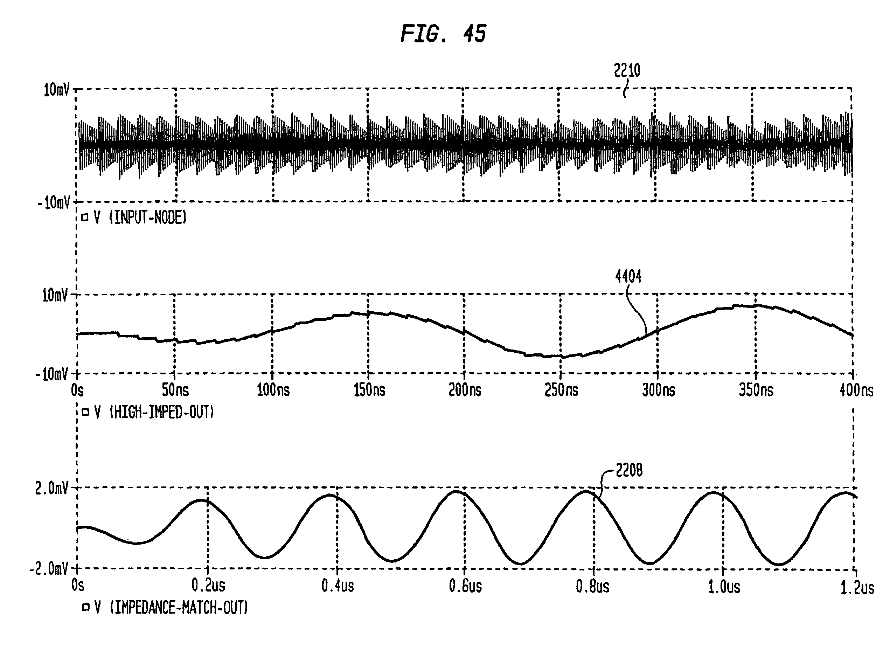

FIG. 45 shows example simulation waveforms for the circuit of FIG. 44. Waveform 2210 is the input to the circuit showing the distortions caused by the switch closure. Waveform 4404 is the unfiltered output at the storage unit. Waveform 2208 is the impedance matched output of the downconverter on a different time scale.

FIG. 46 is a schematic diagram of an exemplary energy transfer system 2202 circuit to downconvert a 915 MHz signal to a 5 MHz signal using a 101.1 MHz clock. The circuit has additional tank circuitry to improve conversion efficiency.

FIG. 89 shows example simulation waveforms for the circuit of FIG. 46. Waveform 2210 is the input to the circuit showing the distortions caused by the switch closure. Waveform 4604 is the unfiltered output at the storage unit Waveform 2208 is the output of the downconverter after the impedance match circuit.

FIG. 48 is a schematic diagram of an exemplary energy transfer system 2202 circuit to downconvert a 915 MHz signal to a 5 MHz signal using a 101.1 MHz clock. The circuit has switch bypass circuitry to improve conversion efficiency.

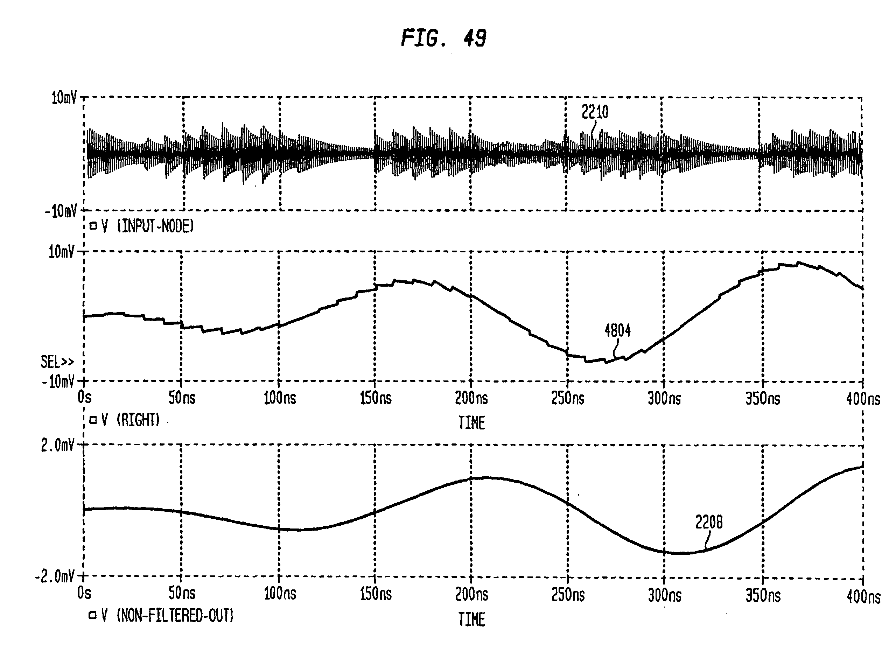

FIG. 49 shows example simulation waveforms for the circuit of FIG. 48. Waveform 2210 is the input to the circuit showing the distortions caused by the switch closure. Waveform 4804 is the unfiltered output at the storage unit. Waveform 2208 is the output of the downconverter after the impedance match circuit.

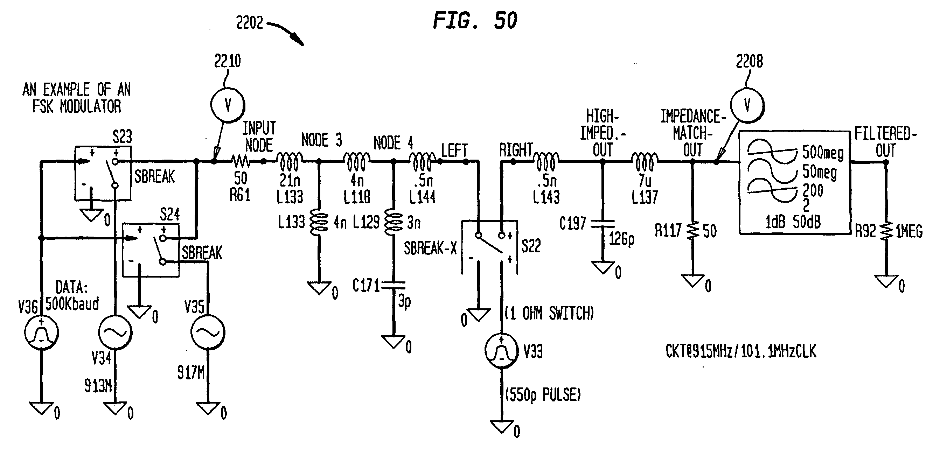

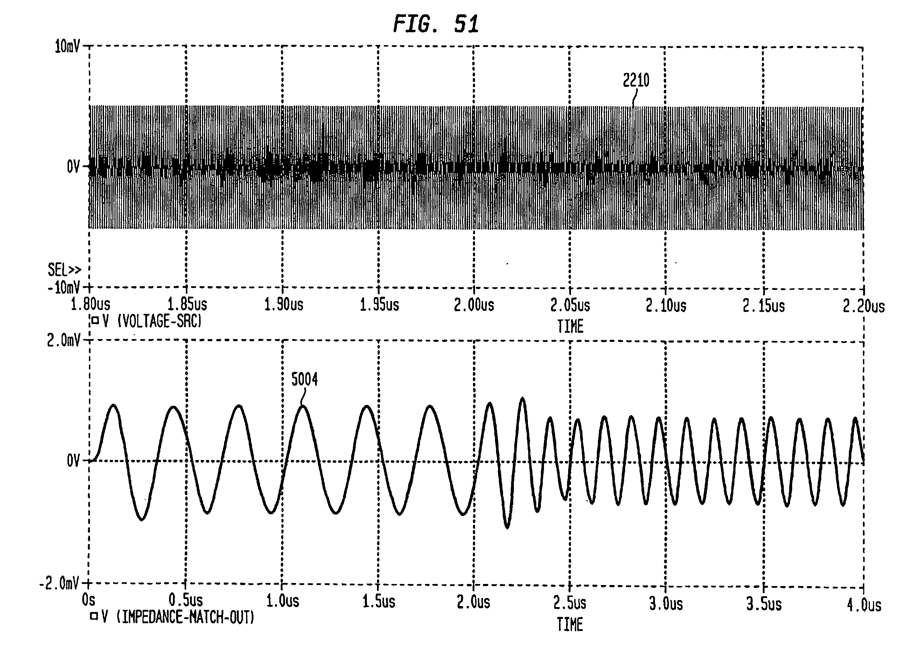

FIG. 50 shows a schematic of the example circuit in FIG. 44 connected to an FSK source that alternates between 913 and 917 MHz, at a baud rate of 500 Kbaud. FIG. 51 shows the original FSK waveform 2210 and the downconverted waveform 2208 at the output of the load impedance match circuit

### IV. Conclusions

Example embodiments of the methods, systems, and components of the present invention have been described herein. As noted elsewhere, these example embodiments have been described for illustrative purposes. The invention can be implemented in hardware, software, and combinations thereof.

### Claims

1. A method of down-converting a modulated electromagnetic carrier signal (2210) to a lower frequency modulated carrier signal (2208), comprising:

   1) receiving (1208) the modulated electromagnetic carrier signal (2210);
   2) transferring energy (1212) from the received modulated electromagnetic carrier signal (2210) to the lower frequency modulated carrier signal (2208) by repeatedly storing (2406) said energy over successive time apertures (1301) occurring at a rate that is an aliasing rate of the received modulated carrier signal, such rate being equal to the result of the division by n of the sum or difference of a frequency of the modulated electromagnetic carrier signal (2210) and a frequency of the lower frequency modulated carrier signal (2208), where *n* is an integer; and
3) generating (1212) the lower frequency modulated carrier signal (2208) from the stored energy;

wherein said transferring of energy substantially prevents accurate voltage reproduction of the received modulated electromagnetic carrier signal during the time apertures.

2. A method according to claim 1, wherein step 2) includes:

generating an energy transfer signal (2206) having a train of pulses (4206) at the aliasing rate, with non-negligible apertures (1301), and using the energy transfer signal (2206) to transfer the energy from the received modulated carrier signal (2210).

3. A method according to any preceding claim, wherein step 2) includes:

coupling the received modulated carrier signal (2210) to a reactive storage device (2701) at the aliasing rate.

4. A method according to claim 1, wherein step 2) includes:

gating (2304) the received carrier signal (2210) according to an energy transfer signal (2206) comprising a stream of pulses (4206), having non-negligible apertures (1301), that repeat at the aliasing rate.

5. A method according to claim 1, wherein step 2) includes:

a) transferring (1212) a non-negligible portion of energy contained in a portion of the received modulated carrier signal (2210); and
b) repeating step 2)a) at the aliasing rate.

6. A method according to any preceding claim, wherein step 2) includes controlling a frequency relationship between the received modulated carrier signal (2210) and the aliasing rate.

7. A method according to any one of claims 1 to 5, wherein step 2) includes controlling a phase relationship between the received modulated carrier signal (2210) and the aliasing rate.

8. A method according to any one of claims 1 to 5, wherein step 2) includes controlling a frequency relationship and a phase relationship between the received modulated carrier signal (2210) and the aliasing rate.

9. A method according to any one of claims 1 to 5, wherein the apertures (1301) are approximately equal in duration to half cycles of the received modulated carrier signal (2210).

10. A method according to any one of claims 1 to 5, wherein the apertures (1301) are approximately equal in duration to or greater in duration than ten percent of cycles of the received modulated carrier signal (2210).

11. A method according to any one of claims 1 to 5, wherein the apertures (1301) are approximately equal in duration to or greater in duration than twenty-five percent of cycles of the received modulated carrier signal (2210).

12. A method according to any one of claims 1 to 5, wherein the apertures (1301) are approximately equal in duration to or greater in duration than fifty percent of cycles of the received modulated carrier signal (2210).

13. A method according to any one of claims 1 to 5, wherein the apertures (1301) are approximately equal in duration to or greater in duration than seventy-five percent of cycles of the received modulated carrier signal (2210).

14. A method according to any one of claims 1 to 5, wherein the apertures (1301) are equal in duration to N cycles of the received modulated carrier signal (2210), wherein N equals A plus B, where A is a positive integer and B is a fraction of an integer.

15. A method according to any one of claims 1 to 14, wherein step 2) includes transferring non-negligible amounts of energy relative to energy contained in cycles of the received modulated carrier signal (2210).

16. A method according to claim 1, wherein step 2) includes generating a train of pulses (4206) having non-negligible apertures (1301) relative to a period of the received modulated carrier signal (2210).

17. A method according to claim 5, wherein step 2)a) includes transferring at least ten percent of the energy contained in a period of the received modulated carrier signal (2210).

18. A method according to claim 5, wherein step 2)a) includes transferring at least twenty-five percent of the energy contained in a period of the received modulated carrier signal (2210).

19. A method according to claim 5, wherein step 2)a) includes transferring at least fifty percent of the energy contained in a period of the received modulated carrier signal (2210).

20. A method according to claim 5, wherein step 2)a) includes transferring at least seventy-five percent of the energy contained in a period of the received modulated carrier signal (2210).

21. A method according to any one of claims 1 to 5, wherein the apertures (1301) are approximately equal in duration to half cycles of the received modulated carrier signal (2210) and are not aligned with the received modulated carrier signal (2210).

22. A method according to any one of claims 1 to 5, wherein the apertures (1301) are substantially synchronized with the received modulated carrier signal (2210).

23. A method according to any one of claims 1 to 5, wherein the apertures (1301) are not synchronized with the received modulated carrier signal (2210).

24. A method according to claim 2, wherein step 2) further includes generating the energy transfer signal (2206) independently of the received modulated carrier signal (2210).

25. A method according to any one of claims 1 to 5, wherein step 2) includes generating an asynchronous energy transfer signal (2206) having the aliasing rate and using the asynchronous energy transfer signal (2206) to store the energy from the received modulated carrier signal (2210).

26. A method according to any one of claims 1 to 5, wherein step 2) includes storing energy differentially.

27. A method according to any one of claims 1 to 5, wherein step 2) includes the step of:

   i) controlling the amount of energy transferred from the received modulated carrier signal (2210).

28. A method according to claim 27, wherein step 2)i) includes controlling an aperture (1301).

29. A method according to claim 28, wherein step 2)i) further includes controlling an aperture width.

30. A method according to claim 28, wherein step 2)i) further includes controlling an aperture frequency.

31. A method according to claim 28, wherein step 2)i) further includes controlling an aperture shape.

32. A method according to claim 27, wherein step 2)i) includes controlling energy transfer characteristics.

33. A method according to any preceding claim, wherein step 3) includes: discharging the stored energy between apertures (1301) in a controlled manner.

34. A method according to any preceding claim, wherein step 2) includes storing sufficient energy from the received modulated carrier signal (2210) to drive a load (2918) without additional buffering or amplification, wherein the load is a high impedance load or a low impedance load (2918).

35. A method according to any preceding claim, wherein step 2) includes storing energy from the received modulated carrier signal (2210) without pre-amplification (LNA) of the received modulated carrier signal (2210).

36. A method according to any preceding claim, wherein step 1) includes receiving the modulated carrier signal (2210) through a relatively low input impedance path (2906).

37. A method according to any preceding claim, wherein step 1) includes receiving the modulated carrier signal (2210) through a relatively efficient power transfer path (2906).

38. A method according to any preceding claim, wherein step 2) includes gating the received modulated carrier signal (2210) using a switch module (2402).

39. A method of claim 38, wherein the impedance of said switch module (2402) is matched to a source impedance (2912), thereby increasing energy transferred from said received modulated carrier signal (2210).

40. A method of claim 38, wherein the impedance of said switch module (2402) is matched to a load impedance (2918), thereby increasing energy transferred from said received modulated carrier signal (2210).

41. A method of claim 40, wherein said received modulated carrier signal (2210) is coupled to said switch module (2402) via a resonant circuit (2906, 3616), said resonant circuit (2906,3616) storing energy from components of said received modulated carrier signal (2210) while said switch module (2402) is open, and wherein energy stored in said resonant circuit (2906, 3616) is discharged via said switch module (2402) while said switch module (2402) is closed, thereby increasing energy transferred from said received modulated carrier signal (2210).

42. Apparatus for down-converting a modulated electromagnetic carrier signal (2210) to a lower frequency modulated carrier signal (2208), comprising:

   means for receiving (1208) the modulated electromagnetic carrier signal (2210);
   means (2202) for transferring energy from the received modulated electromagnetic carrier signal (2210) to the lower frequency modulated carrier signal (2208) by repeatedly storing (2406) said energy over successive time apertures (1301) occurring at a rate that is an aliasing rate of the received modulated carrier signal, such rate being equal to the result of the division by n of the sum in difference of a frequency of the modulated electromagnetic carrier signal (2210) and a frequency of the lower frequency modulated carrier signal (2208),

   where *n* is an integer; and
   means for generating (2406) the lower frequency modulated carrier signal (2208) from the stored energy;
   wherein said transferring of energy substantially prevents accurate voltage reproduction of the received modulated electromagnetic carrier signal during the time apertures.

43. Apparatus according to claim 42, wherein said means (2202) for transferring energy includes:

   means (2720) for generating an energy transfer signal (2206) having a train of pulses (4206) at the aliasing rate, with non-negligible apertures (1301) and means (2402) for using the energy transfer signal (2206) to transfer the energy from the received modulated carrier signal (2210).

44. Apparatus according to claim 42, wherein said means (2202) for transferring energy includes means (2402) for coupling the received modulated carrier signal (2210) to a reactive storage module (2701) at the aliasing rate.

45. Apparatus according to claim 42, wherein said means (2202) for transferring energy includes:

   means (2402) for gating the received modulated carrier signal (2210) according to an energy transfer signal (2206) comprising a stream of pulses (4206), having non-negligible apertures (1301), that repeat at the aliasing rate.

46. Apparatus according to claim 42, wherein said means (2202) for transferring energy includes:

   means (2402,2406,2206) for transferring non-negligible portions of energy contained in portions of the received modulated carrier signal (2210) at the aliasing rate.

47. Apparatus according to any one of claims 42 to 46, wherein said means (2202) for transferring energy includes means (2208) for controlling a frequency relationship between the received modulated carrier signal (2210) and the aliasing rate.

48. Apparatus according to any one of claims 42 to 46, wherein said means (2202) for transferring energy includes means (2208) for controlling a phase relationship between the received modulated carrier signal (2210) and the aliasing rate.

49. Apparatus according to any one of claims 42 to 46, wherein said means for storing energy includes means (2208) for controlling a frequency relationship and a phase relationship between the received modulated carrier signal (2210) and the aliasing rate.

50. Apparatus according to any one of claims 42 to 46, wherein the apertures (1301) are approximately equal in duration to half cycles of the received modulated carrier signal (2210).

51. Apparatus according to any one of claims 42 to 46, wherein the apertures (1301) are approximately equal in duration to or greater in duration than ten percent of cycles of the received modulated carrier signal (2210).

52. Apparatus according to any one of claims 42 to 46, wherein the apertures (1301) are approximately equal in duration to or greater in duration than twenty-five percent of cycles of the received modulated carrier signal (2210).

53. Apparatus according to any one of claims 42 to 46, wherein the apertures (1301) are approximately equal in duration to or greater in duration than fifty percent of cycles of the received modulated carrier signal (2210).

54. Apparatus according to any one of claims 42 to 46, wherein the apertures (1301) are approximately equal in duration to or greater in duration than seventy-five percent of cycles of the received modulated carrier signal (2210).

55. Apparatus according to any one of claims 42 to 46, wherein the apertures (1301) are equal in duration to N cycles of the received modulated carrier signal (2210), wherein N equals A plus B, where A is a positive integer and B is a fraction of an integer.

56. Apparatus according to any one of claims 42 to 55, wherein said means (2202) for transferring energy includes means for transferring non-negligible amounts of energy relative to energy contained in half cycles of the received modulated carrier signal (2210).

57. Apparatus according to any one of claims 42 to 46, wherein said means (2202) for transferring energy comprises means (2720) for generating a train of pulses (4206) having non-negligible apertures (1301) relative to a period of the received modulated carrier signal (2210).

58. Apparatus according to claim 46, wherein said means for transferring non-negligible portions of energy comprises means for transferring at least ten percent of the energy contained in a period of the received modulated carrier signal (2210).

59. Apparatus according to claim 46, wherein said means for transferring non-negligible portions of energy comprises means for transferring at least twenty-five percent of the energy contained in a period of the received modulated carrier signal (2210).

60. Apparatus according to claim 46, wherein said means for transferring non-negligible portions of energy comprises means for transferring at least fifty percent of the energy contained in a period of the received modulated carrier signal (2210).

61. Apparatus according to claim 46, wherein said means for transferring non-negligible portions of energy comprises means for transferring at least seventy five-percent of the energy contained in a period of the received modulated carrier signal (2210).

62. Apparatus according to any one of claims 42 to 46, wherein the apertures (1301) are approximately equal in duration to half cycles of the received modulated carrier signal (2210) and are not aligned with the received modulated carrier signal (2210).

63. Apparatus according to any one of claims 42 to 46, wherein the apertures (1301) are substantially synchronized with the received modulated carrier signal (2210).

64. Apparatus according to any one of claims 42 to 46, wherein the apertures (1301) are not synchronized with the received modulated carrier signal (2210).

65. Apparatus according to claim 43, wherein said means (2202) for transferring energy further includes means (2720) for generating the energy transfer signal (2206) independently of the received modulated carrier signal (2210).

66. Apparatus according to any one of claims 42 to 46, wherein said means (2202) for transferring energy includes means (2720) for generating an asynchronous energy transfer signal (2206) having the aliasing rate and for using the asynchronous energy transfer signal (2206) to store the energy from the received modulated carrier signal (2210).

67. Apparatus according to any one of claims 42 to 46, wherein said means (2202) for transferring energy comprises a first means (2308A) for storing energy and a second means (2308B) for storing energy, configured differentially.

68. Apparatus according to any one of claims 42 to 46, wherein said means (2202) for transferring energy includes means (5602) for controlling the amount of energy transferred from the received modulated carrier signal (2210).

69. Apparatus according to claim 68, wherein said means (5602) for controlling the amount of energy transferred from the received modulated carrier signal includes means for controlling the apertures (1301).

70. Apparatus according to claim 69, wherein said means (5602) for controlling the apertures includes means for controlling an aperture width.

71. Apparatus according to claim 69, wherein said means (5602) for controlling the apertures includes means (2802) for controlling an aperture frequency.

72. Apparatus according to claim 69, wherein said means (5602) for controlling the apertures includes means (8302) for controlling an aperture shape.

73. Apparatus according to claim 68, wherein said means (5602) for controlling the amount of energy transferred from the received modulated carrier signal (2210) includes means for controlling energy transfer characteristics.

74. Apparatus according to any one of claims 42 to 73, wherein said means for generating (2406) includes means for discharging the stored energy between apertures (1301) in a controlled manner.

75. Apparatus according to any one of claims 42 to 74, wherein said means (2202) for transferring energy (2202) includes means (2406) for storing energy from the modulated electromagnetic carrier signal (2210), wherein said means (2406) for storing energy is able to store sufficient energy from the received modulated carrier signal (2210) to drive a load (2918) without additional buffering or amplification, wherein the load is a high impedance load or a low impedance load (2918).

76. Apparatus according to any one of claims 42 to 75, wherein said means (2406) for storing energy is able to store energy from the received modulated carrier signal (2210) without pre-amplification (LNA) of the received modulated carrier signal (2210).

77. Apparatus according to any one of claims 42 to 76, wherein said means for receiving the modulated carrier signal is arranged to receive the modulated electromagnetic carrier signal (2210) through a relatively low input impedance path (2906).

78. Apparatus according to any one of claims 42 to 77, wherein said means for receiving the modulated electromagnetic carrier signal is arranged to receive the modulated electromagnetic carrier signal (2210) through a relatively efficient power transfer path (2906).

79. Apparatus according to any one of claims 42 to 78, wherein said means (2202) for transferring energy includes means (2308) for gating the received modulated carrier signal (2210) using a switch module (2402).

80. Apparatus according to claim 79, wherein said means (2202) for transferring energy further includes means (2906) for matching an impedance (2916) of said switch module (2402) to a source impedance (3604), thereby increasing energy transferred from said received modulated carrier signal (2210).

81. Apparatus according to claim 79, wherein said means for storing energy further includes means (2908) for matching an impedance (2916) of said switch module (2402) to a load impedance (2918), thereby increasing energy transferred from said received modulated carrier signal (2210).

82. Apparatus according to claim 79, further comprising:

   means for coupling said received modulated carrier signal (2210) to said switch module (2402) via a resonant circuit (3616), said resonant circuit (3616) storing energy from components of said received modulated carrier signal (2210) while said switch module (2402) is open, and wherein energy stored in said resonant circuit (3616) is discharged via said switch module (2402) while said switch module (2402) is closed, thereby increasing energy transferred from said received modulated carrier signal (2210).

83. Apparatus according to any one of claims 42 to 46, further comprising:

   an input impedance match circuit (2906).

84. Apparatus according to any one of claims 42 to 46, further comprising:

   an output impedance match circuit (2908).

85. Apparatus according to any one of claims 42 to 46, further comprising:

   a tank circuit (3616).

86. Apparatus according to claim 79, further comprising:

   a bypass circuit (5302) in parallel with said switch module (2402).

87. Apparatus according to any one of claims 42 to 46, further comprising:

   a feedback loop (2806).

88. Apparatus according to any one of claims 42 to 46, wherein said means (2406) for storing energy includes:

   a capacitive storage device (2702) sized to store substantial amounts of energy relative to the approximate energy contained in cycles of the received modulated carrier signal (2210).

89. Apparatus according to any one of claims 42 to 46, wherein said means (2202) for transferring energy is implemented in a complimentary, metal oxide, semiconductor (C-MOS) material (8200).

90. Apparatus according to any one of claims 42 to 46, wherein said means (2202) for transferring energy is implemented in a single integrated circuit (8200).

91. Apparatus according to any one of claims 42 to 46, further comprising a controllable output impedance (5602).

**Patentansprüche**

1. Verfahren zum Abwärtswandeln eines modulierten elektromagnetischen Trägersignals (2210) in ein niedrigerfrequentes moduliertes Trägersignal (2208), wobei

   1) das modulierte elektromagnetische Trägersignal (2210) empfangen wird (1208),
   2) Energie von dem empfangenen modulierten Trägersignal (2210) auf das niedrigerfrequente modulierte Trägersignal (2208) dadurch übertragen wird (1212), daß die Energie über aufeinanderfolgende Zeitfenster (1301) wiederholt gespeichert wird (2406), wobei die Zeitfenster mit einer Frequenz auftreten, die eine Aliasfrequenz des empfangenen modulierten Trägersignals darstellt und gleich dem Ausdruck:
(eine Frequenz des modulierten elektromagnetischen Trägersignals (2210) plus oder minus einer Frequenz des niedrigerfreqenten modulierten Trägersignals (2208)/n
ist, wobei n eine ganze Zahl ist, und
3) das niedrigerfrequente modulierte Trägersignal (2208) aus der gespeicherten Energie erzeugt wird (1212),

wobei die Übertragung von Energie eine genaue Spannungswiedergabe des empfangenen modulierten elektromagnetischen Trägersignals während der Zeitfenster im wesentlichen verhindert.

2. Verfahren nach Anspruch 1, wobei in dem Schritt 2) ein Energieübertragungssignal (2206) mit einer Impulsfolge (4206) der Aliasfrequenz mit nicht-vernachlässigbaren Fenstern (1301) erzeugt und das Energieübertragungssignal (2206) zur Übertragung der Energie von dem empfangenen modulierten Trägersignal (2210) verwendet wird.

3. Verfahren nach einem der vorhergehenden Ansprüche, wobei in dem Schritt 2) das empfangene modulierte Trägersignal (2210) mit der Aliasfrequenz auf eine Reaktanz-Speichereinrichtung (2701) gekoppelt wird.

4. Verfahren nach Anspruch 1, wobei in dem Schritt 2) das empfangene Trägersignal (2210) entsprechend einem Energieübertragungssignal (2206) torgesteuert wird (2304), das eine Folge von sich mit der Aliasfrequenz wiederholenden Impulsen (4206) mit nicht-vernachlässigbaren Fenstern (1301) aufweist.

5. Verfahren nach Anspruch 1, wobei in dem Schritt 2)

a) ein nicht-vernachlässigbarer Teil der in einem Teil des empfangenen modulierten Trägersignals (2210) enthaltenen Energie übertragen wird (1212) und
b) der Schritt 2)a) mit der Aliasfrequenz wiederholt wird.

6. Verfahren nach einem der vorhergehenden Ansprüche, wobei in dem Schritt 2) eine Frequenzbeziehung zwischen dem empfangenen modulierten Trägersignal (2210) und der Aliasfrequenz gesteuert wird.

7. Verfahren nach einem der Ansprüche 1 bis 5, wobei in dem Schritt 2) eine Phasenbeziehung zwischen dem empfangenen modulierten Trägersignal (2210) und der Aliasftequenz gesteuert wird.

8. Verfahren nach einem der Ansprüche 1 bis 5, wobei in dem Schritt 2) eine Frequenz- und eine Phasenbeziehung zwischen dem empfangenen modulierten Trägersignal (2210) und der Aliasfrequenz gesteuert wird.

9. Verfahren nach einem der Ansprüche 1 bis 5, wobei die Fenster (1301) eine Dauer haben, die näherungsweise gleich Halbzyklen des empfangenen modulierten Trägersignals (2210) ist.

10. Verfahren nach einem der Ansprüche 1 bis 5, wobei die Fenster (1301) eine Dauer haben, die näherungsweise gleich oder größer ist als die Dauer von 10 % der Zyklen des empfangenen modulierten Trägersignals (2210).

11. Verfahren nach einem der Ansprüche 1 bis 5, wobei die Fenster (1301) eine Dauer haben, die näherungsweise gleich oder größer ist als die Dauer von 25 % der Zyklen des empfangenen modulierten Trägersignals (2210).

12. Verfahren nach einem der Ansprüche 1 bis 5, wobei die Fenster (1301) eine Dauer haben, die näherungsweise gleich oder größer ist als die Dauer von 50 % der Zyklen des empfangenen modulierten Trägersignals (2210).

13. Verfahren nach einem der Ansprüche 1 bis 5, wobei die Fenster (1301) eine Dauer haben, die näherungsweise gleich oder größer ist als die Dauer von 75 % der Zyklen des empfangenen modulierten Trägersignals (2210).

14. Verfahren nach einem der Ansprüche 1 bis 5, wobei die Fenster (1301) eine Dauer haben, die gleich N Zyklen des empfangenen modulierten Trägersignals (2210) ist, wobei N gleich A plus B, A eine positive ganze Zahl und B ein Bruchteil einer ganzen Zahl ist.

15. Verfahren nach einem der Ansprüche 1 bis 14, wobei in dem Schritt 2) bezüglich der in Zyklen des empfangenen modulierten Trägersignals (2210) enthaltenen Energie nichtvernachlässigbare Energiemengen übertragen werden.

16. Verfahren nach Anspruch 1, wobei in dem Schritt 2) eine Folge von Impulsen (4206) mit bezüglich einer Periode des empfangenen modulierten Trägersignals (2210) nicht-vernachlässigbaren Fenstern (1301) erzeugt wird.

17. Verfahren nach Anspruch 5, wobei in dem Schritt 2)a) mindestens 10 % der in einer Periode des empfangenen modulierten Trägersignals (2210) enthaltenen Energie übertragen wird.

18. Verfahren nach Anspruch 5, wobei in dem Schritt 2)a) mindestens 25 % der in einer Periode des empfangenen modulierten Trägersignals (2210) enthaltenen Energie übertragen wird.

19. Verfahren nach Anspruch 5, wobei in dem Schritt 2)a) mindestens 50 % der in einer Periode des empfangenen modulierten Trägersignals (2210) enthaltenen Energie übertragen wird.

20. Verfahren nach Anspruch 5, wobei in dem Schritt 2)a) mindestens 75 % der in einer Periode des empfangenen modulierten Trägersignals (2210) enthaltenen Energie übertragen wird.

21. Verfahren nach einem der Ansprüche 1 bis 5, wobei die Fenster (1301) eine Dauer haben, die näherungsweise gleich Halbzyklen des empfangenen modulierten Trägersignals (2210) ist, und auf das empfangene modulierte Trägersignal (2210) nicht ausgerichtet sind.

22. Verfahren nach einem der Ansprüche 1 bis 5, wobei die Fenster (1301) mit dem empfangenen modulierten Trägersignal (2210) im wesentlichen synchronisiert sind.

23. Verfahren nach einem der Ansprüche 1 bis 5, wobei die Fenster (1301) mit dem empfangenen modulierten Trägersignal (2210) nicht synchronisiert sind.

24. Verfahren nach Anspruch 2, wobei in dem Schritt 2) das Energieübertragungssignal (2206) unabhängig von dem empfangenen modulierten Trägersignal (2210) erzeugt wird.

25. Verfahren nach einem der Ansprüche 1 bis 5, wobei in dem Schritt 2) ein asynchrones Energieübertragungssignal (2206) mit der Aliasfrequenz erzeugt und zum Speichern der Energie von dem empfangenen modulierten Trägersignal (2210) verwendet wird.

26. Verfahren nach einem der Ansprüche 1 bis 5, wobei in dem Schritt 2) Energie differentiell gespeichert wird.

27. Verfahren nach einem der Ansprüche 1 bis 5, wobei zu dem Schritt 2) der Schritt i) gehört: Steuern der von dem empfangenen modulierten Trägersignal (2210) übertragenen Energiemenge.

28. Verfahren nach Anspruch 27, wobei in dem Schritt 2)i) ein Fenster (1301) gesteuert wird.

29. Verfahren nach Anspruch 28, wobei in dem Schritt 2)i) die Fensterbreite gesteuert wird.

30. Verfahren nach Anspruch 28, wobei in dem Schritt 2)i) die Fensterfrequenz gesteuert wird.

31. Verfahren nach Anspruch 28, wobei in dem Schritt 2)i) die Fensterform gesteuert wird.

32. Verfahren nach Anspruch 27, wobei in dem Schritt 2)i) Energieübertragungskennlinien gesteuert werden.

33. Verfahren nach einem der vorhergehenden Ansprüche, wobei in dem Schritt 3) die gespeicherte Energie zwischen Fenstern (1301) in gesteuerter Weise entladen wird.

34. Verfahren nach einem der vorhergehenden Ansprüche, wobei in dem Schritt 2) von dem empfangenen modulierten Trägersignal (2210) Energie gespeichert wird, die zur Ansteuerung einer Last (2918) ohne zusätzliche Pufferung oder Verstärkung ausreicht, wobei die Last eine hoch- oder eine niederimpedante Last (2918) ist.

35. Verfahren nach einem der vorhergehenden Ansprüche, wobei in dem Schritt 2) Energie von dem empfangenen modulierten Trägersignal (2210) ohne Vorverstärkung (LNA) des empfangenen modulierten Trägersignals (2210) gespeichert wird.

**36.** Verfahren nach einem der vorhergehenden Ansprüche, wobei in dem Schritt 1) das modulierte Trägersignal (2210) über einen verhältnismäßig niederimpedanten Eingangspfad (2906) empfangen wird.

**37.** Verfahren nach einem der vorhergehenden Ansprüche, wobei in dem Schritt 1) das modulierte Trägersignal (2210) über einen verhältnismäßig effizienten Leistungsübertragungspfad (2906) empfangen wird.

**38.** Verfahren nach einem der vorhergehenden Ansprüche, wobei in dem Schritt 2) das empfangene modulierte Trägersignal (2210) unter Verwendung eines Schaltermoduls (2402) torgesteuert wird.

**39.** Verfahren nach Anspruch 38, wobei die Impedanz des Schaltermoduls (2402) an die Quellenimpedanz (2912) angepaßt wird, um die von dem empfangenen modulierten Trägersignal (2210) übertragene Energie zu erhöhen.

**40.** Verfahren nach Anspruch 38, wobei die Impedanz des Schaltermoduls (2402) an die Lastimpedanz (2918) angepaßt wird, um die von dem empfangenen modulierten Trägersignal (2210) übertragene Energie zu erhöhen.

**41.** Verfahren nach Anspruch 40, wobei das empfangene modulierte Trägersignal (2210) auf den Schaltermodul (4202) über einen Resonanzkreis (2906, 3616) gekoppelt wird, der im offenen Zustand des Schaltermoduls (2402) Energie von Komponenten des empfangenen modulierten Trägersignals (2210) speichert, und wobei die in dem Resonanzkreis (2908, 3616) gespeicherte Energie im geschlossenen Zustand des Schaltermoduls (2402) über diesen entladen wird, um die von dem empfangenen modulierten Trägersignal (2210) übertragene Energie zu erhöhen.

**42.** Vorrichtung zum Abwärtswandeln eines modulierten elektromagnetischen Trägersignals (2210) ein niedrigerfrequentes moduliertes Trägersignal (2208) mit

einer Einrichtung zum Empfangen (1208) des modulierten elektromagnetischen Trägersignals (2210),

einer Einrichtung (2202) zum Übertragen von Energie von dem empfangenen modulierten Trägersignal (2210) auf das niedrigerfrequente modulierte Trägersignal (2208) durch wiederholtes Speichern (2206) der Energie über aufeinanderfolgende Zeitfenster (1301), die mit einer Frequenz auftreten, die eine Aliasfrequenz des empfangenen modulierten Trägersignals ist und gleich dem Ausdruck

(eine Frequenz des modulierten elektromagnetischen Trägersignals (2210) plus oder minus einer Frequenz des niedrigerfreqenten modulierten Trägersignals (2208)/n

ist, wobei n eine ganze Zahl ist, und

einer Einrichtung zum Erzeugen (2406) des niedrigerfrequenten modulierten Trägersignals (2208) aus der gespeicherten Energie,

wobei die Übertragung von Energie eine genaue Spannungswiedergabe des modulierten Trägersignals während der Zeitfenster im wesentlichen verhindert.

**43.** Vorrichtung nach Anspruch 42, wobei die Energieübertragungseinrichtung (2202) eine Einrichtung (2720) zum Erzeugen eines Energieübertragungssignals (2206) mit einer Impulsfolge (4206) der Aliasfrequenz mit nicht-vernachlässigbaren Fenstern (1301) sowie eine Einrichtung (2402) aufweist, die das Energieübertragungssignal (2206) zur Übertragung der Energie von dem empfangenen modulierten Trägersignal (2210) verwendet.

**44.** Vorrichtung nach Anspruch 42, wobei die Energieübertragungseinrichtung (2202) eine Einrichtung (2402) aufweist, die das empfangene modulierte Trägersignal (2210) mit der Aliasfrequenz auf einen Reaktanz-Speichermodul (2701) koppelt.

**45.** Vorrichtung nach Anspruch 42, wobei die Energieübertragungseinrichtung (2202) eine Einrichtung (2402) aufweist, die das empfangene Trägersignal (2210) entsprechend einem Energieübertragungssignal (2206) torsteuert, das eine Folge von sich mit der Aliasfrequenz wiederholenden Impulsen (4206) mit nicht-vernachlässigbaren Fenstern (1301) enthält.

**46.** Vorrichtung nach Anspruch 42, wobei die Energieübertragungseinrichtung (2202) eine Einrichtung (2402, 2406, 2206) aufweist, die nicht-vernachlässigbare Teile von in Teilen des empfangenen modulierten Trägersignals (2210) enthaltener Energie mit der Aliasfrequenz überträgt.

**47.** Vorrichtung nach einem der Ansprüche 42 bis 46, wobei die Energieübertragungseinrichtung (2202) eine Einrichtung (2208) zum Steuern einer Frequenzbeziehung zwischen dem empfangenen modulierten Trägersignal (2210) und der Aliasfrequenz aufweist.

**48.** Vorrichtung nach einem der Ansprüche 42 bis 46, wobei die Energieübertragungseinrichtung (2202) eine Einrichtung (2208) zum Steuern einer Phasenbeziehung zwischen dem empfangenen modulierten Trägersignal (2210) und der Aliasfrequenz aufweist.

**49.** Vorrichtung nach einem der Ansprüche 42 bis 46, wobei die Energieübertragungseinrichtung (2202) eine Einrichtung (2208) zum Steuern einer Frequenz- und eine Phasenbeziehung zwischen dem empfangenen modulierten Trägersignal (2210) und der Aliasfrequenz aufweist.

**50.** Vorrichtung nach einem der Ansprüche 42 bis 46, wobei die Fenster (1301) eine Dauer haben, die näherungsweise gleich Halbzyklen des empfangenen modulierten Trägersignals (2210) ist.

**51.** Vorrichtung nach einem der Ansprüche 42 bis 46, wobei die Fenster (1301) eine Dauer haben, die näherungsweise gleich oder größer ist als die Dauer von 10 % der Zyklen des empfangenen modulierten Trägersignals (2210).

**52.** Vorrichtung nach einem der Ansprüche 42 bis 46, wobei die Fenster (1301) eine Dauer haben, die näherungsweise gleich oder größer ist als die Dauer von 25 % der Zyklen des empfangenen modulierten Trägersignals (2210).

**53.** Vorrichtung nach einem der Ansprüche 42 bis 46, wobei die Fenster (1301) eine Dauer haben, die näherungsweise gleich oder größer ist als die Dauer von 50 % der Zyklen des empfangenen modulierten Trägersignals (2210).

**54.** Vorrichtung nach einem der Ansprüche 42 bis 46, wobei die Fenster (1301) eine Dauer haben, die näherungsweise gleich oder größer ist als die Dauer von 75 % der Zyklen des empfangenen modulierten Trägersignals (2210).

**55.** Vorrichtung nach einem der Ansprüche 42 bis 46, wobei die Fenster (1301) eine Dauer haben, die gleich N Zyklen des empfangenen modulierten Trägersignals (2210) ist, wobei N gleich A plus B, A eine positive ganze Zahl und B ein Bruchteil einer ganzen Zahl ist.

**56.** Vorrichtung nach einem der Ansprüche 42 bis 55, wobei die Energieübertragungseinrichtung (2202) eine Einrichtung zum Übertragen von bezüglich der in Zyklen des empfangenen modulierten Trägersignals (2210) enthaltenen Energie nicht-vernachlässigbaren Energiemengen aufweist.

**57.** Vorrichtung nach einem der Ansprüche 42 bis 46, wobei die Energieübertragungseinrichtung (2202) eine Einrichtung (2720) zum Erzeugen einer Folge von Impulsen (4206) mit bezüglich einer Periode des empfangenen modulierten Trägersignals (2210) nicht-vernachlässigbaren Fenstern (1301) aufweist.

**58.** Vorrichtung nach Anspruch 46, wobei die Einrichtung zum Übertragen nicht-vernachlässigbarer Energieteile eine Einrichtung aufweist, die mindestens 10 % der in einer Periode des empfangenen modulierten Trägersignals (2210) enthaltenen Energie überträgt.

**59.** Vorrichtung nach Anspruch 46, wobei die Einrichtung zum Übertragen nicht-vernachlässigbarer Energieteile eine Einrichtung aufweist, die mindestens 25 % der in einer Periode des empfangenen modulierten Trägersignals (2210) enthaltenen Energie überträgt.

**60.** Vorrichtung nach Anspruch 46, wobei die Einrichtung zum Übertragen nicht-vernachlässigbarer Energieteile eine Einrichtung aufweist, die mindestens 50 % der in einer Periode des empfangenen modulierten Trägersignals (2210) enthaltenen Energie überträgt.

**61.** Vorrichtung nach Anspruch 46, wobei die Einrichtung zum Übertragen nicht-vernachlässigbarer Energieteile eine Einrichtung aufweist, die mindestens 75 % der in einer Periode des empfangenen modulierten Trägersignals (2210) enthaltenen Energie überträgt.

**62.** Vorrichtung nach einem der Ansprüche 42 bis 46, wobei die Fenster (1301) eine Dauer haben, die näherungsweise gleich Halbzyklen des empfangenen modulierten Trägersignals (2210) ist, und auf das empfangene modulierte Trägersignal (2210) nicht ausgerichtet sind.

**63.** Vorrichtung nach einem der Ansprüche 42 bis 46, wobei die Fenster (1301) mit dem empfangenen modulierten Trägersignal (2210) im wesentlichen synchronisiert sind.

**64.** Vorrichtung nach einem der Ansprüche 42 bis 46, wobei die Fenster (1301) mit dem empfangenen modulierten Trägersignal (2210) nicht synchronisiert sind.

**65.** Vorrichtung nach Anspruch 43, wobei die Energieübertragungseinrichtung (2202) eine Einrichtung (2720) zum Erzeugen des Energieübertragungssignals (2206) unabhängig von dem empfangenen modulierten Trägersignal (2210) aufweist.

**66.** Vorrichtung nach einem der Ansprüche 42 bis 46, wobei die Energieübertragungseinrichtung (2202) eine Einrichtung (2720) aufweist, die ein asynchrones Energieübertragungssignal (2206) mit der Aliasfrequenz erzeugt und zum Speichern der Energie von dem empfangenen modulierten Trägersignal (2210) verwendet.

**67.** Vorrichtung nach einem der Ansprüche 42 bis 46, wobei die Energieübertragungseinrichtung (2202) eine erste Energiespeichereinrichtung (2308A) und eine zweite Energiespeichereinrichtung (2308B) aufweist, die differentiell konfiguriert sind.

**68.** Vorrichtung nach einem der Ansprüche 42 bis 46, wobei die Energieübertragungseinrichtung (2202) eine Einrichtung (5602) zum Steuern der von dem empfangenen modulierten Trägersignal (2210) übertragenen Energiemenge.

**69.** Vorrichtung nach Anspruch 68, wobei die Einrichtung (5602) zum Steuern der von dem empfangenen modulierten Trägersignal (2210) übertragenen Energiemenge eine Einrichtung zum Steuern der Fenster (1301) aufweist.

**70.** Vorrichtung nach Anspruch 69, wobei die Fenstersteuereinrichtung (5602) eine Einrichtung zum Steuern der Fensterbreite aufweist.

**71.** Vorrichtung nach Anspruch 69, wobei die Fenstersteuereinrichtung (5602) eine Einrichtung (2802) zum Steuern der Fensterfrequenz aufweist.

**72.** Vorrichtung nach Anspruch 69, wobei die Fenstersteuereinrichtung (5602) zum eine Einrichtung (8302) zum Steuern der Fensterform aufweist.

**73.** Vorrichtung nach Anspruch 68, wobei die Einrichtung (5602) zum Steuern der von dem empfangenen modulierten Trägersignal (2210) übertragenen Energiemenge eine Einrichtung zum Steuern von Energieübertragungskennlinien aufweist.

**74.** Vorrichtung nach einem der Ansprüche 42 bis 73, wobei die Erzeugungseinrichtung (2406) eine Einrichtung zum gesteuerten Entladen der gespeicherten Energie zwischen Fenstern (1301) aufweist.

**75.** Vorrichtung nach einem der Ansprüche 42 bis 74, wobei die Energieübertragungseinrichtung (2202) eine Einrichtung (2406) zum Speichern von Energie von dem modulierten Trägersignal (2210) aufweist, wobei die Energiespeichereinrichtung (2406) von dem empfangenen modulierten Trägersignal (2210) ausreichend Energie zu speichern vermag, um eine Last (2918) ohne zusätzliche Pufferung oder Verstärkung anzusteuern, wobei die Last eine hoch- oder eine niederimpedante Last (2918) ist.

**76.** Vorrichtung nach einem der Ansprüche 42 bis 75, wobei die Energiespeichereinrichtung (2406) von dem empfangenen modulierten Trägersignal (2210) Energie ohne Vorverstärkung (LNA) des empfangenen modulierten Trägersignals (2210) zu speichern vermag.

**77.** Vorrichtung nach einem der Ansprüche 42 bis 76, wobei die Einrichtung zum Empfangen des modulierten Trägersignals so ausgelegt ist, daß sie das modulierte elektromagnetische Trägersignal (2210) über einen verhältnismäßig niederimpedanten Eingangspfad (2906) empfängt.

**78.** Vorrichtung nach einem der Ansprüche 42 bis 77, wobei die Einrichtung zum Empfangen des modulierten Trägersignals so ausgelegt ist, daß sie das modulierte elektromagnetische Trägersignal (2210) über einen verhältnismäßig effizienten Leistungsübertragungspfad (2906) empfängt.

**79.** Vorrichtung nach einem der Ansprüche 42 bis 78, wobei die Energieübertragungseinrichtung (2202) eine Einrichtung (2308) zur Torsteuerung des empfangenen modulierten Trägersignals (2210) unter Verwendung eines Schaltermoduls (2402) aufweist.

80. Vorrichtung nach Anspruch 79, wobei die Energieübertragungseinrichtung (2202) eine Einrichtung (2906) zum Anpassen einer Impedanz (2916) des Schaltermoduls (2402) an eine Quellenimpedanz (2912) aufweist, um die von dem empfangenen modulierten Trägersignal (2210) übertragene Energie zu erhöhen.

81. Vorrichtung nach Anspruch 79, wobei die Energiespeichereinrichtung eine Einrichtung (2908) zum Anpassen einer Impedanz (2916) des Schaltermoduls (2402) an eine Lastimpedanz (2918) aufweist, um die von dem empfangenen modulierten Trägersignal (2210) übertragene Energie zu erhöhen.

82. Vorrichtung nach Anspruch 79 mit einer Einrichtung, die das empfangene modulierte Trägersignal (2210) auf den Schaltermodul (4202) über einen Resonanzkreis (3616) koppelt, der im offenen Zustand des Schaltermoduls (2402) Energie von Komponenten des empfangenen modulierten Trägersignals (2210) speichert, und wobei die in dem Resonanzkreis (3616) gespeicherte Energie im geschlossenen Zustand des Schaltermoduls (2402) über diesen entladen wird, um die von dem empfangenen modulierten Trägersignal (2210) übertragene Energie zu erhöhen.

83. Vorrichtung nach einem der Ansprüche 42 bis 46 mit einem Eingangsimpedanz-Anpassungskreis (2906).

84. Vorrichtung nach einem der Ansprüche 42 bis 46 mit einem Ausgangsimpedanz-Anpassungskreis (2906).

85. Vorrichtung nach einem der Ansprüche 42 bis 46 mit einem Resonanzkreis (3616).

86. Vorrichtung nach Anspruch 79 mit einem zu dem Schaltermodul (2402) parallelen Bypass-Kreis (5302).

87. Vorrichtung nach einem der Ansprüche 42 bis 46 mit einer Rückkopplungsschleife (2806).

88. Vorrichtung nach einem der Ansprüche 42 bis 46, wobei die Energiespeichereinrichtung (2406) eine kapazitive Speichereinrichtung (2702) aufweist, die so dimensioniert ist, daß sie bezüglich der in Zyklen des empfangenen modulierten Trägersignals (2210) näherungsweise enthaltenen Energie wesentliche Energiemengen speichert.

89. Vorrichtung nach einem der Ansprüche 42 bis 46, wobei die Energieübertragungseinrichtung (2206) in einem komplementären Metalloxid-Halbleitermaterial (C-MOS) (8200) ausgeführt ist.

90. Vorrichtung nach einem der Ansprüche 42 bis 46, wobei die Energieübertragungseinrichtung (2202) eine Einrichtung aufweist, die in einer einzelnen integrierten Schaltung (8200) ausgeführt ist.

91. Vorrichtung nach einem der Ansprüche 42 bis 46 mit einer steuerbaren Ausgangsimpedanz (5602).

**Revendications**

1. Procédé d'abaissement de fréquence d'un signal de porteuse électromagnétique modulée (2210) pour obtenir un signal de porteuse modulée à fréquence inférieure (2208), comprenant les étapes consistant à:

   1) recevoir (1208) le signal de porteuse électromagnétique modulée (2210);
   2) transférer de l'énergie (1212) du signal de porteuse modulée reçu (2210) au signal de porteuse modulée à fréquence inférieure (2208) par emmagasinage répété (2406) de ladite énergie sur des fenêtres de temps successives (1301) apparaissant à une cadence qui est une fréquence de repliement du spectre du signal de porteuse modulée reçu, cette cadence étant égale à:
   (la fréquence du signal de porteuse électromagnétique modulée (2210) plus ou moins la fréquence du signal de porteuse modulée à fréquence inférieure (2208))/n, où n est un entier naturel; et
   3) générer (1212) le signal de porteuse modulée à fréquence inférieure (2208) à partir de l'énergie emmagasinée;

   dans lequel ledit transfert d'énergie empêche substantiellement une reproduction de tension précise du signal de porteuse électromagnétique modulée reçu pendant les fenêtres de temps.

**2.** Procédé selon la revendication 1, dans lequel l'étape 2) comprend le fait de:

générer un signal de transfert d'énergie (2206) comprenant un train d'impulsions (4206) à la fréquence de repliement du spectre, ayant des fenêtres non négligeables (1301), et utiliser le signal de transfert d'énergie (2206) pour transférer l'énergie à partir du signal de porteuse modulée reçu (2210).

**3.** Procédé selon l'une quelconque des revendications précédentes, dans lequel l'étape 2) comprend le fait de:

coupler le signal de porteuse modulée reçu (2210) à un dispositif d'accumulation à réactance (2701) à la fréquence de repliement du spectre.

**4.** Procédé selon la revendication 1, dans lequel l'étape 2) comprend le fait de:

transmettre par porte (2304) le signal de porteuse reçu (2210) conformément à un signal de transfert d'énergie (2206) comprenant un train d'impulsions (4206), ayant des fenêtres non négligeables (1301), qui se répètent à la fréquence de repliement du spectre.

**5.** Procédé selon la revendication 1, dans lequel l'étape 2) comprend le fait de:

a) transférer (1212) une partie non négligeable de l'énergie contenue dans une partie du signal de porteuse modulée reçu (2210); et
b) répéter l'étape 2)a) à la fréquence de repliement du spectre.

**6.** Procédé selon l'une quelconque des revendications précédentes, dans lequel l'étape 2) comprend le fait de commander une relation de fréquence entre le signal de porteuse modulée reçu (2210) et la fréquence de repliement du spectre.

**7.** Procédé selon l'une quelconque des revendications 1 à 5, dans lequel l'étape 2) comprend le fait de commander une relation de phase entre le signal de porteuse modulée reçu (2210) et la fréquence de repliement du spectre.

**8.** Procédé selon l'une quelconque des revendications 1 à 5, dans lequel l'étape 2) comprend le fait de commander une relation de fréquence et une relation de phase entre le signal de porteuse modulée reçu (2210) et la fréquence de repliement du spectre.

**9.** Procédé selon l'une quelconque des revendications 1 à 5, dans lequel les fenêtres (1301) sont d'une durée à peu près égale à la moitié d'un cycle du signal de porteuse modulée reçu (2210).

**10.** Procédé selon l'une quelconque des revendications 1 à 5, dans lequel les fenêtres (1301) sont d'une durée à peu près égale ou supérieure à dix pour cent d'un cycle du signal de porteuse modulée reçu (2210).

**11.** Procédé selon l'une quelconque des revendications 1 à 5, dans lequel les fenêtres (1301) sont d'une durée à peu près égale ou supérieure à vingt-cinq pour cent d'un cycle du signal de porteuse modulée reçu (2210).

**12.** Procédé selon l'une quelconque des revendications 1 à 5, dans lequel les fenêtres (1301) sont d'une durée à peu près égale ou supérieure à cinquante pour cent d'un cycle du signal de porteuse modulée reçu (2210).

**13.** Procédé selon l'une quelconque des revendications 1 à 5, dans lequel les fenêtres (1301) sont d'une durée à peu près égale ou supérieure à soixante-quinze pour cent d'un cycle du signal de porteuse modulée reçu (2210).

**14.** Procédé selon l'une quelconque des revendications 1 à 5, dans lequel les fenêtres (1301) sont d'une durée égale à N cycles du signal de porteuse modulée reçu (2210), avec N égale A plus B, A étant un entier positif et B étant une fraction d'un entier.

**15.** Procédé selon l'une quelconque des revendications 1 à 14, dans lequel l'étape 2) comprend le fait de transférer des quantités d'énergie non négligeables par rapport à l'énergie contenue dans un cycle du signal de porteuse modulée reçu (2210).

**16.** Procédé selon la revendication 1, dans lequel l'étape 2) comprend le fait de générer un train d'impulsions (4206) ayant des fenêtres (1301) non négligeables par rapport à la période du signal de porteuse modulée reçu (2210).

17. Procédé selon la revendication 5, dans lequel l'étape 2)a) comprend le fait de transférer au moins dix pour cent de l'énergie contenue dans une période du signal de porteuse modulée reçu (2210).

18. Procédé selon la revendication 5, dans lequel l'étape 2)a) comprend le fait de transférer au moins vingt-cinq pour cent de l'énergie contenue dans une période du signal de porteuse modulée reçu (2210).

19. Procédé selon la revendication 5, dans lequel l'étape 2)a) comprend le fait de transférer au moins cinquante pour cent de l'énergie contenue dans une période du signal de porteuse modulée reçu (2210).

20. Procédé selon la revendication 5, dans lequel l'étape 2)a) comprend le fait de transférer au moins soixante-quinze pour cent de l'énergie contenue dans une période du signal de porteuse modulée reçu (2210).

21. Procédé selon l'une quelconque des revendications 1 à 5, dans lequel les fenêtres (1301) sont d'une durée à peu près égale à la moitié d'un cycle du signal de porteuse modulée reçu (2210) et ne sont pas alignées avec le signal de porteuse modulée reçu (2210).

22. Procédé selon l'une quelconque des revendications 1 à 5, dans lequel les fenêtres (1301) sont substantiellement synchronisées avec le signal de porteuse modulée reçu (2210).

23. Procédé selon l'une quelconque des revendications 1 à 5, dans lequel les fenêtres (1301) ne sont pas synchronisées avec le signal de porteuse modulée reçu (2210).

24. Procédé selon la revendication 2, dans lequel l'étape 2) comprend en outre le fait de générer le signal de transfert d'énergie (2206) indépendamment du signal de porteuse modulée reçu (2210).

25. Procédé selon l'une quelconque des revendications 1 à 5, dans lequel l'étape 2) comprend le fait de générer un signal de transfert d'énergie asynchrone (2206) ayant la fréquence de repliement du spectre et d'utiliser le signal de transfert d'énergie asynchrone (2206) pour emmagasiner l'énergie à partir du signal de porteuse modulée reçu (2210).

26. Procédé selon l'une quelconque des revendications 1 à 5, dans lequel l'étape 2) comprend le fait d'emmagasiner l'énergie de manière différentielle.

27. Procédé selon l'une quelconque des revendications 1 à 5, dans lequel l'étape 2) comprend l'étape consistant à:

    i) commander la quantité d'énergie transférée à partir du signal de porteuse modulée reçu (2210).

28. Procédé selon la revendication 27, dans lequel l'étape 2)i) comprend le fait de commander une fenêtre (1301).

29. Procédé selon la revendication 28, dans lequel l'étape 2)i) comprend en outre le fait de commander une largeur de fenêtre.

30. Procédé selon la revendication 28, dans lequel l'étape 2)i) comprend en outre le fait de commander une fréquence de fenêtre.

31. Procédé selon la revendication 28, dans lequel l'étape 2)i) comprend en outre le fait de commander une forme de fenêtre.

32. Procédé selon la revendication 27, dans lequel l'étape 2)i) comprend le fait de commander des caractéristiques de transfert d'énergie.

33. Procédé selon l'une quelconque des revendications précédentes, dans lequel l'étape 3) comprend le fait de décharger l'énergie emmagasinée, entre les fenêtres (1301), d'une manière commandée.

34. Procédé selon l'une quelconque des revendications précédentes, dans lequel l'étape 2) comprend le fait d'emmagasiner suffisamment d'énergie à partir du signal de porteuse modulée reçu (2210) pour attaquer une charge (2918) sans employer d'organe tampon ou d'amplification supplémentaire, la charge étant une charge à haute impédance ou une charge à basse impédance (2918).

35. Procédé selon l'une quelconque des revendications précédentes, dans lequel l'étape 2) comprend le fait d'emmagasiner de l'énergie à partir du signal de porteuse modulée reçu (2210) sans pré-amplification (à faible bruit) du signal de porteuse modulée reçu (2210).

36. Procédé selon l'une quelconque des revendications précédentes, dans lequel l'étape 1) comprend le fait de recevoir le signal de porteuse modulée (2210) par un chemin à impédance d'entrée relativement basse (2906).

37. Procédé selon l'une quelconque des revendications précédentes, dans lequel l'étape 1) comprend le fait de recevoir le signal de porteuse modulée (2210) par un chemin de transfert d'énergie relativement efficace (2906).

38. Procédé selon l'une quelconque des revendications précédentes, dans lequel l'étape 2) comprend le fait de transmettre par porte le signal de porteuse modulée reçu (2210) en utilisant un module de commutation (2402).

39. Procédé selon la revendication 38, dans lequel l'impédance dudit module de commutation (2402) est adaptée à une impédance de source (2912), pour accroître l'énergie transférée à partir dudit signal de porteuse modulée reçu (2210).

40. Procédé selon la revendication 38, dans lequel l'impédance dudit module de commutation (2402) est adaptée à une impédance de charge (2918), pour accroître l'énergie transférée à partir dudit signal de porteuse modulée reçu (2210).

41. Procédé selon la revendication 40, dans lequel ledit signal de porteuse modulée reçu (2210) est couplé audit module de commutation (2402) via un circuit résonant (2906, 3616), ledit circuit résonant (2906, 3616) emmagasinant de l'énergie à partir de composantes dudit signal de porteuse modulée reçu (2210) pendant que ledit module de commutation (2402) est ouvert, et dans lequel l'énergie emmagasinée dans ledit circuit résonant (2906, 3616) est déchargée via ledit module de commutation (2402) pendant que ledit module de commutation (2402) est fermé, pour accroître l'énergie transférée à partir dudit signal de porteuse modulée reçu (2210).

42. Appareil pour abaisser la fréquence d'un signal de porteuse électromagnétique modulée (2210) afin d'obtenir un signal de porteuse modulée à fréquence inférieure (2208), comprenant:

un moyen pour recevoir (1208) le signal de porteuse électromagnétique modulée (2210);
un moyen (2202) pour transférer de l'énergie du signal de porteuse modulée reçu (2210) au signal de porteuse modulée à fréquence inférieure (2208) par emmagasinage répété (2406) de ladite énergie sur des fenêtres de temps successives (1301) apparaissant à une cadence qui est une fréquence de repliement du spectre du signal de porteuse modulée reçu, cette cadence étant égale à:
(la fréquence du signal de porteuse électromagnétique modulée (2210) plus ou moins la fréquence du signal de porteuse modulée à fréquence inférieure (2208))/n, où n est un entier naturel; et
un moyen pour générer (2406) le signal de porteuse modulée à fréquence inférieure (2208) à partir de l'énergie emmagasinée;

dans lequel ledit transfert d'énergie empêche substantiellement une reproduction de tension précise du signal de porteuse électromagnétique modulée reçu pendant les fenêtres de temps.

43. Appareil selon la revendication 42, dans lequel ledit moyen (2202) pour transférer de l'énergie comprend:

un moyen (2720) pour générer un signal de transfert d'énergie (2206) comprenant un train d'impulsions (4206) à la fréquence de repliement du spectre, ayant des fenêtres non négligeables (1301), et un moyen (2402) pour utiliser le signal de transfert d'énergie (2206) afin de transférer l'énergie à partir du signal de porteuse modulée reçu (2210).

44. Appareil selon la revendication 42, dans lequel ledit moyen (2202) pour transférer de l'énergie comprend un moyen (2402) pour coupler le signal de porteuse modulée reçu (2210) à un dispositif d'accumulation à réactance (2701) à la fréquence de repliement du spectre.

**45.** Appareil selon la revendication 42, dans lequel ledit moyen (2202) pour transférer de l'énergie comprend:

un moyen (2402) pour transmettre par porte le signal de porteuse reçu (2210) conformément à un signal de transfert d'énergie (2206) comprenant un train d'impulsions (4206), ayant des fenêtres non négligeables (1301), qui se répètent à la fréquence de repliement du spectre.

**46.** Appareil selon la revendication 42, dans lequel ledit moyen (2202) pour transférer de l'énergie comprend:

un moyen (2402, 2406, 2206) pour transférer des parties non négligeables de l'énergie contenue dans des parties du signal de porteuse modulée reçu (2210) à la fréquence de repliement du spectre.

**47.** Appareil selon l'une quelconque des revendications 42 à 46, dans lequel ledit moyen (2202) pour transférer de l'énergie comprend un moyen (2208) pour commander une relation de fréquence entre le signal de porteuse modulée reçu (2210) et la fréquence de repliement du spectre.

**48.** Appareil selon l'une quelconque des revendications 42 à 46, dans lequel ledit moyen (2202) pour transférer de l'énergie comprend un moyen (2208) pour commander une relation de phase entre le signal de porteuse modulée reçu (2210) et la fréquence de repliement du spectre.

**49.** Appareil selon l'une quelconque des revendications 42 à 46, dans lequel ledit moyen pour emmagasiner de l'énergie comprend un moyen (2208) pour commander une relation de fréquence et une relation de phase entre le signal de porteuse modulée reçu (2210) et la fréquence de repliement du spectre.

**50.** Appareil selon l'une quelconque des revendications 42 à 46, dans lequel les fenêtres (1301) sont d'une durée à peu près égale à la moitié d'un cycle du signal de porteuse modulée reçu (2210).

**51.** Appareil selon l'une quelconque des revendications 42 à 46, dans lequel les fenêtres (1301) sont d'une durée à peu près égale ou supérieure à dix pour cent d'un cycle du signal de porteuse modulée reçu (2210).

**52.** Appareil selon l'une quelconque des revendications 42 à 46, dans lequel les fenêtres (1301) sont d'une durée à peu près égale ou supérieure à vingt-cinq pour cent d'un cycle du signal de porteuse modulée reçu (2210).

**53.** Appareil selon l'une quelconque des revendications 42 à 46, dans lequel les fenêtres (1301) sont d'une durée à peu près égale ou supérieure à cinquante pour cent d'un cycle du signal de porteuse modulée reçu (2210).

**54.** Appareil selon l'une quelconque des revendications 42 à 46, dans lequel les fenêtres (1301) sont d'une durée à peu près égale ou supérieure à soixante-quinze pour cent d'un cycle du signal de porteuse modulée reçu (2210).

**55.** Appareil selon l'une quelconque des revendications 42 à 46, dans lequel les fenêtres (1301) sont d'une durée égale à N cycles du signal de porteuse modulée reçu (2210), avec N égale A plus B, A étant un entier positif et B étant une fraction d'un entier.

**56.** Appareil selon l'une quelconque des revendications 42 à 55, dans lequel ledit moyen (2202) pour transférer de l'énergie comprend un moyen pour transférer des quantités d'énergie non négligeables par rapport à l'énergie contenue dans un cycle du signal de porteuse modulée reçu (2210).

**57.** Appareil selon l'une quelconque des revendications 42 à 46, dans lequel ledit moyen (2202) pour transférer de l'énergie comprend un moyen (2720) pour générer un train d'impulsions (4206) ayant des fenêtres (1301) non négligeables par rapport à la période du signal de porteuse modulée reçu (2210).

**58.** Appareil selon la revendication 46, dans lequel ledit moyen pour transférer des parties non négligeables d'énergie comprend un moyen pour transférer au moins dix pour cent de l'énergie contenue dans une période du signal de porteuse modulée reçu (2210).

**59.** Appareil selon la revendication 46, dans lequel ledit moyen pour transférer des parties non négligeables d'énergie comprend un moyen pour transférer au moins vingt-cinq pour cent de l'énergie contenue dans une période du signal de porteuse modulée reçu (2210).

**60.** Appareil selon la revendication 46, dans lequel ledit moyen pour transférer des parties non négligeables d'énergie comprend un moyen pour transférer au moins cinquante pour cent de l'énergie contenue dans une période du signal de porteuse modulée reçu (2210).

**61.** Appareil selon la revendication 46, dans lequel ledit moyen pour transférer des parties non négligeables d'énergie comprend un moyen pour transférer au moins soixante-quinze pour cent de l'énergie contenue dans une période du signal de porteuse modulée reçu (2210).

**62.** Appareil selon l'une quelconque des revendications 42 à 46, dans lequel les fenêtres (1301) sont d'une durée à peu près égale à la moitié d'un cycle du signal de porteuse modulée reçu (2210) et ne sont pas alignées avec le signal de porteuse modulée reçu (2210).

**63.** Appareil selon l'une quelconque des revendications 42 à 46, dans lequel les fenêtres (1301) sont substantiellement synchronisées avec le signal de porteuse modulée reçu (2210).

**64.** Appareil selon l'une quelconque des revendications 42 à 46, dans lequel les fenêtres (1301) ne sont pas synchronisées avec le signal de porteuse modulée reçu (2210).

**65.** Appareil selon la revendication 43, dans lequel ledit moyen (2202) pour transférer de l'énergie comprend en outre un moyen (2720) pour générer le signal de transfert d'énergie (2206) indépendamment du signal de porteuse modulée reçu (2210).

**66.** Appareil selon l'une quelconque des revendications 42 à 46, dans lequel ledit moyen (2202) pour transférer de l'énergie comprend un moyen (2720) pour générer un signal de transfert d'énergie asynchrone (2206) ayant la fréquence de repliement du spectre et pour utiliser le signal de transfert d'énergie asynchrone (2206) afin d'emmagasiner l'énergie à partir du signal de porteuse modulée reçu (2210).

**67.** Appareil selon l'une quelconque des revendications 42 à 46, dans lequel ledit moyen (2202) pour transférer de l'énergie comprend un premier moyen (2308A) pour emmagasiner de l'énergie et un second moyen (2308B) pour emmagasiner de l'énergie, configurés de manière différentielle.

**68.** Appareil selon l'une quelconque des revendications 42 à 46, dans lequel ledit moyen (2202) pour transférer de l'énergie comprend un moyen (5602) pour commander la quantité d'énergie transférée à partir du signal de porteuse modulée reçu (2210).

**69.** Appareil selon la revendication 68, dans lequel ledit moyen (5602) pour commander la quantité d'énergie transférée à partir du signal de porteuse modulée reçu comprend un moyen pour commander les fenêtres (1301).

**70.** Appareil selon la revendication 69, dans lequel ledit moyen (5602) pour commander les fenêtres comprend un moyen pour commander une largeur de fenêtre.

**71.** Appareil selon la revendication 69, dans lequel ledit moyen (5602) pour commander les fenêtres comprend un moyen (2802) pour commander une fréquence de fenêtre.

**72.** Appareil selon la revendication 69, dans lequel ledit moyen (5602) pour commander les fenêtres comprend un moyen (8302) pour commander une forme de fenêtre.

**73.** Appareil selon la revendication 68, dans lequel ledit moyen (5602) pour commander la quantité d'énergie transférée à partir du signal de porteuse modulée reçu (2210) comprend un moyen pour commander des caractéristiques de transfert d'énergie.

**74.** Appareil selon l'une quelconque des revendications 42 à 73, dans lequel ledit moyen pour générer (2406) comprend un moyen pour décharger l'énergie emmagasinée, entre les fenêtres (1301), d'une manière commandée.

**75.** Appareil selon l'une quelconque des revendications 42 à 74, dans lequel ledit moyen (2202) pour transférer de l'énergie comprend un moyen (2406) pour emmagasiner de l'énergie à partir du signal de porteuse électromagnétique modulée (2210), dans lequel ledit moyen (2406) pour emmagasiner de l'énergie est capable d'emmagasiner suffisamment d'énergie à partir du signal de porteuse modulée reçue (2210) pour attaquer une charge (2918) sans employer d'organe tampon ou d'amplification supplémentaire, la charge étant une charge à haute impédance ou une charge à basse impédance (2918).

76. Appareil selon l'une quelconque des revendications 42 à 75, dans lequel ledit moyen (2406) pour emmagasiner de l'énergie est capable d'emmagasiner de l'énergie à partir du signal de porteuse modulée reçu (2210) sans pré-amplification (à faible bruit) du signal de porteuse modulée reçu (2210).

77. Appareil selon l'une quelconque des revendications 42 à 76, dans lequel ledit moyen pour recevoir le signal de porteuse modulée est agencé pour recevoir le signal de porteuse électromagnétique modulée (2210) par un chemin à impédance d'entrée relativement basse (2906).

78. Appareil selon l'une quelconque des revendications 42 à 77, dans lequel ledit moyen pour recevoir le signal de porteuse électromagnétique modulée est agencé pour recevoir le signal de porteuse électromagnétique modulée (2210) par un chemin de transfert d'énergie relativement efficace (2906).

79. Appareil selon l'une quelconque des revendications 42 à 78, dans lequel ledit moyen (2202) pour transférer de l'énergie comprend un moyen (2308) pour transmettre par porte le signal de porteuse modulée reçu (2210) en utilisant un module de commutation (2402).

80. Appareil selon la revendication 79, dans lequel ledit moyen (2202) pour transférer de l'énergie comprend en outre un moyen (2906) pour adapter l'impédance (2916) dudit module de commutation (2402) à une impédance de source (3604), pour accroître l'énergie transférée à partir dudit signal de porteuse modulée reçu (2210).

81. Appareil selon la revendication 79, dans lequel ledit moyen pour emmagasiner de l'énergie comprend en outre un moyen (2908) pour adapter l'impédance (2916) dudit module de commutation (2402) à une impédance de charge (2918), pour accroître l'énergie transférée à partir dudit signal de porteuse modulée reçu (2210).

82. Appareil selon la revendication 79, comprenant en outre:

un moyen pour coupler ledit signal de porteuse modulée reçu (2210) audit module de commutation (2402) via un circuit résonant (3616), ledit circuit résonant (3616) emmagasinant de l'énergie à partir de composantes dudit signal de porteuse modulée reçu (2210) pendant que ledit module de commutation (2402) est ouvert, et

dans lequel l'énergie emmagasinée dans ledit circuit résonant (3616) est déchargée via ledit module de commutation (2402) pendant que ledit module de commutation (2402) est fermé, pour accroître l'énergie transférée à partir dudit signal de porteuse modulée reçu (2210).

83. Appareil selon l'une quelconque des revendications 42 à 46, comprenant en outre:

un circuit d'adaptation d'impédance d'entrée (2906).

84. Appareil selon l'une quelconque des revendications 42 à 46, comprenant en outre:

un circuit d'adaptation d'impédance de sortie (2908).

85. Appareil selon l'une quelconque des revendications 42 à 46, comprenant en outre:

un circuit bouchon (3616).

86. Appareil selon la revendication 79, comprenant en outre:

un circuit de dérivation (5302) monté en parallèle avec ledit module de commutation (2402).

87. Appareil selon l'une quelconque des revendications 42 à 46, comprenant en outre:

une chaîne de rétroaction (2806).

88. Appareil selon l'une quelconque des revendications 42 à 46, dans lequel ledit moyen (2406) pour emmagasiner de l'énergie comprend:

un dispositif d'accumulation à capacitance (2702) dimensionné pour emmagasiner des quantités d'énergie substantielles par rapport à l'énergie approximative contenue dans un cycle du signal de porteuse modulée reçu (2210).

89. Appareil selon l'une quelconque des revendications 42 à 46, dans lequel ledit moyen (2202) pour transférer de l'énergie est constitué par des transistors métal-oxyde-semiconducteur complémentaires (CMOS) (8200).

90. Appareil selon l'une quelconque des revendications 42 à 46, dans lequel ledit moyen (2202) pour transférer de l'énergie est constitué par un seul circuit intégré (8200).

91. Appareil selon l'une quelconque des revendications 42 à 46, comprenant en outre une impédance de sortie réglable (5602).

## FIG. 1

112 — MODULATING BASEBAND SIGNAL F_{MB} → MODULATOR → MODULATED CARRIER SIGNAL F_{MC} — 116

110

CARRIER SIGNAL F_C — 114

210 —

## FIG. 2

EXAMPLE ANALOG MODULATING BASEBAND SIGNAL F_{MB}

AMPLITUDE

t →

310 —

## FIG. 3

EXAMPLE DIGITAL MODULATING BASEBAND SIGNAL F_{MB}

SECOND STATE 314

FIRST STATE 312

t

CARRIER SIGNAL (e.g. 900 MHz)
410 —

## FIG. 4

AMPLITUDE 414

t →

ANALOG
BASEBAND SIGNAL
210

FIG. 5A

CARRIER SIGNAL
410

FIG. 5B

AM CARRIER
SIGNAL
516

FIG. 5C

DIGITAL
BASEBAND SIGNAL
310

*FIG. 6A*

CARRIER SIGNAL
410

*FIG. 6B*

AM CARRIER SIGNAL
616

*FIG. 6C*

ANALOG
BASEBAND SIGNAL
210

*FIG. 7A*

CARRIER SIGNAL
410

*FIG. 7B*

FM CARRIER SIGNAL
716

*FIG. 7C*

DIGITAL
BASEBAND SIGNAL
310 —

*FIG. 8A*

CARRIER SIGNAL
410 —

*FIG. 8B*

FM CARRIER SIGNAL
816 —

*FIG. 8C*

ANALOG
BASEBAND SIGNAL
210

*FIG. 9A*

0°
+90°
+180°
$t_0$  $t_1$  $t_2$  $t_3$  $t_4$

*FIG. 9B*

CARRIER SIGNAL
410

PHASE MODULATED
CARRIER SIGNAL
916

*FIG. 9C*

70

DIGITAL
BASEBAND SIGNAL
310

*FIG. 10A*

314
SECOND STATE
(AMPLITUDE 2)

FIRST STATE
(AMPLITUDE 1)
312

$t_0$  $t_1$  $t_2$  $t_3$  $t_4$

CARRIER SIGNAL
410

*FIG. 10B*

PHASE MODULATED
CARRIER SIGNAL
1016

*FIG. 10C*

$t_0$  $t_1$  $t_2$  $t_3$  $t_4$

FIG. 11

## FIG. 12

1207

| RECEIVING A MODULATED CARRIER SIGNAL | 1208 |

↓

| RECEIVING AN ENERGY TRANSFER SIGNAL HAVING AN ALIASING RATE | 1210 |

↓

| TRANSFERRING ENERGY FROM THE MODULATED CARRIER SIGNAL AT THE ALIASING RATE TO DOWN-CONVERT THE EM SIGNAL TO AN IF SIGNAL | 1214 |

*FIG. 13E*

*FIG. 13A*

616

t$_1$   t$_2$

*FIG. 13B*

2206   4206   1301

*FIG. 13C*

2208

*FIG. 13D*

2208

## FIG. 14

1401

1402 — SELECTING OR DETERMINING THE
FREQUENCY OF THE EM SIGNAL

1404 — SELECTING OR DETERMINING THE
INTERMEDIATE FREQUENCY

1406 — SELECTING OR DETERMINING AN
ALIASING RATE FOR THE
ENERGY TRANSFER SIGNAL $F_{AR}$

2206

### FIG. 15A

$F_{AR}$(e.g.,1.8GHZ)

2206

### FIG. 15B

$F_{AR}$(e.g.,900MHZ)

2206

### FIG. 15C

$F_{AR}$(e.g.,450MHZ)

2206

### FIG. 15D

$F_{AR}$(e.g.,300MHZ)

2206

### FIG. 15E

$F_{AR}$(e.g.,225MHZ)

2206

### FIG. 15F

$F_{AR}$(e.g.,180MHZ)

2206

### FIG. 15G

$F_{AR}$(e.g.,150MHZ)

2206

### FIG. 15H

$F_{AR}$(e.g.,128MHZ)

EP 1 125 359 B1

516
(e.g.,901MHZ)

FIG. 16A

1604

FIG. 16B

1608

FIG. 16D

FIG. 16C

ENERGY
TRANSFER SIGNAL
2206

ENERGY TRANSFER PULSES
4206

APERTURES
1301

FIG. 16E

2208

1610A

1610B

2208

FIG. 16F

FIG. 16G

2208

*FIG. 17A*

616

*FIG. 17B*

1704

*FIG. 17D*

1708

*FIG. 17C*

2206     4206     APERTURES 1301

*FIG. 17E*

2208     1710A     1710B

*FIG. 17F*

2208

*FIG. 17G*

2208

FIG. 18A

FIG. 18B

FIG. 18D

FIG. 18C

FIG. 18E

FIG. 18F

FIG. 18G

EP 1 125 359 B1

FIG. 19A

FIG. 19B

FIG. 19D

FIG. 19C

FIG. 19E

FIG. 19F

FIG. 19G

80

916 **FIG. 20A**

2004 **FIG. 20B**

2008 **FIG. 20D**

**FIG. 20C**

2206

4206

APERTURES
1301

**FIG. 20E**

2208 2010B

2010A

**FIG. 20F**

2208

**FIG. 20G**

2208

1016

*FIG. 21A*

2104

*FIG. 21B*

2108

*FIG. 21D*

*FIG. 21C*

2206

4206

APERTURES
1301

*FIG. 21E*

2208

2110A

2110B

*FIG. 21F*

2208

2208

*FIG. 21G*

FIG. 22

2202

2210

MODULATED CARRIER
SIGNAL

2204

ENERGY TRANSFER
MODULE

2208

DOWN-CONVERTED
SIGNAL

ENERGY TRANSFER
SIGNAL HAVING AN
ALIASING RATE

2206

FIG. 23A

2302

2210

MODULATED CARRIER
SIGNAL

2304

GATED TRANSFER
MODULE

2208

DOWN-CONVERTED
SIGNAL

ENERGY TRANSFER
SIGNAL HAVING AN
ALIASING RATE

2206

FIG. 23B

2306

2210

MODULATED CARRIER
SIGNAL

2308

INVERTED
GATED TRANSFER
MODULE

2208

DOWN-CONVERTED
SIGNAL

2206

ENERGY TRANSFER
SIGNAL HAVING AN
ALIASING RATE

## FIG. 24

2302

2402

SWITCH
MODULE

2210

MODULATED CARRIER
SIGNAL

2406

STORAGE
MODULE

2208

DOWN-CONVERTED
SIGNAL

ENERGY TRANSFER
SIGNAL HAVING AN
ALIASING RATE

2206

GATED TRANSFER MODULE

2304

## FIG. 25A

2402

2502

2210

SWITCH MODULE

S          D

2506          2508

G

2504

## FIG. 25B

2402

SWITCH MODULE

FIG. 25C

2402

2512

SWITCH MODULE

2513

2206

FIG. 25D

2402

2514

SWITCH MODULE

2515

2206

FIG. 26A

2302

BREAK-BEFORE-MAKE MODULE
2602

MODULATED CARRIER SIGNAL
2210

INPUT
2608

no
2402A

OUTPUT
2610

nc
2402B

DOWN-CONVERTED SIGNAL
2208

ENERGY TRANSFER SIGNAL HAVING AN ALIASING RATE
2206

STORAGE MODULE
2406

ISOLATION SIGNAL
2612

GATED TRANSFER MODULE
2304

## FIG. 26B

ENERGY TRANSFER
SIGNAL HAVING AN
ALIASING RATE
2206

"MADE" OR
"CLOSED"

NON-NEGLIGIBLE
APERTURE

"BROKEN"
OR "OPEN"

$t_1$

## FIG. 26C

ISOLATION SIGNAL
2612

"MADE" OR
"CLOSED"

"BROKEN"
OR "OPEN"

$t_0$  $t_2$

## FIG. 27A

2406

STORAGE MODULE

REACTIVE
STORAGE
MODULE — 2701

## FIG. 27B

2406

STORAGE MODULE

REACTIVE STORAGE
MODULE — 2701

CAPACITIVE
STORAGE
MODULE — 2702

## FIG. 27C

2702

CAPACITIVE
STORAGE MODULE

TERMINAL
2706

CAPACITOR(S)
2704

## FIG. 27D

2406

STORAGE MODULE

REACTIVE STORAGE MODULE — 2701

INDUCTIVE STORAGE MODULE — 2708

## FIG. 27E

2406

STORAGE MODULE

REACTIVE STORAGE MODULE — 2701

CAPACITIVE/ INDUCTIVE STORAGE MODULE — 2710

## FIG. 27F

2702

CAPACITIVE STORAGE MODULE

CAPACITOR 2712

# FIG. 27G

## FIG. 27H

2724 2740

4206

2722

A. RISING EDGE PULSE GENERATOR

## FIG. 27I

2724 2750

4206

2722

B. FALLING-EDGE PULSE GENERATOR

## FIG. 27J

2720

INPUT
SIGNAL
2724

DELAY
2722

PULSES
4206

INVERTER
2728

U7

## FIG. 27K

2720

nand

vdd

vdd

S    S

M169    M171

PULSES
4206

M170

vneg

S

M172

S

vss

vneg

inverter

vdd

vdd

M168

INPUT
SIGNAL
2724

M167

vneg

S

vss

## FIG. 27L

INPUT
SIGNAL
2724

OSCILLATOR    2730

EP 1 125 359 B1

## FIG. 28

EP 1 125 359 B1

# FIG. 29

IMPEDANCE MATCHED ALIASING MODULE

# FIG. 30

94

EP 1 125 359 B1

FIG. 31A

2724

$V$

$^{\square V}(F_{osc})$  t ⟶

FIG. 31B

3004 (2206)

$V$

$^{\square V}(F_{ar})$  t ⟶

EP 1 125 359 B1

# FIG. 32

ENERGY TRANSFER MODULE

# FIG. 33

96

## FIG. 34A

~ 5.0mV

~-5.0mV

□ V (VOLTAGE-SRC)

## FIG. 34B

~ 5.0mV

~-5.0mV

□ V (INPUT)

## FIG. 34C

□ V (APERTURE)

## FIG. 34D

~ 10.0mV

~-10.0mV

200ns    220ns    240ns   TIME   260ns    280ns    300ns

□ V (OUTPUT)

## FIG. 34E

~ 10.0mV

~-10.0mV

200ns    250ns    300ns    350ns    400ns    450ns    500ns

□ V (OUTPUT)

## FIG. 34F

~ 2.0mV

~-2.0mV

200ns    250ns    300ns    350ns    400ns    450ns    500ns

□ V (FILTERED-OUT)      TIME

# FIG. 35A
## DIFFERENTIAL ENERGY TRANSFER CONFIGURATION

## FIG. 35B
### DIFFERENTIAL INPUT TO DIFFERENTIAL OUTPUT

## FIG. 35C
### SINGLE INPUT TO DIFFERENTIAL OUTPUT

## FIG. 35D
### DIFFERENTIAL INPUT TO SINGLE OUTPUT

# FIG. 35E
## EXAMPLE INPUT/OUTPUT CIRCUITRY

## FIG. 36A

2202

ALIASING MODULE

2210

MODULATED CARRIER SIGNAL

2906

IMPEDANCE-MATCH MODULE

2204

ENERGY TRANSFER MODULE

2208

DOWN-CONVERTED SIGNAL

N

3604
MODULATED CARRIER SIGNAL SOURCE IMPEDANCE

2916
INPUT IMPEDANCE

## FIG. 36B

2202

ALIASING MODULE

2210

MODULATED CARRIER SIGNAL

2204

ENERGY TRANSFER MODULE

2908

IMPEDANCE-MATCH MODULE

2208

DOWN-CONVERTED SIGNAL

LOAD

2918

3612
ENERGY TRANSFER MODULE OUTPUT IMPEDANCE

3608
OUTPUT IMPEDANCE

FIG. 36C

2202

ALIASING MODULE

2210

MODULATED CARRIER
SIGNAL

2204

ENERGY
TRANSFER
MODULE

2208

DOWN-CONVERTED
SIGNAL

TANK
CIRCUIT

3616

## FIG. 37A

## FIG. 37B

FIG. 38A

FIG. 38B

FIG. 38C

FIG. 38D

FIG. 38E

FIG. 38F

EP 1 125 359 B1

FIG. 39A

FIG. 39B

FIG. 39C

FIG. 39D

FIG. 39E

FIG. 39F

*FIG. 40A*

5.0mV
2210

-5.0mV

□ V (VOLTAGE-SRC)   t ——▶

*FIG. 40B*                4002

5.0mV

-5.0mV

□ V (INPUT)   t ——▶

*FIG. 40C*

3710

3804

□ V (UNDER-SAMPLING SIGNAL)   t ——▶

*FIG. 40D*

200uV

4006

-200uV

200ns          220ns          240ns          260ns          280ns          300ns
                                    TIME
□ V (OUTPUT)

*FIG. 40E*

200uV

-200uV

200ns     250ns     300ns     350ns     400ns     450ns     500ns
□ V (OUTPUT)

*FIG. 40F*

150uV

-150uV

200ns     250ns     300ns     350ns     400ns     450ns     500ns
□ V (FILTERED-OUT)                    TIME

EP 1 125 359 B1

## FIG. 41A

INPUT MODULATED CARRIER SIGNAL
2210

2202

2204

2402

4114

4116

2918

LOAD

2704 STORAGE CAPACITANCE

ENERGY TRANSFER SIGNAL

2206 (PULSE WITH A NON-NEGLIGIBLE APERTURE)

## FIG. 41B

2202

2204

4106

4116

INPUT MODULATED CARRIER SIGNAL
2210

2918

ie. LOW IMPEDANCE LOAD ~2k ohm

4108 STORAGE CAPACITANCE

ENERGY TRANSFER SIGNAL

2206 (PULSE WITH A NON-NEGLIGIBLE APERTURE)

FIG. 42A

FIG. 42B

FIG. 42C

FIG. 42D

FIG. 42E

FIG. 42F

## FIG. 43A

2802

2 MEMORY
LOCATIONS
PREVIOUS
CURRENT

FEEDBACK
2806

A/D

4302

STATE
MACHINE OR
EQUIVALENT

4304

DAC

4306

VCO

4308

PULSE
GENERATOR
e.g. FIG. 27J

4310

ENERGY TRANSFER
SIGNAL HAVING AN
ALIASING RATE
2206

6902
ENERGY TRANSFER
SIGNAL MODULE

## FIG. 43B

4319

**INITIALIZATION**

SET DAC TO MIDRANGE

READ A/D

STORE A/D RESULT IN PREVIOUS

SET INC DAC FLAG

INC DAC

**STATE MACHINE FLOWCHART**

READ A/D

STORE A/D RESULT IN CURRENT

CURRENT > PREVIOUS?

MOVE A/D CURRENT INTO PREVIOUS

INC DAC FLAG SET?

INC DAC FLAG SET?

DEC DAC

CLEAR INC DAC FLAG

INC DAC

SET INC DAC FLAG

## FIG. 43C

FEEDBACK
2806

RECTIFIER — 4316

ENERGY TRANSFER
SIGNAL HAVING AN
ALIASING RATE
2206

4314 — INTEGRATOR

MULTIPLIER

4318 —

4320 — PULSE
GENERATOR
e.g. FIG. 27J

DIFFERENCE
CIRCUIT

VOLTAGE
REFERENCE — 4312

2730 —

OSCILLATOR

ENERGY TRANSFER SIGNAL MODULE 2802

FIG. 44

CKT@915MHz/101.1MHzCLK

EP 1 125 359 B1

EP 1 125 359 B1

## FIG. 45

FIG. 46

FIG. 47

FIG. 48

CKT@915MHz/101.1MHzCLK

FIG. 49

EP 1 125 359 B1

*FIG. 50*

AN EXAMPLE OF AN FSK MODULATOR

CKT8915MHz/101.1MHzCLK

# FIG. 51

EP 1 125 359 B1

FIG. 52A

INPUT SIGNAL: 950Mhz
50 OHM IMPEDANCE

ENERGY TRANSFER SIGNAL 2206

FREQ 150Mhz
PULSE WIDTH 550ps

OUTPUT FREQ. 50Mhz
PHASE A

OUTPUT FREQ. 50Mhz
PHASE B

6.67ns

550ps

EP 1 125 359 B1

EP 1 125 359 B1

## FIG. 52B

□ V (OUTPUTA 2208A)

## FIG. 52C

□ V (OUTPUTB 2208B)

## FIG. 53

5302

5312

2402

INPUT MODULATED
CARRIER SIGNAL

2210

LOAD

STORAGE
CAPACITANCE

ENERGY TRANSFER
SIGNAL

2206

(PULSE WITH A NON-
NEGLIGIBLE APERTURE)

FIG. 54

*FIG. 55*

EP 1 125 359 B1

## FIG. 56A

EP 1 125 359 B1

FIG. 56B

CLOCK
5614

FIG. 56C

OPTIONAL ENABLE
5610

FIG. 56D

INVERTED CLOCK 5622

FIG. 56E

DELAYED CLOCK 5624

LESS C

FIG. 56F

APERTURE
1301

ENERGY TRANSFER SIGNAL
2206

PULSES
4206

PULSES
4206

FIG. 57

FIG. 58

EP 1 125 359 B1

**FIG. 59**

DIFFERENTIAL AMPLIFIER/FILTER

$R_L$

OUTPUT-NODE

S1
Sbreak-X

Aperture_Gen.

C2

C3

L3

C1

3616

L1

L2

2906

2202/5902

INPUT-NODE

TX1
kbreak

RF
SIGNAL
SOURCE

50
R1

V1

FIG. 60

SPECTRUM ANALYZER

2918

$R_L$

6012

CKT@915MHz/~230MHzCLK

OUTPUT-NODE

6006

(47) 150p

6010

S1  Sbreak-X

S2  Sbreak-X

Aperture_Gen.

L3 12n

C1 2p

L1 18n

L2 18n

TX1 kbreak

6004 BALUN

2202/6002

INPUT-NODE

RF SIGNAL SOURCE

50 R1

V1

## FIG. 61

CKT@915MHz/101.1MHzCLK

EP 1 125 359 B1

132

FIG. 62

EP 1 125 359 B1

FIG. 63

EP 1 125 359 B1

## FIG. 64

EP 1 125 359 B1

*FIG. 65A*

□ V(out1)
E1: (981.86n, 1.404m) E2: (883.04n, -1.402m) DIFF(E): (98.82n, 2.806m)
F1: (837.43n, 1.253m) F2: (738.01n, -1.252m) DIFF(F): (99.42n, 2.505m)

*FIG. 65B*

□ V(impedance-match-out)
E1: (981.86n, 1.404m) E2: (883.04n, -1.402m) DIFF(E): (98.82n, 2.806m)
F1: (837.43n, 1.253m) F2: (738.01n, -1.252m) DIFF(F): (99.42n, 2.505m)

EP 1 125 359 B1

FIG. 66A

2.0mV

-2.0mV
0.5us          0.6us          0.7us     TIME     0.8us          0.9us          1.0us

☐ V(impedance-match-out)
A1: (810.53n, 1.642m) A2: (710.52n, -1.621m) DIFF(A): (100.01n, 3.263m)
B1: (777.78n, 942.32u) B2: (677.18n, -942.51u) DIFF(B): (100.60n, 1.885m)

FIG. 66B

2.0mV

-2.0mV
0.5us          0.6us          0.7us     TIME     0.8us          0.9us          1.0us

☐ V(impedance-match-out)
E1: (981.86n, 1.404m) E2: (883.04n, -1.402m) DIFF(E): (98.82n, 2.806m)
F1: (837.43n, 1.253m) F2: (738.01n, -1.252m) DIFF(F): (99.42n, 2.505m)

## FIG. 67A

SWITCH
2402

2202

CAPACITOR
2407

CONTROL SIGNAL
2206

PULSES
4206

## FIG. 67B

$$q = C \cdot V \qquad \text{EQ. 10}$$

$$V = A \cdot \sin(t) \qquad \text{EQ. 11}$$

$$q(t) = C \cdot A \cdot \sin(t) \qquad \text{EQ. 12}$$

$$\triangle q(t) = C \cdot A \cdot \sin(t) - C \cdot A \cdot \sin(t-T) \qquad \text{EQ. 13}$$

$$\triangle q(t) = C \cdot A \cdot (\sin(t) - \sin(t-T)) \qquad \text{EQ. 14}$$

$$\sin(\alpha) - \sin(\beta) = 2 \cdot \sin\left(\frac{\alpha - \beta}{2}\right) \cdot \cos\left(\frac{\alpha + \beta}{2}\right) \qquad \text{EQ. 15}$$

$$\triangle q(t) = 2 \cdot C \cdot A \cdot \sin\left[\frac{t-(t-T)}{2}\right] \cdot \cos\left[\frac{t+(t-T)}{2}\right] \qquad \text{EQ. 16}$$

$$\triangle q(t) = 2 \cdot C \cdot A \cdot \sin\left(\frac{1}{2} \cdot T\right) \cdot \cos\left(t - \frac{1}{2} \cdot T\right) \qquad \text{EQ. 17}$$

$$q(t) = \int C \cdot A \cdot (\sin(t) - \sin(t-T)) dt \qquad \text{EQ. 18}$$

$$q(t) = -\cos(t) \cdot C \cdot A + \cos(t-T) \cdot C \cdot A \qquad \text{EQ. 19}$$

$$q(t) = C \cdot A \cdot (\cos(t-T) - \cos(t)) \qquad \text{EQ. 20}$$

## FIG. 67C

$$\frac{(q(t))}{sin(t)}$$

C = 1
A = .5
T = π

GRAPH 1

t

## FIG. 67D

$$\frac{(q(t))}{sin(t)}$$

C = 1
A = .5
T = π/10

GRAPH 2

t

## FIG. 67E

POWER-CHARGE RELATIONSHIP

| | |
|---|---|
| $q = C \cdot V$ | EQ. 21 |
| $V = q/C$ | EQ. 22 |
| $V = J/C$ | EQ. 23 |
| $J = q^2/C$ | EQ. 24 |
| $P = J/S$ | EQ. 25 |
| $P = \dfrac{q^2}{C \cdot S}$ | EQ. 26 |

## FIG. 67F

INSERTION LOSS

INSERTION LOSS IN dB IS EXPRESSED BY:

$$ILdB = 10 \cdot log\left(\frac{Pin}{Pout}\right) \text{ or}$$

$$ILdB = 10 \cdot log\left[\frac{\left(\frac{Vin^2}{Rin}\right)}{\left(\frac{Vout^2}{Rout}\right)}\right]$$

## FIG. 68A

2204

6B00

6804/2402

2210
MODULATED
CARRIER
SIGNAL

S    D

G

6806

2704

2406

2206
ENERGY
TRANSFER
SIGNAL

2208
DOWN-
CONVERTED
SIGNAL

## FIG. 68B

$1/R_{on}$

$V_T$

$V_{GS}$

FIG. 69A

FET SOURCE

6904

2210

6902

TIME

FIG. 69B

FET GATE

2206

6906

TIME

FIG. 69C

$V_{GS}$

$V_T$

6911

6910

6908

6912

TIME

EP 1 125 359 B1

FIG. 70

MODULATED CARRIER SIGNAL 2210

ENERGY TRANSFER SIGNAL 2206

DOWN-CONVERTED SIGNAL 2208

EP 1 125 359 B1

142

FIG. 71A

$V_S$[FET 7004,7018]

7104
7105
7102
7103
TIME

FIG. 71B

$V_G$[FET 7004]

7106
V+
V-
TIME

FIG. 71C

$V_{GS}$[FET 7004]

7110
7112
7111
7108
7109
$V_T$
TIME

FIG. 71D

$V_G$[FET 7018]

7114
V+
V-
TIME

FIG. 71E

TIME
$V_T$
7117
7122
7116
$V_{GS}$[FET 7018]
7118
7120

FIG. 72

## FIG. 73

EP 1 125 359 B1

FIG. 74

*FIG. 75*

**FIG. 76**

**FIG. 77**

**FIG. 78**

FIG. 79

FIG. 80

FIG. 81

EP 1 125 359 B1

FIG. 82A

EP 1 125 359 B1

FIG. 82B

FIG. 82C

A1: (4.6344n,2.0867)  A2: (0.000,50.185n)  DIFF(A): (4.6344n,2.0867)

FIG. 82D

A1: (4.6344n,2.0867)  A2: (0.000,50.185n)  DIFF(A): (4.6344n,2.0867)

EP 1 125 359 B1

FIG. 82E

2202

8226

8200

Dncnvrt_
Clock

U1
1  2
inv.5x1_.5x2.3

U2
1  2
inv.5x1_.5x2.3

U3
1  2
inv.5x2_.5x4.6

U8
1 clk      Q 3
   edgedff
2 d        Q̄ 4

U5
1  2
inv1x3_1x6.9

U4
1  2
inv.5x3_.5x6.9

U9
1 clk      Q 3
   edgedff
2 d        Q̄ 4

ENERGY TRANSFER
MODULE #1
ETM
SP2  SP1
Clk

2204A

8222(2206)

I_out
IN-PHASE          2208A
SIGNAL ("I")

8224(2206)        2204B

Clk
SP2  SP1
ETM
ENERGY TRANSFER
MODULE #2

ANTENNA

SIGNAL          2210
SPLITTER

QUADRATURE
SIGNAL ("Q")

Q_out

2208B

EP 1 125 359 B1

153

## FIG. 82F

LO SIGNAL — 8216

## FIG. 82G

INVERTED LO SIGNAL — 8218

## FIG. 82H

NON-INVERTED LO SIGNAL — 8220

## FIG. 82I

I-CHANNEL OSCILLATING SIGNAL — 8222

## FIG. 82J

Q-CHANNEL OSCILLATING SIGNAL — 8224

FIG. 83

FIG. 84A

EP 1 125 359 B1

FIG. 84B — 2210

FIG. 84C — 2206

FIG. 84D — 2210

FIG. 84E — 2208

157

FIG. 84F

FIG. 84G

FIG. 84H

FIG. 84I

FIG. 84J

□V(V4:+)   A1:(1.0000G,9.4703m)  A2:(920.000M,23.970u)  DIFF(A):80.000M,9.4463m)

FIG. 84K

□V(V1:+)   A1:(1.0000G,9.4703m)  A2:(920.000M,23.970u)  DIFF(A):80.000M,9.4463m)

FIG. 84L

□ V(SP1)   A1:(1.0000G,9.4703m)  A2:(920.000M,23.970u)  DIFF(A):80.000M,9.4463m)

FIG. 84M

□ V(SP2)   A1:(1.0000G,9.4703m)  A2:(920.000M,23.970u)  DIFF(A):80.000M,9.4463m)

FIG. 84N

FIG. 84O

FIG. 84P

FIG. 84Q

A1:(10.000M, 6.0816mm)  A2:(0.000, 49.846m)  DIFF(A):(10.000M, -43.764m)

EP 1 125 359 B1

160

FIG. 85A

FIG. 85B

FIG. 85C

FIG. 85D

FIG. 85E

162

EP 1 125 359 B1

FIG. 85F

FIG. 85G

FIG. 85H

FIG. 85I

EP 1 125 359 B1

FIG. 85J

FIG. 85K

FIG. 85L

FIG. 85M

A1:(1.0000G, 5.3091m)   A2:(818.000M, 11.646u)   DIFF(A):(182.000M, 5.2974m)

EP 1 125 359 B1

FIG.
85N

100nV

0V
0Hz    2MHz    4MHz    6MHz    8MHz    10MHz    12MHz    14MHz
⬛ V (V4:+)                              FREQUENCY

FIG.
85O

400mV

0V
0Hz    2MHz    4MHz    6MHz    8MHz    10MHz    12MHz    14MHz
☐ V (V1:+)                              FREQUENCY

FIG.
85P

400uV

0V
0Hz    2MHz    4MHz    6MHz    8MHz    10MHz    12MHz    14MHz
☐ V (SP1)                               FREQUENCY

FIG.
85Q

10mV

SEL>>
0V
0Hz    2MHz    4MHz    6MHz    8MHz    10MHz    12MHz    14MHz
☐ V (SP2)                               FREQUENCY

EP 1 125 359 B1

165

## FIG. 86A

8600

8606   S   G   8614   D
8602   8610

8608   n+   n+   8612

P

8604

## FIG. 86B

8616

8606   S   G   8614   D
8602   8610

8620   n+   n+   8622

8624   8626

P

8618

FIG. 86C

FIG. 87A

EP 1 125 359 B1

FIG. 87B

FIG. 87C

FIG. 87D

FIG. 87E

EP 1 125 359 B1

FIG. 87F

FIG. 87G

FIG. 87H

FIG. 87I

FIG. 87J

10mV

0V
0.79GHz          0.90GHz          1.00GHz    FREQUENCY   1.10GHz          1.20GHz
        □ V (V4:+)

FIG. 87K

400mV

0V
0.79GHz          0.90GHz          1.00GHz    FREQUENCY   1.10GHz          1.20GHz
        □ V (V1:+)   ◇ V (V7:+)

FIG. 87L

10mV

SEL>>
0V
0.79GHz          0.90GHz          1.00GHz    FREQUENCY   1.10GHz          1.20GHz
        ⬚ V (SP1)

FIG. 87M

4.0mV

0V
0.79GHz          0.90GHz          1.00GHz    FREQUENCY   1.10GHz          1.20GHz
        □ V (SP2)
A1:(1.0000G, 3.9326m)   A2:(788.000M, 9.0941u)   DIFF(A):(212.000M, -3.9235m)

EP 1 125 359 B1

FIG. 87N

FIG. 87O

FIG. 87P

FIG. 87Q

A1:(10.000M, 5.1957m)   A2:(0.000, 10.751m)   DIFF(A):(10.000M, -5.5551m)

172

EP 1 125 359 B1